# EUROPEAN PATENT SPECIFICATION

(11) **EP 4 509 579 B1**
(45) Date of publication and mention of the grant of the patent: **31.12.2025**
(21) Application number: 24170935.1
(22) Date of filing: 18.04.2024
(51) Int. Cl.: C09K 11/06, C07F 7/08, H10K 50/00, H10K 85/40, H10K 85/60

(54) **FLUORENE-CONTAINING HETEROCYCLIC COMPOUND AND ORGANIC ELECTROLUMINESCENT DEVICE THEREOF**
FLUORENHALTIGE HETEROCYCLISCHE VERBINDUNG UND ORGANISCHE ELEKTROLUMINESZENZVORRICHTUNG DAFÜR
COMPOSÉ HÉTÉROCYCLIQUE CONTENANT DU FLUORÈNE ET DISPOSITIF ÉLECTROLUMINESCENT ORGANIQUE ASSOCIÉ

(30) Priority: 16.08.2023 CN 202311034121
(43) Date of publication of application: 19.02.2025
(73) Proprietor: Changchun Hyperions Technology Co., Ltd., Bayhood Science and Technology Development Zone Changchun City Jilin 130000 (CN)
(72) Inventor: GUO, Jianhua, Changchun City, 130000 (CN); MIAO, Yuhe, Changchun City, 130000 (CN); DU, Mingzhu, Changchun City, 130000 (CN)
(74) Representative: Plougmann Vingtoft a/s

(56) References cited:
- WO-A1-2010/060160
- CN-A- 108 358 922
- CN-B- 108 409 773
- US-A1- 2022 315 542
- US-A1- 2023 192 669
- SHIJIE REN ET AL: "Solution Processable Monosubstituted Hexa-Peri-Hexabenzocoronene Self-Assembling Dyes", ADVANCED FUNCTIONAL MATERIALS, WILEY - V C H VERLAG GMBH & CO. KGAA, DE, vol. 22, no. 10, 16 March 2012 (2012-03-16), pages 2015 - 2026, XP072294562, ISSN: 1616-301X, DOI: 10.1002/ADFM.201102141

## Description

### TECHNICAL FIELD

The present disclosure relates to the field of organic electroluminescent materials and specifically, to a fluorene-containing heterocyclic compound and an organic electroluminescent device thereof.

### BACKGROUND

With the rapid development of information technology, new goals and requirements have been put forward for the performance of information display systems, and the display with high brightness, high resolution, a wide viewing angle, and low energy consumption has become a research hotspot. The organic electroluminescent, also known as organic light-emitting diode (OLED), display technology has advantages of being full-solid-state, high luminescence efficiency, high color contrast, fast response speed, being free of viewing angle limitation, light weight, low power consumption, being easy to achieve flexible display and 3D display, and the like and thus has gradually become the focus of research. US2023/192669A1 discloses compounds suitable for use in e.g. an OLED.

The light emission principle of an organic electroluminescent device is as follows: under the action of an applied electric field, holes and electrons are injected from the anode and the cathode, respectively, then compound in the light-emitting layer and generate excitons, the excitons transfer energy to organic light-emitting molecules such that the organic light-emitting molecules transition from the ground state to the excited state with the excited molecules in an unstable state, and when the excited molecules returns from the excited state to the ground state, energy is released in the form of light, resulting in the luminescence phenomenon. At present, the OLED device is mostly in a sandwich-shaped structure and includes a cathode, an anode, and organic layers disposed between the cathode and the anode. According to different functions of the organic layers, the organic layers are divided into a hole injection layer, a hole transport layer, a hole blocking layer, an electron blocking layer, an electron injection layer, an electron transport layer, a light-emitting layer, and a light extraction layer.

With the continuous development of organic electroluminescent devices, the development of functional materials is far from meeting market requirements, and as a result, the organic electroluminescent material has become a research hotspot in the field. Currently, the organic electroluminescent device shows problems of a high drive voltage, low luminescence efficiency, and high power consumption, and the reason is that the electron transport efficiency of an electron transport material is low, the transport of electrons and holes is unbalanced, and the electrons and the holes cannot be effectively transmitted to the light-emitting layer; at the same time, the energy levels of the functional layer do not match so that part of electrons and holes to escape from the light-emitting layer, resulting in a decrease of the luminescence efficiency and an increase of the drive voltage. In addition, the problems existing in the light-emitting layer that electron migration is not balanced with hole migration and the triplet energy levels of host and guest materials do not match also cause the low efficiency of generating the excitons by the recombination of electrons and holes, further affecting the luminescence efficiency of the organic electroluminescent device.

Optimization and performance improvement of the OLED device may be achieved by improving the materials of different functional layers in the device. Therefore, to solve the current problems that exist in the electron transport material and the light-emitting layer material, an electron transport material, a hole blocking material, and a light-emitting layer host material that have better performance need to be developed.

### SUMMARY

In terms of the preceding problems, the present disclosure provides a fluorene-containing heterocyclic compound and an organic electroluminescent device that includes the heterocyclic compound to solve the problems of a high drive voltage, low luminescence efficiency, and short service life of the organic electroluminescent device. With the preceding problems significantly improved, the organic electroluminescent device can have a low drive voltage, high luminescence efficiency, and a long service life.

Specifically, the present disclosure provides a fluorene-containing heterocyclic compound. The fluorene-containing heterocyclic compound has a structure represented by Formula I: 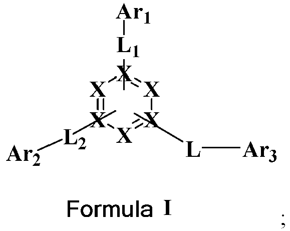 wherein in Formula I, X is independently selected from C(R₀) or an N atom, and at least one of Xis selected from an N atom;
R₀ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Ar₃ is selected from a group represented by Formula II-1 or Formula II-2: 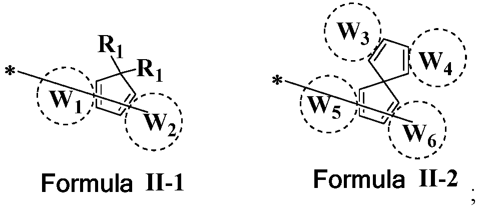
the ring W₁, the ring W₂, the ring W₃, the ring W₄, the ring W₅ and the ring W₆ are independently selected from any one of the following structures: 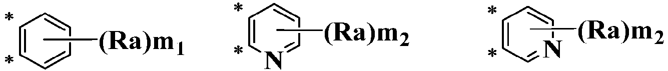 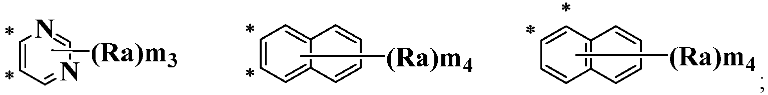
"*" represents a fusion site;
Ra is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
m₁ is independently selected from 0, 1, 2, 3 or 4, m₂ is independently selected from 0, 1, 2 or 3, m₃ is independently selected from 0, 1 or 2, and m₄ is independently selected from 0, 1, 2, 3, 4, 5 or 6;
R₁ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl; or two adjacent R₁ are linked to each other to form a substituted or unsubstituted C3 to C7 aliphatic ring;
L is selected from any one of a single bond, C6 to C30 arylene unsubstituted or substituted by one or more Rb, or C2 to C30 heteroarylene unsubstituted or substituted by one or more Rb;
L₁ and L₂ are independently selected from any one of a single bond, substituted or unsubstituted C6 to C30 arylene, or substituted or unsubstituted C2 to C30 heteroarylene;
Ar₁ and Ar₂ are independently selected from C6 to C30 aryl unsubstituted or substituted by one or more Rc or are selected from any one of the following groups: 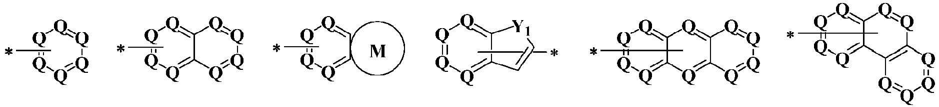 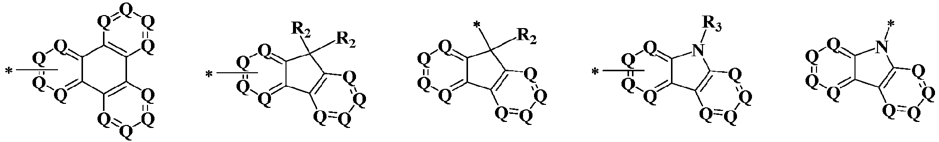 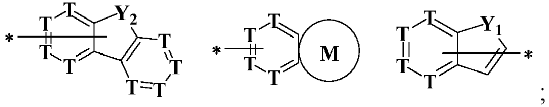
Q is independently selected from C(Rd) or an N atom, and at least one Q in each group is selected from an N atom;
T is independently selected from C(Rd);
the ring M is independently selected from C3 to C7 aliphatic ring unsubstituted or substituted by one or more R₄;
Y₁ is selected from O, S, C(R₅)₂ or N(R₆); Y₂ is selected from an O atom, an S atom or N(R₃);
Rd is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₂, R₄ and R₅ are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₃ and R₆ are independently selected from any one of substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Rb and Rc are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
with the proviso that at least one of R₁, Ra, Rb, Rc or Rd is selected from a group represented by Formula III: 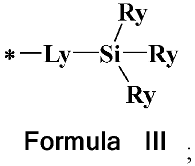
Ry is independently selected from any one of hydrogen, deuterium, cyano, nitro, halogen, substituted or unsubstituted C1 to C12 alkyl, substituted or unsubstituted C2 to C12 alkenyl, substituted or unsubstituted C3 to C12 cycloalkyl, or substituted or unsubstituted C2 to C12 heterocycloalkyl;
Ly is independently selected from any one of a single bond, substituted or unsubstituted C6 to C30 aryl, or substituted or unsubstituted C2 to C30 heteroaryl;
when two or more R₁, Ra, Rb, Rc and Rd are present, the two or more R₁, Ra, Rb, Rc and Rd are identical to each other or different from each other.

Another scheme of the present disclosure provides an organic electroluminescent device. The organic electroluminescent device includes an anode, a cathode and an organic layer, where the organic layer is disposed between the anode and the cathode, the organic layer includes at least one of a light-emitting layer, an electron transport layer or a hole blocking layer, at least one of the light-emitting layer, the electron transport layer or the hole blocking layer includes any one or more of the fluorene-containing heterocyclic compound described in the present disclosure.

Another scheme of the present disclosure provides an organic electroluminescent device. The organic electroluminescent device includes an anode, a cathode and an organic layer, where the organic layer is disposed on an outer side of at least one of the anode or the cathode, the organic layer includes a light extraction layer, and the light extraction layer includes any one or more of the fluorene-containing heterocyclic compound described in the present disclosure.

The fluorene-containing heterocyclic compound provided by the present disclosure has relatively high electron mobility and suitable highest occupied molecular orbital (HOMO) and lowest unoccupied molecular orbital (LUMO) energy levels and can improve the electron mobility, adjust the transport balance between holes and electrons, reduce the energy potential barrier between electron injection and transport, and reduce a drive voltage; the compound can match the energy level of an adjacent functional layer, improve the electron transport efficiency, and limit holes within the light-emitting layer to avoid light emission at the interface of the light-emitting layer, thereby reducing power consumption while improving the luminescence efficiency.

In another aspect, the compound has a relatively high glass transition temperature and is not prone to crystallize during film formation by evaporation. Especially, since its structure includes a silicon-containing group, the molecular material possesses a relatively large space structure, has good uniformity and stability during film formation by evaporation, and can reduce an inter-molecular stack effect, reduce the quenching of energy, and improve film morphology of the heterocyclic compound, thereby further improving the lifetime of an organic electroluminescent device.

### DETAILED DESCRIPTION

The present disclosure is further illustrated below in conjunction with specific embodiments. It is to be understood that these embodiments are intended to illustrate the present disclosure and are not to limit the scope

In the compounds of the present disclosure, any atom not specifically designated as a particular isotope is included as any stable isotope of that atom and contains atoms at both its natural and non-natural isotopic abundance.

The halogen atom in the present disclosure includes fluorine, chlorine, bromine and iodine.

In the present disclosure, when the position of a substituent on an aromatic ring is not fixed, it indicates that the substituent may be linked to any one of the corresponding optional sites of the aromatic ring. For example, 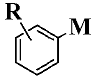 may be represented as 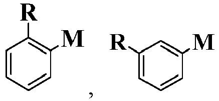 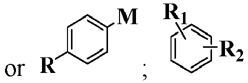 may be represented as 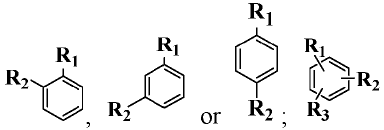 may be represented as 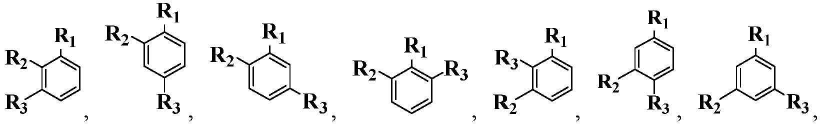 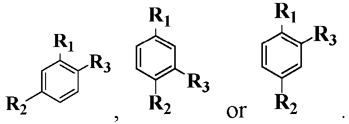 The rest can be represented in the same manner.

In the present disclosure, the expression that "two adjacent groups are linked to form a ring" means that adjacent groups are bound to each other and optionally aromatized to form a substituted or unsubstituted aromatic ring, heteroaromatic ring, aliphatic ring or aliphatic heterocyclic ring. The term "adjacent groups" refers to two substituents on two atoms that are directly linked to each other, a substituent that is set in the closest spatial proximity to a corresponding substituent, and another substituent that is on the atom that has a corresponding substituent, for example, two substituents substituted in ortho-positions of a benzene ring or two substituents on the same carbon atom in an alicyclic ring may be considered to be "adjacent" to each other.

The aliphatic ring and the aliphatic heterocyclic ring may be saturated rings or may be unsaturated rings, and specifically, the linked ring may be a three-membered ring, a four-membered ring, a five-membered ring, a six-membered ring, a seven-membered ring, a spirocyclic ring or a fuse ring; the number of ring carbon atoms of the formed aromatic ring is preferably 6 to 30, particularly preferably 6 to 18, and most preferably 6 to 12; the number of ring carbon atoms of the formed heteroaromatic ring is preferably 2 to 30, particularly preferably 2 to 18, and most preferably 2 to 12; the number of ring carbon atoms of the formed aliphatic ring is preferably 3 to 30, particularly preferably 3 to 18, more preferably 3 to 12, and most preferably 3 to 7; the number of ring carbon atoms of the formed aliphatic heterocyclic ring is preferably 3 to 30, particularly preferably 2 to 18, more preferably 2 to 12, and most preferably 2 to 7. Furthermore, the linked ring may be, but is not limited to, benzene, naphthalene, indene, cyclopentene, cyclopentane, benzocyclopentane cyclopentanobenzene, cyclohexene, cyclohexane, benzocyclohexane, pyridine, quinoline, isoquinoline, benzofuran, benzothiophene, dibenzofuran, dibenzothiophene, phenanthrene or pyrene.

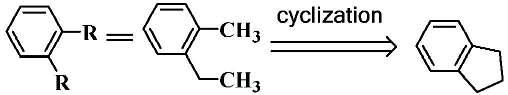

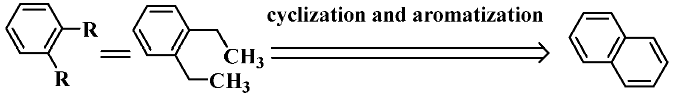

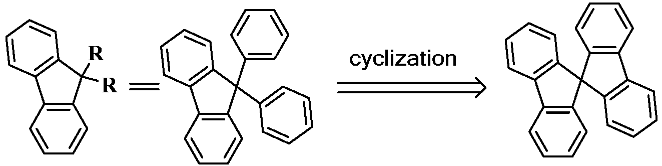

"Substituted" in "substituted or unsubstituted" as used in the present disclosure, for example, "substituted" in "substituted or unsubstituted alkyl, substituted or unsubstituted silyl, substituted or unsubstituted alkoxy, substituted or unsubstituted cycloalkyl, substituted or unsubstituted heterocycloalkyl, substituted or unsubstituted aryl, substituted or unsubstituted heteroaryl, substituted or unsubstituted arylidene, or substituted or unsubstituted heteroarylidene", means that at least one hydrogen atom on the group is substituted with a substituent. When a plurality of hydrogens are substituted with a plurality of substituents, the plurality of substituents may be identical to or different from each other. The substituents used for "substituted" in "substituted or unsubstituted" include, but are not limited to, the following groups: deuterium, tritium, cyano, nitro, hydroxyl, a halogen atom, substituted or unsubstituted C1 to C12 alkyl, substituted or unsubstituted C2 to C12 alkenyl, substituted or unsubstituted C3 to C12 cycloalkyl, substituted or unsubstituted C6 to C30 aryl, substituted or unsubstituted C2 to C30 heteroaryl, substituted or unsubstituted C1 to C12 alkoxy, substituted or unsubstituted C1 to C12 alkylthio, substituted or unsubstituted C1 to C12 alkylamino, substituted or unsubstituted C6 to C30 aryloxy, and substituted or unsubstituted C6 to C30 arylamine. The substituents are preferably the following groups: deuterium, tritium, cyano, fluorine, chlorine, bromine, iodine, nitro, methyl, ethyl, propyl, butyl, pentyl, hexyl, heptyl, octyl, cyclopropyl, cyclobutyl, cyclopentyl, cyclohexyl, cyclobutenyl, cyclopentenyl, cyclohexenyl, cyclopentadienyl, cyclohexadienyl, adamantyl, norbornyl, trifluoromethyl, trifluoroethyl, trimethylsilyl, triethylsilyl, tri-*tert*-butylsilyl, triphenylsilyl, trideuteromethyl, methoxy, ethoxy, phenyl, biphenyl, terphenyl, naphthyl, phenanthryl, triphenylenyl, anthryl, pyrenyl, chrysenyl, fluoranthenyl, benzocyclopropyl, benzocyclobutyl, benzocyclopentyl, benzocyclohexyl, benzocycloheptyl, benzocyclobutenyl, benzcyclopentenyl, benzocyclohexenyl, 9,9-dimethylfluorenyl, 9,9-diphenylfluorenyl, 9-methyl-9-phenylfluorenyl, 9,9'-spirobifluorenyl, diphenylamino, pyridyl, pyrimidinyl, pyrazinyl, pyridazinyl, triazinyl, quinolyl, isoquinolyl, quinazolinyl, quinoxalinyl, benzoquinolyl, benzisoquinolyl, phenanthrolinyl, oxazolyl, benzoxazolyl, thiazolyl, benzothiazolyl, imidazolyl, benzimidazolyl, benzofuryl, dibenzofuryl, benzothienyl, dibenzothienyl, indolyl, carbazolyl, and the like. In addition, each of the preceding substituents may be substituted or unsubstituted, and two adjacent substituents may be linked to form a ring.

Alkyl as used in the present disclosure refers to a monovalent group obtained by removing one hydrogen atom from an alkane molecule. Alkyl may be linear alkyl or branched alkyl and preferably has 1 to 12 carbon atoms, more preferably 1 to 8 carbon atoms, and particularly preferably 1 to 6 carbon atoms. Examples of alkyl may include, but are not limited to, methyl, ethyl, n-propyl, isopropyl, n-butyl, tert-butyl, isobutyl, s-butyl, n-pentyl, isopentyl, n-hexyl, and the like.

Cycloalkyl as used in the present disclosure refers to a monovalent group obtained by removing one hydrogen atom from a cycloalkane molecule. Cycloalkyl preferably has 3 to 12 carbon atoms, more preferably 3 to 10 carbon atoms, and particularly preferably 3 to 7 carbon atoms. Examples of cycloalkyl include, but are not limited to, cyclopropyl, cyclobutyl, cyclopentyl, cyclohexyl, cycloheptyl, adamantyl, norbornyl, and the like.

Heterocycloalkyl as used in the present disclosure refers to a monovalent group obtained by substituting at least one carbon atom in a cycloalkane molecule with heteroatoms, where the heteroatoms include, but are not limited to, oxygen, sulphur, nitrogen, silicon or phosphorus atoms. Heterocycloalkyl preferably has 3 to 12 carbon atoms, more preferably 3 to 10 carbon atoms, and particularly preferably 3 to 6 carbon atoms. Examples of heterocycloalkyl include, but are not limited to, pyrrolyl, tetrahydropyranyl, piperidyl, tetrahydrofuryl, and the like.

The alkoxy in the present disclosure is represented by -O-alkyl. Alkoxy may be linear alkoxy or branched alkoxy and preferably has 1 to 12 carbon atoms, more preferably 1 to 8 carbon atoms, and particularly preferably 1 to 6 carbon atoms. Examples of alkoxy may include, but are not limited to, methoxy, ethoxy, *n*-propoxy, isopropoxy, *n*-butoxy, isobutoxy, *tert*-butoxy, *n*-pentoxy, *n*-hexoxy, and the like.

Aryl as used in the present disclosure refers to the generic term of monovalent groups obtained by removing one hydrogen atom from the aromatic nucleus carbon of an aromatic compound molecule. Aryl includes monocyclic aryl, polycyclic aryl, fused ring aryl, or a combination thereof, and preferably has 6 to 30 carbon atoms, more preferably 6 to 18 carbon atoms, and particularly preferably 6 to 12 carbon atoms. Examples of aryl include, but are not limited to, phenyl, biphenyl, terphenyl, tetraphenyl, naphthyl, phenanthryl, anthryl, triphenylenyl, fluorenyl, benzofluorenyl, spirobifluorenyl, benzospirobifluorenyl, pyrenyl, fluoranthenyl, chrysenyl, and the like.

Heteroaryl as used in the present disclosure refers to a monovalent group obtained by substituting one or more aromatic nucleus carbon atoms in an aromatic hydrocarbon molecule by heteroatoms, where the heteroatoms include, but are not limited to, oxygen, sulphur, nitrogen, silicon or phosphorus atoms. Heteroaryl preferably has 2 to 30 carbon atoms, more preferably 2 to 18 carbon atoms, and particularly preferably 2 to 12 carbon atoms. Examples of heteroaryl include, but are not limited to, oxazolyl, benzoxazolyl, naphthoxazolyl, phenanthroxazolyl, anthroxazolyl, triphenylenoxazolyl, pyridoxazoly, thiazolyl, benzothiazolyl, naphthothiazolyl, phenanthrothiazolyl, anthrothiazolyl, triphenylenothiazolyl, pyridothiazolyl, imidazolyl, benzimidazolyl, naphthoimidazolyl, phenanthroimidazolyl, anthroimidazoly, triphenylenoimidazoly, pyridoimidazoly, spirofluorenexanthyl, spirofluorenethioxanthyl, furyl, benzofuryl, pyridofuryl, naphthofuryl, phenanthrofuryl, anthrofuryl, triphenylenofuryl, dibenzofuryl, benzodibenzofuryl, thienyl, benzothienyl, pyridothienyl, naphthothienyl, phenanthrothienyl, anthrothienyl, triphenylenothienyl, dibenzothienyl, benzodibenzothienyl, indolyl, naphthoindolyl, phenanthroindolyl, anthroindolyl, triphenylenoindolyl, carbazolyl, pyridyl, pyrimidinyl, bipyridyl, bipyrimidinyl, phenylpyridyl, phenylpyrimidinyl, pyrazinyl, pyridazinyl, triazinyl, quinolyl, isoquinolyl, quinazolinyl, quinoxalinyl, naphthyridinyl, *ortho*-phenanthrolinyl, benzoquinolyl, benzisoquinolyl, benzoquinazolinyl, benzoquinoxalinyl, and the like.

Silyl in the present disclosure refers to a monovalent group obtained by removing one hydrogen atom from a silane molecule and may be represented by a group shown in -Si(Rs)(Rs)(Rs), where Rs is selected from hydrogen, deuterium, cyano, halogen, or is selected from any one or more of alkyl, alkenyl, alkoxy or cycloalkyl. Silyl preferably has 1 to 30 carbon atoms, preferably 1 to 25 carbon atoms, more preferably 1 to 22 carbon atoms, and most preferably 1 to 18 carbon atoms. Examples of silyl may include, but are not limited to, trimethylsilyl, triethylsilyl, triisopropylsilyl, tri-*tert*-butylsilyl, dimethylethylsilyl, dimethyl-*tert*-butylsilyl, diethylmethyllsilyl, tricyclopropylsilyl, tricyclobutylsilyl, and the like.

The aliphatic ring in the present disclosure may be a saturated or unsaturated ring and may include cycloalkane, cycloolefin, cycloalkyne, and the like. The aliphatic ring preferably has 3 to 25 carbon atoms, more preferably 3 to 20 carbon atoms, particularly preferably 3 to 15 carbon atoms, preferably 5 to 10 carbon atoms, and most preferably 5 to 7 carbon atoms. Examples of the aliphatic ring may include, but are not limited to, cyclopropane, cyclobutane, cyclopentane, cyclohexane, cycloheptane, adamantane, norbornene alkanes, cyclopropene, cyclobutene, cyclopentene, cyclohexene, cycloheptene, and the like.

Arylene as used in the present disclosure refers to those having two binding positions on aryl, that is, a divalent group. The description stated above about aryl may be applied to arylene except that arylene is a divalent group.

Heteroarylene as used in the present disclosure refers to those having two binding positions on heteroaryl, that is, a divalent group. The description stated above about heteroaryl may be applied to heteroarylene except that heteroarylene is a divalent group.

"At least one" and "one or more" as used in the present disclosure refer to, if permitted, one, two, three, four, five, six, seven, eight or more.

One embodiment of the present disclosure provides a fluorene-containing heterocyclic compound having a structure represented by Formula I: 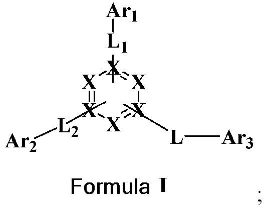
wherein in Formula I, X is independently selected from C(R₀) or an N atom, and at least one of Xis selected from an N atom;
R₀ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Ar₃ is selected from a group represented by Formula II-1 or Formula II-2: 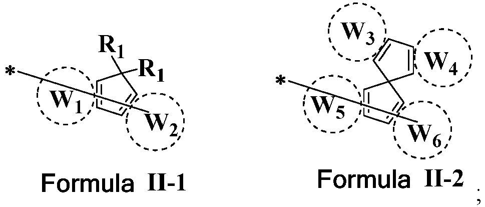
the ring W₁, the ring W₂, the ring W₃, the ring W₄, the ring W₅ and the ring W₆ are independently selected from any one of the following structures: 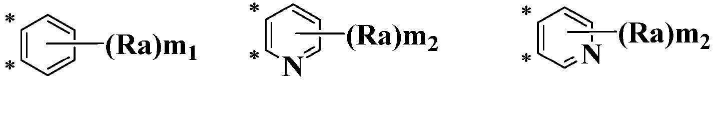 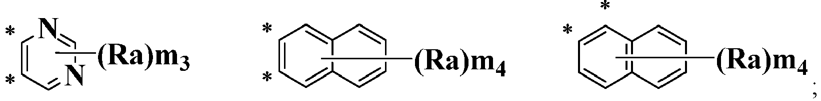
"*" represents a fusion site;
Ra is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
m₁ is independently selected from 0, 1, 2, 3 or 4, m₂ is independently selected from 0, 1, 2 or 3, m₃ is independently selected from 0, 1 or 2, and m₄ is independently selected from 0, 1, 2, 3, 4, 5 or 6;
R₁ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl; or two adjacent R₁ are linked to each other to form a substituted or unsubstituted C3 to C7 aliphatic ring;
L is selected from any one of a single bond, C6 to C30 arylene unsubstituted or substituted by one or more Rb, or C2 to C30 heteroarylene unsubstituted or substituted by one or more Rb;
L₁ and L₂ are independently selected from any one of a single bond, substituted or unsubstituted C6 to C30 arylene, or substituted or unsubstituted C2 to C30 heteroarylene;
Ar₁ and Ar₂ are independently selected from C6 to C30 aryl unsubstituted or substituted by one or more Rc or are selected from any one of the following groups: 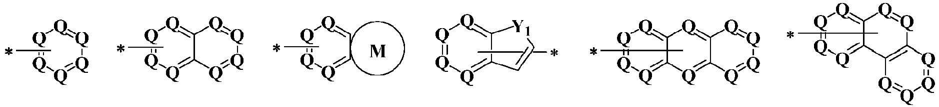 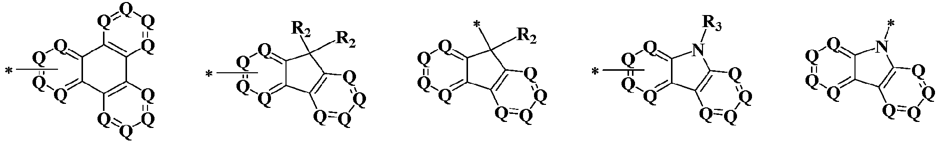 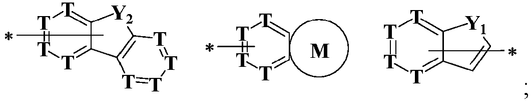
Q is independently selected from C(Rd) or an N atom, and at least one Q in each group is selected from an N atom;
T is independently selected from C(Rd);
the ring M is independently selected from C3 to C7 aliphatic ring unsubstituted or substituted by one or more R₄;
Y₁ is selected from O, S, C(R₅)₂ or N(R₆); Y₂ is selected from an O atom, an S atom or N(R₃);
Rd is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₂, R₄ and R₅ are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₃ and R₆ are independently selected from any one of substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Rb and Rc are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
with the proviso that at least one of R₁, Ra, Rb, Rc or Rd is selected from a group represented by Formula III: 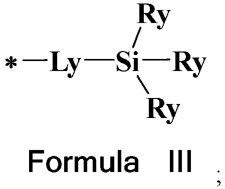
Ry is independently selected from any one of hydrogen, deuterium, cyano, nitro, halogen, substituted or unsubstituted C1 to C12 alkyl, substituted or unsubstituted C2 to C12 alkenyl, substituted or unsubstituted C3 to C12 cycloalkyl, or substituted or unsubstituted C2 to C12 heterocycloalkyl;
Ly is independently selected from any one of a single bond, substituted or unsubstituted C6 to C30 aryl, or substituted or unsubstituted C2 to C30 heteroaryl;
when multiple R₁, Ra, Rb, Rc and Rd are present, the multiple R₁, Ra, Rb, Rc and Rd are identical to each other or different from each other.

Preferably, one X in 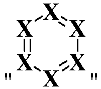 is selected from an N atom, more preferably, two X in 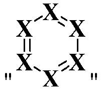 are selected from N atoms, and still more preferably, three X in 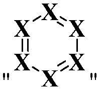 are selected from N atoms.

Preferably, 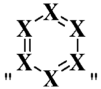 is selected from any one of the following groups: 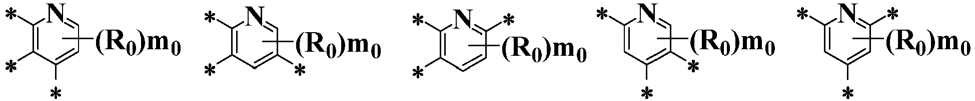 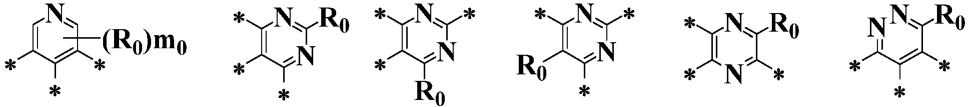 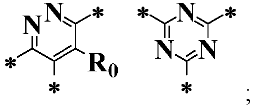
wherein R₀ is the same as defined for R₀ described above; m₀ is independently selected from 0, 1 or 2;
"*"is the linkage site to L₁, L₂ or L.

Preferably, the fluorene-containing heterocyclic compound is selected from any one of the structures represented by Formulas I-1 to I-4: 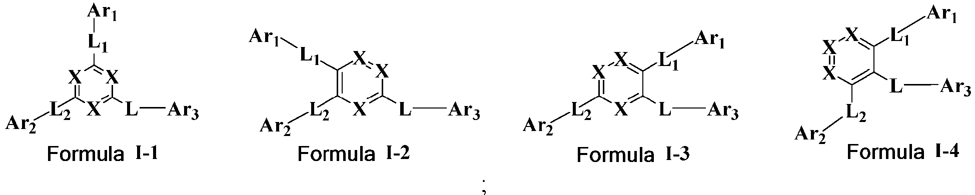 wherein Ar₁, Ar₂, Ar₃, L, L₁, L₂ and X are the same as defined above.

More preferably, the fluorene-containing heterocyclic compound is selected from any one of the structures represented by Formulas IV-1 to IV-5: 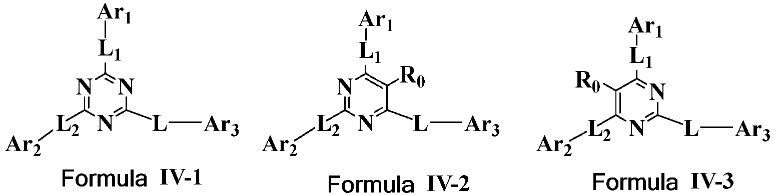 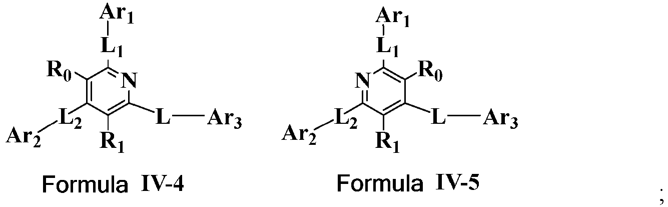 wherein Ar₁, Ar₂, Ar₃, L, L₁, L₂ and R₀ are the same as defined above.

Preferably, at least one of R₀, R₁, Ra, Rb, Rc or Rd is selected from a group represented by Formula III, which means that any one, any two, any three, any four, any five or all of multiple R, multiple R₁, multiple Ra, multiple Rb, multiple Rc, and multiple Rd are selected from the group represented by Formula III.

Preferably, at least one (any one, any two, any three, any four, any five or all) of R₁, Ra, Rb, Rc or Rd is selected from a group represented by Formula III; more preferably, at least one (any one, any two, any three, any four, any five or all) of Ra, Rb, Rc or Rd is selected from a group represented by Formula III; still more preferably, at least one (any one, any two, any three, any four, any five or all) of Ra, Rc or Rd is selected from a group represented by Formula III.

Preferably, one or two of Ra are selected from a group represented by Formula III.

Preferably, one or two of Rc and Rd are selected from a group represented by Formula III.

Preferably, one or two of Ra and one or two of Rc and Rd are selected from a group represented by Formula III.

Preferably, Ar₃ is independently selected from any one of the following groups: 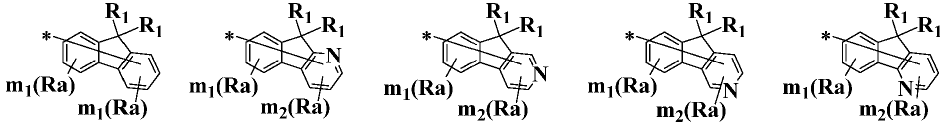 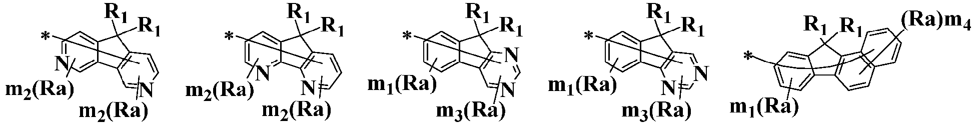 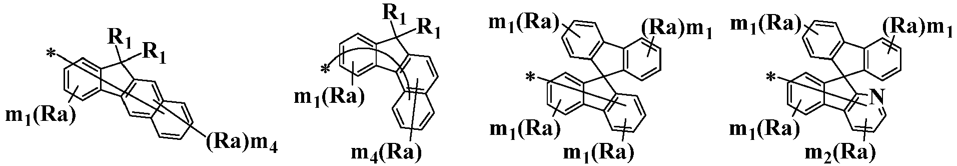 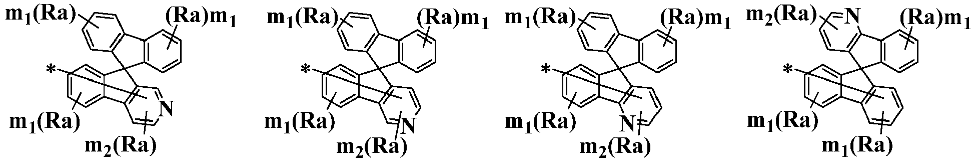 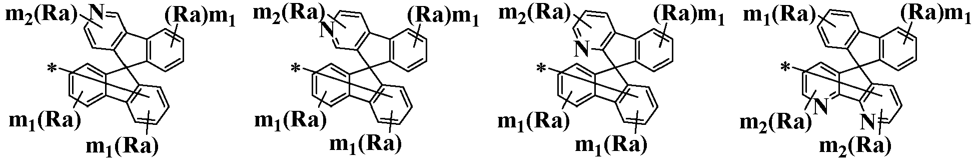 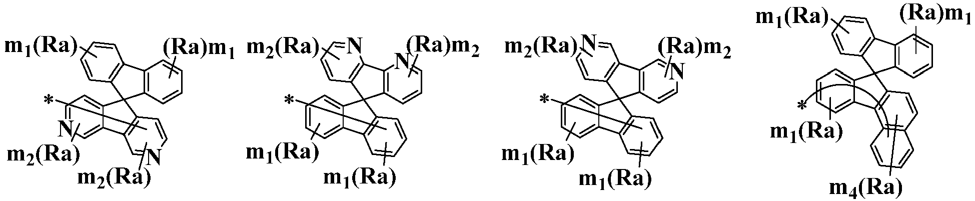 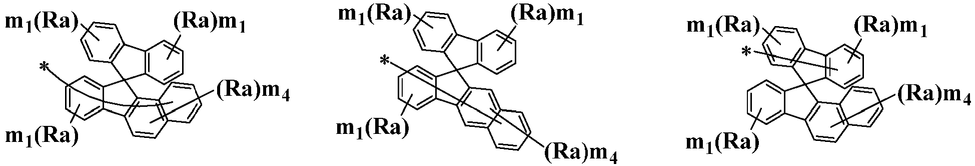 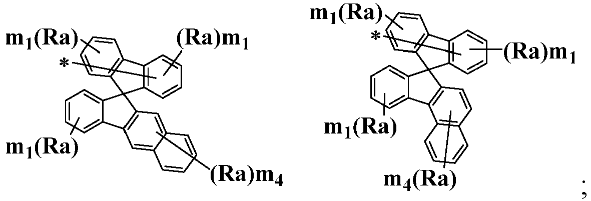 wherein R₁ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl; or two adjacent R₁ are linked to each other to form any one of the following ring groups: 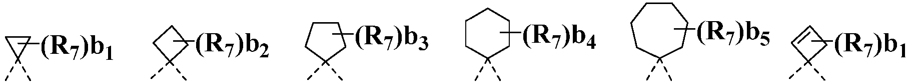 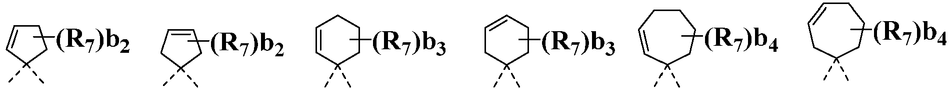 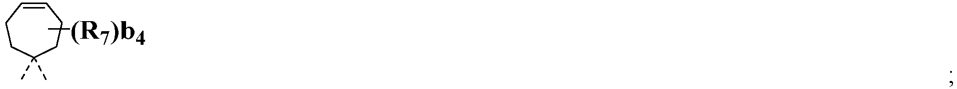
R₇ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
n₁ is independently selected from 0, 1, 2, 3 or 4, n₂ is independently selected from 0, 1, 2, 3, 4, 5 or 6, n₃ is independently selected from 0, 1, 2, 3, 4, 5, 6, 7 or 8, n₄ is independently selected from 0, 1, 2, 3, 4, 5, 6, 7, 8, 9 or 10, and n₅ is independently selected from 0, 1, 2, 3, 4, 5, 6, 7, 8, 9, 10, 11 or 12;
Ra is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
m₁ is independently selected from 0, 1, 2, 3 or 4, m₂ is independently selected from 0, 1, 2 or 3, m₃ is independently selected from 0, 1 or 2, and m₄ is independently selected from 0, 1, 2, 3, 4, 5 or 6.

Preferably, Formula II-1 is selected from any one of the following groups:

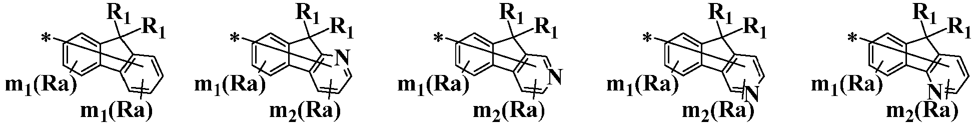

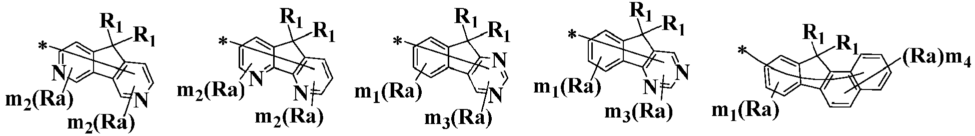

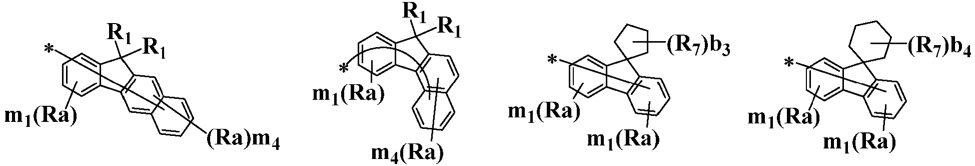

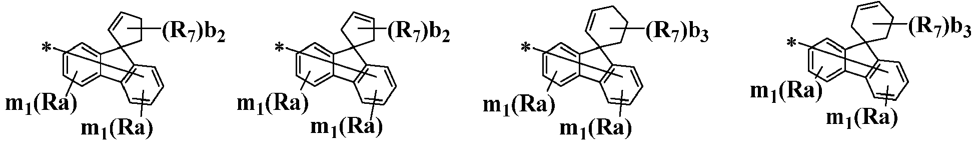

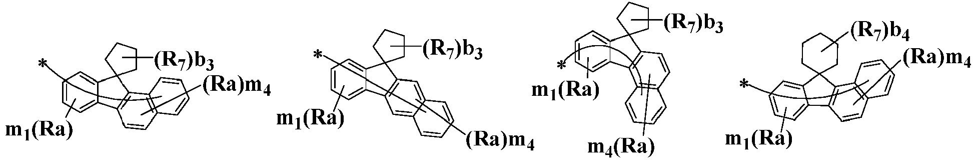

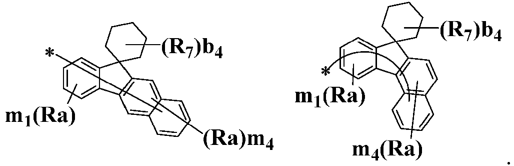

Preferably, R₁ in the present disclosure is independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl and adamantyl-substituted biphenyl, or is selected from a group represented by Formula III.

More preferably, R₁ is independently selected from a group represented by Formula III.

Preferably, R₇ in the present disclosure is independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl and adamantyl-substituted biphenyl.

Preferably, Formula II-2 is selected from any one of the following groups:

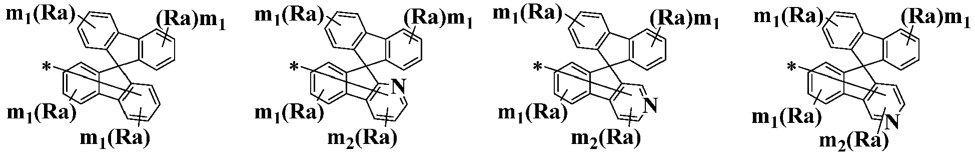

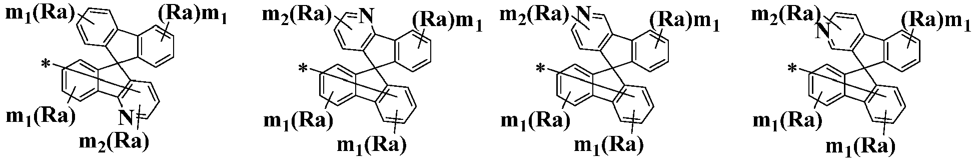

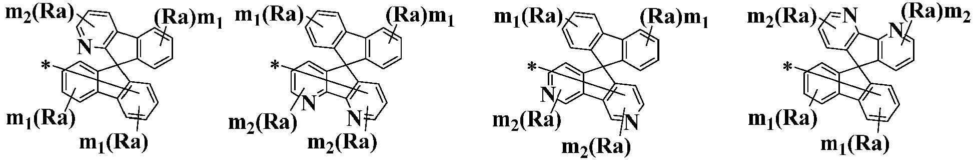

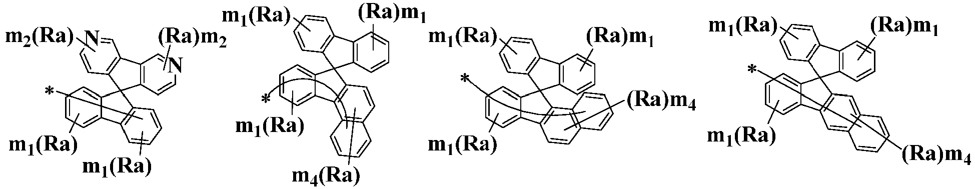

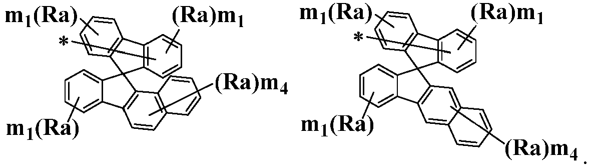

Preferably, Ra in the present disclosure is independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl and adamantyl-substituted biphenyl, or is selected from a group represented by Formula III.

Preferably, Ra is independently selected from a group represented by Formula III.

Preferably, Ly is independently selected from a single bond, substituted or unsubstituted phenylene, substituted or unsubstituted biphenylene, substituted or unsubstituted naphthylene, or substituted or unsubstituted pyridylene.

The "substituted" group in Ly is selected from any one or more of deuterium or C1 to C6 alkyl.

Preferably, Ry is independently selected from hydrogen, deuterium, cyano, nitro, fluorine, chlorine, bromine, iodine, or any one of the following groups unsubstituted or substituted with one or more deuterium: methyl, ethyl, *n*-propyl, isopropyl, *n*-butyl, isobutyl, *tert*-butyl, vinyl, propenyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl and methyl-substituted norbornyl.

Preferably, Ry is not hydrogen or deuterium simultaneously.

More preferably, Formula III is selected from any one of the following groups:

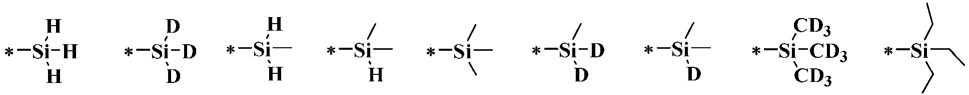

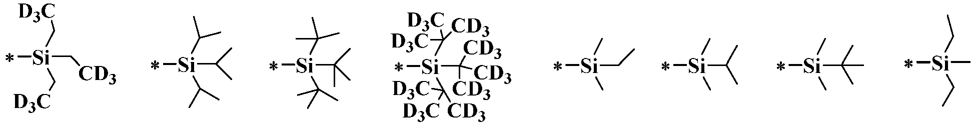

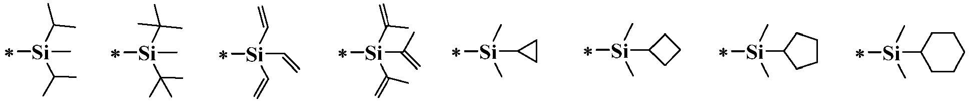

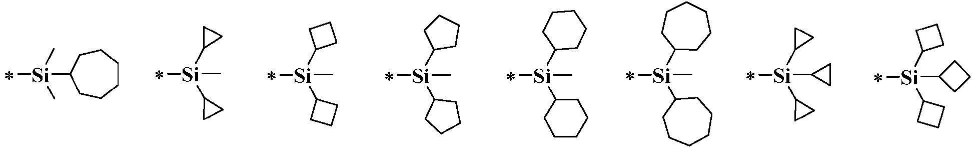

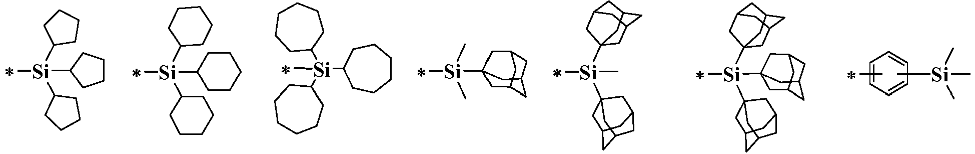

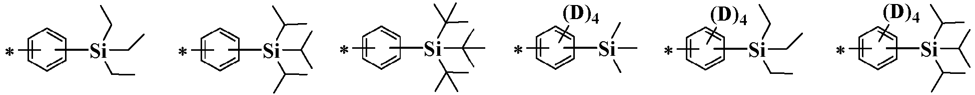

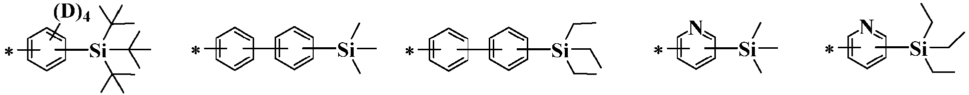

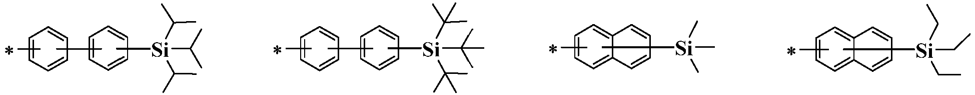

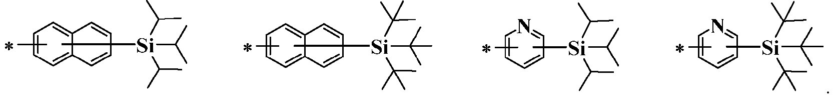

Preferably, the ring M in the groups of Ar₁ and Ar₂ is independently selected from any one of the following structures: 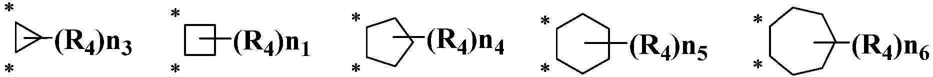 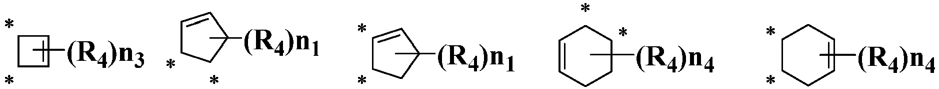 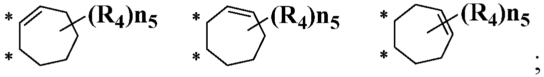
wherein R₄ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, or substituted or unsubstituted C2 to C12 heterocycloalkyl;
n₁ is independently selected from 0, 1, 2, 3 or 4, n₂ is selected from 0, 1, 2 or 3, n₃ is selected from 0, 1 or 2, n₄ is selected from 0, 1, 2, 3, 4, 5 or 6, n₅ is selected from 0, 1, 2, 3, 4, 5, 6, 7 or 8, and n₆ is independently selected from 0, 1, 2, 3, 4, 5, 6, 7, 8, 9 or 10.

Preferably, Ar₁ and Ar₂ are independently selected from any one of the following groups: 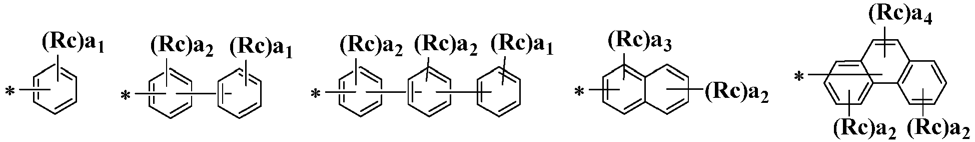 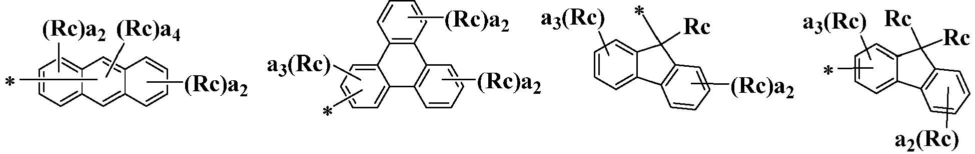 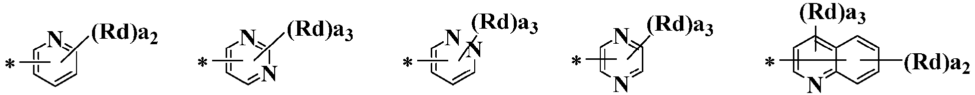 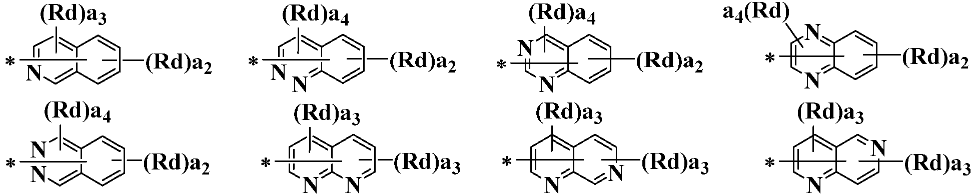 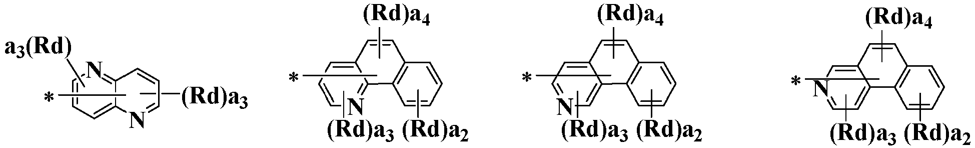 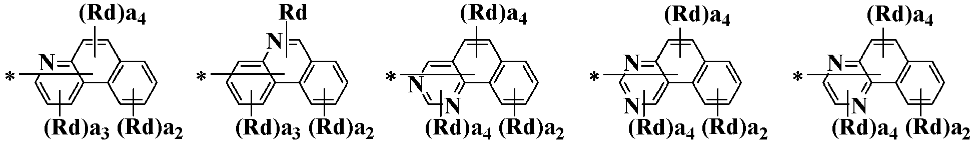 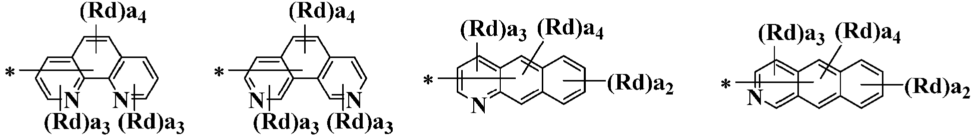 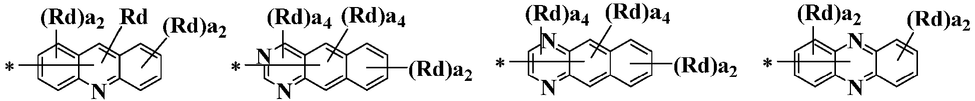 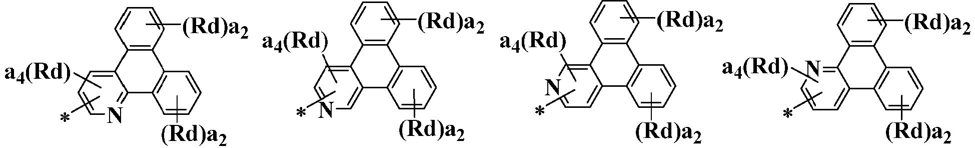 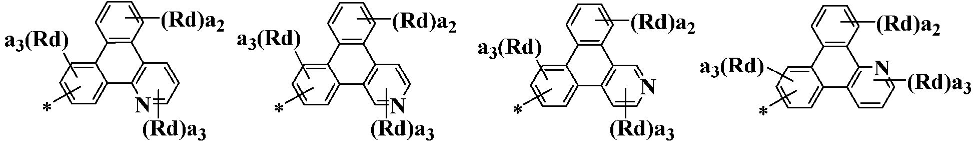 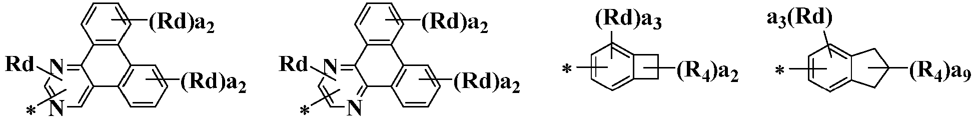 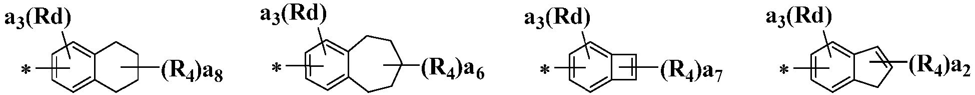 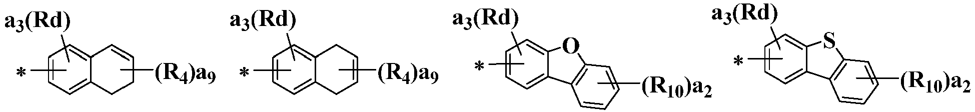 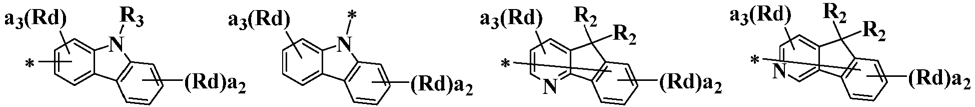 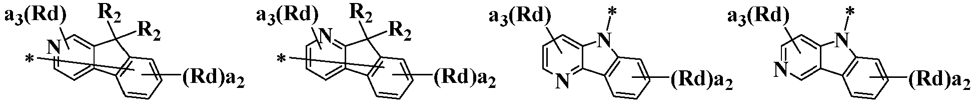 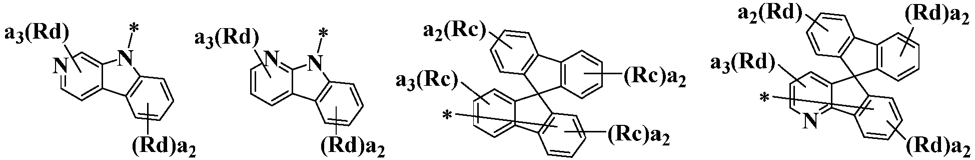 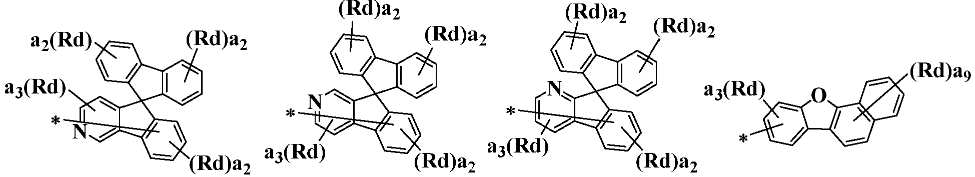 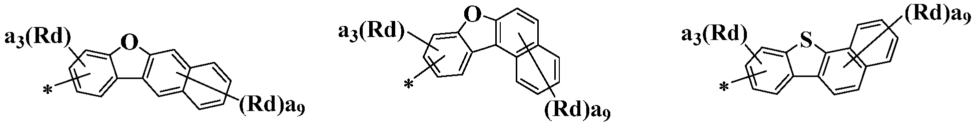 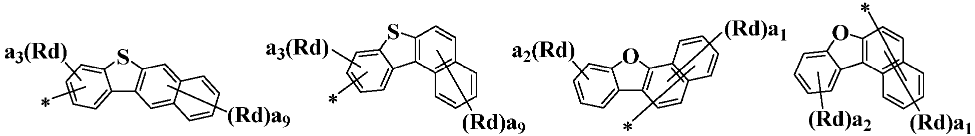 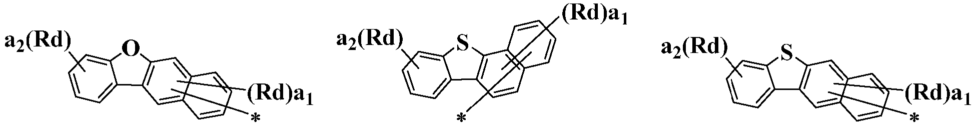 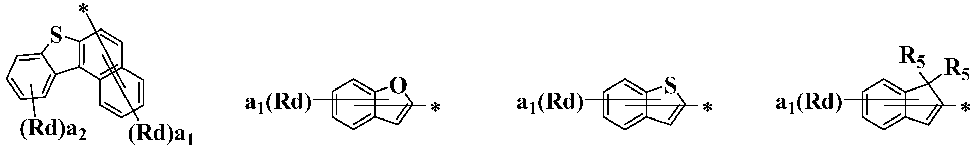 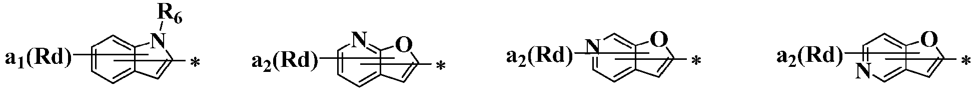 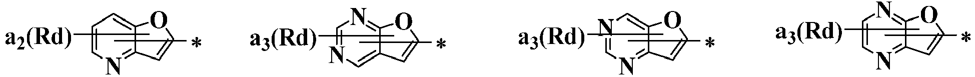 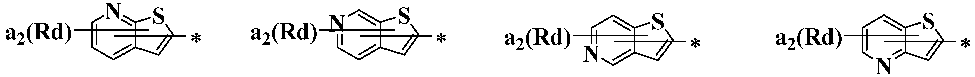 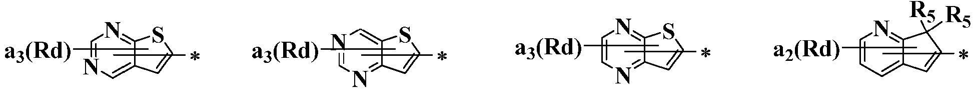 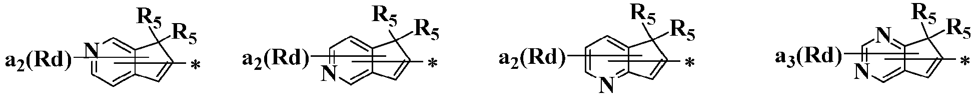 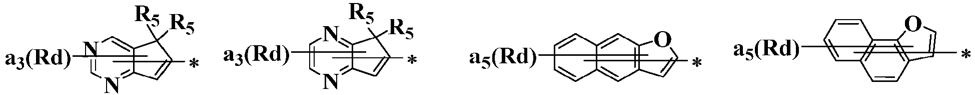 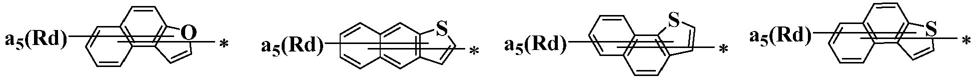 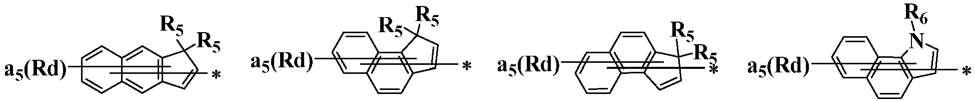 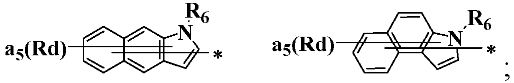
wherein Rc, Rd, R₂, R₃, R₄, R₅ and R₆ are the same as defined in Formula I;
a₁ is independently selected from 0, 1, 2, 3, 4 or 5, a₂ is independently selected from 0, 1, 2, 3 or 4, a₃ is independently selected from 0, 1, 2 or 3, a₄ is independently selected from 0, 1 or 2, as is independently selected from 0, 1, 2, 3, 4, 5, 6 or 7, a₆ is independently selected from 0, 1, 2, 3, 4, 5, 6, 7, 8, 9 or 10, a₇ is independently selected from 0, 1 or 2, a₈ is independently selected from 0, 1, 2, 3, 4, 5, 6, 7 or 8, and a₉ is independently selected from 0, 1, 2, 3, 4, 5 or 6.

Preferably, Rc is independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl or adamantyl-substituted biphenyl, or is selected from a group represented by Formula III.

Preferably, Rc is independently selected from a group represented by Formula III.

Preferably, Rd is independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl or adamantyl-substituted biphenyl, or is selected from a group represented by Formula III.

Preferably, Rd is independently selected from a group represented by Formula III.

Preferably, R₃ and R₆ are independently selected from is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl and adamantyl-substituted biphenyl.

Preferably, R₂, R₄ and R₅ are independently selected from hydrogen, deuterium, tritium, cyano, fluorine, chlorine, bromine, iodine or nitro, or is selected from any one of the following groups unsubstituted or substituted with one or more deuterium: methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, biphenyl, naphthyl, pyridyl, pyrimidinyl, benzofuryl, benzothienyl, benzocyclopropyl, benzocyclobutyl, benzocyclopentyl, benzocyclohexyl, dibenzofuryl, dibenzothienyl, methyl-substituted phenyl, ethyl-substituted phenyl, *n*-propyl-substituted phenyl, isopropyl-substituted phenyl, *n*-butyl-substituted phenyl, isobutyl-substituted phenyl, *tert*-butyl-substituted phenyl, methyl-substituted biphenyl, isopropyl-substituted biphenyl, *tert*-butyl-substituted biphenyl, adamantyl-substituted phenyl and adamantyl-substituted biphenyl.

Preferably, L, L₁ and L₂ are independently selected from a single bond or any one of the following groups: 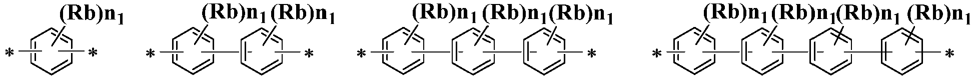 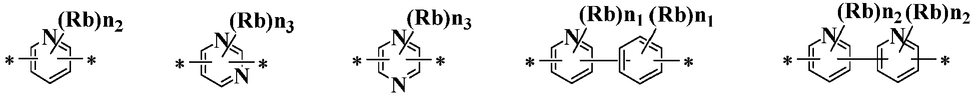 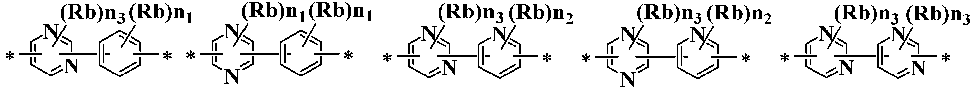 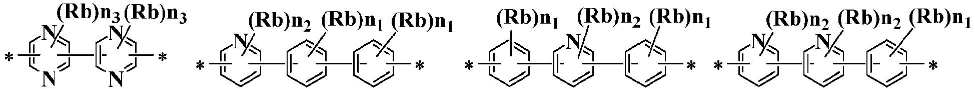 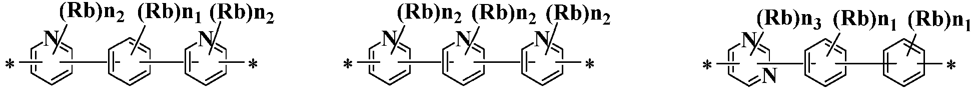 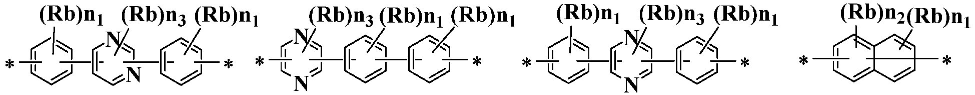 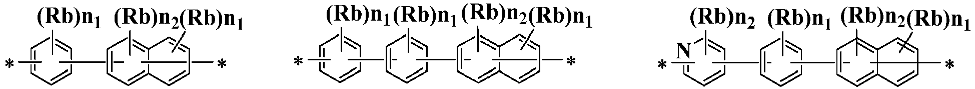 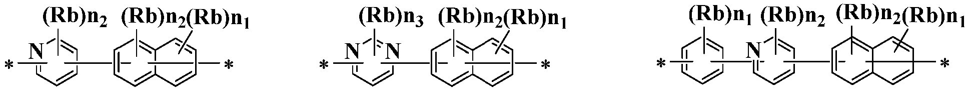 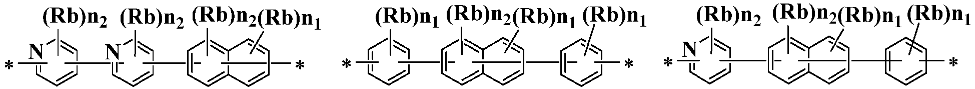 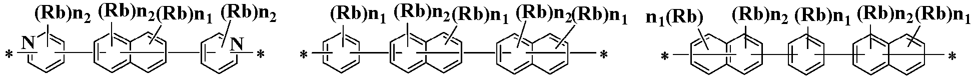 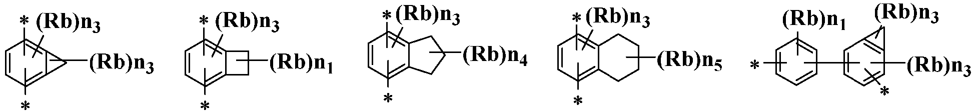 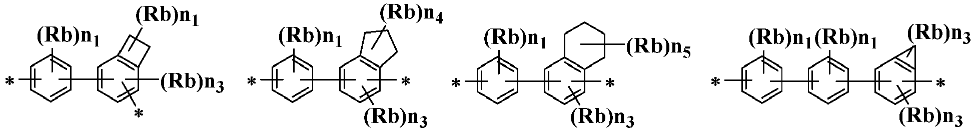 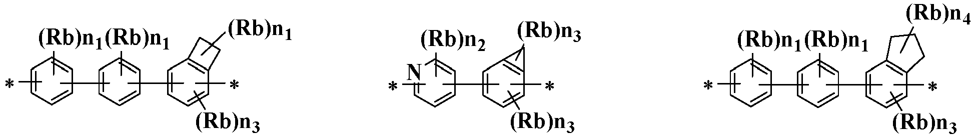 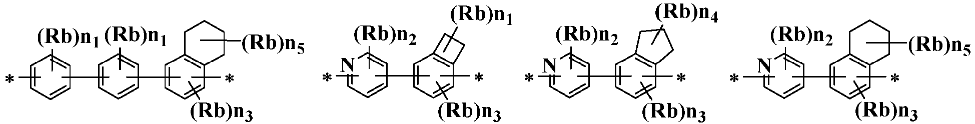 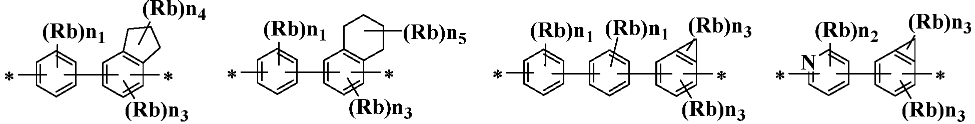 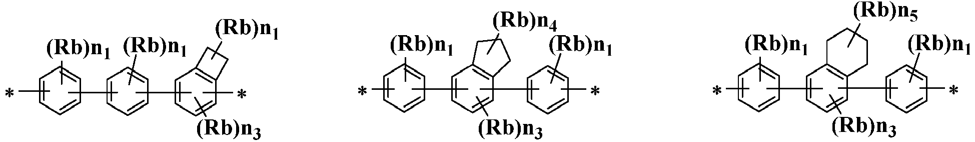 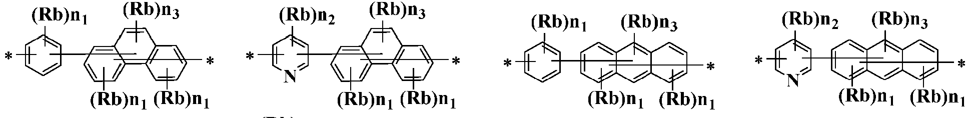 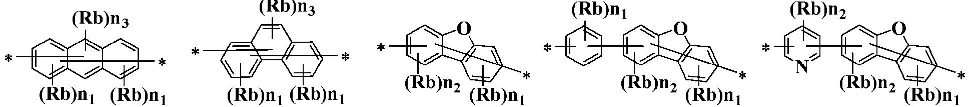 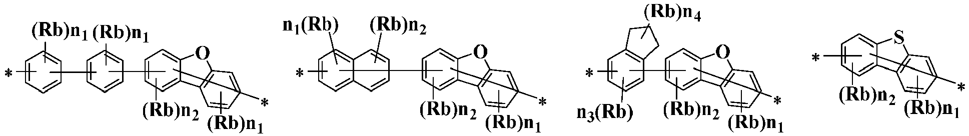 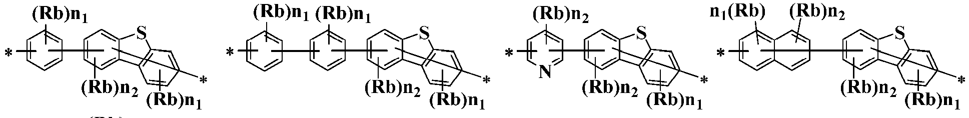 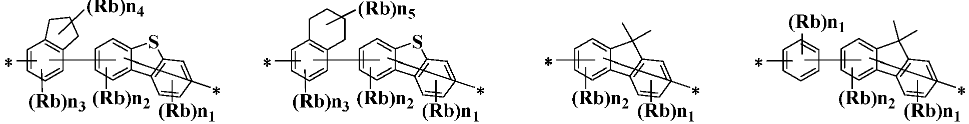 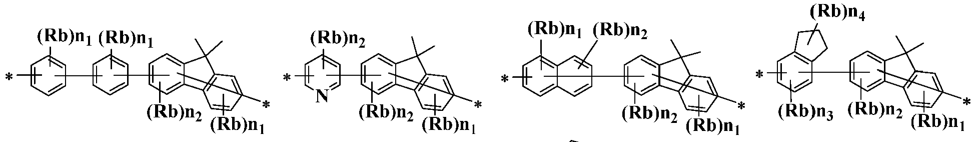 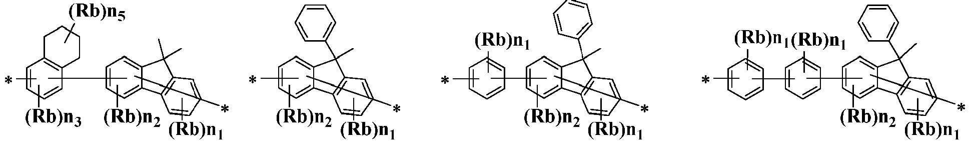 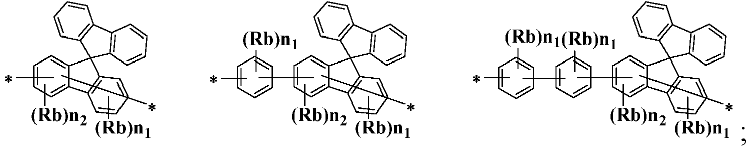
Rb is the same as defined for Rb above;
n₁ is independently selected from 0, 1, 2, 3 or 4, n₂ is independently selected from 0, 1, 2 or 3, n₃ is independently selected from 0, 1 or 2, n₄ is independently selected from 0, 1, 2, 3, 4, 5 or 6, and n₅ is independently selected from 0, 1, 2, 3, 4, 5, 6, 7 or 8.

Preferably, Rb is independently selected from any one of hydrogen, deuterium, tritium, cyano, fluorine, chlorine, bromine, iodine, nitro, methyl, ethyl, *n*-propyl, isopropyl, *n*-butyl, isobutyl, *tert*-butyl, cyclopropyl, cyclobutyl, cyclopentyl, cyclohexyl, cycloheptyl, adamantyl, norbornyl, trimethylsilyl, dimethylethylsilyl, methyldiethylilyl, triethylsilyl, tri-*tert*-butylsilyl, fluoro-substituted methyl, fluoro-substituted ethyl, methyl-substituted adamantyl, methyl-substituted norbornyl, phenyl, deuterated methyl, deuterated ethyl, deuterated *n*-propyl, deuterated isopropyl, deuterated *tert*-butyl or deuterated phenyl, or is selected from a group represented by Formula III.

Preferably, Rd is independently selected from a group represented by Formula III.

Most preferably, the heterocyclic compound is selected from any one of the following structures:

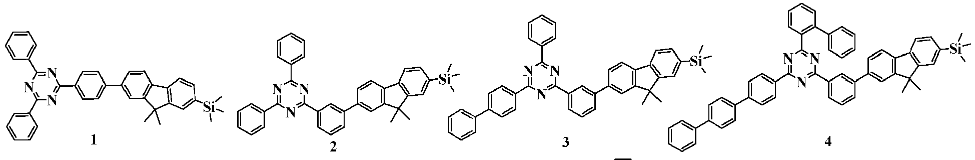

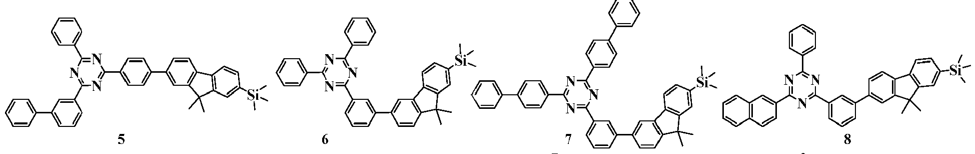

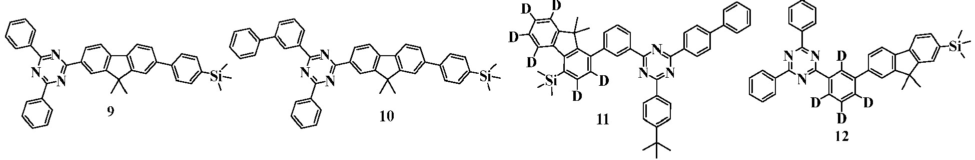

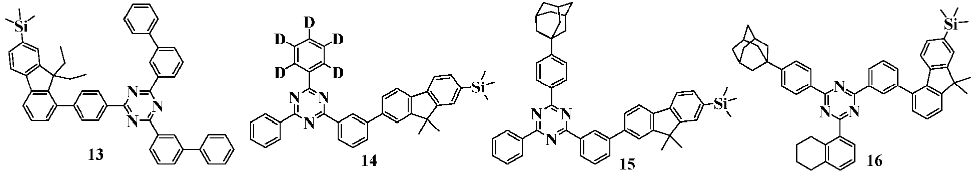

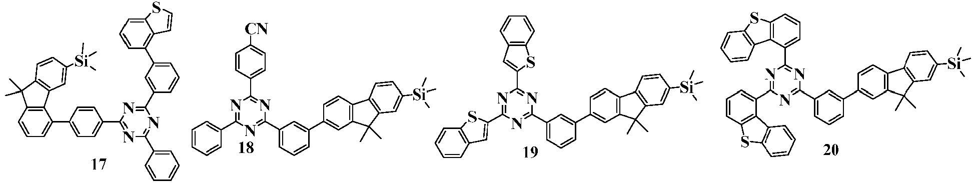

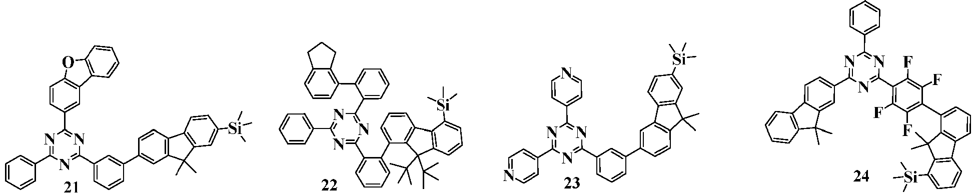

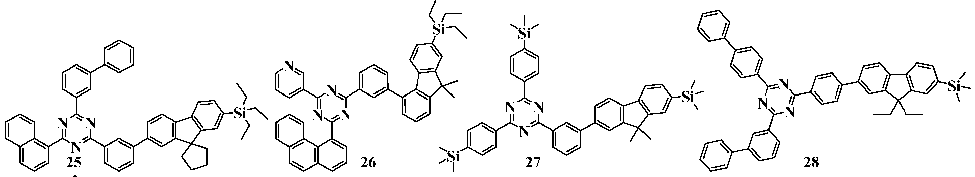

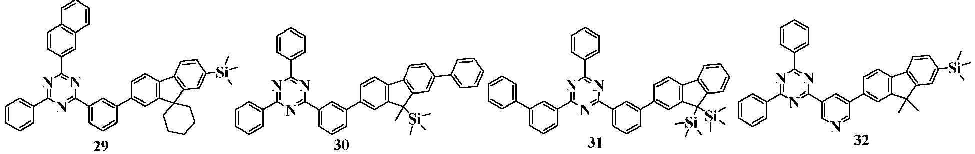

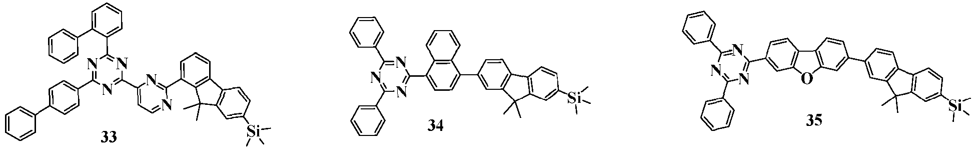

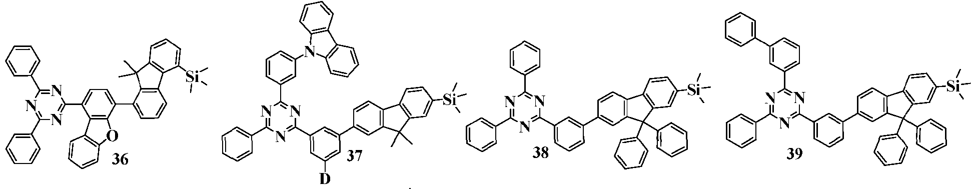

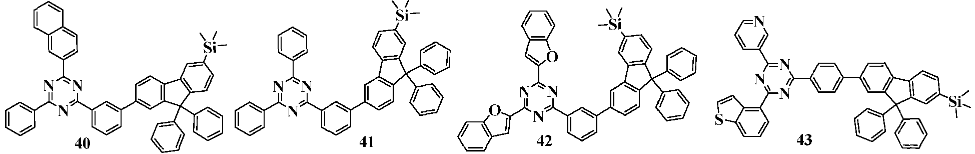

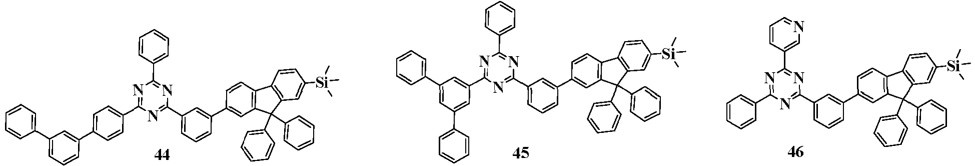

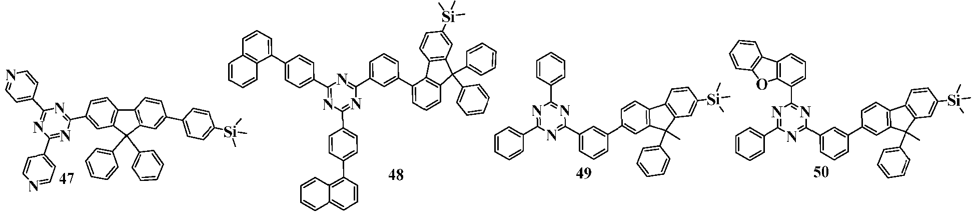

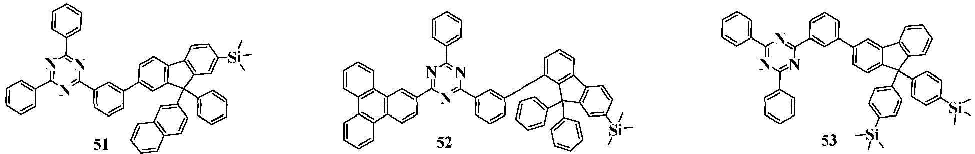

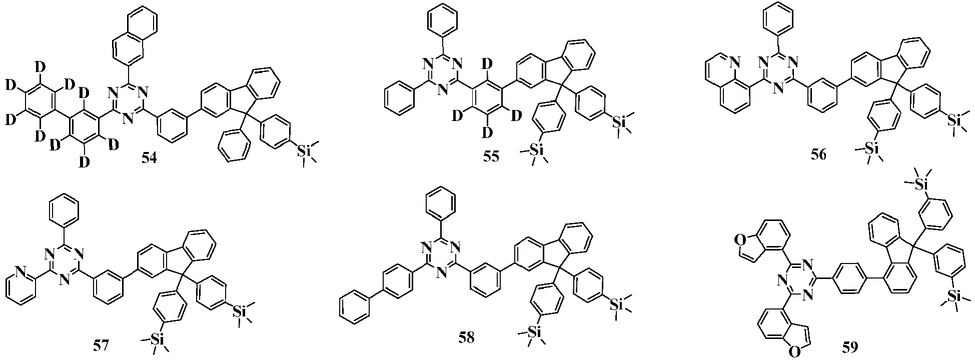

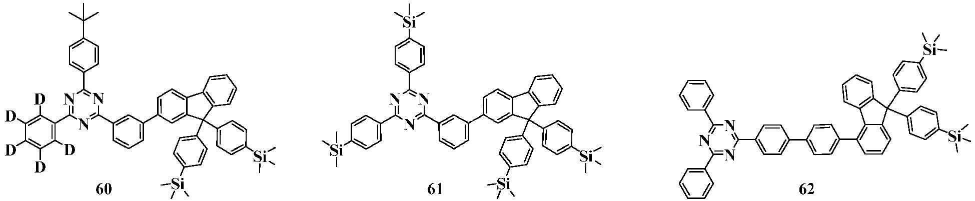

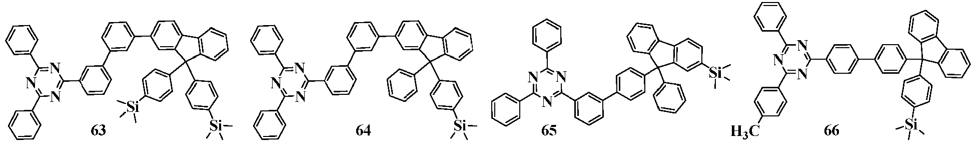

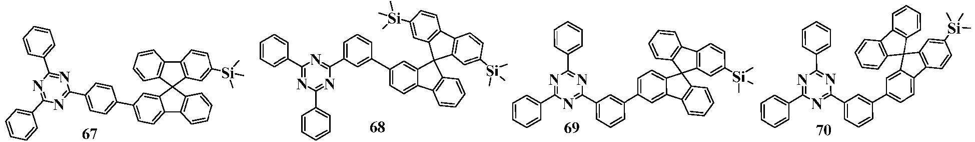

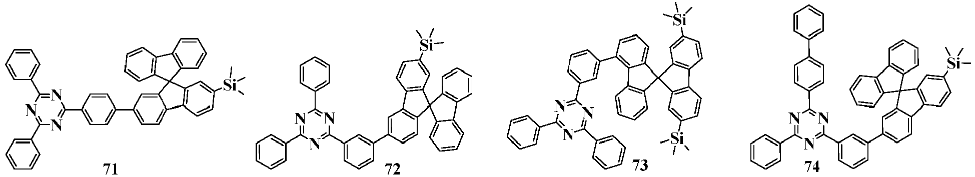

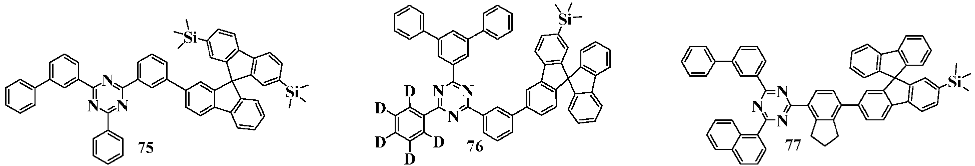

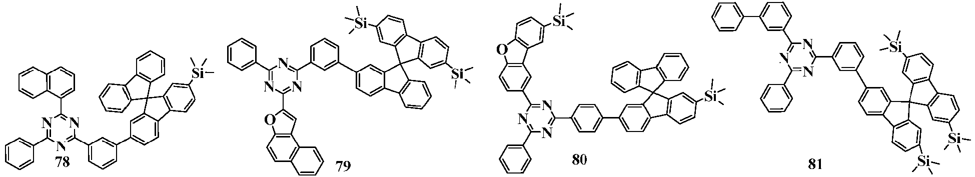

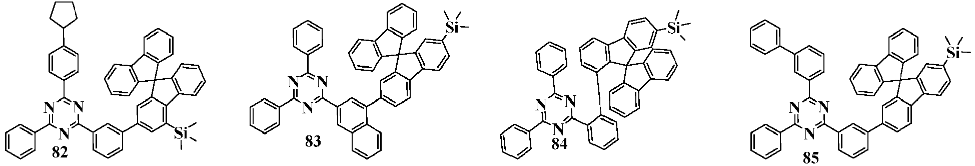

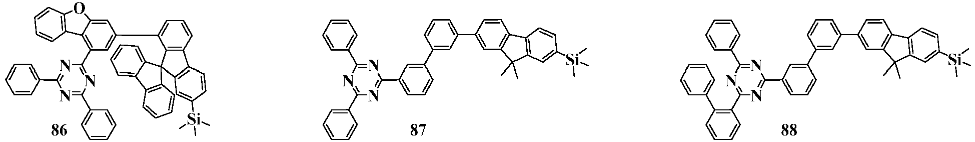

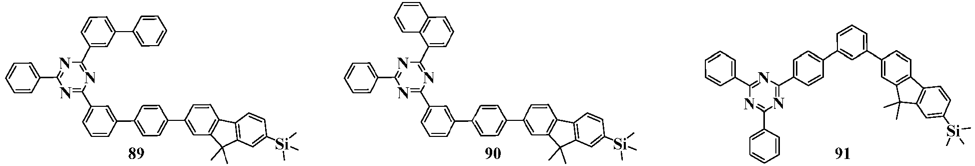

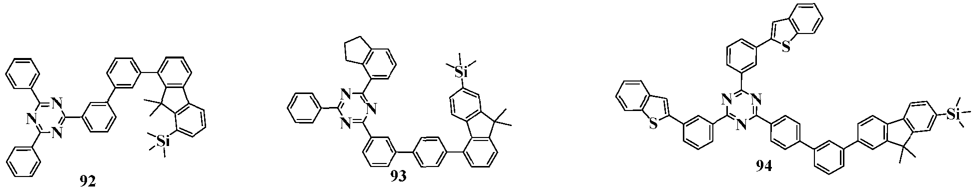

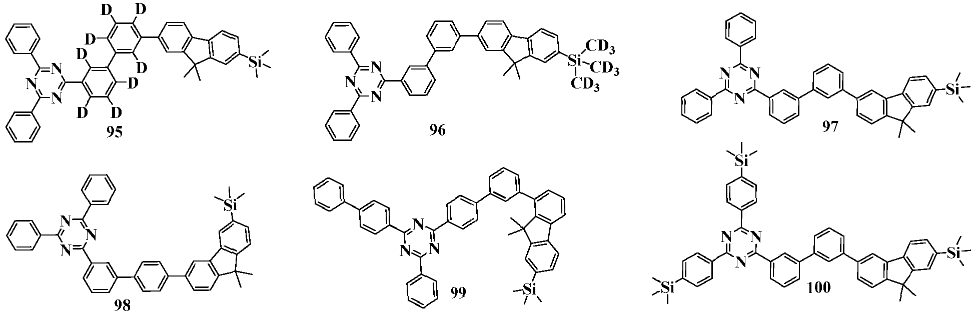

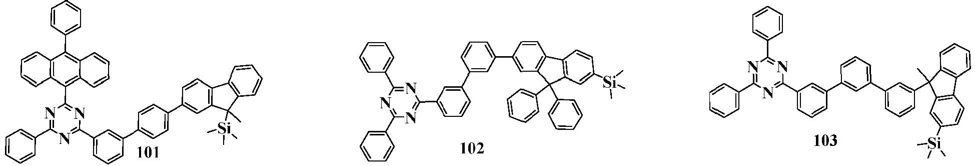

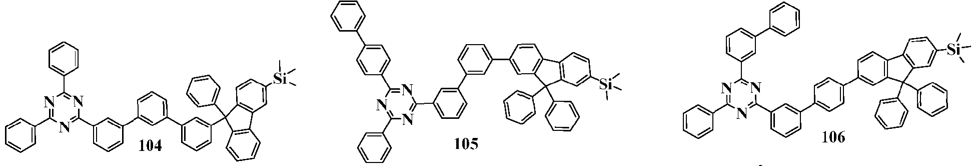

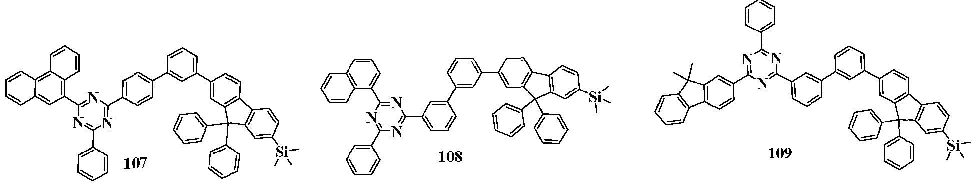

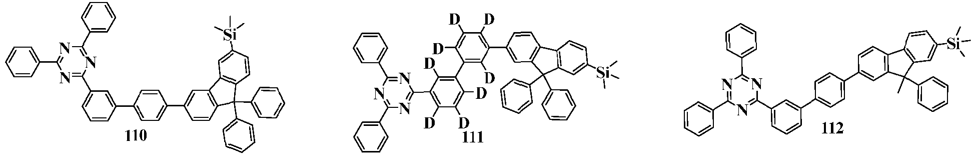

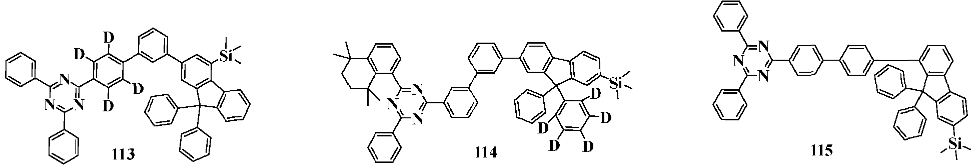

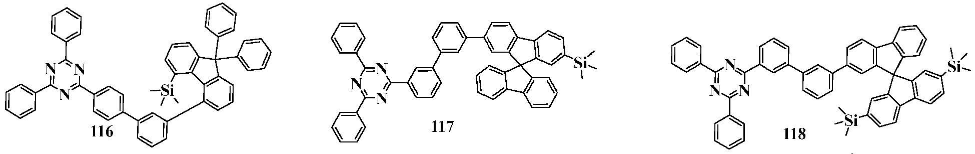

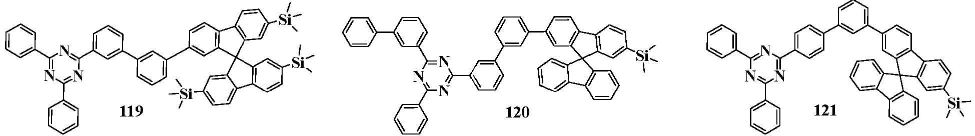

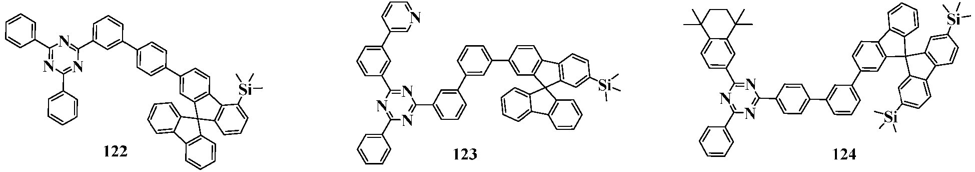

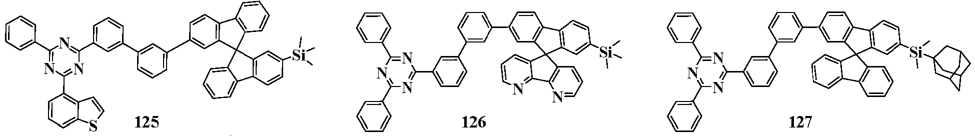

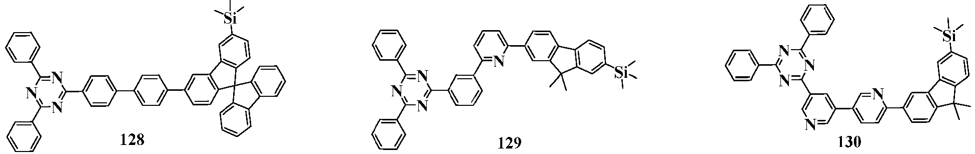

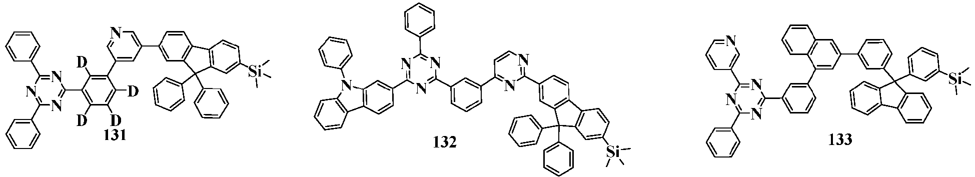

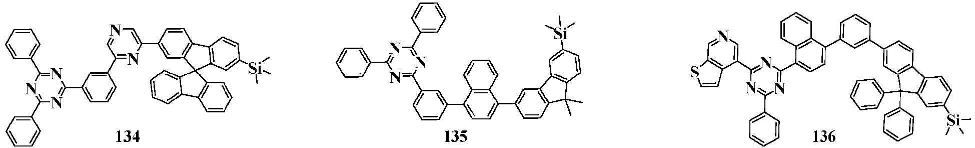

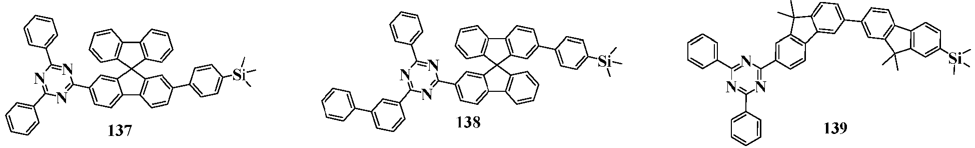

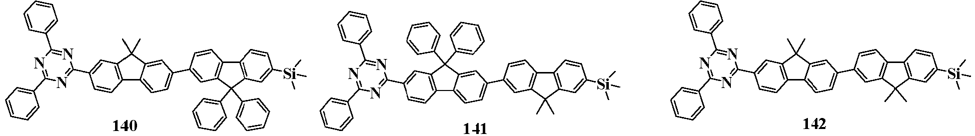

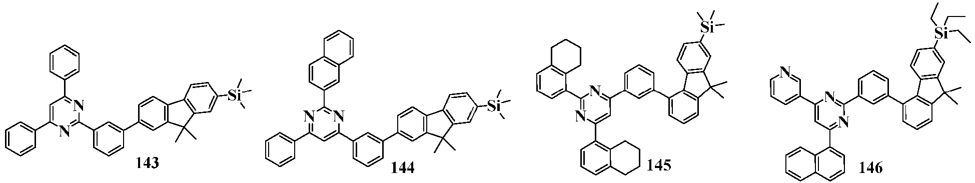

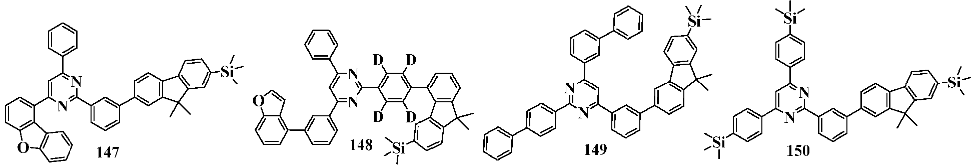

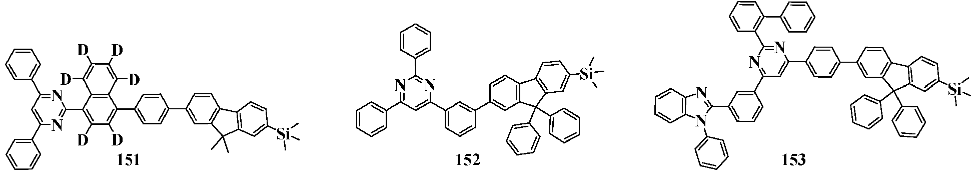

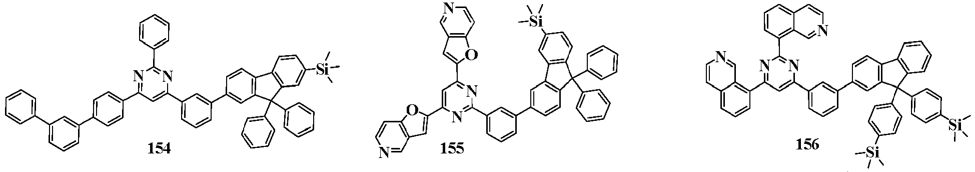

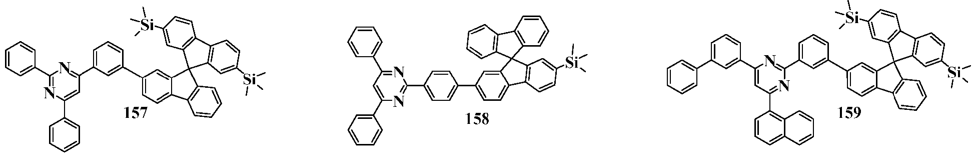

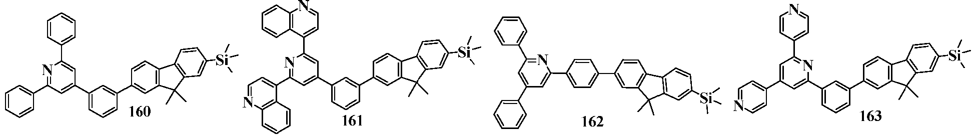

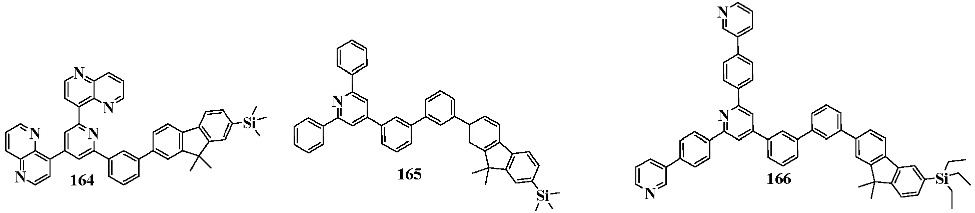

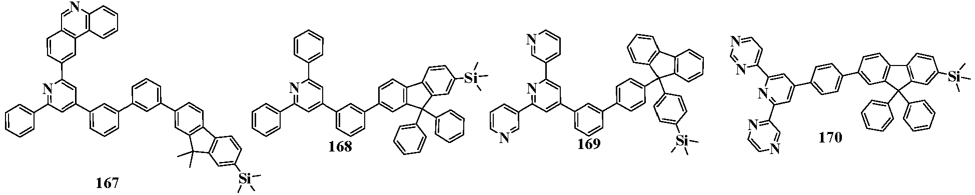

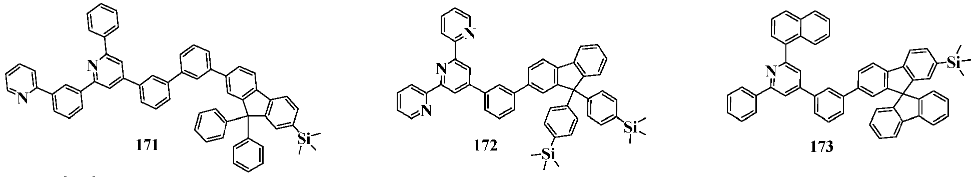

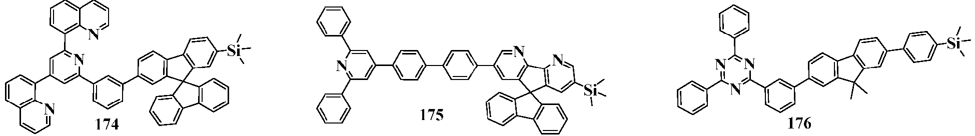

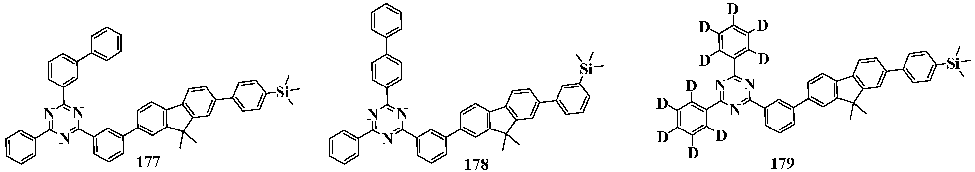

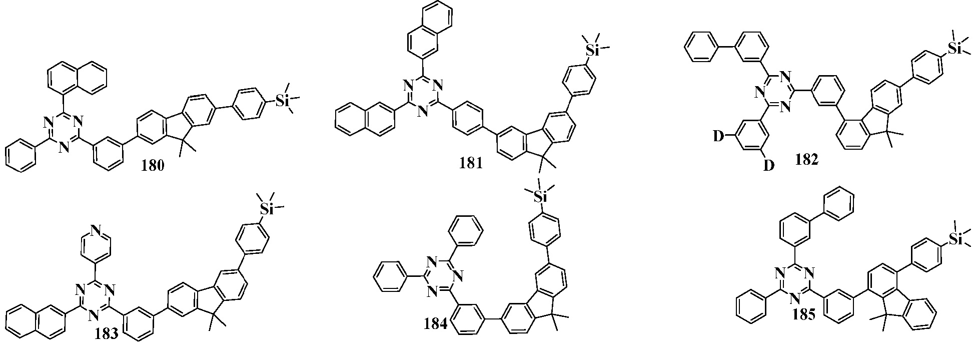

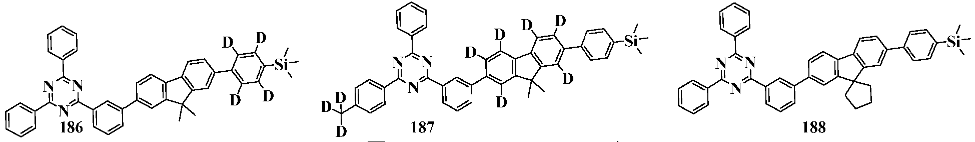

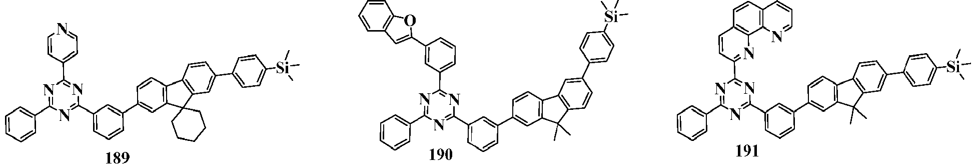

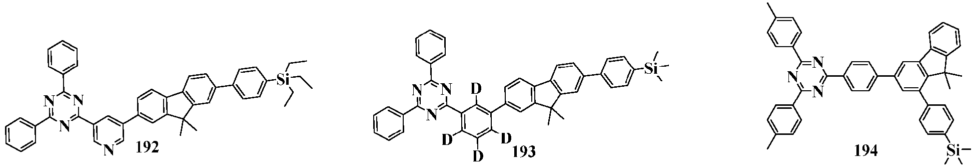

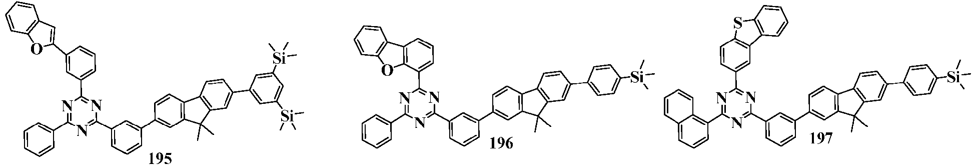

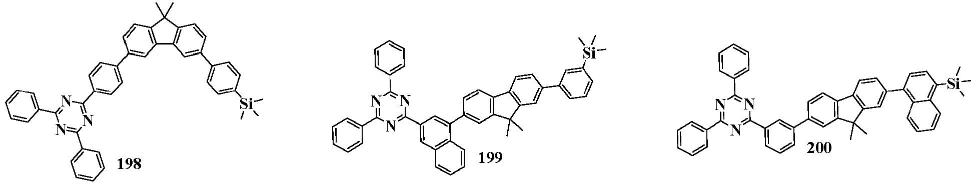

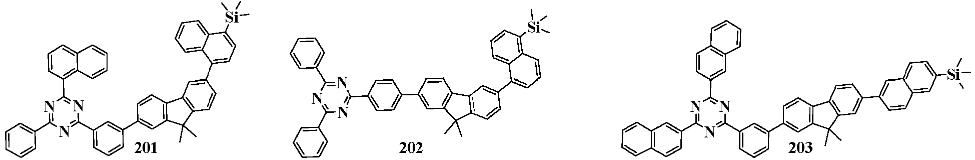

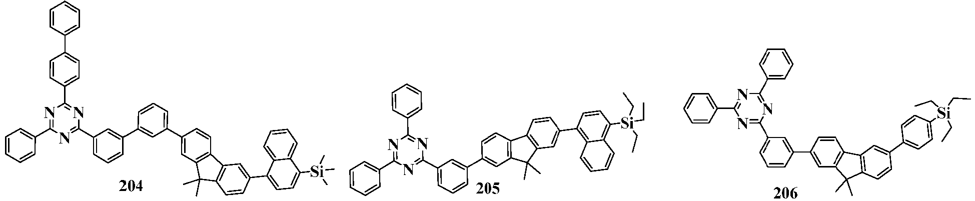

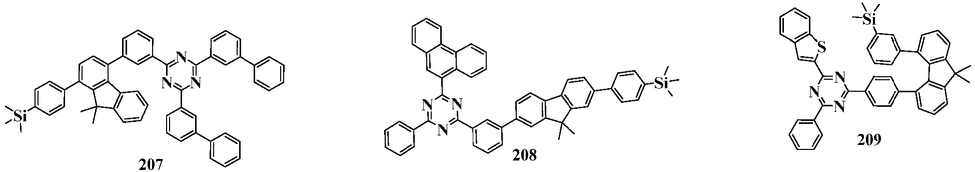

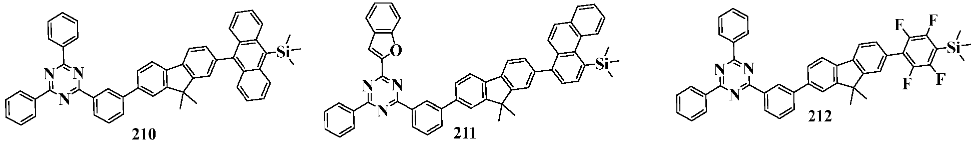

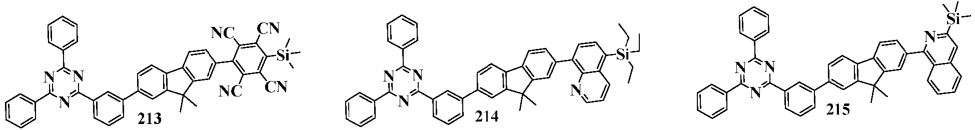

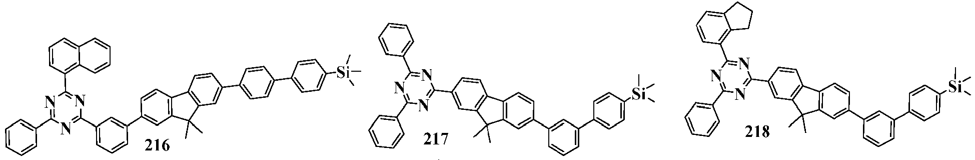

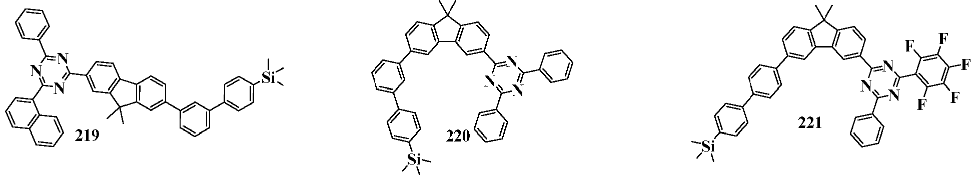

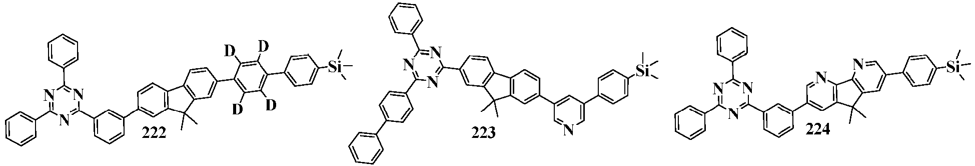

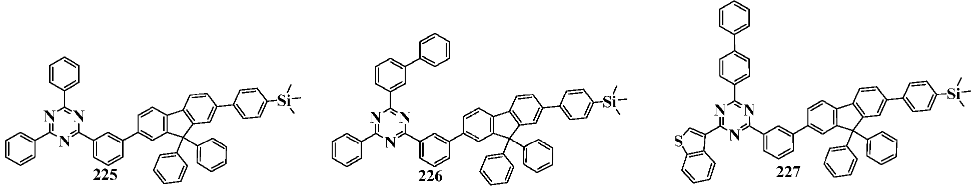

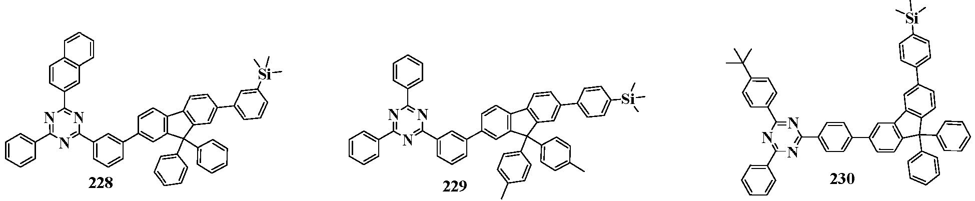

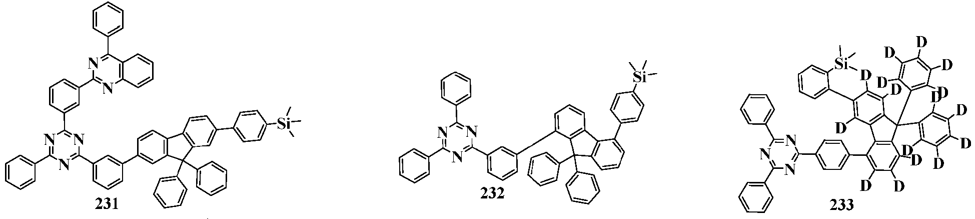

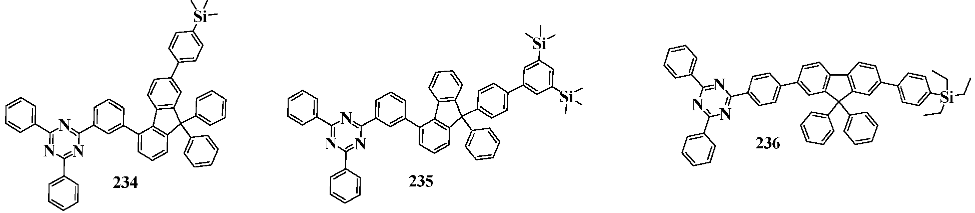

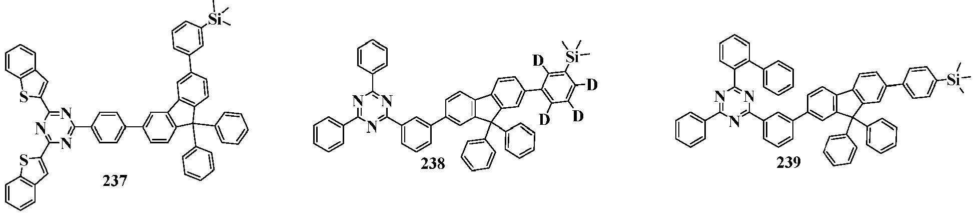

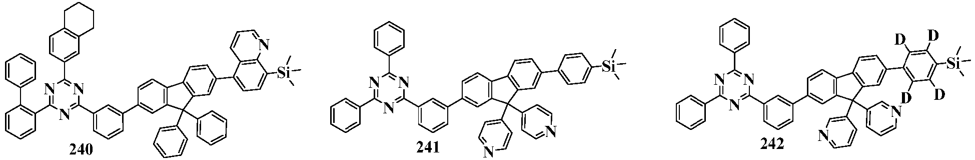

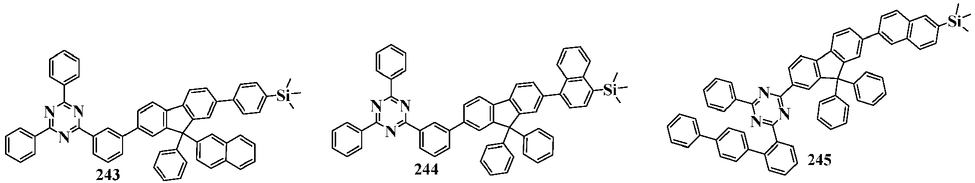

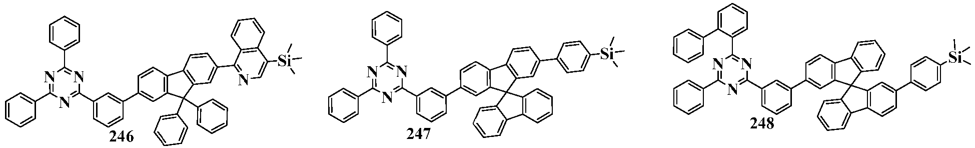

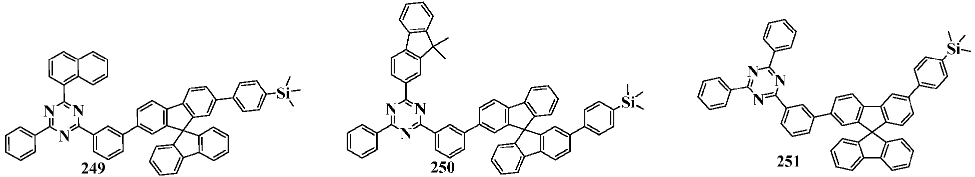

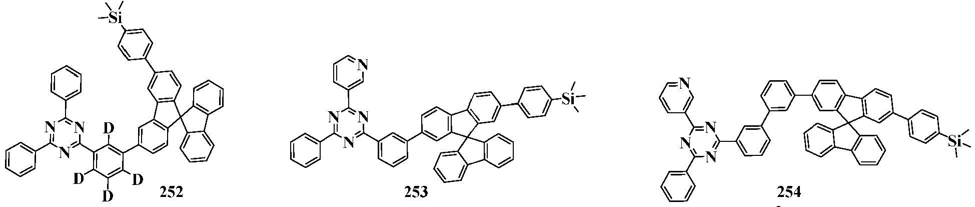

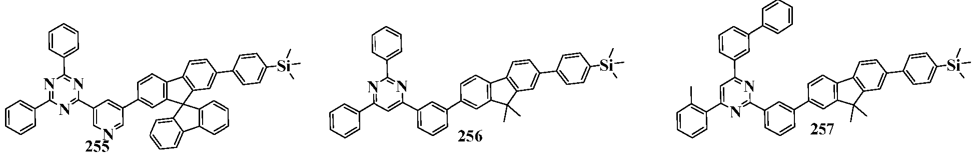

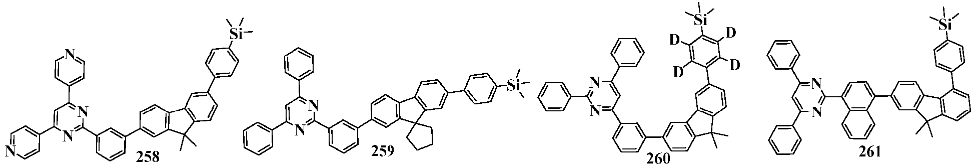

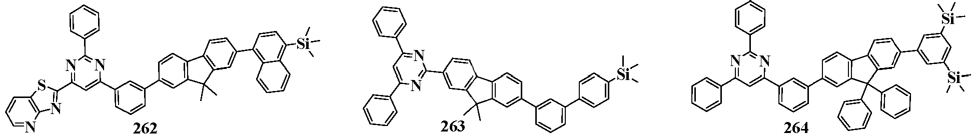

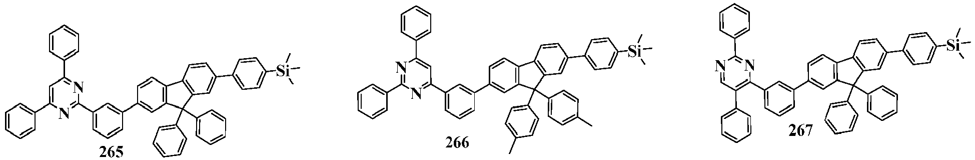

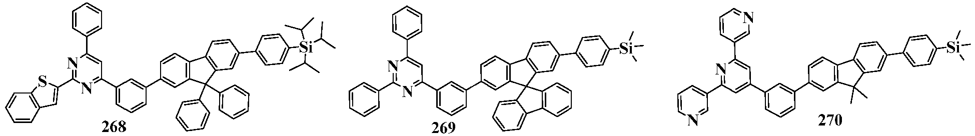

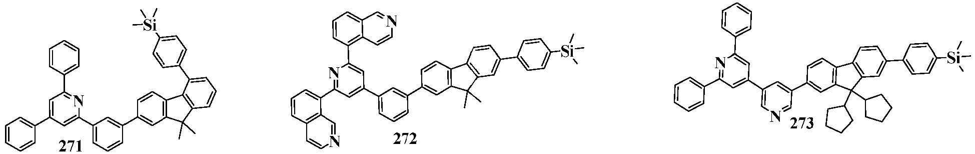

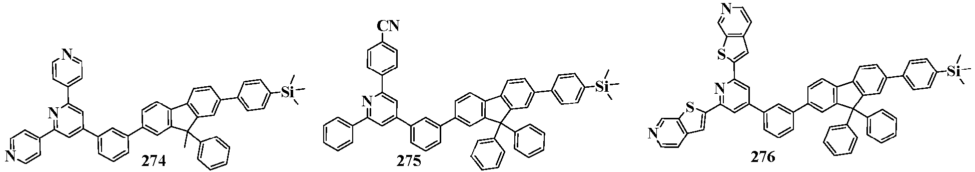

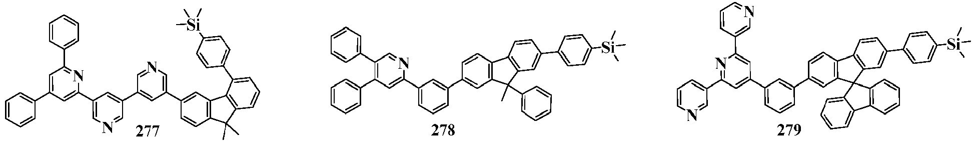

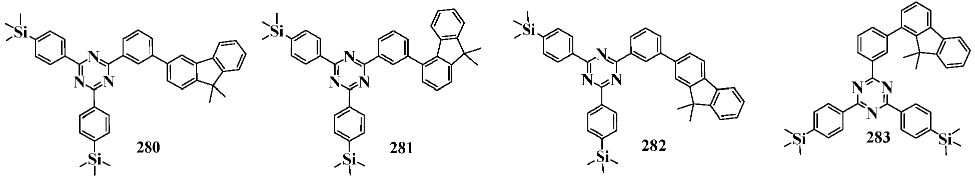

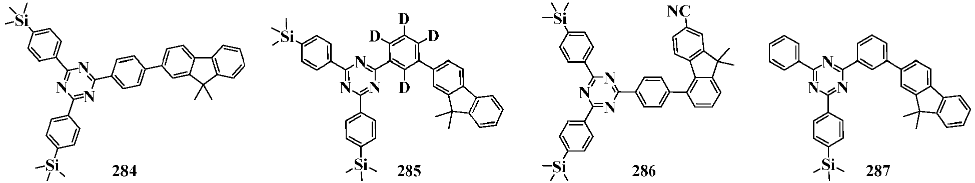

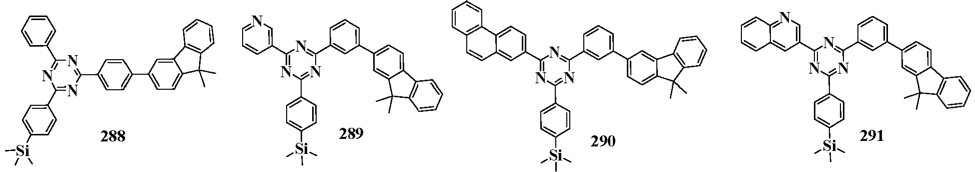

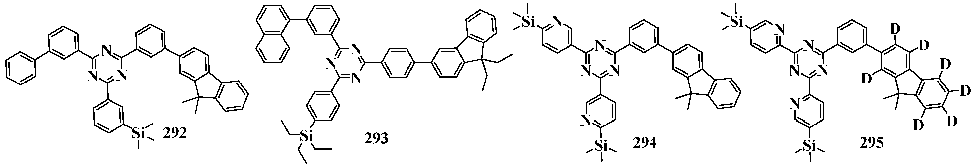

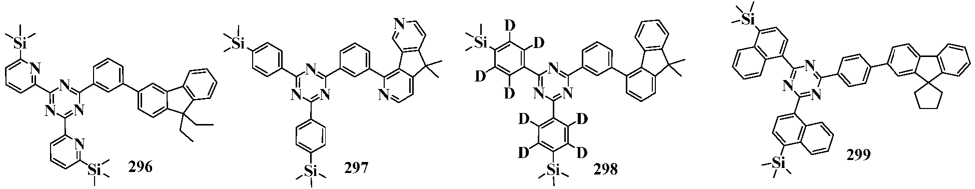

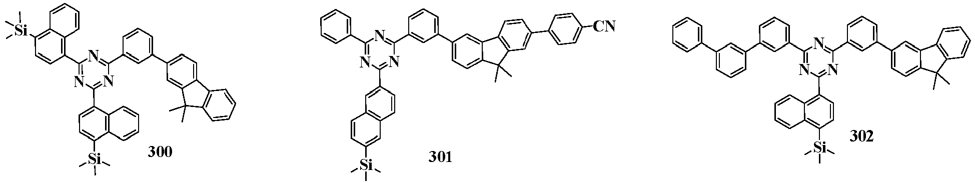

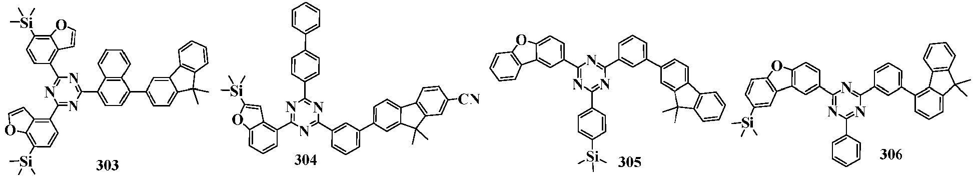

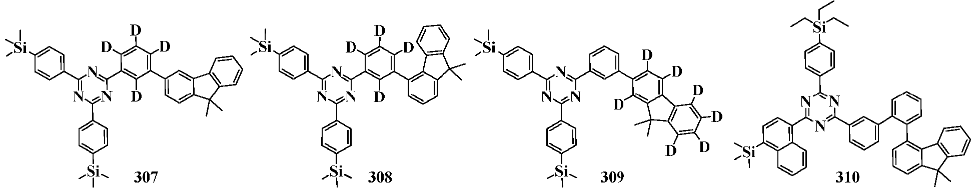

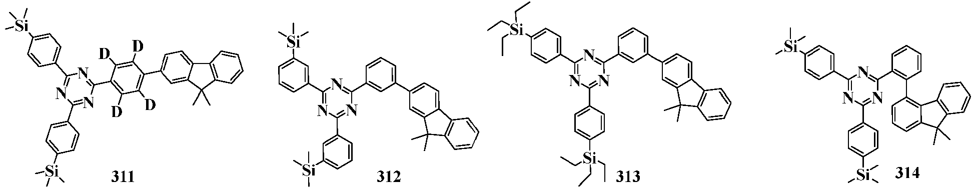

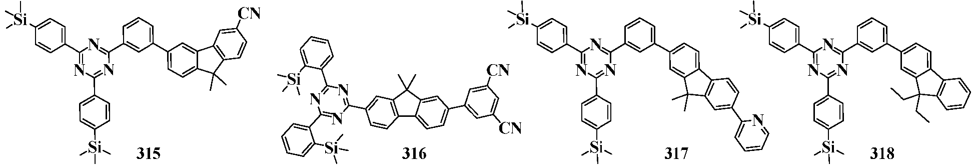

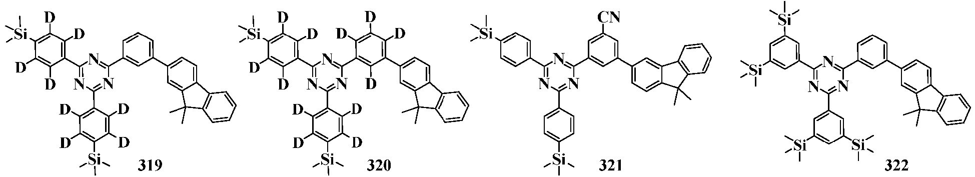

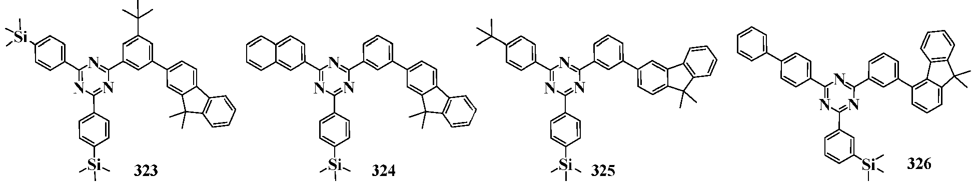

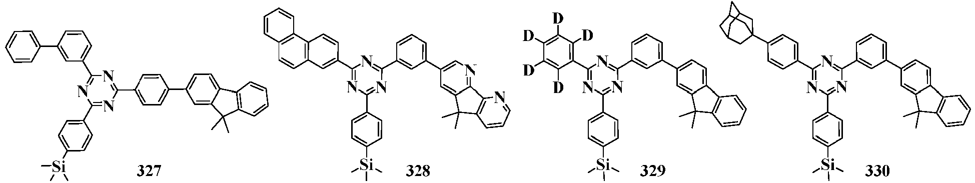

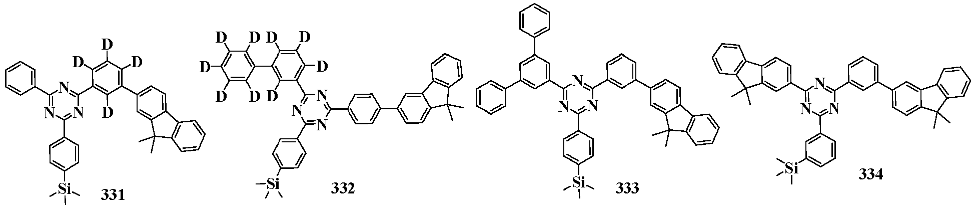

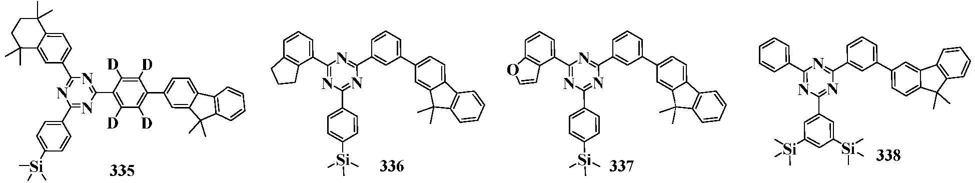

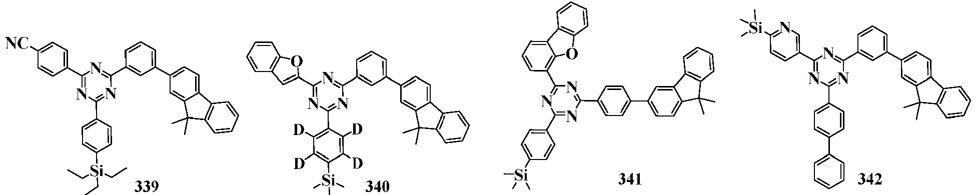

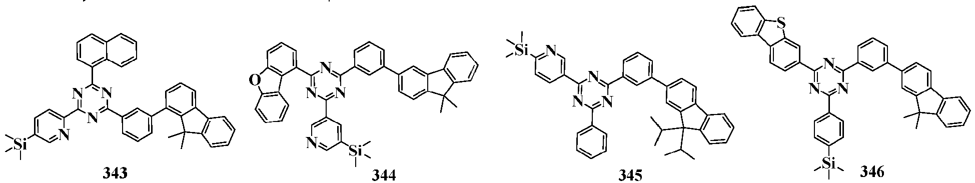

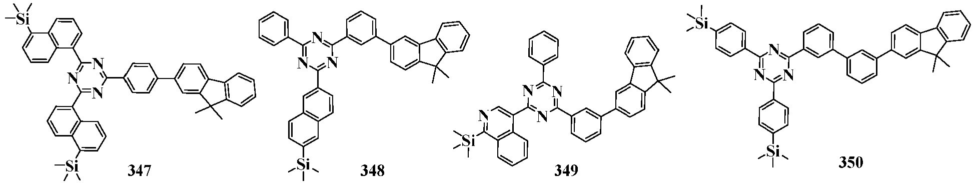

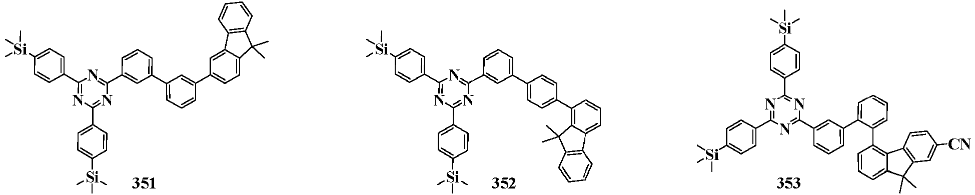

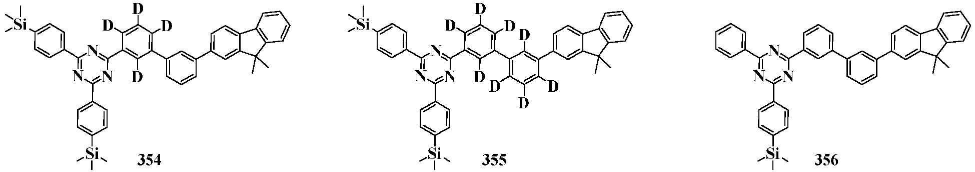

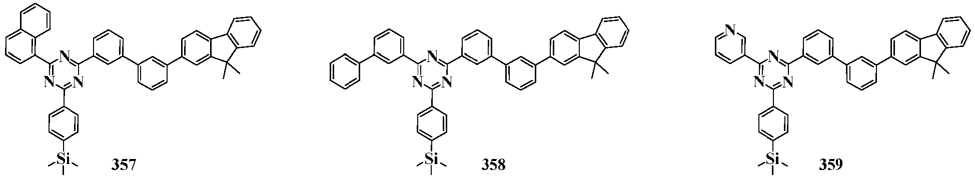

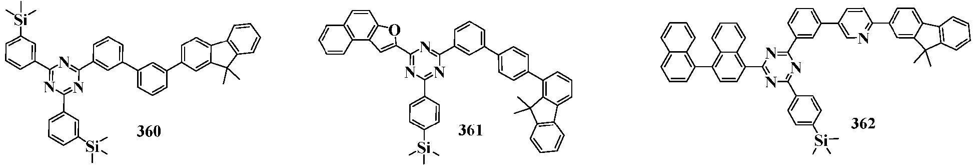

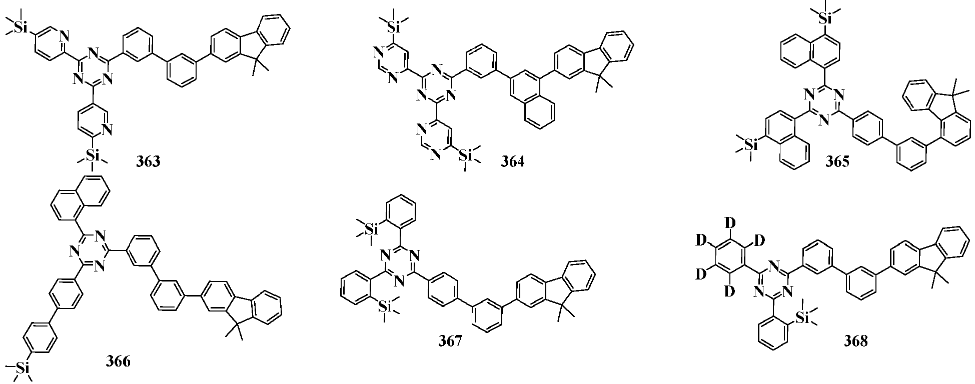

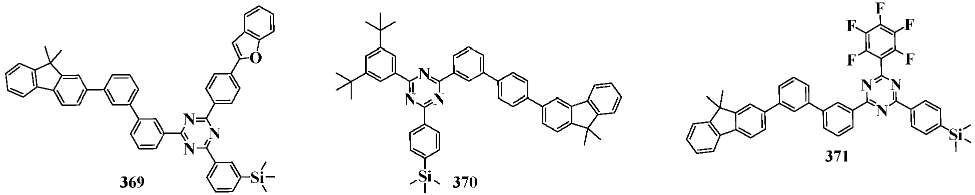

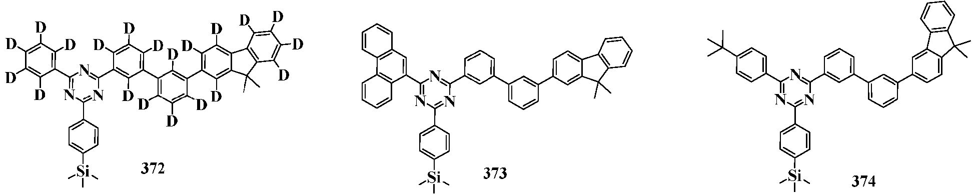

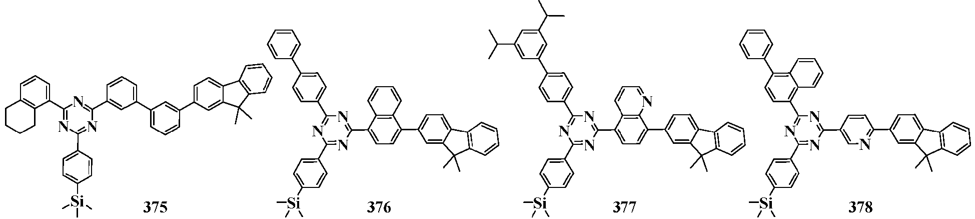

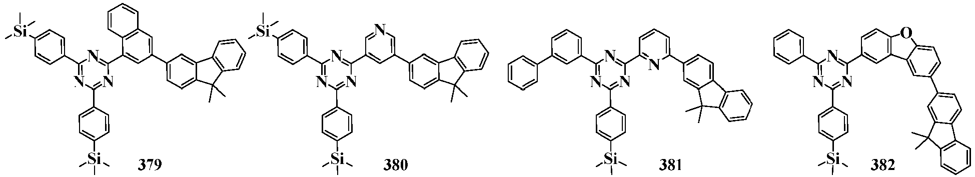

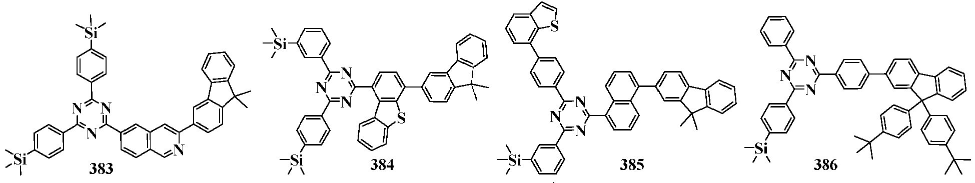

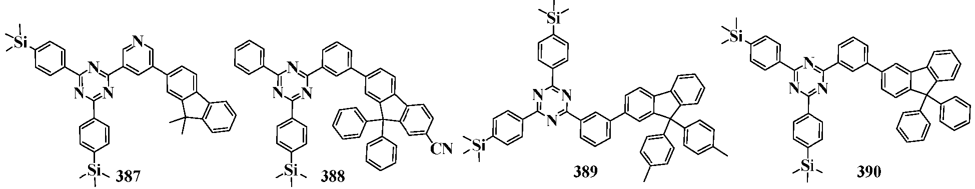

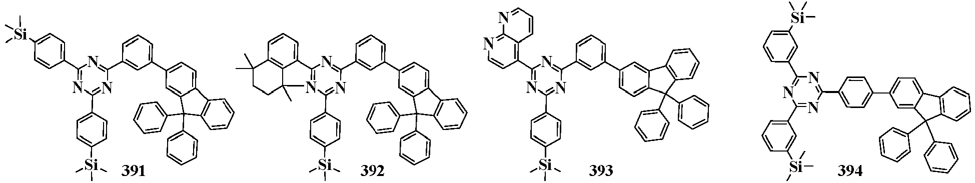

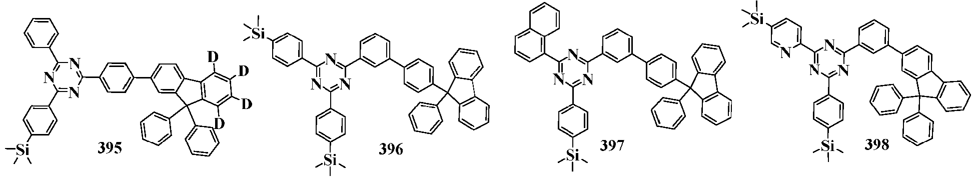

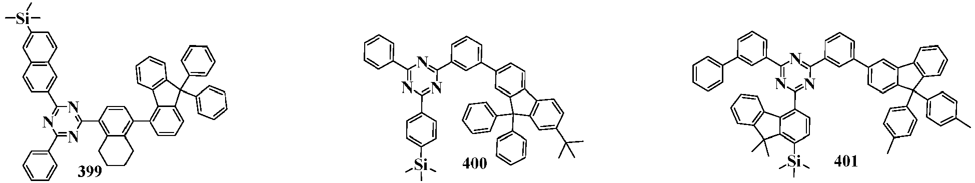

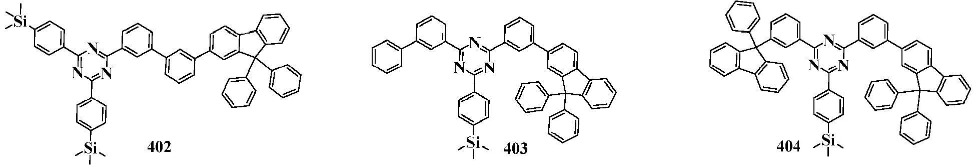

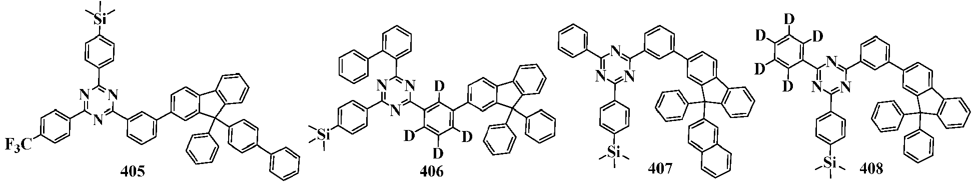

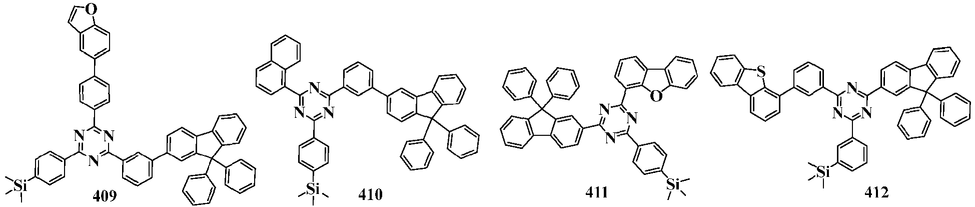

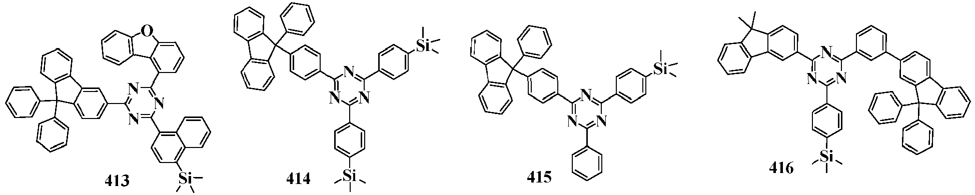

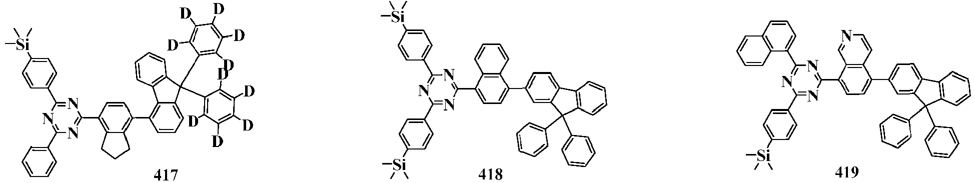

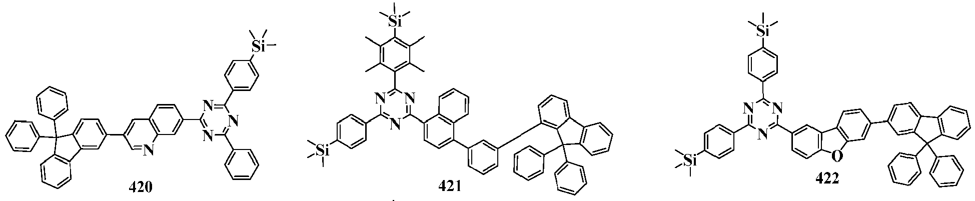

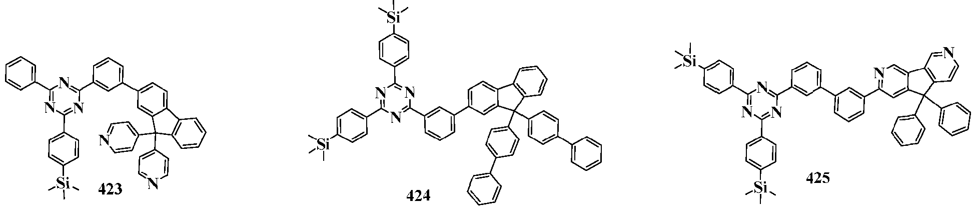

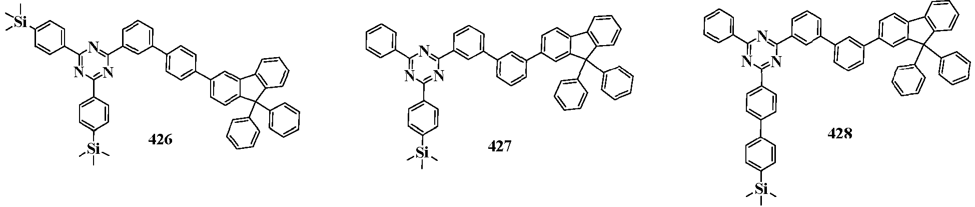

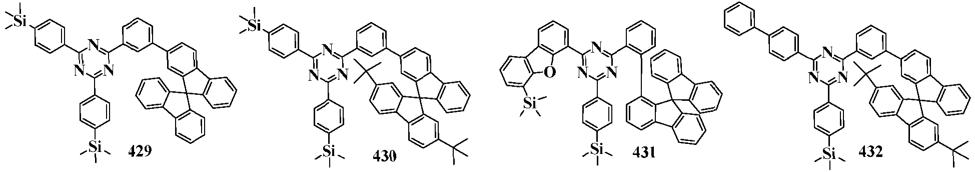

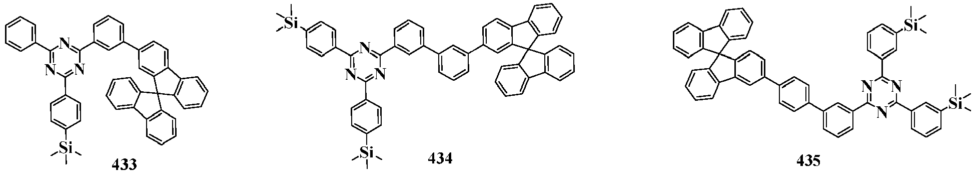

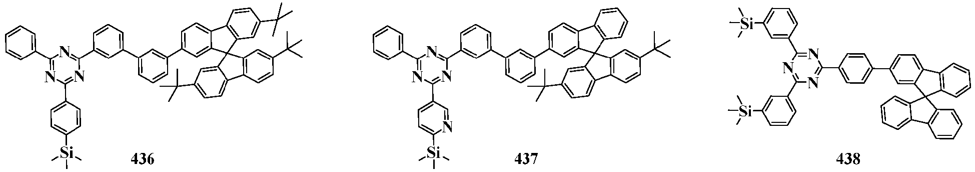

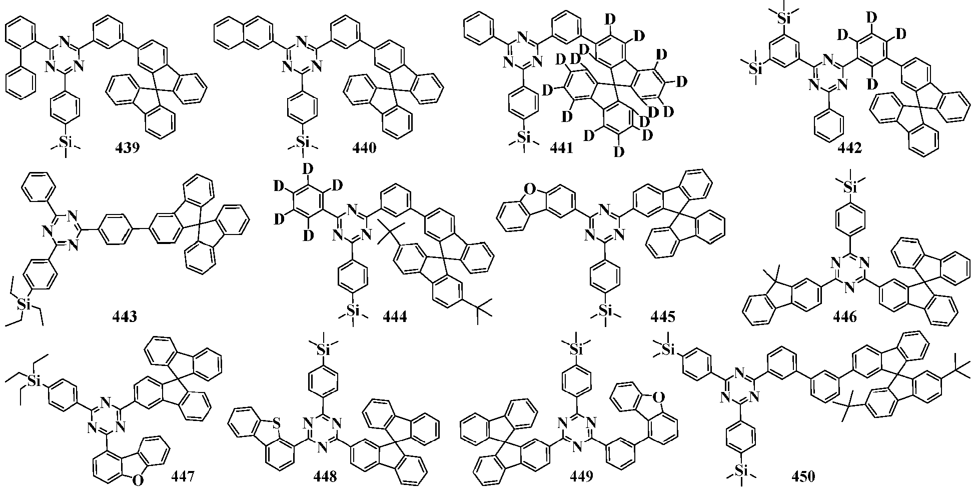

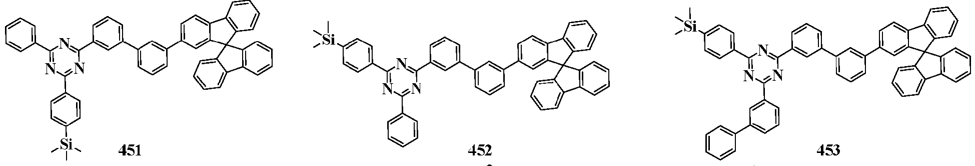

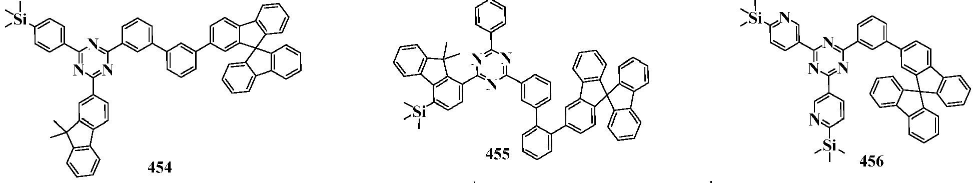

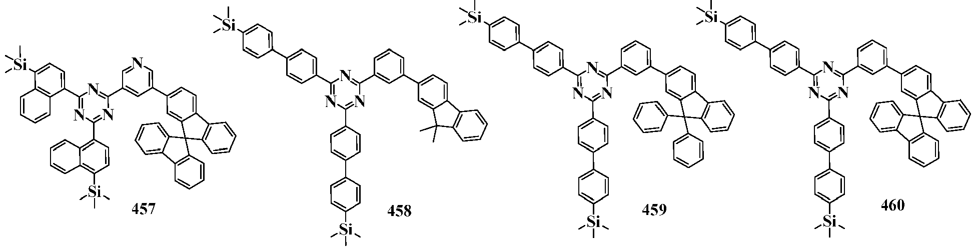

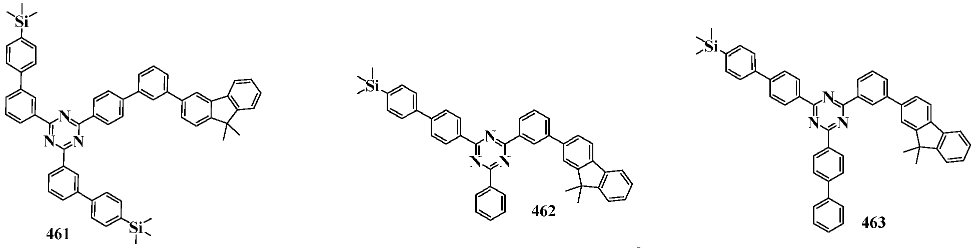

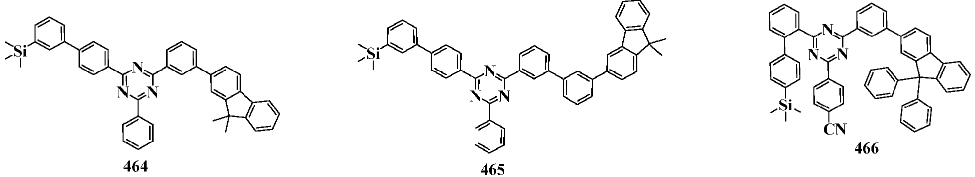

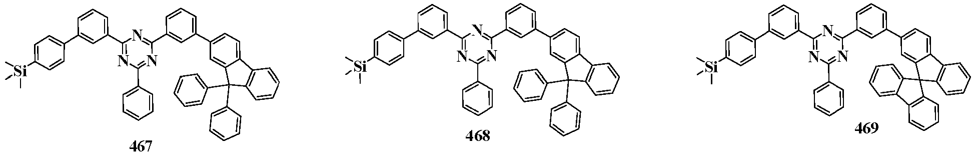

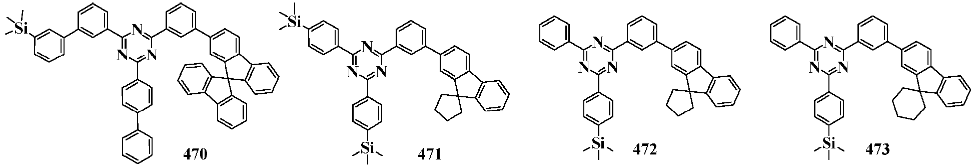

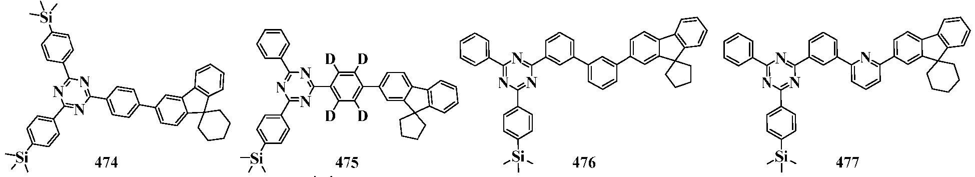

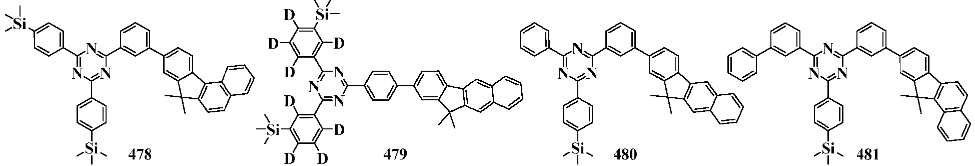

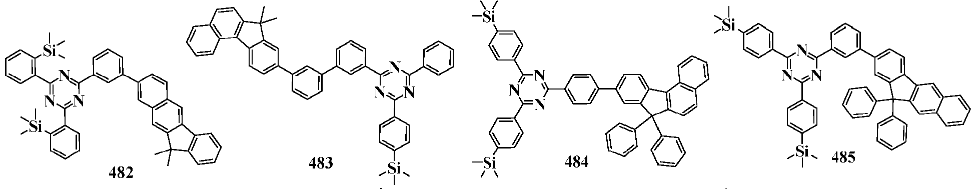

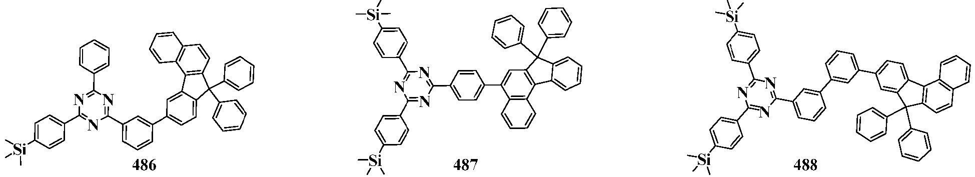

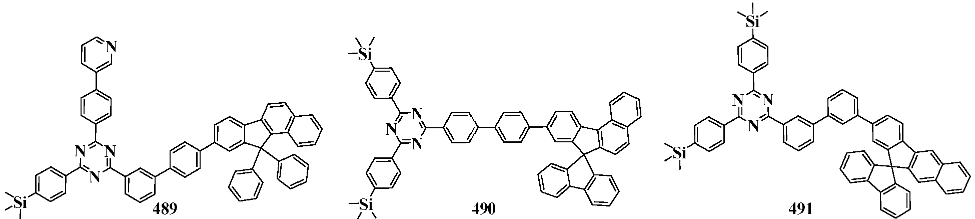

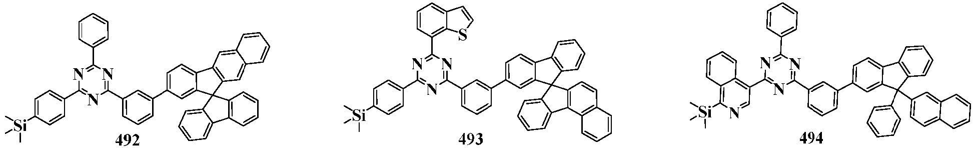

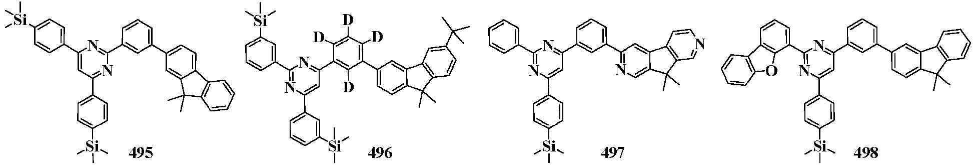

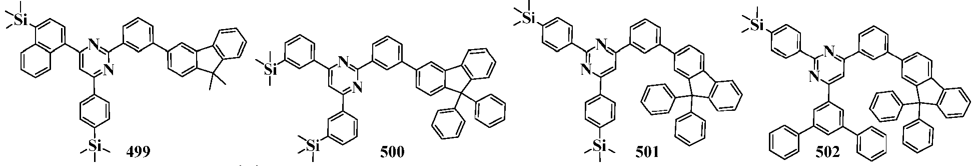

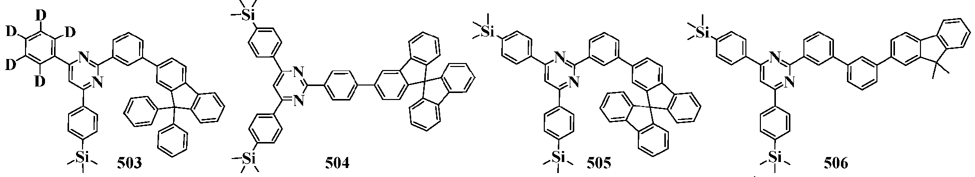

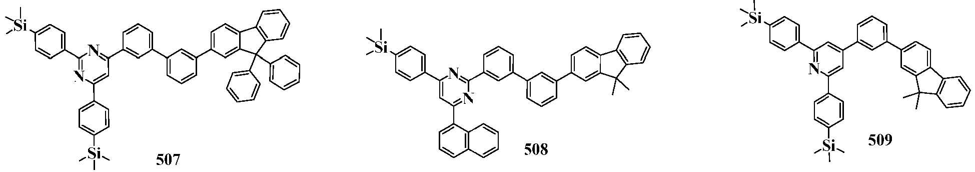

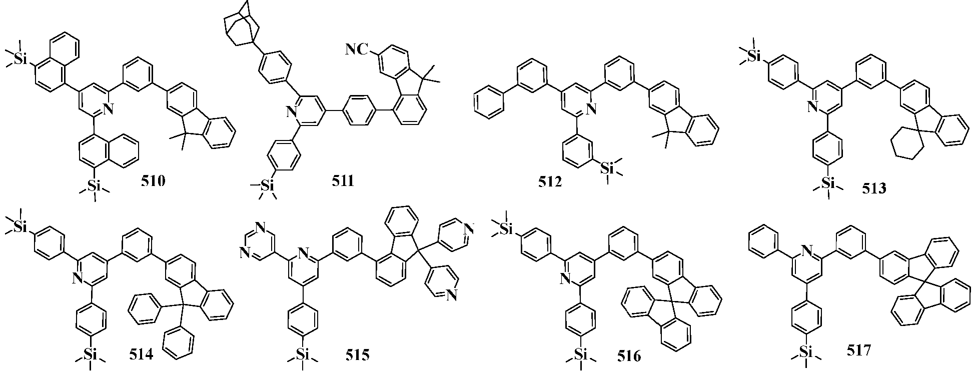

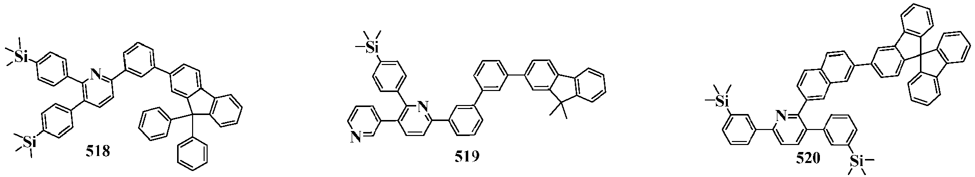

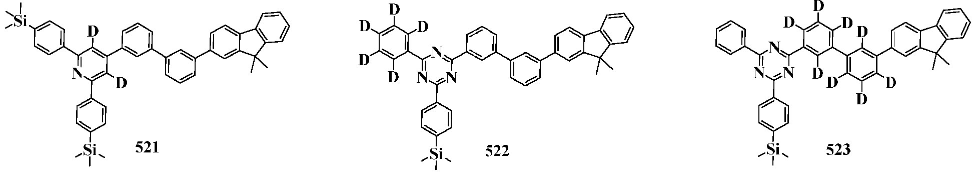

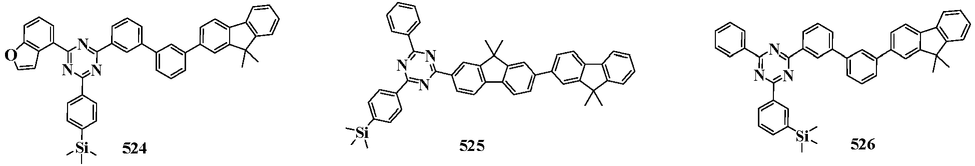

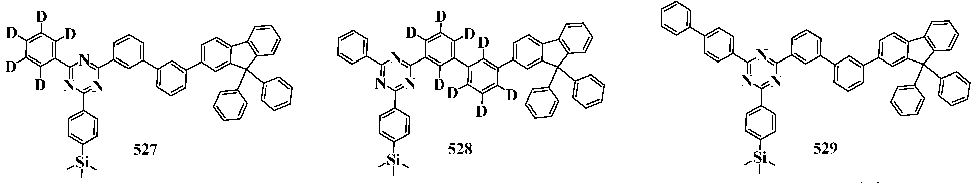

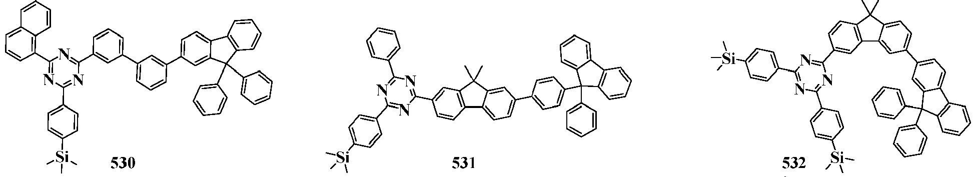

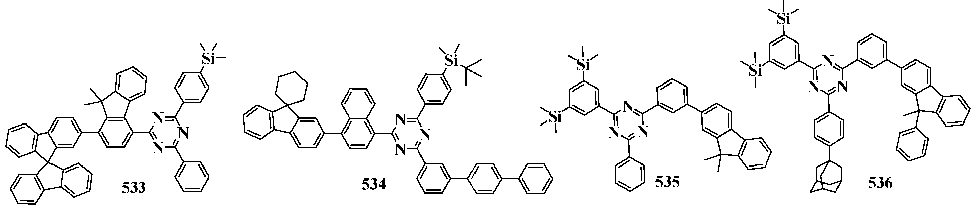

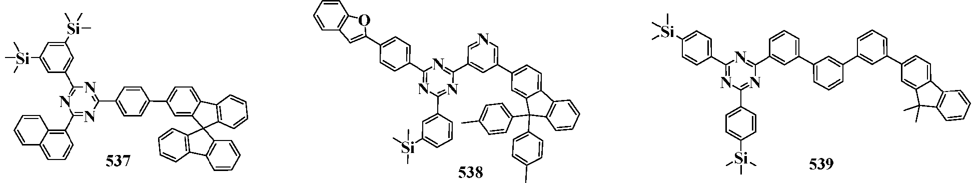

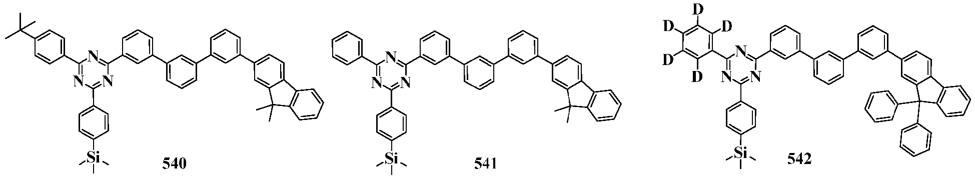

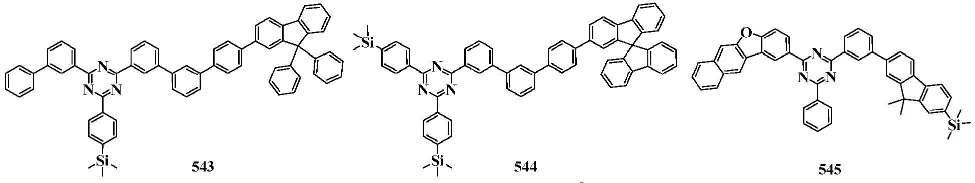

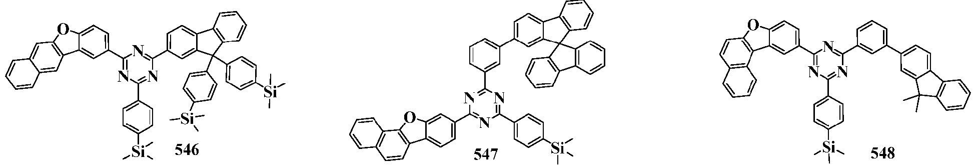

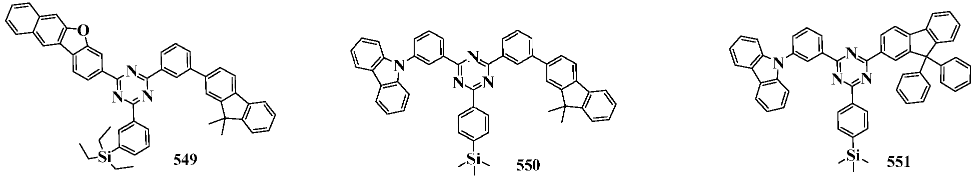

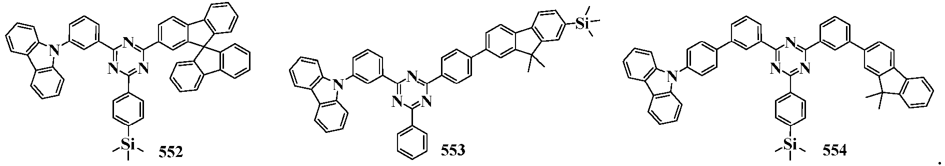

Some specific chemical structures of the fluorene-containing heterocyclic compound represented by Formula 1 of the present disclosure are exemplified above. However, the present disclosure is not limited to these chemical structures, and any group based on the structure represented by Formula I and having the substituent defined above shall be included therein.

Another embodiment of the present disclosure provides an organic electroluminescent device. The organic electroluminescent device includes an anode, a cathode and an organic layer, and the organic layer includes any one or more of the fluorene-containing heterocyclic compound described in the present disclosure.

The organic electroluminescent device in the present disclosure at least includes an anode, a cathode and an organic layer. One organic electroluminescent device may include one or more organic layers, and the one or more organic layers may be disposed between the anode and may also be disposed on an outer side of at least one of the anode or the cathode.

The organic layer including the above-mentioned compound may include, for example, but are not limited to, an anode-side organic layer (a hole transport layer, a hole injection layer, a light-emitting auxiliary layer, and the like) disposed between an anode and a light-emitting layer, a light-emitting layer, a cathode-side organic layer (an electron transport layer, a hole-blocking layer, an electron injection layer, and the like) disposed between a cathode and a light-emitting layer, and an organic layer (a light extraction layer, a light-efficiency improvement layer, a sealing layer, and the like) disposed an outer side of a cathode.

Preferably, the organic layer is disposed between the anode and the cathode, and the organic layer includes any one or more of the fluorene-containing heterocyclic compound described in the present disclosure.

Preferably, the organic layer includes at least one of a light-emitting layer, an electron transport layer or a hole blocking layer, and at least one of the light-emitting layer, the electron transport layer or the hole blocking layer includes any one or more of the fluorene-containing heterocyclic compound described in the present disclosure.

Preferably, the organic layer includes a light-emitting layer, and the light-emitting layer includes any one or more of the fluorene-containing heterocyclic compound described in the present disclosure.

More preferably, the organic layer includes a doped material and a host material, and the host material includes any one or more of the fluorene-containing heterocyclic compound described in the present disclosure.

Preferably, the organic layer includes an electron transport region, the electron transport region includes at least one of an electron injection layer, an electron transport layer or a hole blocking layer and includes any one or more of the fluorene-containing heterocyclic compound described in the present disclosure.

Preferably, the organic layer includes at least one of an electron transport layer or a hole blocking layer, and at least one of the electron transport layer or the hole blocking layer includes any one or more of the fluorene-containing heterocyclic compound described in the present disclosure.

Preferably, the organic layer includes an electron transport layer, and the electron transport layer includes any one or more of the fluorene-containing heterocyclic compound described in the present disclosure.

Preferably, the organic layer includes a hole blocking layer, and the hole blocking layer includes any one or more of the fluorene-containing heterocyclic compound described in the present disclosure.

Preferably, the organic layer is disposed on an outer side of at least one of the anode or the cathode, and the organic layer includes any one or more of the fluorene-containing heterocyclic compound described in the present disclosure. Further preferably, the organic layer is disposed on an outer side of the cathode.

Preferably, the organic layer includes a light extraction layer, and the light extraction layer includes any one or more of the fluorene-containing heterocyclic compound described in the present disclosure.

The material of each film of the organic electroluminescent device is particularly limited in the present disclosure, and the substances known in the art can be used. The above-mentioned organic functional layers of the organic electroluminescent device and the electrodes on both sides of the device are introduced below.

The anode in the present disclosure needs to have a high work function to improve the efficiency of hole injection. The material of the anode may be the following materials: metal oxides, combinations of metals and oxides, metals or alloys thereof, and the like. Specific examples of the material of the anode may include, but are not limited to, indium tin oxide (ITO), indium zinc oxide (IZO), aluminum (Al), titanium (Ti), gold (Au), platinum (Pt), copper (Cu), silver (Ag), indium tin oxide/silver/indium tin oxide (ITO/Ag/ITO), and the like.

The cathode in the present disclosure needs to have a low work function to improve the efficiency of electron injection. The material of the cathode may be metals or alloys thereof. Specific examples of the material of the cathode may include, but are not limited to, aluminum (Al), silver (Ag), calcium (Ca), indium (In), magnesium: silver (Mg:Ag), and the like.

The material of the hole injection layer in the present disclosure needs to have a good hole injection capability and possesses a suitable HOMO energy level to reduce the interface potential barrier between the anode and the hole transport layer and enhance the hole injection capability. The material of the hole injection layer may be the following materials: aromatic amine derivatives, metal oxides, phthalocyanine metal complexes, multicyano conjugated organics, polymers, and the like. Specific examples of the material of the hole injection layer include, but are not limited to, 2,3,6,7,10,11-hexacyano-1,4,5,8,9,12-hexaazatriphenylene (HAT-CN), copper phthalocyanine (CuPC), 4,4',4"-tris(N,N-2-naphthylphenylamino)triphenylamine (2-TNATA), 4,4',4"-tris(N-3-methylphenyl-N-phenylamino)triphenylamine (m-MTDATA), 2,3,5,6-tetrafluoro-7,7',8,8'-tetracyanoquinodimethane (F4-TCNQ), poly(4-vinyltriphenylamine) (PVTPA), and the like.

The material of the hole transport layer in the present disclosure needs to have a high hole mobility to facilitate hole injection. The material of the hole transport layer may be the following materials: aromatic amine derivatives, carbazole derivatives, fluorene derivatives, polymers, and the like. Specific examples of the material of the hole transport layer include, but are not limited to, N,N'-bis(1-naphthalenyl)-N,N'-bisphenyl-(1,1'-biphenyl)-4,4'-diamine (NPB), N,N'-bis(naphthalene-2-yl)-N,N'-diphenyl-[1,1'-biphenyl]-4,4'-diamine (β-NPB), N,N,N',N'-tetra-1-naphthalenyl-[1,1'-bisphenyl]-4,4'-diamine (α-TNB), N,N'-bis(3-methylphenyl)-N,N'-diphenyl-(1,1'-biphenyl)-4,4'-diamine (TPD), 4,4'-cyclohexylidenebis[N,N-bis(4-methylphenyl)aniline] (TAPC), 4,4',4"-tris(carbazol-9-yl)-triphenylamine (TCTA), polyvinylcarbazole (PVC), and the like.

The material of the electron blocking layer in the present disclosure needs to have a good hole transport capability and a good capability to block electrons to efficiently transport holes and limit the escape of electrons to the interface of the light-emitting layer. The material of the electron blocking layer may be the following materials: aromatic amine derivatives, carbazole derivatives, and the like. Specific examples of the material of the electron blocking layer may include, but are not limited to, N,N-bis([1,1'-biphenyl]-4-yl)-(9H-carbazol-9-yl)-[1,1'-biphenyl]-4-amine, N-(4'-(9H-carbazol-9-yl)-[1,1'-biphenyl]-4-N-([1,1'-biphenyl]-4-yl)-9,9-dimethyl-9H-fluorene-2 -amine, N,N'-bis(naphthalen-1-yl)-N,N'-bis(phenyl)-benzidine (NPD), and the like.

The material of the light-emitting layer in the present disclosure may be a red, green or blue light-emitting material and usually includes a guest (doped) material and a host material. The guest material may be a simple fluorescent material, phosphorescent material or TADF material or may be a combination of a fluorescent and a phosphorescent material. The host material of the light-emitting layer not only needs to have a bipolar charge transfer property, but also needs to have a suitable energy level to effectively transfer the excitation energy to the guest light-emitting material, and such a material may be, for example, diphenylvinyl aryl derivatives, stilbene derivatives, carbazole derivatives, triaryl amine derivatives, anthracene derivatives, pyrene derivatives, and the like, and preferably is at least one of the heterocyclic compound described in the present disclosure. Specific examples of the host material may include, but are not limite to, 4,4'-bis(9-carbazolyl)biphenyl (CBP), 4,4'-bis(carbazol-9-yl)-2,2'-dimethylbiphenyl (CDBP), 9-(4-*tert*-butylphenyl)-3,6-bis(triphenylsilyl)-9H-carbazole (CZSi), 9,9'-(2,6-pyridinediyldi-3,1-phenylene)bis-9H-carbazole (26DCZPPY), 9,9'-diphenyl-9H,9'H-3,3'-bicarbazole (BCzPh), 9-(5-(3-(9H -carbazol-9-yl)phenyl)pyridin-3-yl)-9H-carbazole (CPPyC), 4,4'-bis(carbazol-9-yl)-2,2'-dimethylbiphenyl (CDBP), 1,3-bis(N-carbazolyl)benzene (MCP), 9,9-diethyl-N,N-diphenyl-7-[4-(1-phenyl-1H-benzo[d]imidazol-2-yl)phenyl]-9H-fluoren-2-ami ne (EFIN), 10-(4'-(diphenylamino)biphenyl-4-yl)acridin-9(10H)-one (ADBP), tris[4-(pyrenyl)-phenyl]amine (TPyPA), 9,10-di(naphth-2-yl)anthracene (ADN), 2-(*tert*-butyl)-9,10-di(2-naphthalenyl)anthracene (TBADN), 1-(7-[9,9'-bianthracen]-10-yl-9,9-dioctyl-9H-fluoren-2-yl)pyrene (BAnF8Pye), 9,9,9',9'-tetra(4-methylphenyl)-2,2'-bi-9H-fluorene (BDAF), tris(6-fluoro-8-hydroxyquinolinato)aluminum (6FAlq₃), tris(8-hydroxyquinolinato)aluminum (Alq₃), bis(10-hydroxybenzo[H]quinolinato)beryllium (BeBq2), bis(8-quinolinolato)zinc (Znq2), and the like.

Specific examples of the guest material may be, but are not limited to, any one or more of the following structures: metal complexes (for example, iridium complexes, platinum complexes, osmium complexes, rhodium complexes, and the like), anthracene derivatives, pyrene derivatives, perylene derivatives, and the like. Specific examples of the guest material may include, but are not limited to, bis(2-(naphthalen-2-yl)pyridine)(acetylacetonate)iridium (Ir(npy)₂acac), tris[2-phenyl-4-methylquinoline)]iridium (Ir(Mphq)₃), acetylacetonatobis(2-phenylpyridine)iridium (Ir(ppy)₂(acac)), tris[2-(3-methyl-2-pyridinyl)phenyl]iridium (Ir(3mppy)₃), bis(2-benzo[H]quinoline-C2,N')(acetylacetonato)iridium(III) (Ir(bzq)₂(acac)), tris(2-(3,5-dimethylphenyl)quinoline-C2,N')iridium(III) (Ir(dmpq)₃), bis(1-phenyl-isoquinoline)(acetylacetonato)iridium(III) (Ir(piq)₂(acac)), 2,5,8,11-tetra-*tert*-butylperylene (TBPe), rubrene, 9-(9-phenylcarbazole-3-yl)-10-(naphthalene-1-yl) (PCAN), 1,4-bis(4-(9H-carbazol-9-yl)styryl)benzene (BCzSB), 1,1'-(4,4'-(4-phenyl-4H-1,2,4-triazole-3,5-diyl)bis(4,1-phenylene))bis(10H-phenoxazine) (2PXZ-TAZ), and the like.

The material of the hole blocking layer in the present disclosure needs to have a good electron transport capability and a good capability to block holes to efficiently transport electrons and limit the escape of holes to the interface of the light-emitting layer. The material of the hole blocking layer may be the following materials: metal complexes, quinoline derivatives, imidazole derivatives, *o*-diazophene derivatives, triazole derivatives, azabenzene derivatives, and the like, and is preferably at least one of the heterocyclic compound described in the present disclosure. Examples of the material of the hole blocking layer may include, but are not limited to, bis(2-methyl-8-quinolinolato-N1,O8)-(1,1'-biphenyl-4-olato)aluminum (BAlq), 1,3,5-tris(N-phenylbenzimidazol-2-yl)benzene (TPBi), 2,9-dimethyl-4,7-diphenyl-1,10-phenanthroline (BCP), 3,3'-[5'-[3-(3-pyridinyl)phenyl][1,1':3',1"-terphenyl]-3,3"-diyl]bispyridine (TmPyPB), and the like.

The material of the electron transport layer in the present disclosure needs to have a high electron mobility to facilitate electron injection. The material of the electron transport layer may be selected from the following materials: quinoline derivatives, imidazole derivatives, o-diazophene derivatives, triazole derivatives, metal chelates, azobenzene derivatives, phenazine derivatives, silicone-containing heterocyclic analogues, boron-containing heterocyclic analogues, and the like and is preferably at least one of the heterocyclic compound described in the present disclosure. Examples of the material of the electron transport layer may include, but are not limited to, 8-hydroxyquinoline aluminum (Alq₃), 2,9-bis(naphthalen-2-yl)-4,7-diphenyl-1,10-phenanthroline (NBphen), 1,3,5-tri(4-pyrid-3-yl-phenyl)benzene (TpPyPB), 1,3,5-tris(4-pyridinquinolin-2-yl)benzene (TPyQB), 3-(biphenyl-4-yl)-4-phenyl-5-(4-*tert*-butylphenyl)-1,2,4-triazole (TAZ), 1,3,5-tris(N-phenylbenzimidazol-2-yl)benzene (TPBi), tris(2,4,6-trimethyl-3-(pyridin-3-yl)phenyl)borane (3TPYMB), and the like.

The material of the electron injection layer in the present disclosure needs to have a good electron injection capability and possesses a suitable LUMO energy level to reduce the interface potential barrier between the cathode and the electron transport layer and enhance the electron injection capability. The material of the electron injection layer includes, but is not limited to, the following materials: metals, alkali metals, alkaline earth metals, metal compounds, metal oxides, metal halides, alkaline earth metal compounds, alkaline earth metal oxides, alkaline earth metal halides, alkali metal compounds, alkali metal oxides, alkali metal halides, and the like. Examples of the material of the electron injection layer include, but are not limited to, lithium (Li), strontium (Sr), ytterbium (Yb), lithium fluoride (LiF), sodium fluoride (NaF), cesium fluoride (CsF), calcium fluoride (CaF₂), 8-hydroxyquinolinolato-lithium (Liq), tris(8-hydroxyquinolinato)aluminum (Alq₃), cesium carbonate (Cs₂CO₃), rubidium acetate (CH₃COORb), lithium oxide (Li₂O), and the like.

The light extraction layer in the present disclosure has the function of light coupling to improve the luminescence efficiency. The material of the light extraction layer may include the following materials: metal compounds, triarylamine derivatives, benzidine derivatives, carbazole derivatives, and the like, and is preferably at least one of the heterocyclic compound described in the present disclosure. Examples of the material of the light extraction layer include, but are not limited to, tris(8-hydroxyquinolinato)aluminum (Alq₃), N,N'-bis(naphthalen-1-yl)-N,N'-bis(phenyl)-2,2'-dimethylbenzidine (NPD), 4,4'-bis(9-carbazolyl)biphenyl (CBP), and the like.

The preparation method of each film of the organic electroluminescent device of the present disclosure is not particularly limited, which may be, but is not limited to, a vacuum evaporation method, a sputtering method, a spin coating method, a spraying method, a silk-screen printing method, and a laser transfer printing method.

The organic electroluminescent device of the present disclosure is mainly applied to the technical fields of information display and illumination and is widely applied to various information displays in the aspect of information display, such as mobile phones, tablet computers, flat-panel televisions, smart watches, VR, vehicle-mounted systems, digital cameras, wearable devices, and the like.

### Synthesis Example

Raw materials and reagents: the raw materials or reagents used in the following synthesis examples are not particularly limited in the present disclosure and may be commercially available products or those prepared by preparation methods well-known to those skilled in the art.

Instruments: G2-Si quadrupole-time-of-flight mass spectrometer (WATERS CORPORATION, UK); Vario EL cube elemental analyzer (ELEMENTAR CO., GERMANY).

The core structure of the compound of Formula I of the present disclosure can be prepared by the reaction route shown below, the substituent can be bonded by methods known in the art, and the type, position and number of the substituent can be varied according to techniques known in the art.

Synthesis route:

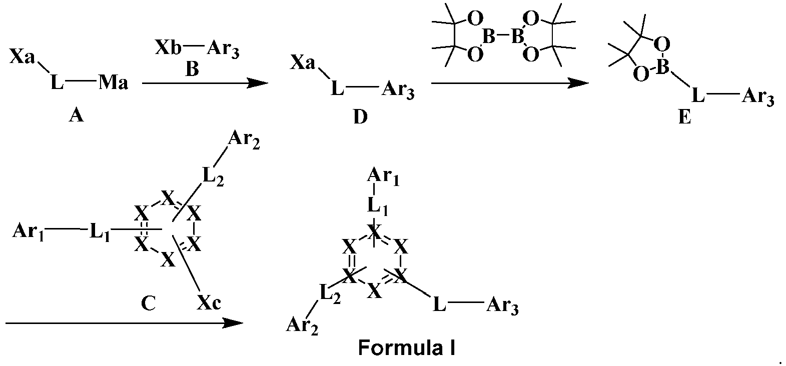

The main type of reaction involved in the present disclosure is Suzuki coupling reaction and Miyaura boronisation reaction, and the raw materials in the synthetic routes provided by the present disclosure can be commercially available products or can be those prepared by preparation methods known in the art.

For example, when L is selected from 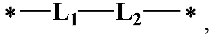 raw material A can be prepared using the synthetic route shown below, which is not limited thereto: 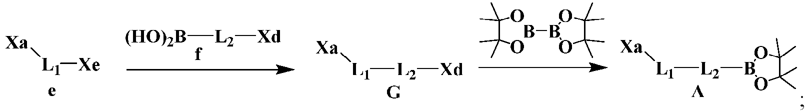 raw material C can be prepared using the synthetic route shown below: 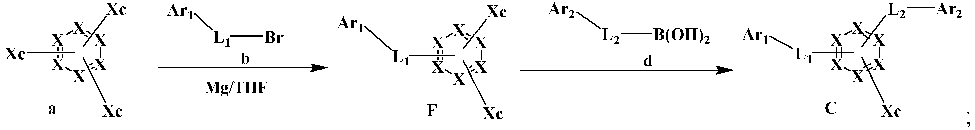 when Ar₁ and Ar₂ are identical to each other, the groups Ar₁ and Ar₂ can be introduced in one step to obtain raw material C, that is,

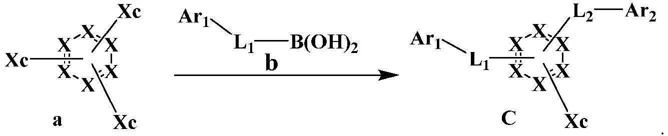

Xa, Xb, Xc, Xd and Xe are independently selected from Cl, Br and I, and Ma is independently selected from

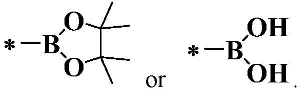

Alternatively, the above reaction sequence may be changed to obtain the fluorene-containing heterocyclic compound represented by Formula I of the present disclosure.

### Synthesis Example 1: Synthesis of Intermediate C-43

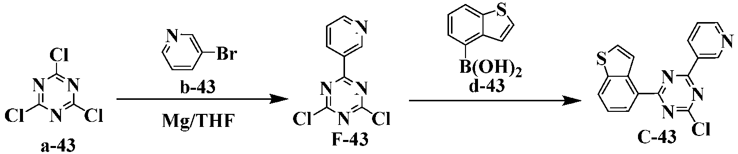

Under nitrogen protection, magnesium (5.04 g, 210 mmol) was added to a reaction flask, 50 mL of anhydrous tetrahydrofuran was added, then two particles of iodine were added, and b-43 (31.60 g, 200 mmol) was slowly added dropwise and dissolved in 100 mL of tetrahydrofuran to initiate Grignard reaction. After the dropwise addition was completed, the reaction was carried out at room temperature for 7 hours. After the reaction was completed, the reaction mixture was cooled to room temperature.

Under nitrogen protection, a-43 (36.88 g, 200 mmol) was added to a reaction flask, then 200 mL of tetrahydrofuran was added, the temperature of the system was lowered to -5 °C, and then the Grignard reagent prepared by the above reaction was added slowly dropwise with the dropwise time of 2 to 3 hours. After the dropwise addition was completed, the reaction was carried out for 5.5 hours at -5 °C. After the reaction was completed, the reaction solution was poured into 12% dilute hydrochloric acid, stirred fully for 30 minutes, and then extracted with dichloromethane (300 mL × three times). The organic phases were separated and dried with anhydrous magnesium sulfate, the solvent was concentrated by distillation under reduced pressure, and the resulting product was filtered by suction and recrystallization with tetrahydrofuran to give Intermediate F-43 (29.51 g, with a yield of 65%) with HPLC purity of ≥ 99.73%. Mass spectrum m/z: theoretical value: 225.9813, and measured value: 225.9826.

Under nitrogen protection, Intermediate F-43 (24.97 g, 110 mmol), d-43 (17.80 g, 100 mmol) and anhydrous potassium phosphate (42.45 g, 200 mmol) were added to a reaction flask, and then 250 mL of toluene solution was added. The reaction flask was purged with nitrogen three times to replace air, tetrakis(triphenylphosphine)palladium (1.16 g, 1.0 mmol) was added, and the resulting mixture was heated with stirring and reacted for 7 hours. After the reaction was completed, the reaction mixture was cooled to room temperature, the solvent was concentrated by distillation under reduced pressure, and the resulting product was filtered by suction. The filter cake was washed with ethanol and recrystallized with toluene to give Intermediate C-43 (20.41 g, with a yield of 63%) with HPLC purity ≥ 99.84%. Mass spectrum m/z: theoretical value: 324.0236, and measured value: 324.0245.

According to the preparation method of Intermediate C-43 described above, raw material a-43, raw material b-43 and raw material d-43 in Synthesis Example 1 were substituted with raw material a, raw material b and raw material d shown in the following table to synthesize the following Intermediates C:

| Raw material a | Raw material b | Raw material d | Intermediate C | Yield/HPLC purity | Mass spectrum m/z |
|---|---|---|---|---|---|
| 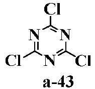 | 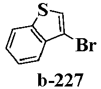 | 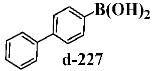 | 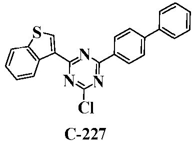 | 25.54 g; | Measured value: 399.0588 |
| | | | | HPLC purity ≥ 99.81% | Theoretical value: 399.0597 |
| 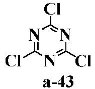 | 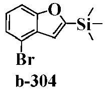 | 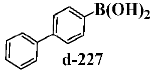 | 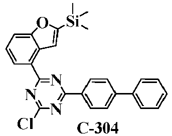 | 28.27 g; | Measured value: 455.1203 |
| | | | | HPLC purity ≥ 99.74% | Theoretical value: 455.1221 |
| 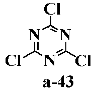 | 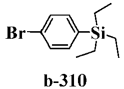 | 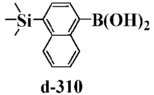 | 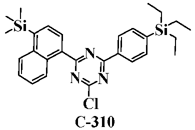 | 31.01 g; | Measured value: 503.1994 |
| | | | | HPLC purity ≥ 99.76% | Theoretical value: 503.1980 |
| 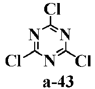 | 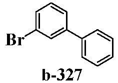 | 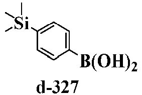 | 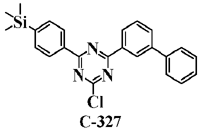 | 26.83 g; | Measured value: 415.1255 |
| | | | | HPLC purity ≥ 99.84% | Theoretical value: 415.1272 |
| 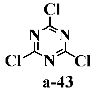 | 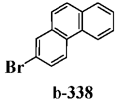 | 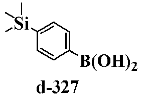 | 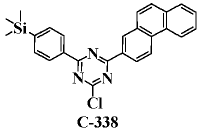 | 27.58 g; | Measured value: 439.1288 |
| | | | | HPLC purity ≥ 99.80% | |
| | | | | | Theoretical value: 439.1272 |
| 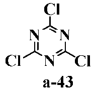 | 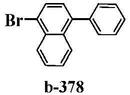 | 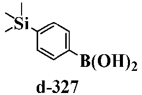 | 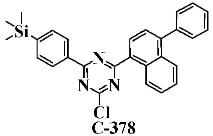 | 27.58 g; | Measured value: 465.1409 |
| | | | | HPLC purity ≥ 99.85% | Theoretical value: 465.1428 |
| 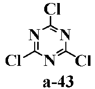 | 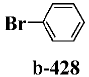 | 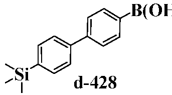 | 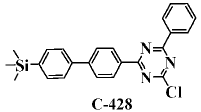 | 27.38 g; | Measured value: 415.1288 |
| | | | | HPLC purity ≥ 99.83% | Theoretical value: 415.1272 |
| 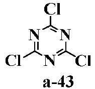 | 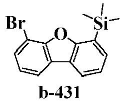 | 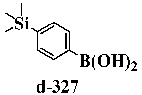 | 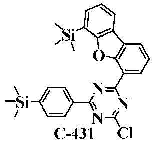 | 30.62 g; | Measured value: 501.1470 |
| | | | | HPLC purity ≥ 99.72% | Theoretical value: 501.1459 |
| 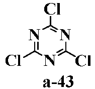 | 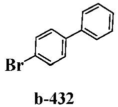 | 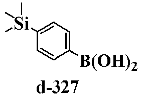 | 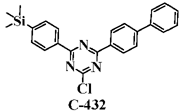 | 28.89 g; | Measured value: 447.1885 |
| | | | | HPLC purity ≥ 99.86% | Theoretical value: 447.1898 |
| 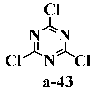 | 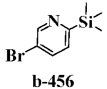 | 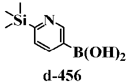 | 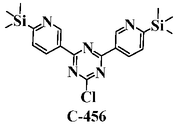 | 27.74 g; | Measured value: 445.1870 |
| | | | | HPLC purity ≥ 99.80% | Theoretical value: 445.1885 |
| 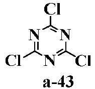 | 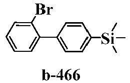 | 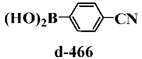 | 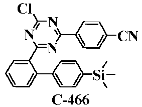 | 27.96 g; | Measured value: 440.1240 |
| | | | | HPLC purity ≥ 99.77% | Theoretical value: 440.1224 |
| 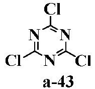 | 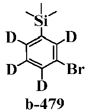 | 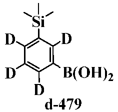 | 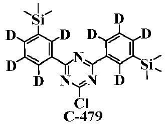 | 26.47 g; | Measured value: 419.1850 |
| | | | | HPLC purity ≥ 99.75% | Theoretical value: 419.1856 |
| 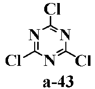 | 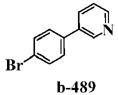 | 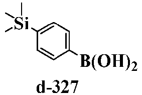 | 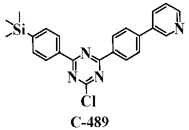 | 25.81 g; | Measured value: 416.1245 |
| | | | | HPLC purity ≥ 99.78% | Theoretical value: 416.1224 |
| 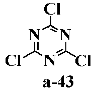 | 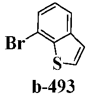 | 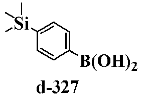 | 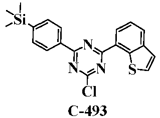 | 25.33 g; | Measured value: 395.0665 |
| | | | | HPLC purity ≥ 99.76% | Theoretical value: 395.0679 |
| 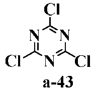 | 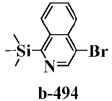 | 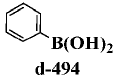 | 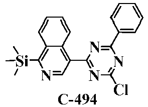 | 25.02 g; | Measured value: 390.1047 |
| | | | | HPLC purity ≥ 99.79% | Theoretical value: 390.1068 |
| 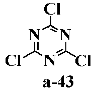 | 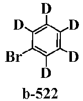 | 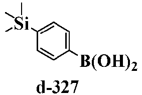 | 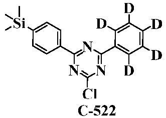 | 22.59 g; | Measured value: 344.1256 |
| | | | | HPLC purity ≥ 99.86% | |
| | | | | | Theoretical value: 344.1272 |
| 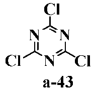 | 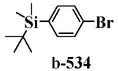 | 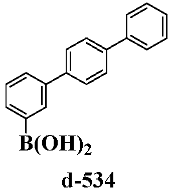 | 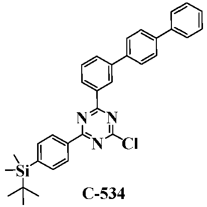 | 33.61 g; | Measured value: 533.2041 |
| | | | | HPLC purity ≥ 99.81% | Theoretical value: 533.2054 |
| 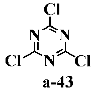 | 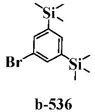 | 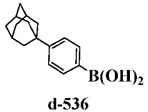 | 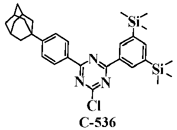 | 33.37 g; | Measured value: 545.2453 |
| | | | | HPLC purity ≥ 99.73% | Theoretical value: 545.2449 |
| 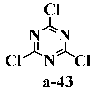 | 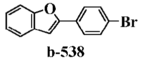 | 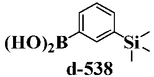 | 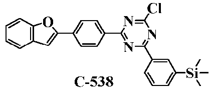 | 29.45 g; | Measured value: 471.1550 |
| | | | | HPLC purity ≥ 99.80% | Theoretical value: 471.1534 |
| 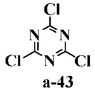 | 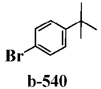 | 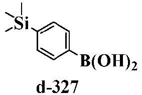 | 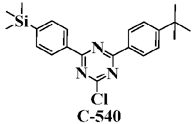 | 26.05 g; | Measured value: 395.1566 |
| | | | | HPLC purity ≥ 99.84% | Theoretical value: 395.1585 |

### Synthesis Example 2: Synthesis of Compound 20

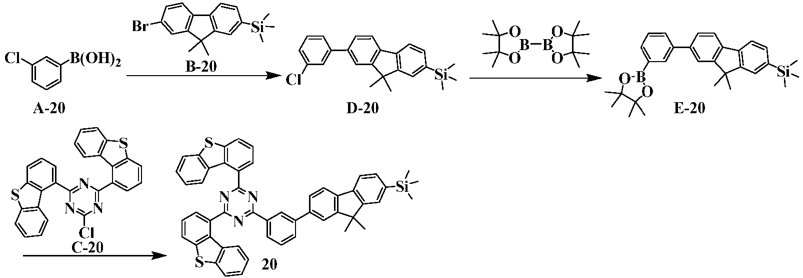

### Preparation of D-20:

Under nitrogen protection, A-20 (20.69 g, 120 mmol), B-20 (41.44 g, 120 mmol) and potassium phosphate (50.94 g, 240 mmol) were added to a reaction flask, and then 450 mL of mixed solvent of toluene/ethanol/water (toluene:ethanol:water v/v = 2:1:1) was added. The reaction flask was purged with nitrogen three times to replace air, tetrakis(triphenylphosphine)palladium (0.14 g, 0.12 mmol) was added, and the resulting mixture was stirred under reflux and reacted for 5 hours. After the reaction was completed, the reaction mixture was cooled to room temperature and filtered by suction, and the filter cake was washed with ethanol and recrystallized with toluene to give D-20 (30.76 g, with a yield of 68%) with HPLC purity ≥ 99.78%. Mass spectrum m/z: measured value: 376.1430, and theoretical value: 376.1414.

### Preparation of E-20:

Under nitrogen protection, D-20 (30.15 g, 80 mmol), bis(pinacolato)diboron (21.58 g, 85 mmol) and KOAc (19.63 g, 200 mmol) were added to a reaction flask, and then 400 mL of DMF solution was added. The reaction flask was purged with nitrogen three times to replace air, Pd(dppf)Cl₂ (0.59 g, 0.8 mmol) was added, and the resulting mixture was heated with stirring and reacted for 6 hours. After the reaction was completed, the reaction mixture was cooled to room temperature, distilled water was added, and then the reaction mixture was extracted with ethyl acetate (500 mL × three times). The organic phases were separated and dried with anhydrous magnesium sulphate, and the resulting solid was purified with hexane:ethyl acetate = 10:1 (v/v) to give E-20 (29.98 g, 80%) with HPLC purity ≥ 99.90%. Mass spectrum m/z: measured value: 468.2645, and theoretical value: 468.2656.

### Preparation of Compound 20:

Under nitrogen protection, E-20 (23.42 g, 50 mmol), C-20 (24.00 g, 50 mmol) and potassium carbonate (13.82 g, 100 mmol) were added to a reaction flask, 250 mL of mixed solvent of toluene/ethanol/water (toluene:ethanol:water v/v = 2:1:1) was added, and then palladium acetate (0.22 g, 1.0 mmol) was added. The reaction flask was purged with nitrogen three times to replace air, and 2-dicyclohexylphosphino-2',4',6'-triisopropylbiphenyl (trade name: Xphos) (0.95 g, 2.0 mmol) was added. After the reaction was completed, the reaction mixture was cooled to room temperature, distilled water was added, and then the reaction mixture was allowed to stand to separate the liquid. The separated organic phases were subjected to solvent concentration by distillation under reduced pressure and filtered by suction, and the filter cake was washed with ethanol and distilled water and recrystallized with toluene to give Compound 20 (23.58 g, 60%) with HPLC purity ≥ 99.89%. Mass spectrum m/z: measured value: 785.2374, and theoretical value: 785.2355. Theoretical element content (%) of C₅₁H₃₉N₃S₂Si: C, 77.92; H, 5.00; N, 5.35. Measured element content (%): C, 77.90; H, 5.05; N, 5.37.

### Synthesis Example 3: Synthesis of Compound 27

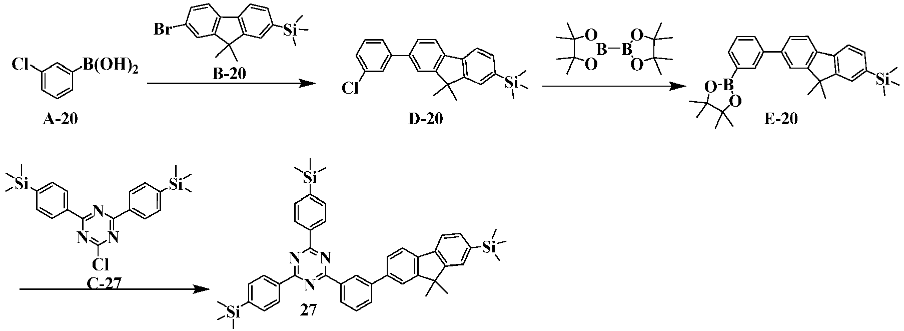

According to the preparation method of Compound 20 in Synthetic Example 2, C-20 was substituted with equimolar C-27 to give Compound 27 (23.34 g), with other steps remaining the same. The purity of the solid detected by HPLC was ≥ 99.96%. Mass spectrum m/z: measured value: 717.3387, and theoretical value: 717.3391. Theoretical element content (%) of C₄₅H₅₁N₃Si₃: C, 75.26; H, 7.16; N, 5.85. Measured element content (%): C, 75.21; H, 7.18; N, 5.87.

### Synthesis Example 4: Synthesis of Compound 43

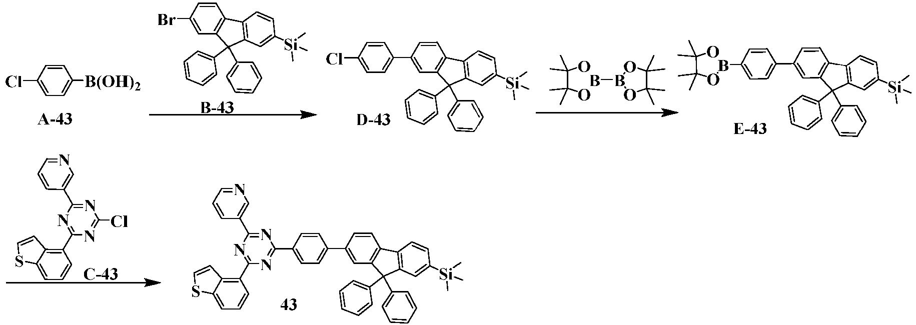

According to the preparation method of Compound 20 in Synthetic Example 2, A-20, B-20 and C-20 were substituted with equimolar A-43, B-43 and C-43 respectively to give Compound 43 (22.27 g), with other steps remaining the same. The purity of the solid detected by HPLC was ≥ 99.84%. Mass spectrum m/z: measured value: 754.2598, and theoretical value: 754.2586. Theoretical element content (%) of C₅₀H₃₈N₄SSi: C, 79.54; H, 5.07; N, 7.42. Measured element content (%): C, 79.50; H, 5.02; N, 7.45.

### Synthesis Example 5: Synthesis of Compound 54

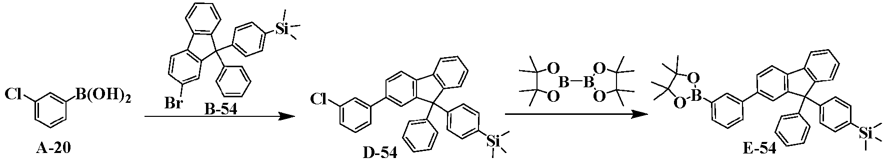

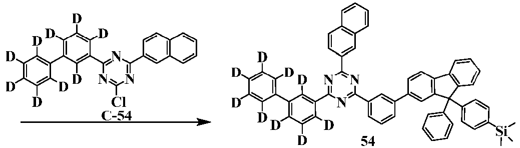

According to the preparation method of Compound 20 in Synthetic Example 2, B-20 and C-20 were substituted with equimolar B-54 and C-54 respectively to give Compound 54 (25.54 g), with other steps remaining the same. The purity of the solid detected by HPLC was ≥ 99.87%. Mass spectrum m/z: measured value: 832.3935, and theoretical value: 832.3948. Theoretical element content (%) of C₅₉H₃₆D₉N₃Si: C, 85.05; H, 6.53; N, 5.04. Measured element content (%): C, 85.10; H, 6.55; N, 5.00.

### Synthesis Example 6: Synthesis of Compound 87

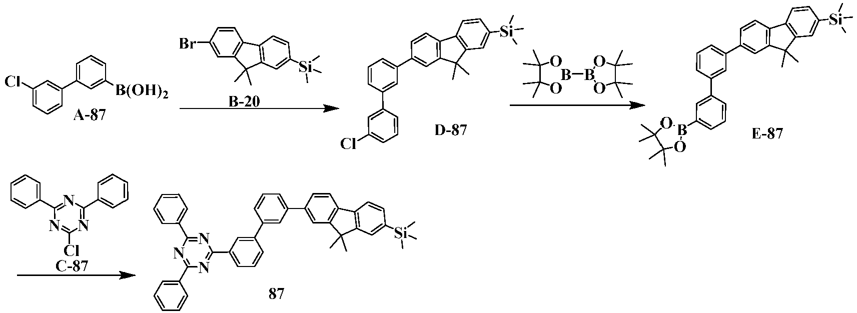

According to the preparation method of Compound 20 in Synthetic Example 2, A-20 and C-20 were substituted with equimolar A-87 and C-87 respectively to give Compound 87 (20.15 g), with other steps remaining the same. The purity of the solid detected by HPLC was ≥ 99.95%. Mass spectrum m/z: measured value: 649.2934, and theoretical value: 649.2913. Theoretical element content (%) of C₄₅H₃₉N₃Si: C, 83.16; H, 6.05; N, 6.47. Measured element content (%): C, 83.12; H, 6.10; N, 6.43.

### Synthesis Example 7: Synthesis of Compound 124

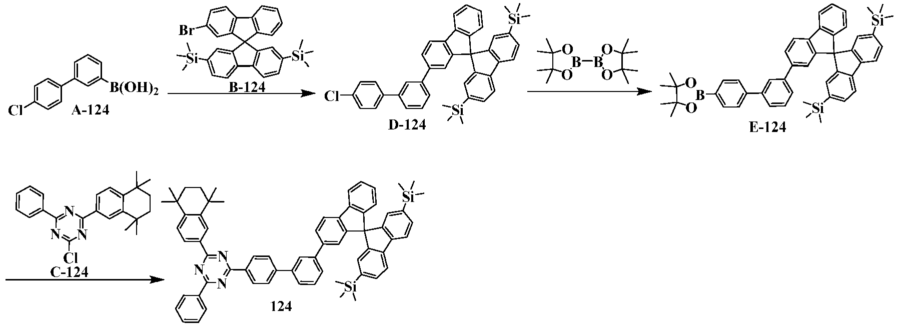

According to the preparation method of Compound 20 in Synthetic Example 2, A-20, B-20 and C-20 were substituted with equimolar A-124, B-124 and C-124 respectively to give Compound 124 (29.09 g), with other steps remaining the same. The purity of the solid detected by HPLC was ≥ 99.80%. Mass spectrum m/z: measured value: 953.4544, and theoretical value: 953.4561. Theoretical element content (%) of C₆₆H₆₃N₃Si₂: C, 83.06; H, 6.65; N, 4.40. Measured element content (%): C, 83.10; H, 6.61; N, 4.45.

### Synthesis Example 8: Synthesis of Compound 188

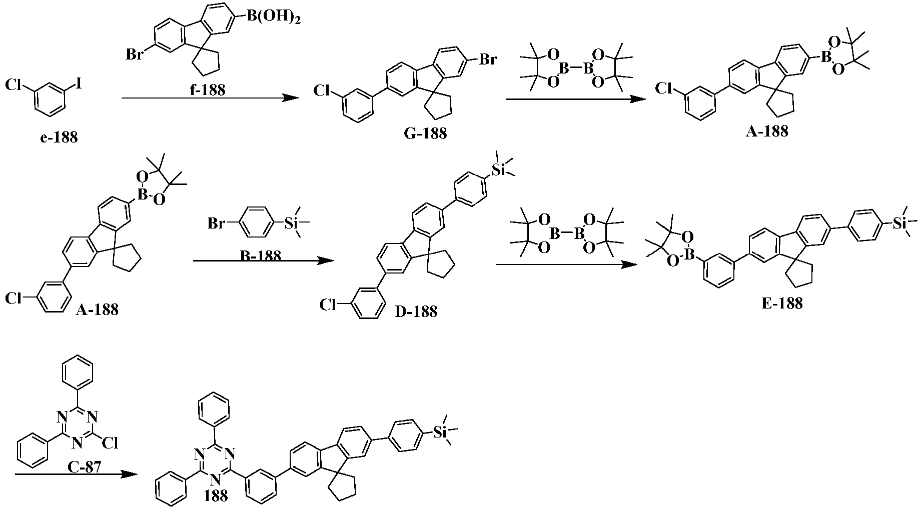

### Preparation of G-188:

Under nitrogen protection, e-188 (59.61 g, 250 mmol), f-188 (85.76 g, 250 mmol) and K₃PO₄ (159.20 g, 750 mmol) were added to a reaction flask, and then 900 mL of toluene solvent was added. The reaction flask was purged with nitrogen three times to replace air, tetrakis(triphenylphosphine)palladium (2.89 g, 2.5 mmol) was added, and the resulting mixture was heated with stirring and reacted for 6 hours. After the reaction was completed, the reaction mixture was cooled to room temperature and filtered by suction under reduced pressure, and the filter cake was washed with ethanol and distilled water and recrystallized with toluene to give G-188 (73.76 g, 72%) with HPLC purity ≥ 99.79%. Mass spectrum m/z: measured value: 408.0267, and theoretical value: 408.0280.

### Preparation of A-188:

Under nitrogen protection, G-188 (69.65 g, 170 mmol), bis(pinacolato)diboron (44.44 g, 175 mmol) and KOAc (49.07 g, 500 mmol) were added to a reaction flask, and then 700 mL of 1,4-dioxane was added. The reaction flask was purged with nitrogen three times to replace air, Pd(dppf)Cl₂ (1.23 g, 1.7 mmol) was added, and the resulting mixture was heated with stirring and reacted for 7.5 hours. After the reaction was completed, the reaction mixture was cooled to room temperature, distilled water was added, and then the reaction mixture was extracted with ethyl acetate (1000 mL × three times). The organic phases were separated and dried with anhydrous magnesium sulphate, and the resulting solid was purified with hexane:ethyl acetate = 20:1 (v/v) to give A-188 (62.90 g, 81%) with HPLC purity ≥ 99.90%. Mass spectrum m/z: measured value: 456.2050, and theoretical value: 456.2027.

### Preparation of Compound 188:

According to the preparation method of Compound 20 in Synthetic Example 2, A-20, B-20 and C-20 were substituted with equimolar A-188, B-188 and C-87 respectively to give Compound 188 (19.90 g), with other steps remaining the same. The purity of the solid detected by HPLC was ≥ 99.87%. Mass spectrum m/z: measured value: 675.3081, and theoretical value: 675.3070. Theoretical element content (%) of C₄₇H₄₁N₃Si: C, 83.51; H, 6.11; N, 6.22. Measured element content (%): C, 83.46; H, 6.13; N, 6.25.

### Synthesis Example 9: Synthesis of Compound 202

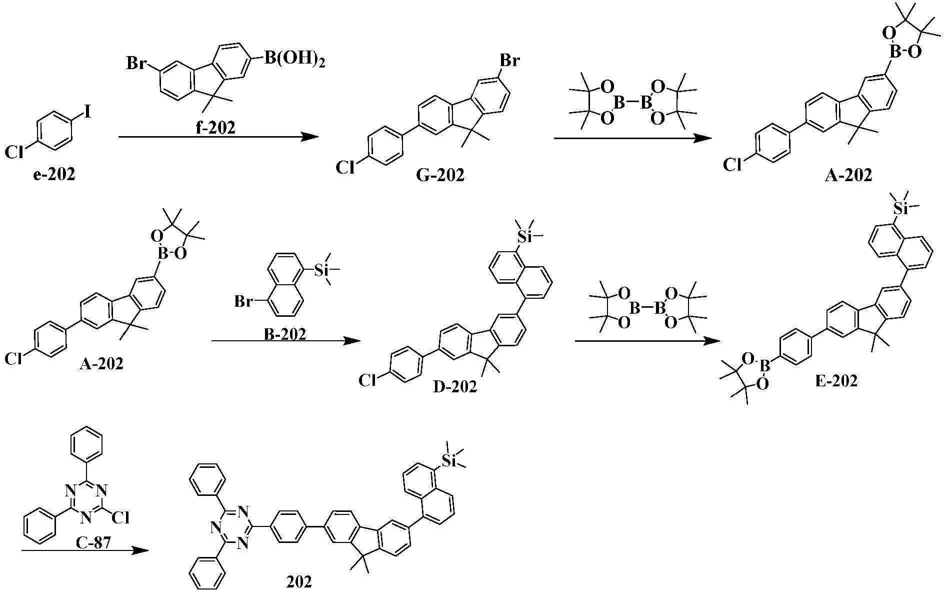

### Preparation of A-202:

According to the preparation method of Intermediate A-188 in Synthetic Example 8, e-188 and f-188 were substituted with equimolar e-202 and f-202 respectively to give A-202 (57.51 g), with other steps remaining the same. The HPLC purity was ≥ 99.90%. Mass spectrum m/z: measured value: 430.1855, and theoretical value: 430.1871.

### Preparation of Compound 202:

According to the preparation method of Compound 20 in Synthetic Example 2, A-20, B-20 and C-20 were substituted with equimolar A-202, B-202 and C-87 respectively to give Compound 202 (20.99 g), with other steps remaining the same. The purity of the solid detected by HPLC was ≥ 99.90%. Mass spectrum m/z: measured value: 699.3052, and theoretical value: 699.3070. Theoretical element content (%) of C₄₉H₄₁N₃Si: C, 84.08; H, 5.90; N, 6.00. Measured element content (%): C, 84.04; H, 5.87; N, 6.03.

### Synthesis Example 10: Synthesis of Compound 227

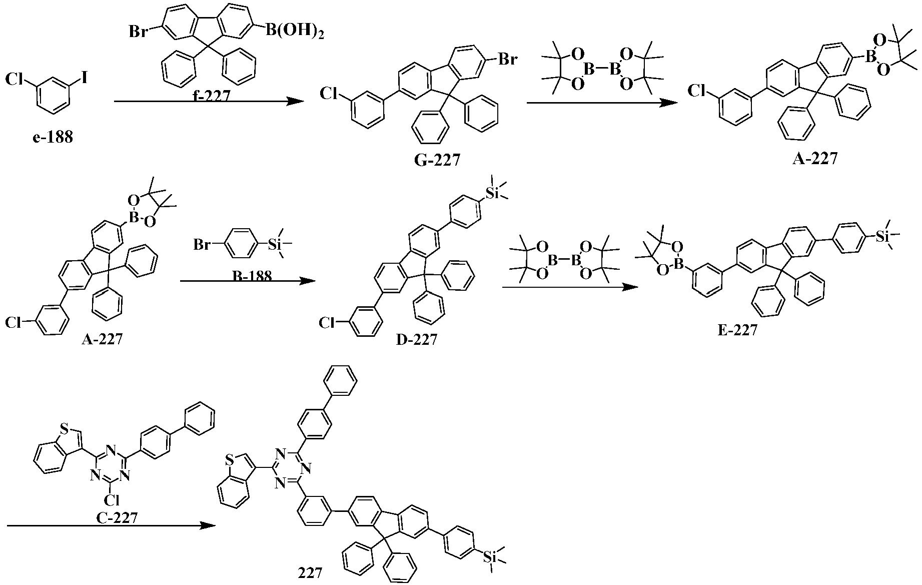

### Preparation of A-227:

According to the preparation method of Intermediate A-188 in Synthetic Example 8, f-188 was substituted with equimolar f-227 to give A-202 (74.52 g), with other steps remaining the same. The HPLC purity was ≥ 99.87%. Mass spectrum m/z: measured value: 554.2168, and theoretical value: 554.2184.

### Preparation of Compound 227:

According to the preparation method of Compound 20 in Synthetic Example 2, A-20, B-20 and C-20 were substituted with equimolar A-227, B-188 and C-227 respectively to give Compound 227 (28.09 g), with other steps remaining the same. The purity of the solid detected by HPLC was ≥ 99.86%. Mass spectrum m/z: measured value: 905.3247, and theoretical value: 905.3260. Theoretical element content (%) of C₆₃H₄₇N₃SSi: C, 83.50; H, 5.23; N, 4.64. Measured element content (%): C, 83.54; H, 5.20; N, 4.60.

### Synthesis Example 11: Synthesis of Compound 279

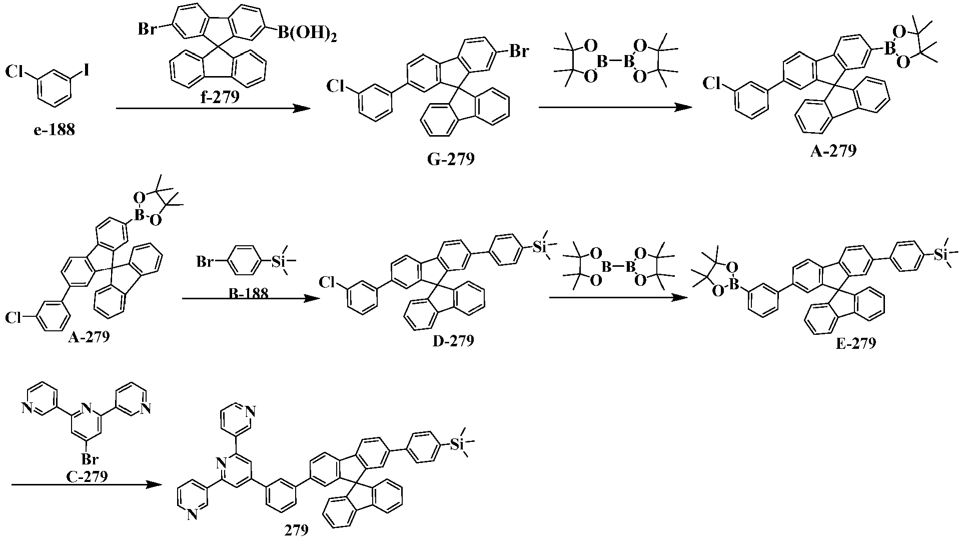

### Preparation of A-279:

According to the preparation method of Intermediate A-188 in Synthetic Example 8, f-188 was substituted with equimolar f-279 to give A-202 (74.25 g), with other steps remaining the same. The HPLC purity was ≥ 99.88%. Mass spectrum m/z: measured value: 552.2051, and theoretical value: 552.2027.

### Preparation of Compound 279:

According to the preparation method of Compound 20 in Synthetic Example 2, A-20, B-20 and C-20 were substituted with equimolar A-279, B-188 and C-279 respectively to give Compound 279 (23.16 g), with other steps remaining the same. The purity of the solid detected by HPLC was ≥ 99.92%. Mass spectrum m/z: measured value: 771.3061, and theoretical value: 771.3070. Theoretical element content (%) of C₅₅H₄₁N₃Si: C, 85.57; H, 5.35; N, 5.44. Measured element content (%): C, 85.53; H, 5.40; N, 5.41.

### Synthesis Example 12: Synthesis of Compound 282

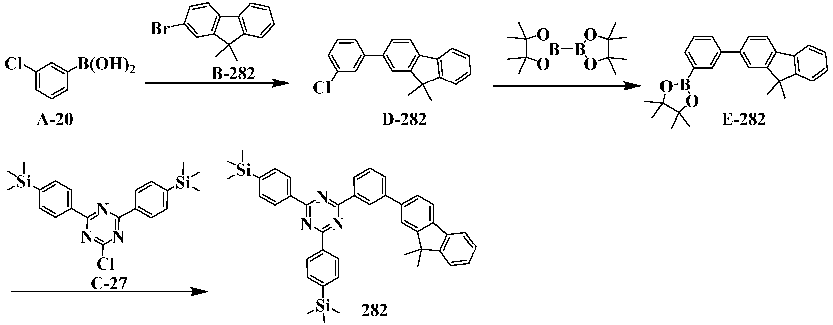

According to the preparation method of Compound 20 in Synthetic Example 2, B-20 and C-20 were substituted with equimolar B-282 and C-27 respectively to give Compound 282 (21.64 g), with other steps remaining the same. The purity of the solid detected by HPLC was ≥ 99.90%. Mass spectrum m/z: measured value: 645.2980, and theoretical value: 645.2996. Theoretical element content (%) of C₄₂H₄₃N₃Si₂: C, 78.09; H, 6.71; N, 6.50. Measured element content (%): C, 78.06; H, 6.73; N, 6.47.

### Synthesis Example 13: Synthesis of Compound 304

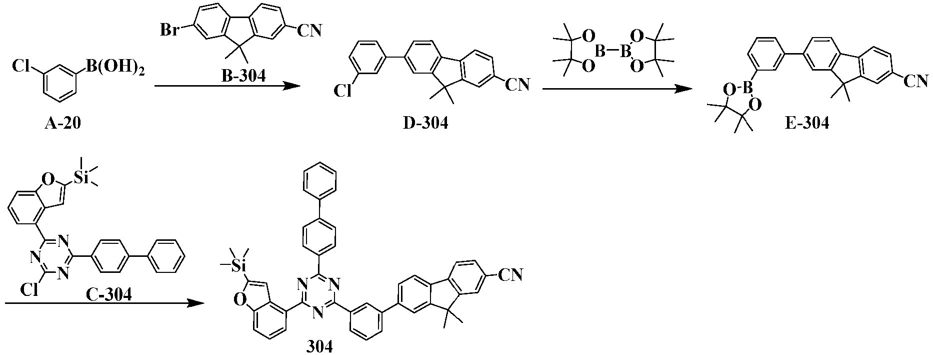

According to the preparation method of Compound 20 in Synthetic Example 2, B-20 and C-20 were substituted with equimolar B-304 and C-304 respectively to give Compound 304 (22.49 g), with other steps remaining the same. The purity of the solid detected by HPLC was ≥ 99.88%. Mass spectrum m/z: measured value: 714.2826, and theoretical value: 714.2815. Theoretical element content (%) of C₄₈H₃₈N₄OSi: C, 80.64; H, 5.36; N, 7.84. Measured element content (%): C, 80.67; H, 5.39; N, 7.80.

### Synthesis Example 14: Synthesis of Compound 307

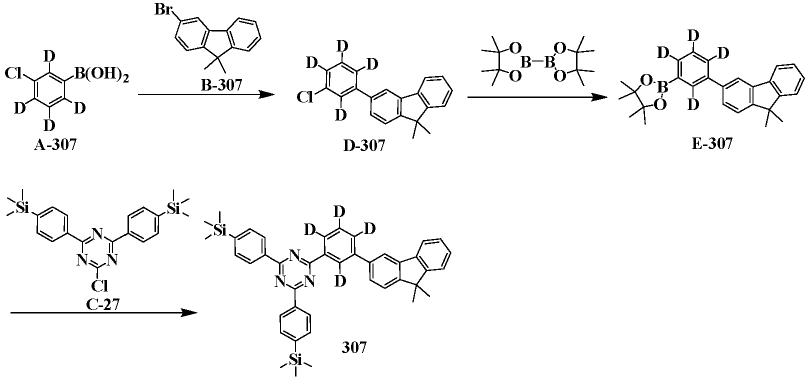

According to the preparation method of Compound 20 in Synthetic Example 2, A-20, B-20 and C-20 were substituted with equimolar A-307, B-307 and C-27 respectively to give Compound 307 (21.45 g), with other steps remaining the same. The purity of the solid detected by HPLC was ≥ 99.95%. Mass spectrum m/z: measured value: 649.3250, and theoretical value: 649.3247. Theoretical element content (%) of C₄₂H₃₉D₄N₃Si₂: C, 77.61; H, 7.29; N, 6.46. Measured element content (%): C, 77.65; H, 7.33; N, 6.42.

### Synthesis Example 15: Synthesis of Compound 310

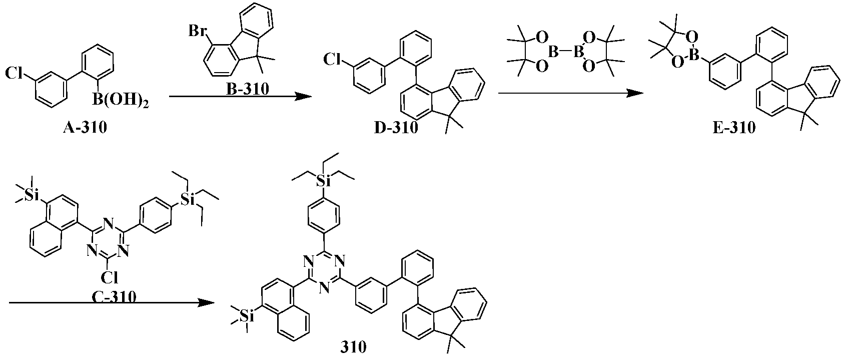

According to the preparation method of Compound 20 in Synthetic Example 2, A-20, B-20 and C-20 were substituted with equimolar A-310, B-310 and C-310 respectively to give Compound 310 (25.03 g), with other steps remaining the same. The purity of the solid detected by HPLC was ≥ 99.82%. Mass spectrum m/z: measured value: 813.3919, and theoretical value: 813.3935. Theoretical element content (%) of C₅₅H₅₅N₃Si₂: C, 81.13; H, 6.81; N, 5.16. Measured element content (%): C, 81.16; H, 6.77; N, 5.12.

### Synthesis Example 16: Synthesis of Compound 327

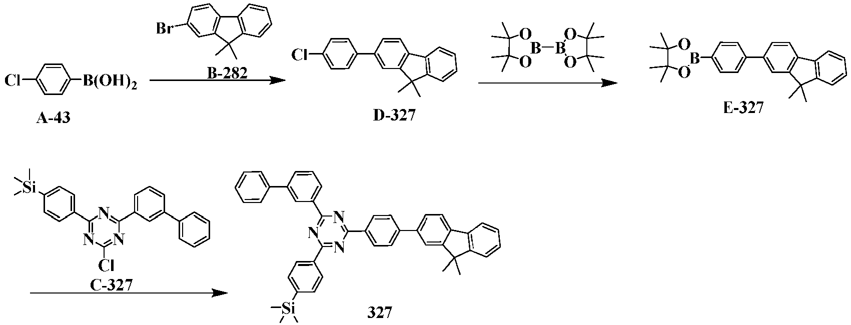

According to the preparation method of Compound 20 in Synthetic Example 2, A-20, B-20 and C-20 were substituted with equimolar A-43, B-282 and C-327 respectively to give Compound 327 (20.99 g), with other steps remaining the same. The purity of the solid detected by HPLC was ≥ 99.96%. Mass spectrum m/z: measured value: 649.2900, and theoretical value: 649.2913. Theoretical element content (%) of C₄₅H₃₉N₃Si: C, 83.16; H, 6.05; N, 6.47. Measured element content (%): C, 83.11; H, 6.02; N, 6.43.

### Synthesis Example 17: Synthesis of Compound 328

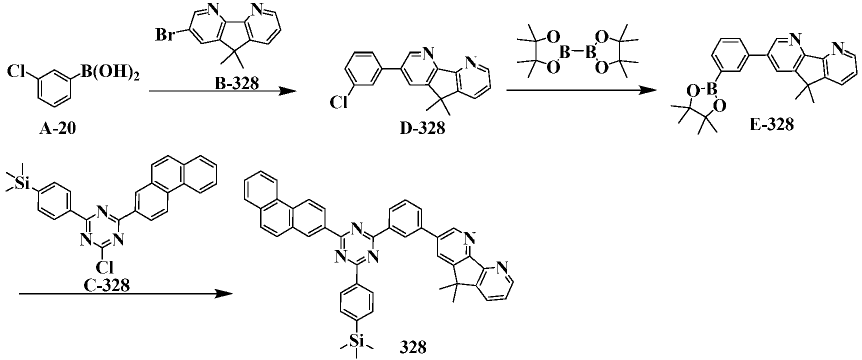

According to the preparation method of Compound 20 in Synthetic Example 2, B-20 and C-20 were substituted with equimolar B-328 and C-328 respectively to give Compound 328 (20.68 g), with other steps remaining the same. The purity of the solid detected by HPLC was ≥ 99.83%. Mass spectrum m/z: measured value: 675.2837, and theoretical value: 675.2818. Theoretical element content (%) of C₄₅H₃₇N₅Si: C, 79.97; H, 5.52; N, 10.36. Measured element content (%): C, 79.92; H, 5.50; N, 10.39.

### Synthesis Example 18: Synthesis of Compound 350

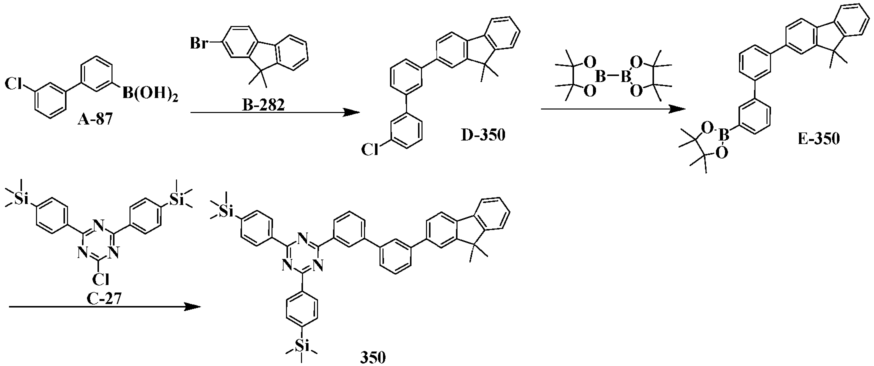

According to the preparation method of Compound 20 in Synthetic Example 2, A-20, B-20 and C-20 were substituted with equimolar A-87, B-282 and C-27 respectively to give Compound 350 (24.00 g), with other steps remaining the same. The purity of the solid detected by HPLC was ≥ 99.98%. Mass spectrum m/z: measured value: 721.3294, and theoretical value: 721.3309. Theoretical element content (%) of C₄₈H₄₇N₃Si₂: C, 79.84; H, 6.56; N, 5.82. Measured element content (%): C, 79.88; H, 6.54; N, 5.79.

### Synthesis Example 19: Synthesis of Compound 378

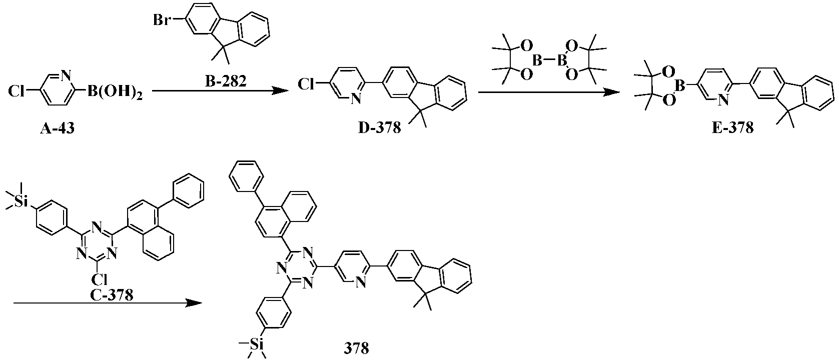

According to the preparation method of Compound 20 in Synthetic Example 2, A-20, B-20 and C-20 were substituted with equimolar A-43, B-282 and C-378 respectively to give Compound 378 (21.72 g), with other steps remaining the same. The purity of the solid detected by HPLC was ≥ 99.90%. Mass spectrum m/z: measured value: 700.3041, and theoretical value: 700.3022. Theoretical element content (%) of C₄₈H₄₀N₄Si: C, 82.25; H, 5.75; N, 7.99. Measured element content (%): C, 82.21; H, 5.77; N, 7.96.

### Synthesis Example 20: Synthesis of Compound 397

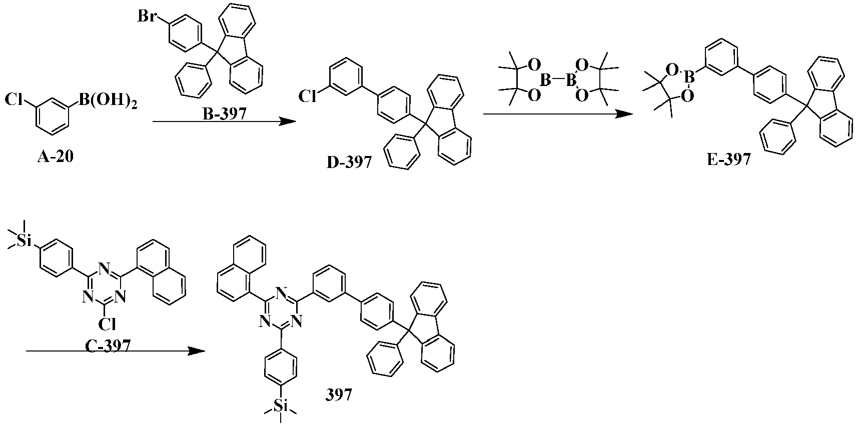

According to the preparation method of Compound 20 in Synthetic Example 2, B-20 and C-20 were substituted with equimolar B-397 and C-397 respectively to give Compound 397 (24.31 g), with other steps remaining the same. The purity of the solid detected by HPLC was ≥ 99.94%. Mass spectrum m/z: measured value: 747.3055, and theoretical value: 747.3070. Theoretical element content (%) of C₅₃H₄₁N₃Si: C, 85.10; H, 5.53; N, 5.62. Measured element content (%): C, 85.14; H, 5.50; N, 5.66.

### Synthesis Example 21: Synthesis of Compound 411

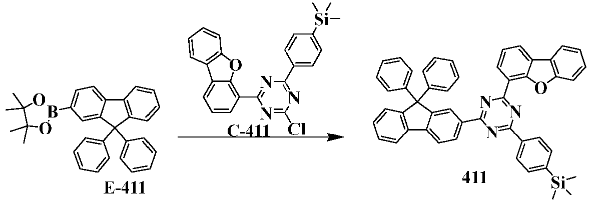

According to the preparation method of Compound 20 in Synthetic Example 2, E-20 and C-20 were substituted with equimolar E-411 and C-411 respectively to give Compound 411 (21.57 g), with other steps remaining the same. The purity of the solid detected by HPLC was ≥ 99.91%. Mass spectrum m/z: measured value: 711.2719, and theoretical value: 711.2706. Theoretical element content (%) of C₄₉H₃₇N₃OSi: C, 82.67; H, 5.24; N, 5.90. Measured element content (%): C, 82.65; H, 5.28; N, 5.87.

### Synthesis Example 22: Synthesis of Compound 422

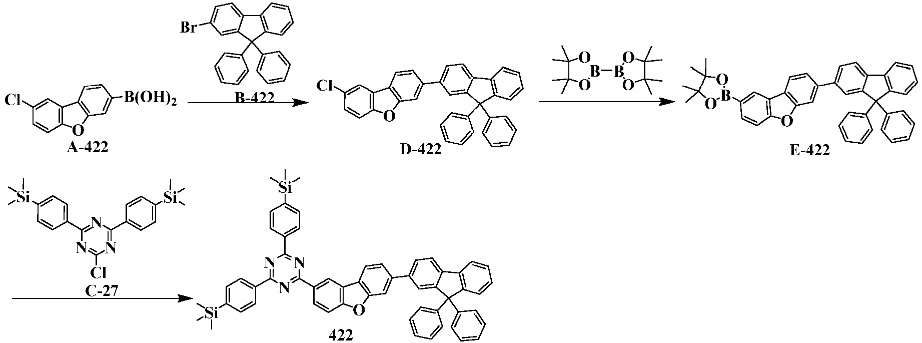

According to the preparation method of Compound 20 in Synthetic Example 2, A-20, B-20 and C-20 were substituted with equimolar A-422, B-422 and C-27 respectively to give Compound 422 (26.23 g), with other steps remaining the same. The purity of the solid detected by HPLC was ≥ 99.85%. Mass spectrum m/z: measured value: 859.3400, and theoretical value: 859.3414. Theoretical element content (%) of C₅₈H₄₉N₃OSi₂: C, 80.98; H, 5.74; N, 4.88. Measured element content (%): C, 80.93; H, 5.78; N, 4.84.

### Synthesis Example 23: Synthesis of Compound 428

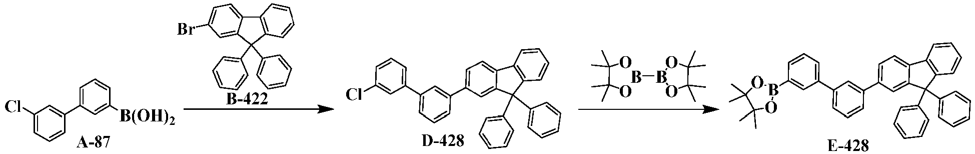

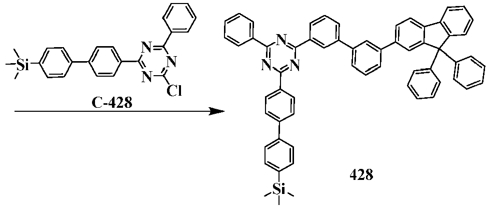

According to the preparation method of Compound 20 in Synthetic Example 2, A-20, B-20 and C-20 were substituted with equimolar A-87, B-422 and C-428 respectively to give Compound 428 (27.21 g), with other steps remaining the same. The purity of the solid detected by HPLC was ≥ 99.95%. Mass spectrum m/z: measured value: 849.3553, and theoretical value: 849.3539. Theoretical element content (%) of C₆₁H₄₇N₃Si: C, 86.18; H, 5.57; N, 4.94. Measured element content (%): C, 86.20; H, 5.55; N, 4.90.

### Synthesis Example 24: Synthesis of Compound 431

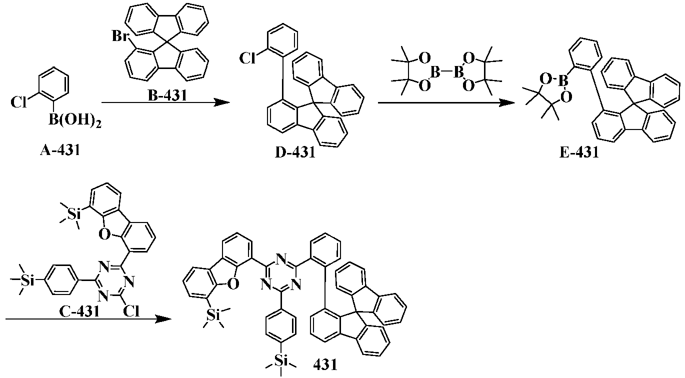

According to the preparation method of Compound 20 in Synthetic Example 2, A-20, B-20 and C-20 were substituted with equimolar A-431, B-431 and C-431 respectively to give Compound 431 (25.74 g), with other steps remaining the same. The purity of the solid detected by HPLC was ≥ 99.84%. Mass spectrum m/z: measured value: 857.3277, and theoretical value: 857.3258. Theoretical element content (%) of C₅₈H₄₇N₃OSi₂: C, 81.17; H, 5.52; N, 4.90. Measured element content (%): C, 81.20; H, 5.50; N, 4.94.

### Synthesis Example 25: Synthesis of Compound 432

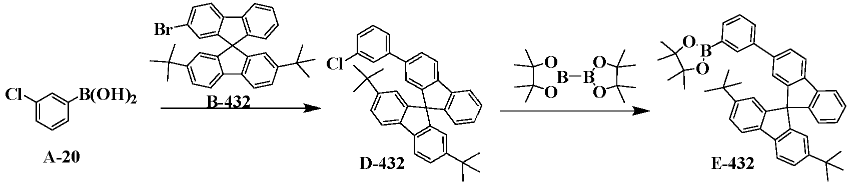

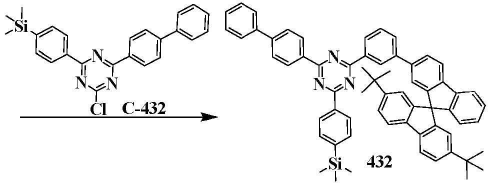

According to the preparation method of Compound 20 in Synthetic Example 2, B-20 and C-20 were substituted with equimolar B-432 and C-432 respectively to give Compound 432 (26.53 g), with other steps remaining the same. The purity of the solid detected by HPLC was ≥ 99.87%. Mass spectrum m/z: measured value: 883.4308, and theoretical value: 883.4322. Theoretical element content (%) of C₆₃H₅₇N₃Si: C, 85.57; H, 6.50; N, 4.75. Measured element content (%): C, 85.52; H, 6.53; N, 4.78.

### Synthesis Example 26: Synthesis of Compound 446

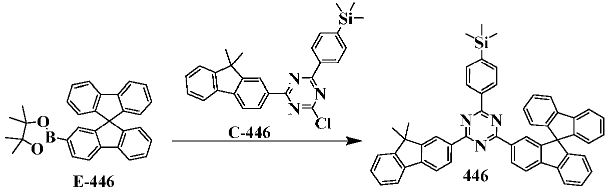

According to the preparation method of Compound 20 in Synthetic Example 2, E-20 and C-20 were substituted with equimolar E-446 and C-446 respectively to give Compound 446 (23.64 g), with other steps remaining the same. The purity of the solid detected by HPLC was ≥ 99.86%. Mass spectrum m/z: measured value: 735.3088, and theoretical value: 735.3070. Theoretical element content (%) of C₅₂H₄₁N₃Si: C, 84.86; H, 5.62; N, 5.71. Measured element content (%): C, 84.88; H, 5.59; N, 5.75.

### Synthesis Example 27: Synthesis of Compound 456

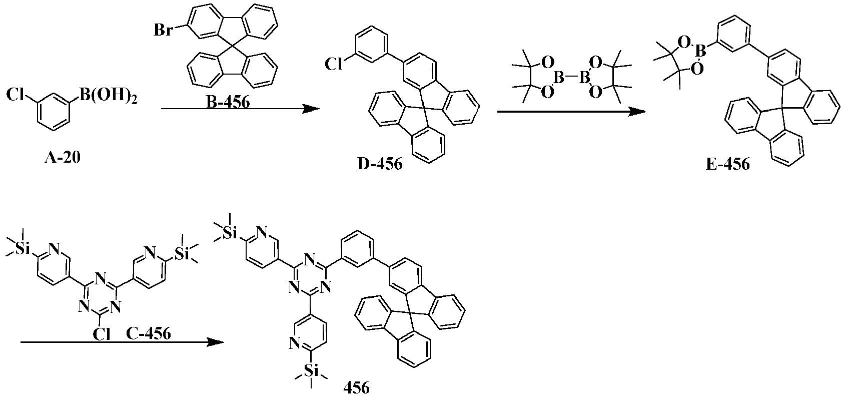

According to the preparation method of Compound 20 in Synthetic Example 2, B-20 and C-20 were substituted with equimolar B-456 and C-456 respectively to give Compound 456 (24.64 g), with other steps remaining the same. The purity of the solid detected by HPLC was ≥ 99.93%. Mass spectrum m/z: measured value: 769.3070, and theoretical value: 769.3057. Theoretical element content (%) of C₅₀H₄₃N₅Si₂: C, 77.98; H, 5.63; N, 9.09. Measured element content (%): C, 77.95; H, 5.66; N, 9.13.

### Synthesis Example 28: Synthesis of Compound 466

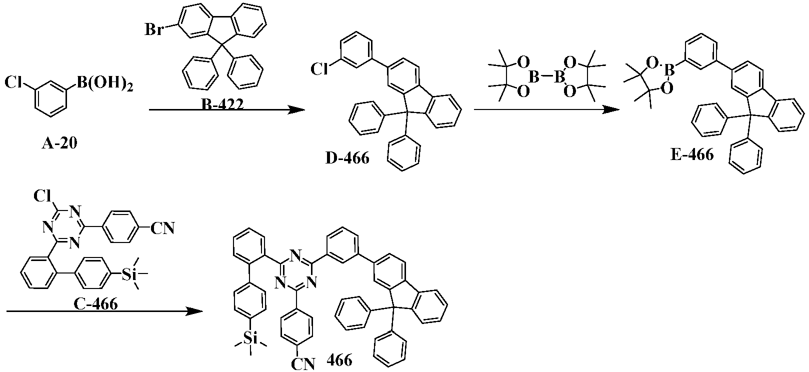

According to the preparation method of Compound 20 in Synthetic Example 2, B-20 and C-20 were substituted with equimolar B-422 and C-466 respectively to give Compound 466 (25.28 g), with other steps remaining the same. The purity of the solid detected by HPLC was ≥ 99.94%. Mass spectrum m/z: measured value: 798.3190, and theoretical value: 798.3179. Theoretical element content (%) of C₅₆H₄₂N₄Si: C, 84.18; H, 5.30; N, 7.01. Measured element content (%): C, 84.14; H, 5.27; N, 7.06.

### Synthesis Example 29: Synthesis of Compound 479

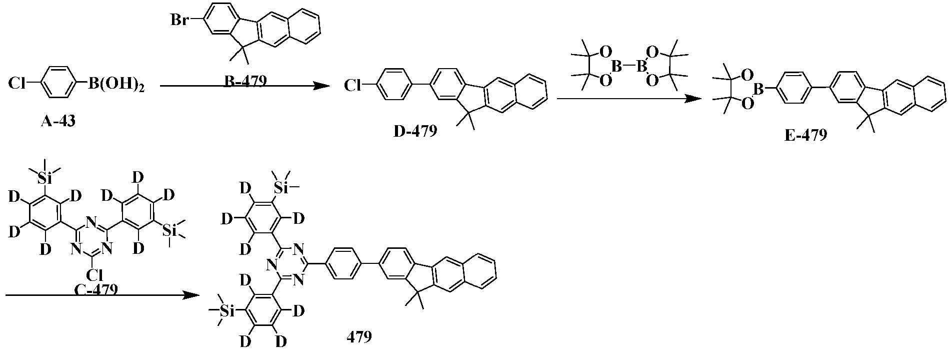

According to the preparation method of Compound 20 in Synthetic Example 2, A-20, B-20 and C-20 were substituted with equimolar A-43, B-479 and C-479 respectively to give Compound 479 (22.28 g), with other steps remaining the same. The purity of the solid detected by HPLC was ≥ 99.87%. Mass spectrum m/z: measured value: 703.3642, and theoretical value: 703.3654. Theoretical element content (%) of C₄₆H₃₇D₈N₃Si₂: C, 78.47; H, 7.59; N, 5.97. Measured element content (%): C, 78.49; H, 7.63; N, 5.92.

### Synthesis Example 30: Synthesis of Compound 483

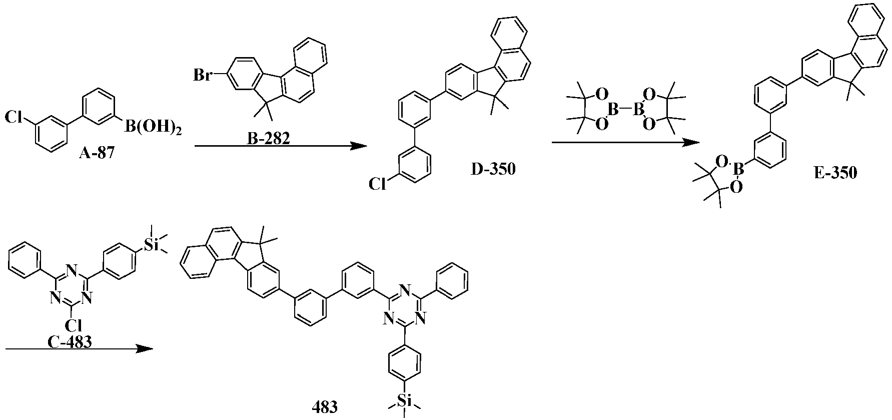

According to the preparation method of Compound 20 in Synthetic Example 2, A-20, B-20 and C-20 were substituted with equimolar A-87, B-282 and C-483 respectively to give Compound 483 (22.36 g), with other steps remaining the same. The purity of the solid detected by HPLC was ≥ 99.90%. Mass spectrum m/z: measured value: 699.3055, and theoretical value: 699.3070. Theoretical element content (%) of C₄₉H₄₁N₃Si: C, 84.08; H, 5.90; N, 6.00. Measured element content (%): C, 84.12; H, 5.95; N, 6.04.

### Synthesis Example 31: Synthesis of Compound 489

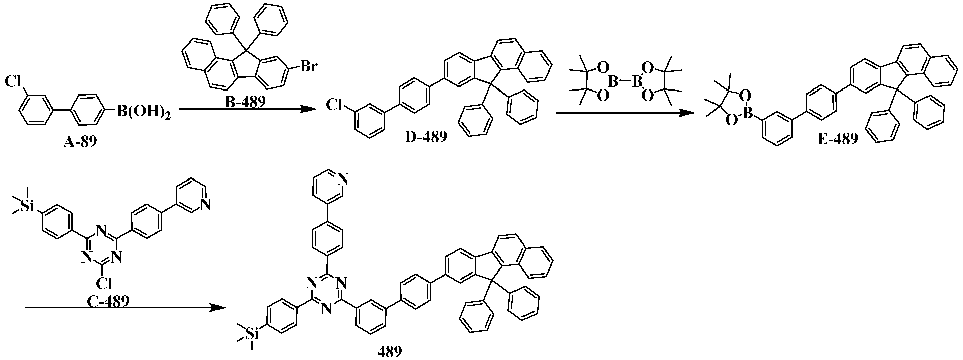

According to the preparation method of Compound 20 in Synthetic Example 2, A-20, B-20 and C-20 were substituted with equimolar A-89, B-489 and C-489 respectively to give Compound 489 (27.58 g), with other steps remaining the same. The purity of the solid detected by HPLC was ≥ 99.89%. Mass spectrum m/z: measured value: 900.3632, and theoretical value: 900.3648. Theoretical element content (%) of C₆₄H₄₈N₄Si: C, 85.30; H, 5.37; N, 6.22. Measured element content (%): C, 85.35; H, 5.33; N, 6.25.

### Synthesis Example 32: Synthesis of Compound 493

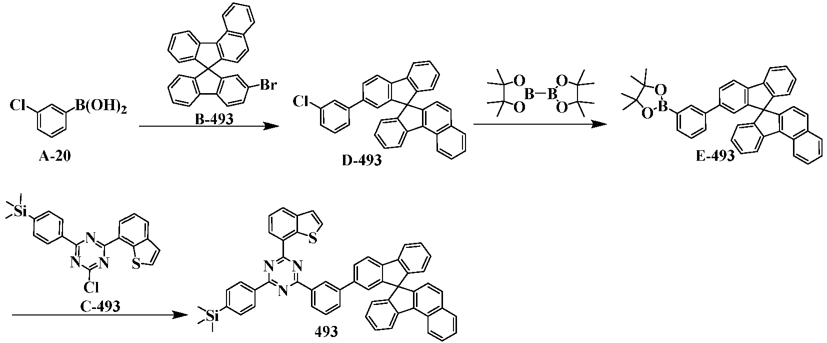

According to the preparation method of Compound 20 in Synthetic Example 2, B-20 and C-20 were substituted with equimolar B-493 and C-493 respectively to give Compound 493 (24.98 g), with other steps remaining the same. The purity of the solid detected by HPLC was ≥ 99.94%. Mass spectrum m/z: measured value: 801.2615, and theoretical value: 801.2634. Theoretical element content (%) of C₅₅H₃₉N₃SSi: C, 82.36; H, 4.90; N, 5.24. Measured element content (%): C, 82.32; H, 4.94; N, 5.27.

### Synthesis Example 33: Synthesis of Compound 494

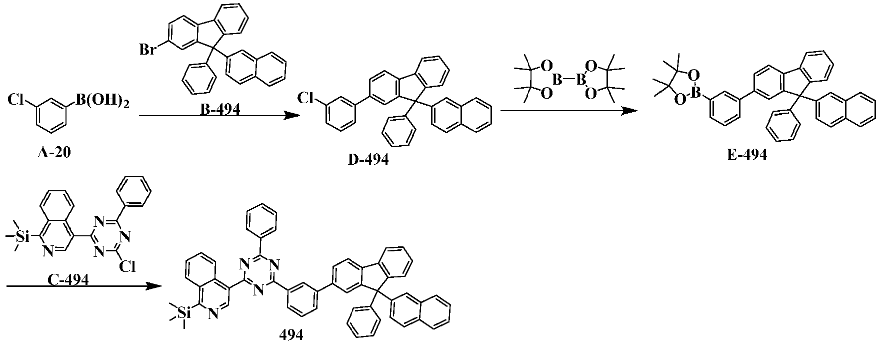

According to the preparation method of Compound 20 in Synthetic Example 2, B-20 and C-20 were substituted with equimolar B-494 and C-494 respectively to give Compound 494 (24.72 g), with other steps remaining the same. The purity of the solid detected by HPLC was ≥ 99.82%. Mass spectrum m/z: measured value: 798.3152, and theoretical value: 798.3179. Theoretical element content (%) of C₅₆H₄₂N₄Si: C, 84.18; H, 5.30; N, 7.01. Measured element content (%): C, 84.20; H, 5.35; N, 7.04.

### Synthesis Example 34: Synthesis of Compound 500

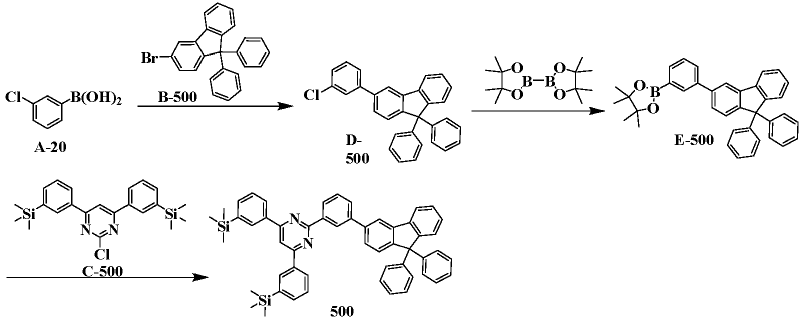

According to the preparation method of Compound 20 in Synthetic Example 2, B-20 and C-20 were substituted with equimolar B-500 and C-500 respectively to give Compound 500 (24.60 g), with other steps remaining the same. The purity of the solid detected by HPLC was ≥ 99.93%. Mass spectrum m/z: measured value: 768.3365, and theoretical value: 768.3356. Theoretical element content (%) of C₅₃H₄₈N₂Si₂: C, 82.76; H, 6.29; N, 3.64. Measured element content (%): C, 82.72; H, 6.33; N, 3.60.

### Synthesis Example 35: Synthesis of Compound 522

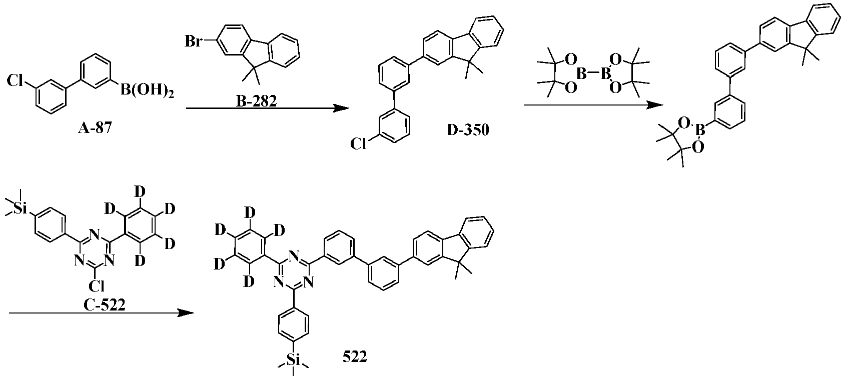

According to the preparation method of Compound 20 in Synthetic Example 2, A-20, B-20 and C-20 were substituted with equimolar A-87, B-282 and C-522 respectively to give Compound 522 (21.41 g), with other steps remaining the same. The purity of the solid detected by HPLC was ≥ 99.98%. Mass spectrum m/z: measured value: 654.3240, and theoretical value: 654.3227. Theoretical element content (%) of C₄₅H₃₄D₅N₃Si: C, 82.53; H, 6.77; N, 6.42. Measured element content (%): C, 82.55; H, 6.72; N, 6.39.

### Synthesis Example 36: Synthesis of Compound 525

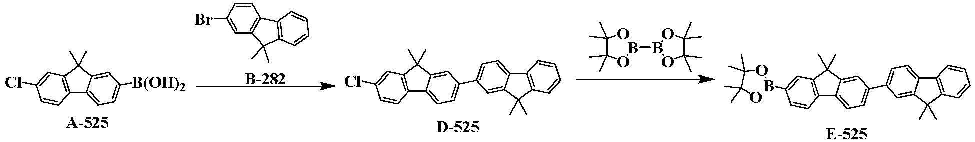

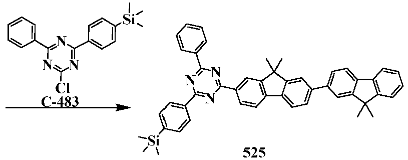

According to the preparation method of Compound 20 in Synthetic Example 2, A-20, B-20 and C-20 were substituted with equimolar A-525, B-282 and C-483 respectively to give Compound 525 (21.32 g), with other steps remaining the same. The purity of the solid detected by HPLC was ≥ 99.90%. Mass spectrum m/z: measured value: 689.3220, and theoretical value: 689.3226. Theoretical element content (%) of C₄₈H₄₃N₃Si: C, 83.56; H, 6.28; N, 6.09. Measured element content (%): C, 83.55; H, 6.30; N, 6.05.

### Synthesis Example 37: Synthesis of Compound 534

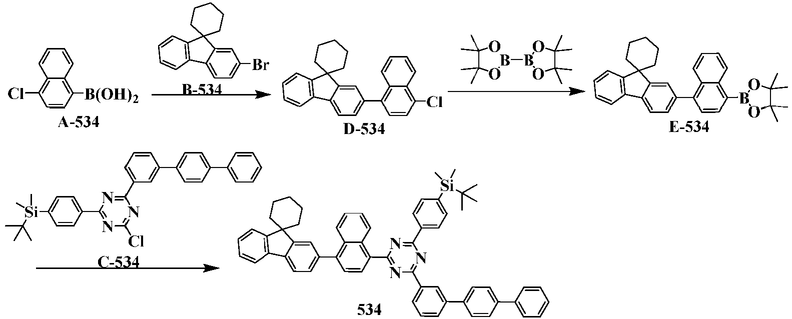

According to the preparation method of Compound 20 in Synthetic Example 2, A-20, B-20 and C-20 were substituted with equimolar A-534, B-534 and C-534 respectively to give Compound 534 (26.59 g), with other steps remaining the same. The purity of the solid detected by HPLC was ≥ 99.81%. Mass spectrum m/z: measured value: 857.4154, and theoretical value: 857.4165. Theoretical element content (%) of C₆₁H₅₅N₃Si: C, 85.37; H, 6.46; N, 4.90. Measured element content (%): C, 85.33; H, 6.50; N, 4.92.

### Synthesis Example 38: Synthesis of Compound 536

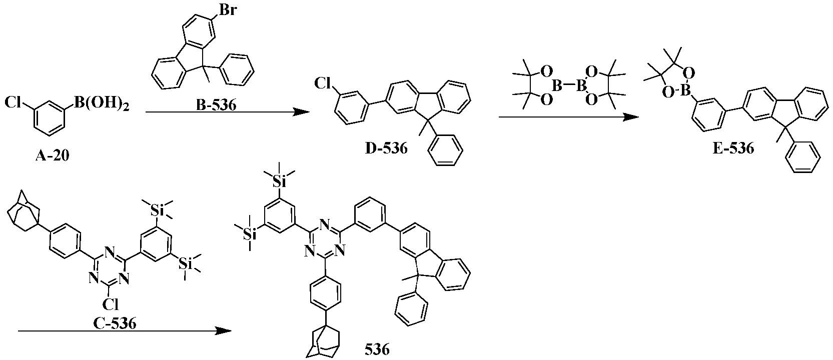

According to the preparation method of Compound 20 in Synthetic Example 2, B-20 and C-20 were substituted with equimolar B-536 and C-536 respectively to give Compound 536 (25.51 g), with other steps remaining the same. The purity of the solid detected by HPLC was ≥ 99.86%. Mass spectrum m/z: measured value: 841.4242, and theoretical value: 841.4248. Theoretical element content (%) of C₅₇H₅₉N₃Si₂: C, 81.28; H, 7.06; N, 4.99. Measured element content (%): C, 81.31; H, 7.04; N, 5.02.

### Synthesis Example 39: Synthesis of Compound 538

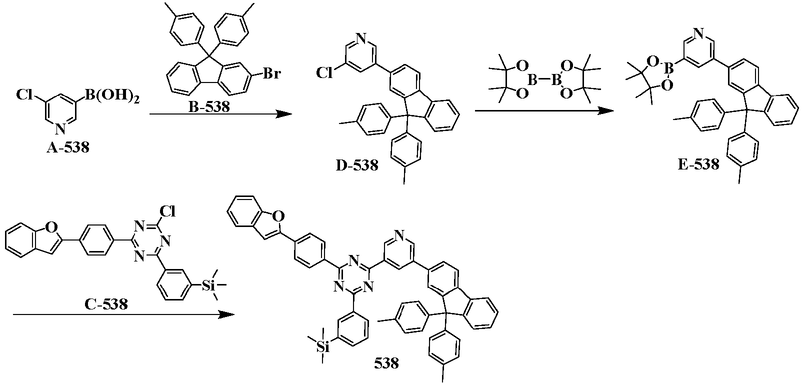

According to the preparation method of Compound 20 in Synthetic Example 2, A-20, B-20 and C-20 were substituted with equimolar A-538, B-538 and C-538 respectively to give Compound 538 (25.27 g), with other steps remaining the same. The purity of the solid detected by HPLC was ≥ 99.84%. Mass spectrum m/z: measured value: 842.3456, and theoretical value: 842.3441. Theoretical element content (%) of C₅₈H₄₆N₄OSi: C, 82.63; H, 5.50; N, 6.65. Measured element content (%): C, 82.60; H, 5.51; N, 6.63.

### Synthesis Example 40: Synthesis of Compound 540

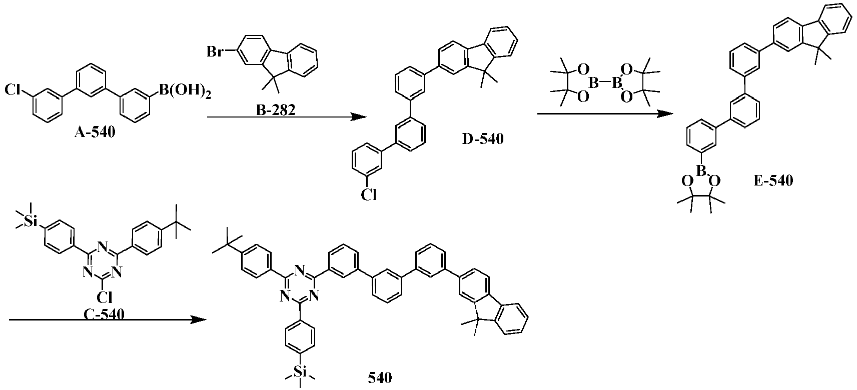

According to the preparation method of Compound 20 in Synthetic Example 2, A-20, B-20 and C-20 were substituted with equimolar A-540, B-282 and C-540 respectively to give Compound 540 (25.02 g), with other steps remaining the same. The purity of the solid detected by HPLC was ≥ 99.90%. Mass spectrum m/z: measured value: 781.3870, and theoretical value: 781.3852. Theoretical element content (%) of C₅₅H₅₁N₃Si: C, 84.46; H, 6.57; N, 5.37. Measured element content (%): C, 84.50; H, 6.52; N, 5.34

### Device Example

Test method: The drive voltage and luminescence efficiency were tested using a combined IVL test system composed of test software, a computer, a K2400 digital source meter produced by KEITHLEY, USA, and a PR788 spectral scanning photometer produced by PHOTO RESEARCH, USA. The lifetime was tested using an M6000 OLED lifetime test system produced by MCSCIENCE. The test was conducted in an atmospheric environment and at room temperature.

The materials used in preparing the organic electroluminescent devices and comparative devices are as follows:

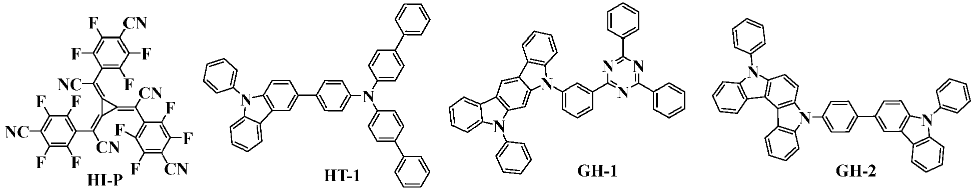

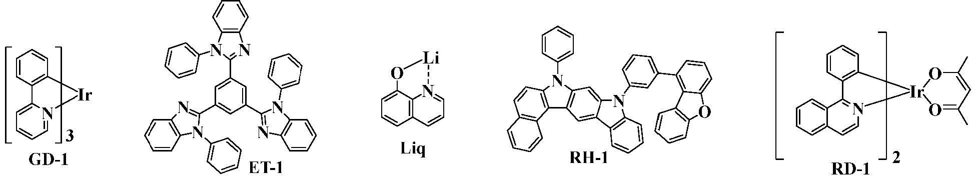

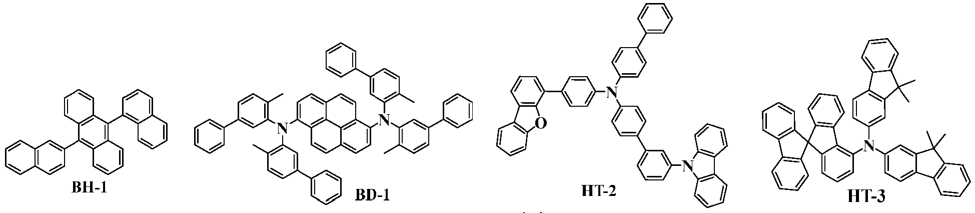

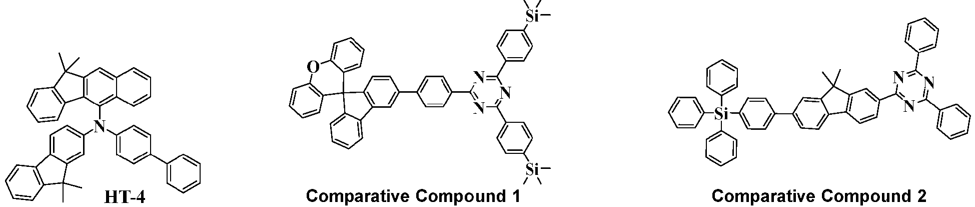

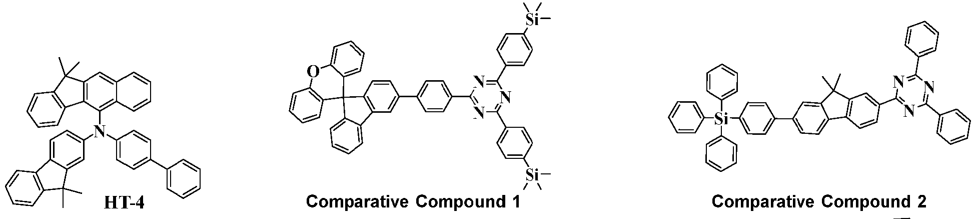

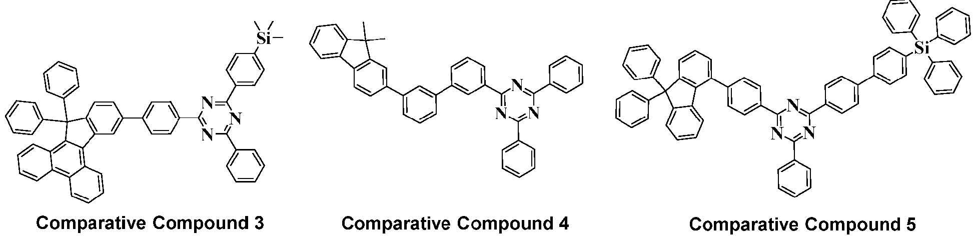

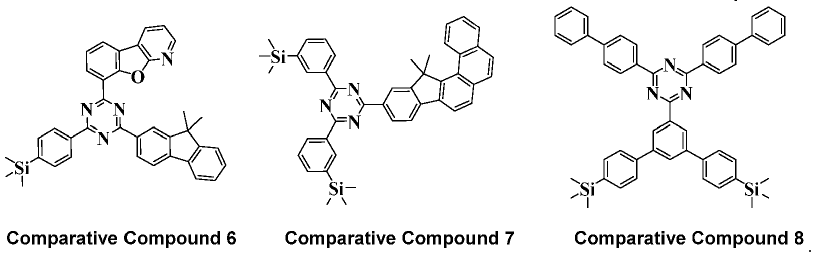

### Device Example 1: Preparation of green organic electroluminescent device

An ITO transparent glass substrate was subjected to ultrasonic cleaning twice with 5% glass cleaning liquid for 20 minutes each time and then subjected to ultrasonic cleaning twice with deionized water for 10 minutes each time. The glass substrate was subjected to ultrasonic cleaning with acetone and isoacetone sequentially for 20 minutes and dried at 120 °C. All organic materials were sublimated, whose purity was 99.99% or above. A mixture of HI-P and HT-1 (at a mass ratio of 3:97) was vacuum-evaporated on the ITO transparent glass substrate to form a hole injection layer with an evaporation thickness of 10 nm; HT-1 was vacuum-evaporated on the hole injection layer to form a hole transport layer with an evaporation thickness of 120 nm; HT-3 was evaporated on the hole transport layer to form a light-emitting auxiliary layer with an evaporation thickness of 40 nm; a mixture of GH-2, GH-1 and GD-1 (at a mass ratio of 47:47:6) was evaporated on the light-emitting auxiliary layer to form a light-emitting layer with an evaporation thickness of 40 nm; a mixture of Compound 20 of the present disclosure and Liq (at a mass ratio of 1:1) was vacuum-evaporated on the light-emitting layer to form an electron transport layer with an evaporation thickness of 30 nm; LiF was evaporated to form an electron injection layer with an evaporation thickness of 1 nm; Al was vacuum-evaporated on the electron injection layer to form a cathode with an evaporation thickness of 130 nm.

### Device Examples 2 to 20: Preparation of green organic electroluminescent device

Compound 20 in Device Example 1 was substituted with Compound 27, Compound 54, Compound 188, Compound 279, Compound 282, Compound 304, Compound 307, Compound 327, Compound 328, Compound 350, Compound 411, Compound 422, Compound 431, Compound 456, Compound 483, Compound 489, Compound 500, Compound 534 and Compound 540 of the present disclosure as the electron transport layer, with other preparation processes remaining completely the same, to prepare organic electroluminescent devices.

### Device Comparative Examples 1 to 2:

Compound 20 in Device Example 1 was substituted with Comparative Compound 1 and Comparative Compound 2 as the electron transport layer, with other preparation processes remaining completely the same, to prepare organic electroluminescent devices.

### Device Example 21: Preparation of green organic electroluminescent device

An ITO transparent glass substrate was subjected to ultrasonic cleaning twice with 5% glass cleaning liquid for 20 minutes each time and then subjected to ultrasonic cleaning twice with deionized water for 10 minutes each time. The glass substrate was subjected to ultrasonic cleaning with acetone and isoacetone sequentially for 20 minutes and dried at 120 °C. All organic materials were sublimated, whose purity was 99.99% or above. A mixture of HI-P and HT-1 (at a mass ratio of 3:97) was vacuum-evaporated on the ITO transparent glass substrate to form a hole injection layer with an evaporation thickness of 10 nm; HT-1 was vacuum-evaporated on the hole injection layer to form a hole transport layer with an evaporation thickness of 120 nm; HT-3 was evaporated on the hole transport layer to form a light-emitting auxiliary layer with an evaporation thickness of 40 nm; a mixture of GH-2, GH-1 and GD-1 (at a mass ratio of 47:47:6) was evaporated on the light-emitting auxiliary layer to form a light-emitting layer with an evaporation thickness of 40 nm; Compound 20 of the present disclosure was vacuum-evaporated on the light-emitting layer to form a hole blocking layer with an evaporation thickness of 10 nm; a mixture of ET-1 and Liq (at a mass ratio of 1:1) was evaporated on the hole blocking layer to form an electron transport layer with an evaporation thickness of 30 nm; LiF was evaporated to form an electron injection layer with an evaporation thickness of 1 nm; Al was vacuum-evaporated on the electron injection layer to form a cathode with an evaporation thickness of 130 nm.

### Device Examples 22 to 40: Preparation of green organic electroluminescent device

Compound 20 in Device Example 1 was substituted with Compound 43, Compound 87, Compound 124, Compound 202, Compound 282, Compound 350, Compound 378, Compound 397, Compound 411, Compound 428, Compound 432, Compound 446, Compound 466, Compound 479, Compound 489, Compound 493, Compound 522, Compound 525 and Compound 536 of the present disclosure as the hole blocking layer, with other preparation processes remaining completely the same, to prepare organic electroluminescent devices.

### Comparative Device Examples 3 to 4:

Compound 20 in Device Example 1 was substituted with Comparative Compound 3 and Comparative Compound 4, with other preparation processes remaining completely the same, to prepare organic electroluminescent devices.

**Table 1: Luminescence property test data of the organic electroluminescent devices prepared in Device Examples 1 to 40 and Device Comparative Examples 1 to 4**

| Example | Electron transport layer material | Hole blocking layer material | Voltage [V] (@ 10 mA/cm²) | Luminescence efficiency [cd/A] (@ 10 mA/cm²) | Lifetime [T95, h] (@ 10 mA/cm²) |
|---|---|---|---|---|---|
| Device Example 1 | Compound 20:Liq | - | 4.8 | 63.8 | 273 |
| Device Example 2 | Compound 27:Liq | - | 4.6 | 64.9 | 273 |
| Device Example 3 | Compound 54:Liq | - | 4.7 | 65.3 | 276 |
| Device Example 4 | Compound 188:Liq | - | 4.7 | 64.4 | 275 |
| Device Example 5 | Compound 279:Liq | - | 4.8 | 63.6 | 272 |
| Device Example 6 | Compound 282:Liq | - | 4.5 | 61.7 | 269 |
| Device Example 7 | Compound 304:Liq | - | 4.8 | 59.9 | 265 |
| Device Example 8 | Compound 307:Liq | - | 4.5 | 65.5 | 278 |
| Device Example 9 | Compound 327:Liq | - | 4.7 | 60.8 | 267 |
| Device Example 10 | Compound 328:Liq | - | 4.7 | 59.6 | 264 |
| Device Example 11 | Compound 350:Liq | - | 4.6 | 62.7 | 275 |
| Device Example 12 | Compound 411:Liq | - | 4.6 | 58.7 | 264 |
| Device Example 13 | Compound 422:Liq | - | 4.8 | 63.0 | 270 |
| Device Example 14 | Compound 431:Liq | - | 4.7 | 62.6 | 271 |
| Device Example 15 | Compound 456:Liq | - | 4.7 | 62.3 | 271 |
| Device Example 16 | Compound 483:Liq | - | 4.8 | 60.2 | 265 |
| Device Example 17 | Compound 489:Liq | - | 4.9 | 60.6 | 266 |
| Device Example 18 | Compound 500:Liq | - | 4.6 | 61.5 | 268 |
| Device Example 19 | Compound 534:Liq | - | 4.9 | 59.1 | 263 |
| Device Example 20 | Compound 540:Liq | - | 4.8 | 61.2 | 270 |
| Device Example 21 | ET-1:Liq | Compound 20 | 4.6 | 73.0 | 325 |
| Device Example 22 | ET-1:Liq | Compound 43 | 4.5 | 72.8 | 324 |
| Device Example 23 | ET-1:Liq | Compound 87 | 4.5 | 74.0 | 331 |
| Device Example 24 | ET-1:Liq | Compound 124 | 4.7 | 73.7 | 331 |
| Device Example 25 | ET-1:Liq | Compound 202 | 4.6 | 73.3 | 329 |
| Device Example 26 | ET-1:Liq | Compound 282 | 4.4 | 72.0 | 323 |
| Device Example 27 | ET-1:Liq | Compound 350 | 4.4 | 72.3 | 328 |
| Device Example 28 | ET-1:Liq | Compound 378 | 4.6 | 68.2 | 314 |
| Device Example 29 | ET-1:Liq | Compound 397 | 4.6 | 68.8 | 317 |
| Device Example 30 | ET-1:Liq | Compound 411 | 4.4 | 67.5 | 315 |
| Device Example 31 | ET-1:Liq | Compound 428 | 4.6 | 71.3 | 320 |
| Device Example 32 | ET-1:Liq | Compound 432 | 4.7 | 69.4 | 322 |
| Device Example 33 | ET-1:Liq | Compound 446 | 4.5 | 67.0 | 313 |
| Device Example 34 | ET-1:Liq | Compound 466 | 4.5 | 68.5 | 315 |
| Device Example 35 | ET-1:Liq | Compound 479 | 4.7 | 74.4 | 332 |
| Device Example 36 | ET-1:Liq | Compound 489 | 4.7 | 70.2 | 320 |
| Device Example 37 | ET-1:Liq | Compound 493 | 4.7 | 67.6 | 318 |
| Device Example 38 | ET-1:Liq | Compound 522 | 4.5 | 74.7 | 334 |
| Device Example 39 | ET-1:Liq | Compound 525 | 4.5 | 69.8 | 319 |
| Device Example 40 | ET-1:Liq | Compound 536 | 4.6 | 71.8 | 321 |
| Comparative Example 1 | Comparative Compound 1:Liq | - | 5.2 | 48.5 | 205 |
| Comparative Example 2 | Comparative Compound 2:Liq | - | 5.0 | 47.6 | 201 |
| Comparative Example 3 | ET-1:Liq | Comparative Compound 3 | 5.1 | 52.8 | 234 |
| Comparative Example 4 | ET-1:Liq | Comparative Compound 4 | 4.7 | 50.6 | 227 |

As can be known from the results in Table 1, the fluorene-containing heterocyclic compound of the present disclosure has high electron mobility and suitable HOMO and LUMO energy levels and thus can improve the electron transport rate and block the holes from migrating to the side of the electron transport layer, and when the fluorene-containing heterocyclic compound is applied to the organic electroluminescent device, the potential barrier between electron injection and transport can be reduced, the driving voltage can be reduced, and the rise of power consumption of the device under a high local voltage can be avoided, thereby extending the lifetime of the device, increasing the recombination efficiency of holes and electrons, and improving the luminescence efficiency of the organic electroluminescent device.

### Device Example 41: Preparation of red organic electroluminescent device

A mixture of HI-P and HT-1 (at a mass ratio of 3:97) was vacuum-evaporated on the ITO transparent glass substrate to form a hole injection layer with an evaporation thickness of 10 nm; HT-1 was vacuum-evaporated on the hole injection layer to form a hole transport layer with an evaporation thickness of 120 nm; HT-3 was vacuum-evaporated on the hole transport layer to form a light-emitting auxiliary layer with an evaporation thickness of 70 nm; a mixture of Compound 20 of the present disclosure, RH-1, and RD-1 (at a mass ratio of 48:48:4) was evaporated on the light-emitting auxiliary layer to form a light-emitting layer with an evaporation thickness of 40 nm; a mixture of ET-1 and Liq (at a mass ratio of 1:1) was vacuum-evaporated on the light-emitting layer to form an electron transport layer with an evaporation thickness of 30 nm; LiF was evaporated to form an electron injection layer with an evaporation thickness of 1 nm; Al was vacuum-evaporated on the electron injection layer to form a cathode with an evaporation thickness of 130 nm.

### Device Examples 42 to 79: Preparation of red organic electroluminescent device

Compound 20 in Device Example 41 was substituted with Compound 27, Compound 43, Compound 54, Compound 87, Compound 124, Compound 188, Compound 202, Compound 227, Compound 279, Compound 282, Compound 304, Compound 307, Compound 310, Compound 327, Compound 328, Compound 350, Compound 378, Compound 397, Compound 411, Compound 422, Compound 428, Compound 431, Compound 432, Compound 446, Compound 456, Compound 466, Compound 479, Compound 483, Compound 489, Compound 493, Compound 494, Compound 500, Compound 522, Compound 525, Compound 534, Compound 536, Compound 538 and Compound 540 of the present disclosure as the red host material, with other preparation processes remaining completely the same, to prepare organic electroluminescent devices.

### Device Comparative Examples 5 to 7:

Compound 20 in Device Example 41 was substituted with Comparative Compound 5, Comparative Compound 6, and Comparative Compound 7 as the red host material, with other preparation processes remaining completely the same, to prepare organic electroluminescent devices.

**Table 2: Luminescence property test data of the organic electroluminescent devices prepared in Device Examples 41 to 79 and Device Comparative Examples 5 to 7**

| Example | Light-emitting layer host material | Voltage [V] (@ 10 mA/cm²) | Luminescence efficiency [cd/A] (@ 10 mA/cm²) | Lifetime [T95, h] (@ 10 mA/cm²) |
|---|---|---|---|---|
| Device Example 41 | Compound 20:RH-1 | 4.3 | 39.3 | 298 |
| Device Example 42 | Compound 27:RH-1 | 4.3 | 41.0 | 305 |
| Device Example 43 | Compound 43:RH-1 | 4.4 | 38.7 | 294 |
| Device Example 44 | Compound 54:RH-1 | 4.5 | 41.4 | 299 |
| Device Example 45 | Compound 87:RH-1 | 4.3 | 40.8 | 304 |
| Device Example 46 | Compound 124:RH-1 | 4.6 | 40.3 | 302 |
| Device Example 47 | Compound 188:RH-1 | 4.5 | 40.1 | 301 |
| Device Example 48 | Compound 202:RH-1 | 4.4 | 39.7 | 300 |
| Device Example 49 | Compound 227:RH-1 | 4.4 | 38.9 | 299 |
| Device Example 50 | Compound 279:RH-1 | 4.5 | 37.7 | 297 |
| Device Example 51 | Compound 282:RH-1 | 4.3 | 36.6 | 294 |
| Device Example 52 | Compound 304:RH-1 | 4.5 | 33.0 | 279 |
| Device Example 53 | Compound 307:RH-1 | 4.3 | 41.8 | 303 |
| Device Example 54 | Compound 310:RH-1 | 4.5 | 37.1 | 292 |
| Device Example 55 | Compound 327:RH-1 | 4.4 | 33.4 | 281 |
| Device Example 56 | Compound 328:RH-1 | 4.4 | 33.1 | 280 |
| Device Example 57 | Compound 350:RH-1 | 4.5 | 38.0 | 296 |
| Device Example 58 | Compound 378:RH-1 | 4.4 | 32.0 | 275 |
| Device Example 59 | Compound 397:RH-1 | 4.5 | 33.8 | 282 |
| Device Example 60 | Compound 411:RH-1 | 4.4 | 30.6 | 270 |
| Device Example 61 | Compound 422:RH-1 | 4.6 | 38.4 | 297 |
| Device Example 62 | Compound 428:RH-1 | 4.6 | 35.5 | 293 |
| Device Example 63 | Compound 431:RH-1 | 4.6 | 36.8 | 293 |
| Device Example 64 | Compound 432:RH-1 | 4.6 | 34.1 | 288 |
| Device Example 65 | Compound 446:RH-1 | 4.5 | 30.3 | 271 |
| Device Example 66 | Compound 456:RH-1 | 4.5 | 36.2 | 290 |
| Device Example 67 | Compound 466:RH-1 | 4.4 | 32.4 | 277 |
| Device Example 68 | Compound 479:RH-1 | 4.5 | 41.3 | 307 |
| Device Example 69 | Compound 483:RH-1 | 4.4 | 34.6 | 286 |
| Device Example 70 | Compound 489:RH-1 | 4.6 | 34.3 | 284 |
| Device Example 71 | Compound 493:RH-1 | 4.5 | 31.5 | 273 |
| Device Example 72 | Compound 494:RH-1 | 4.6 | 31.0 | 272 |
| Device Example 73 | Compound 500:RH-1 | 4.4 | 34.9 | 287 |
| Device Example 74 | Compound 522:RH-1 | 4.4 | 42.1 | 306 |
| Device Example 75 | Compound 525:RH-1 | 4.3 | 31.9 | 274 |
| Device Example 76 | Compound 534:RH-1 | 4.6 | 31.2 | 273 |
| Device Example 77 | Compound 536:RH-1 | 4.6 | 35.2 | 288 |
| Device Example 78 | Compound 538:RH-1 | 4.5 | 32.7 | 278 |
| Device Example 79 | Compound 540:RH-1 | 4.5 | 35.9 | 298 |
| Comparative Example 5 | Comparative Compound 5:RH-1 | 4.8 | 22.7 | 205 |
| Comparative Example 6 | Comparative Compound 6:RH-1 | 4.7 | 23.9 | 211 |
| Comparative Example 7 | Comparative Compound 7:RH-1 | 5.0 | 25.2 | 220 |

As can be known from the results in Table 2, the fluorene-containing heterocyclic compound provided by the present disclosure has suitable energy levels, can match the energy level of an adjacent functional layer, and thus helps to achieve the balance between the electron and hole transport in the light-emitting layer so that the holes and electrons are effectively recombined in the light-emitting layer, thereby reducing the drive voltage, improving the luminescence efficiency, and extending the lifetime of the device.

### Device Example 80: Preparation of blue organic electroluminescent device

A mixture of HI-P and HT-1 (at a mass ratio of 3:97) was vacuum-evaporated on an ITO/Ag/ITO glass substrate which had been cleaned and dried to form a hole injection layer with an evaporation thickness of 10 nm; HT-1 was vacuum-evaporated on the hole injection layer to form a hole transport layer with an evaporation thickness of 130 nm; HT-2 was evaporated on the hole transport layer to form a light-emitting auxiliary layer with an evaporation thickness of 10 nm; a mixture of BH-1 and BD-1 (at a mass ratio of 98:2) was evaporated on the light-emitting auxiliary layer to form a light-emitting layer with an evaporation thickness of 35 nm; a mixture of ET-1 and Liq (at a mass ratio of 1:1) was vacuum-evaporated on the light-emitting layer to form an electron transport layer with an evaporation thickness of 30 nm; Yb was evaporated to form an electron injection layer with an evaporation thickness of 1 nm; an Mg:Ag alloy (at a mass ratio of 1:9) was vacuum-evaporated on the electron injection layer to form a cathode with an evaporation thickness of 15 nm; Compound 43 of the present disclosure was vacuum-evaporated on the cathode to form a light extraction layer with an evaporation thickness of 70 nm.

### Device Examples 81 to 89: Preparation of blue organic electroluminescent device

Compound 43 in Device Example 80 was substituted with Compound 202, Compound 307, Compound 327, Compound 411, Compound 422, Compound 479, Compound 493, Compound 525 and Compound 538 of the present disclosure as the light extraction layer material, with other preparation processes remaining completely the same, to prepare organic electroluminescent devices.

### Device Comparative Example 8:

Compound 43 in Device Example 80 was substituted with Comparative Compound 8 as the light extraction layer material, with other preparation processes remaining completely the same, to prepare an organic electroluminescent device.

**Table 3: Luminescence property test data of the organic electroluminescent devices prepared in Device Examples 80 to 89 and Device Comparative Example 8**

| Example | Light extraction layer material, | Luminescence efficiency [cd/A] (@ 10 mA/cm²) | Lifetime [T95, h] (@ 10 mA/cm²) |
|---|---|---|---|
| Example 80 | Compound 43 | 9.5 | 168 |
| Example 81 | Compound 202 | 9.1 | 153 |
| Example 82 | Compound 307 | 8.8 | 149 |
| Example 83 | Compound 327 | 9.2 | 158 |
| Example 84 | Compound 411 | 9.5 | 165 |
| Example 85 | Compound 422 | 9.2 | 155 |
| Example 86 | Compound 479 | 8.9 | 150 |
| Example 87 | Compound 493 | 9.3 | 160 |
| Example 88 | Compound 525 | 9.0 | 152 |
| Example 89 | Compound 538 | 9.4 | 163 |
| Comparative Example 8 | Comparative Compound 8 | 7.0 | 115 |

With the comparison with Comparative Compound 8, the fluorene-containing heterocyclic compound provided by the present disclosure has a higher refractive index and a higher glass transition temperature, and when applied to the light extraction layer of the organic electroluminescent device, can improve the luminescence efficiency of the device and extend the lifetime of the device.

## Claims

1. A fluorene-containing heterocyclic compound, having a structure represented by Formula I: 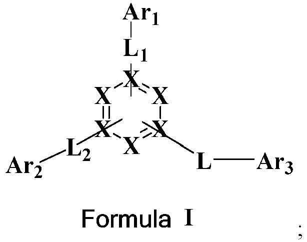
wherein in Formula I, X is independently selected from C(R₀) or an N atom, and at least one of X is selected from an N atom;
R₀ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Ar₃ is selected from a group represented by Formula II-1 or Formula II-2: 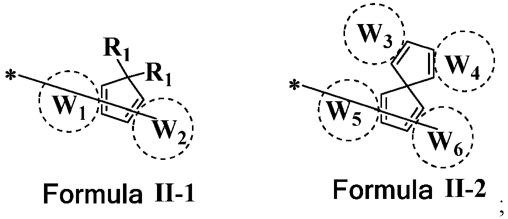
the ring W₁, the ring W₂, the ring W₃, the ring W₄, the ring W₅, and the ring W₆ are independently selected from any one of the following structures: 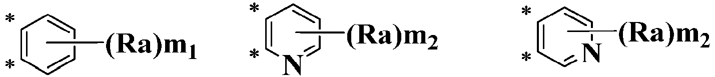 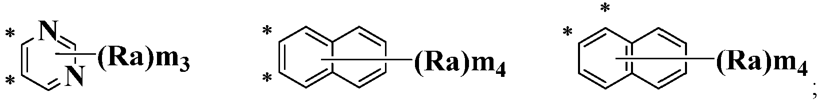
"*" represents a fusion site;
Ra is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
m₁ is independently selected from 0, 1, 2, 3 or 4, m₂ is independently selected from 0, 1, 2 or 3, m₃ is independently selected from 0, 1 or 2, and m₄ is independently selected from 0, 1, 2, 3, 4, 5 or 6;
R₁ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl; or two adjacent R₁ are linked to each other to form a substituted or unsubstituted C3 to C7 aliphatic ring;
L is selected from any one of a single bond, C6 to C30 arylene unsubstituted or substituted by one or more Rb, or C2 to C30 heteroarylene unsubstituted or substituted by one or more Rb;
L₁ and L₂ are independently selected from any one of a single bond, substituted or unsubstituted C6 to C30 arylene, or substituted or unsubstituted C2 to C30 heteroarylene;
Ar₁ and Ar₂ are independently selected from C6 to C30 aryl unsubstituted or substituted by one or more Rc, or is selected from any one of the following groups: 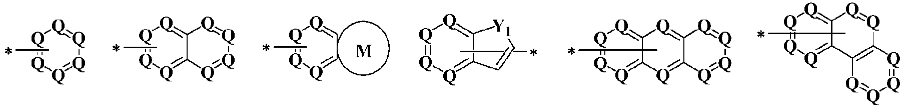 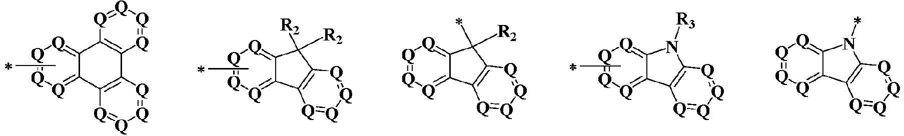 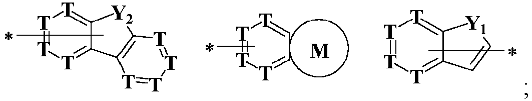
Q is independently selected from C(Rd) or an N atom, and at least one Q in each group is selected from an N atom;
T is independently selected from C(Rd);
the ring M is independently selected from C3 to C7 aliphatic ring unsubstituted or substituted by one or more R₄;
Y₁ is selected from O, S, C(R₅)₂ or N(R₆); Y₂ is selected from an O atom, an S atom or N(R₃);
Rd is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₂, R₄ and R₅ are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
R₃ and R₆ are independently selected from any one of substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
Rb and Rc are independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
with the proviso that at least one of R₁, Ra, Rb, Rc or Rd is selected from a group represented by Formula III: 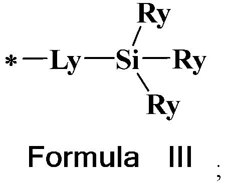
Ry is independently selected from any one of hydrogen, deuterium, cyano, nitro, halogen, substituted or unsubstituted C1 to C12 alkyl, substituted or unsubstituted C2 to C12 alkenyl, substituted or unsubstituted C3 to C12 cycloalkyl, or substituted or unsubstituted C2 to C12 heterocycloalkyl;
Ly is independently selected from any one of a single bond, substituted or unsubstituted C6 to C30 aryl, or substituted or unsubstituted C2 to C30 heteroaryl;
when two or more R₁, Ra, Rb, Rc and Rd are present, the two or more R₁, Ra, Rb, Rc and Rd are identical to each other or different from each other.

2. The fluorene-containing heterocyclic compound according to claim 1, wherein the fluorene-containing heterocyclic compound is selected from any one of the following structures represented by Formulas IV-1 to IV-5: 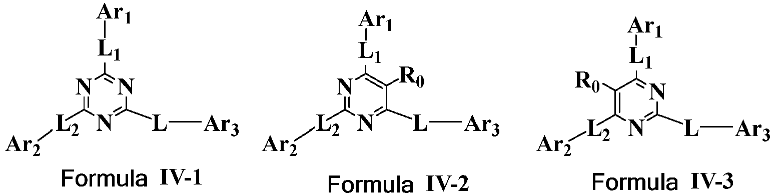 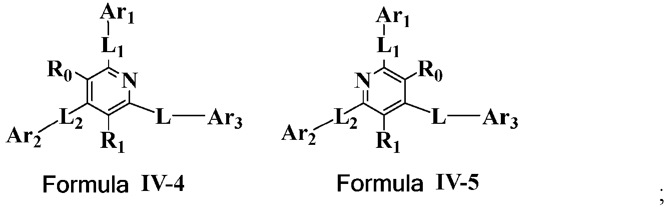 wherein Ar₁, Ar₂, Ar₃, L, L₁, L₂ and R₀ are the same as defined in Formula I.

3. The fluorene-containing heterocyclic compound according to claim 1, wherein Ar₃ is independently selected from any one of the following groups: 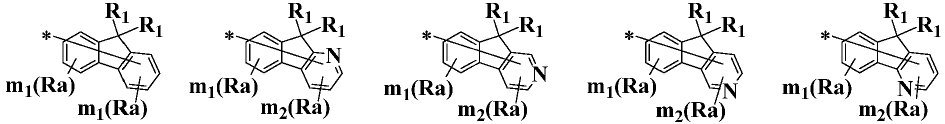 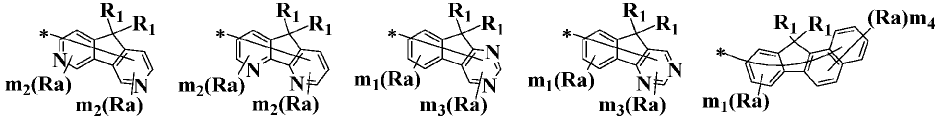 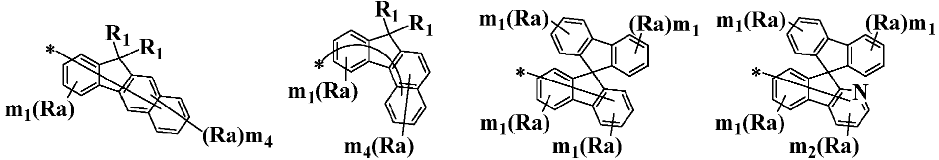 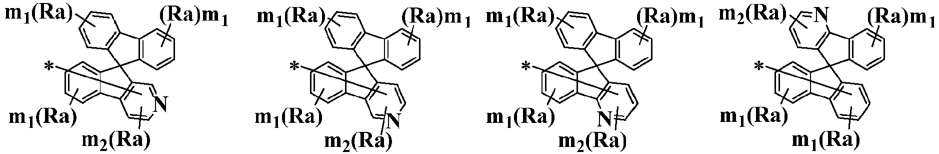 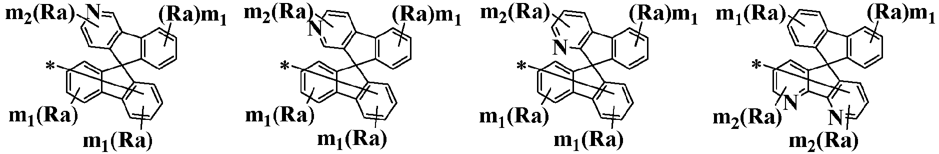 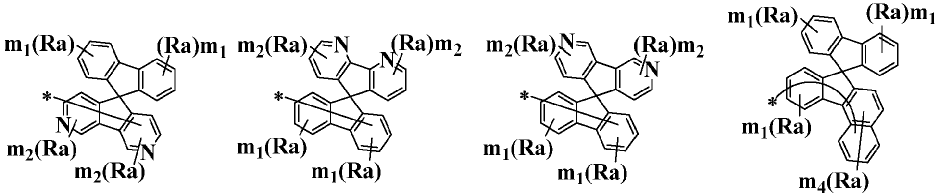 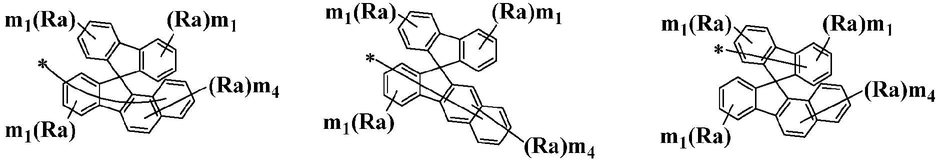 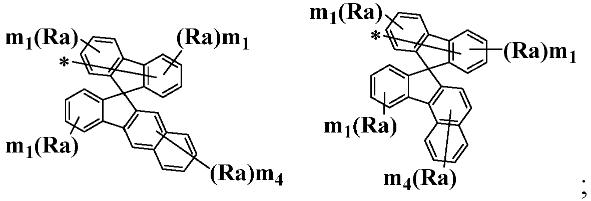
wherein R₁ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl; or two adjacent R₁ are linked to each other to form any one of the following ring groups: 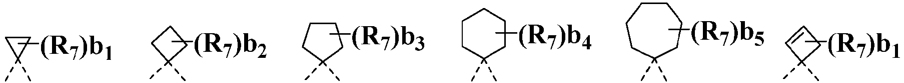 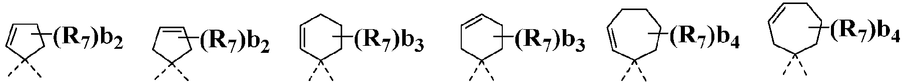 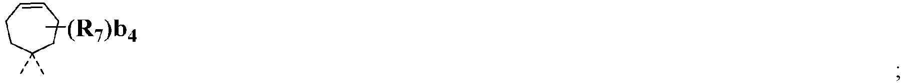
R₇ is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
n₁ is independently selected from 0, 1, 2, 3 or 4, n₂ is independently selected from 0, 1, 2, 3, 4, 5 or 6, n₃ is independently selected from 0, 1, 2, 3, 4, 5, 6, 7 or 8, n₄ is independently selected from 0, 1, 2, 3, 4, 5, 6, 7, 8, 9 or 10, and n₅ is independently selected from 0, 1, 2, 3, 4, 5, 6, 7, 8, 9, 10, 11 or 12;
Ra is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
m₁ is independently selected from 0, 1, 2, 3 or 4, m₂ is independently selected from 0, 1, 2 or 3, m₃ is independently selected from 0, 1 or 2, and m₄ is independently selected from 0, 1, 2, 3, 4, 5 or 6.

4. The fluorene-containing heterocyclic compound according to claim 1, wherein at least one of Ra, Rc or Rd is selected from a group represented by Formula III, and when two or more Ra, Rc and Rd are present, the two or more Ra, Rc and Rd are identical to or different from each other.

5. The fluorene-containing heterocyclic compound according to claim 1, wherein Formula III is selected from any one of the following groups:

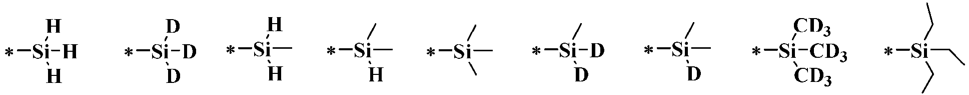

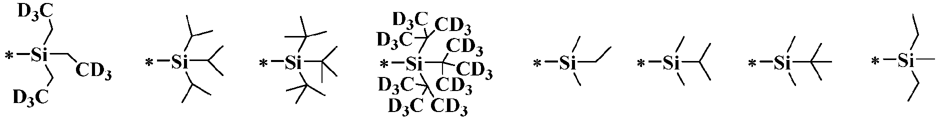

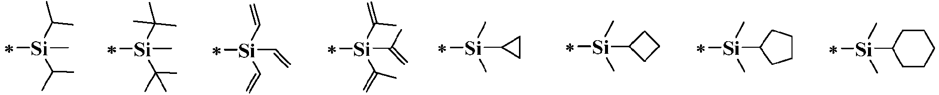

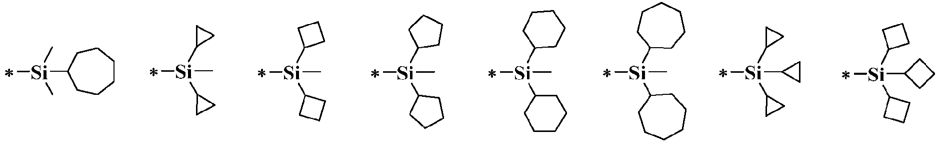

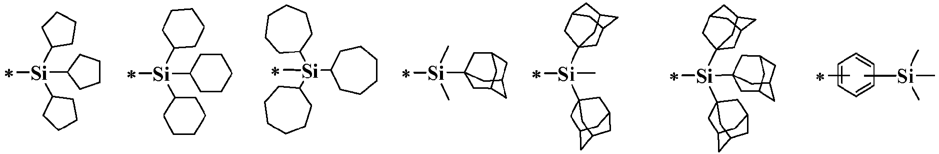

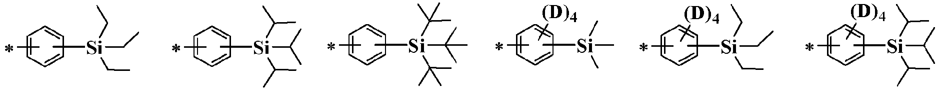

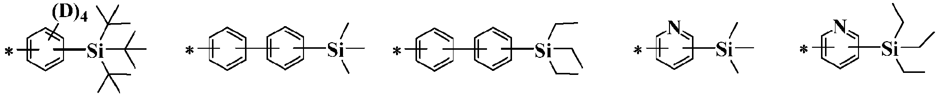

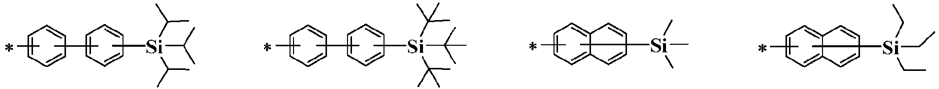

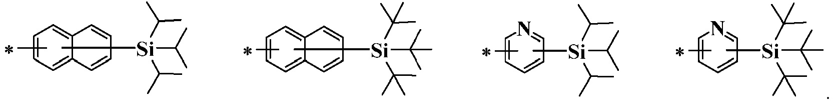

6. The fluorene-containing heterocyclic compound according to claim 1, wherein Ar₁ and Ar₂ are independently selected from any one of the following groups: 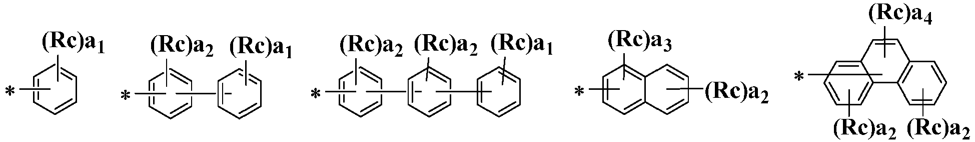 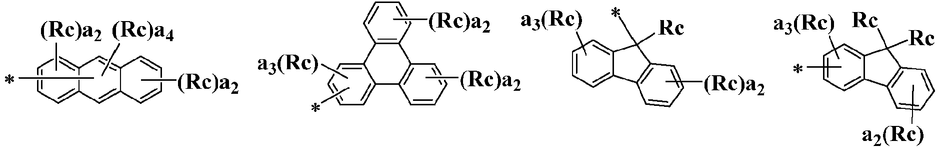 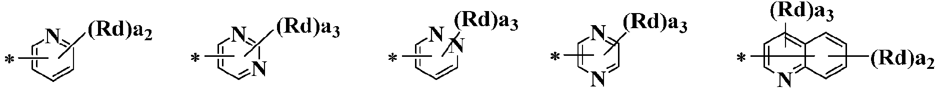 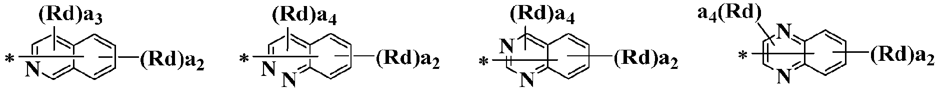 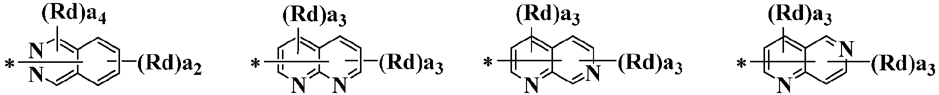 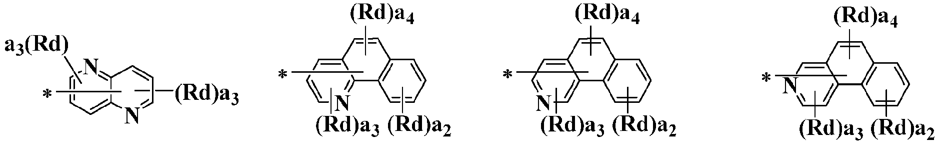 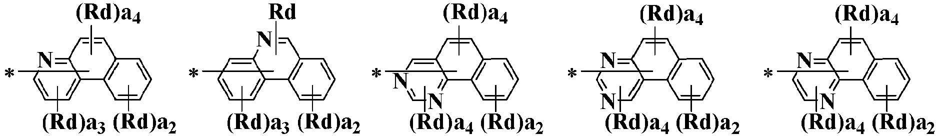 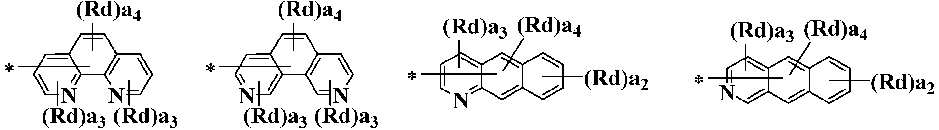 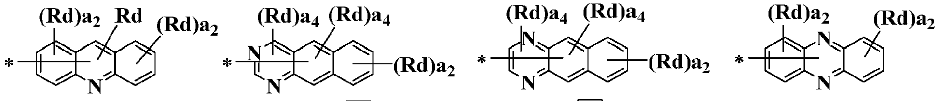 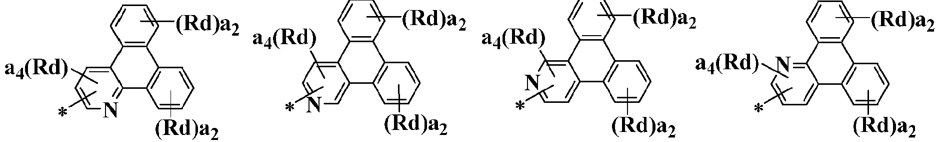 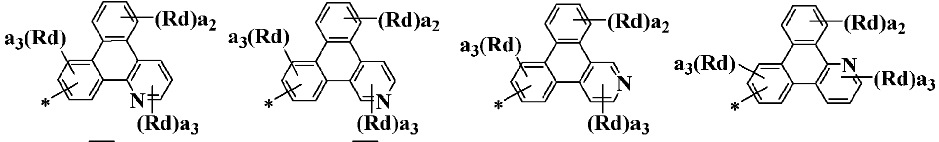 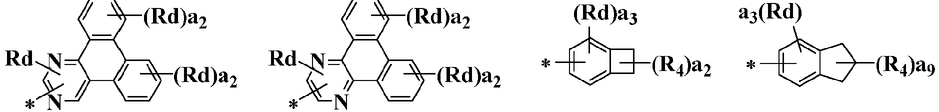 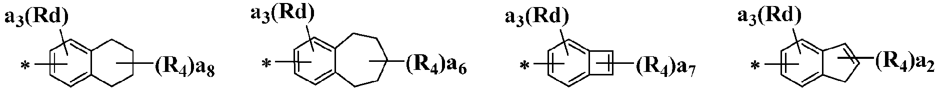 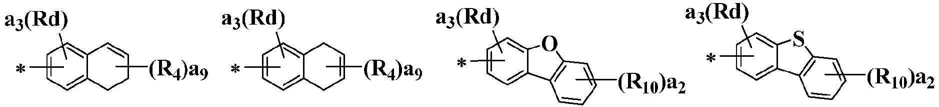 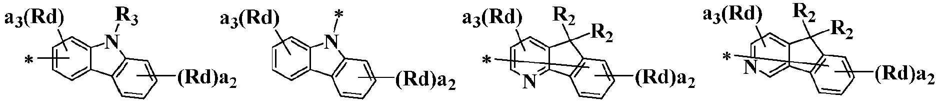 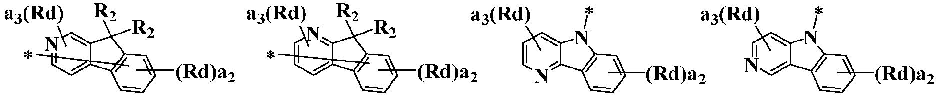 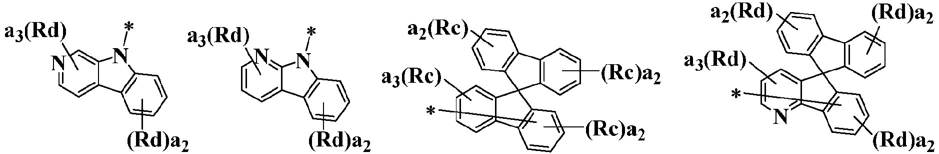 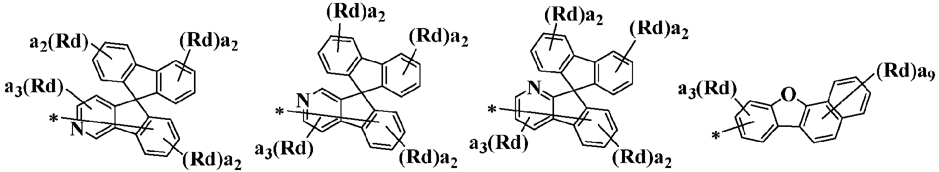 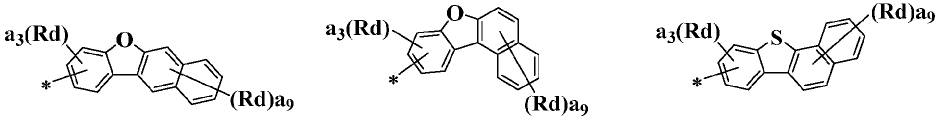 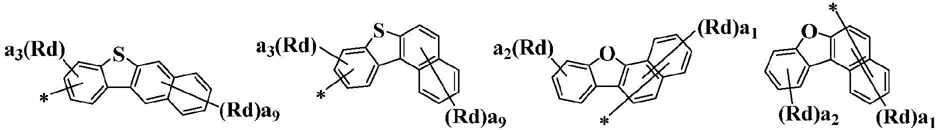 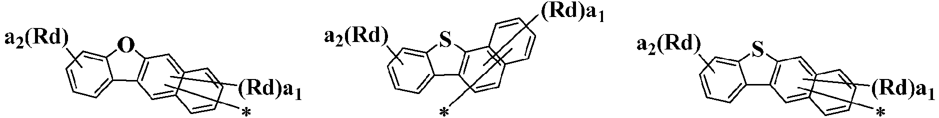 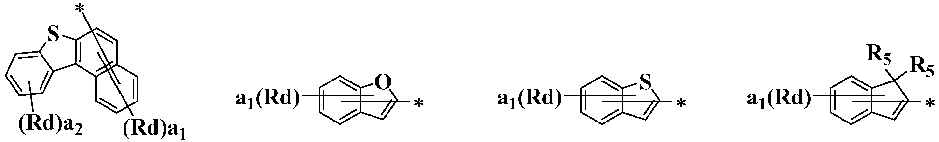 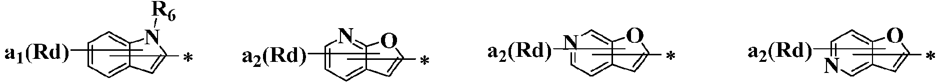 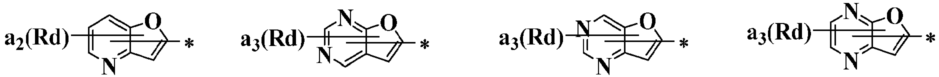 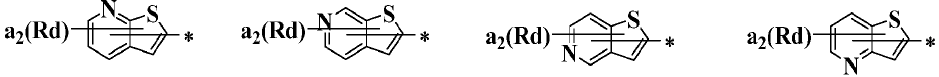 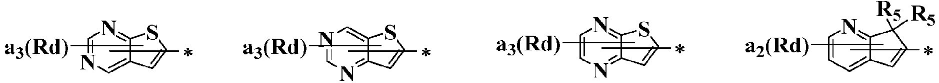 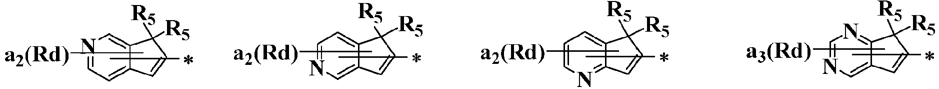 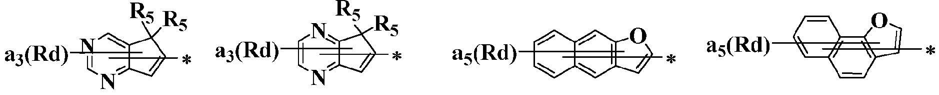 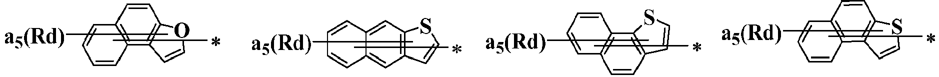 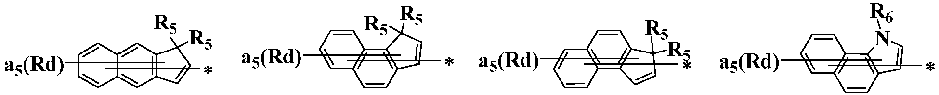 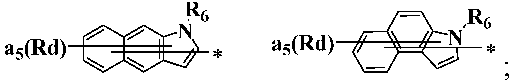
wherein Rc, Rd, R₂, R₃, R₄, R₅ and R₆ are the same as defined in Formula I;
a₁ is independently selected from 0, 1, 2, 3, 4 or 5, a₂ is independently selected from 0, 1, 2, 3 or 4. a₃ is independently selected from 0, 1, 2 or 3, a₄ is independently selected from 0, 1 or 2, as is independently selected from 0, 1, 2, 3, 4, 5, 6 or 7, a₆ is independently selected from 0, 1, 2, 3, 4, 5, 6, 7, 8, 9 or 10, a₇ is independently selected from 0, 1 or 2, as is independently selected from 0, 1, 2, 3, 4, 5, 6, 7 or 8, and a₉ is independently selected from 0, 1, 2, 3, 4, 5 or 6.

7. The fluorene-containing heterocyclic compound according to claim 1, wherein L, L₁ and L₂ are independently selected from a single bond or any one of the following groups: 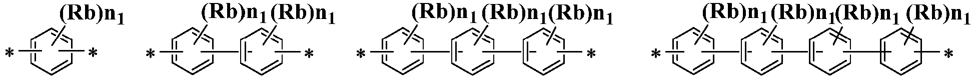 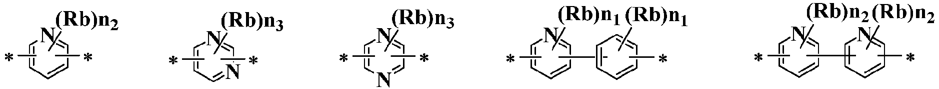 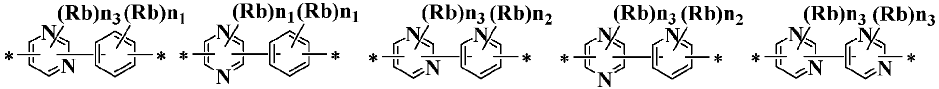 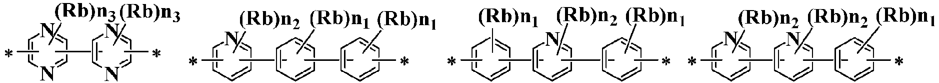 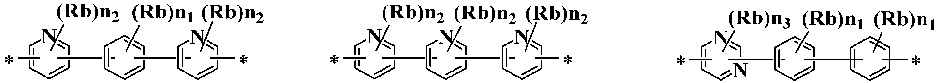 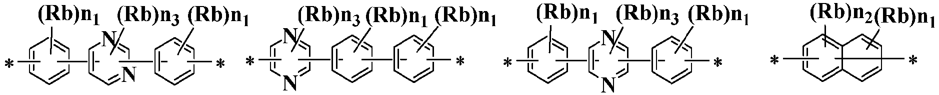 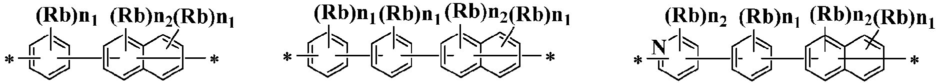 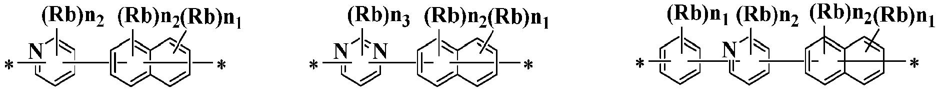 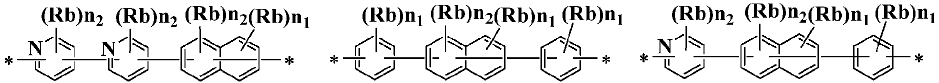 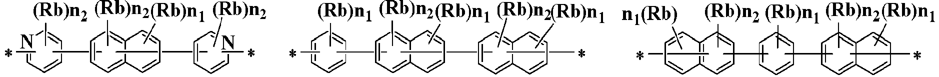 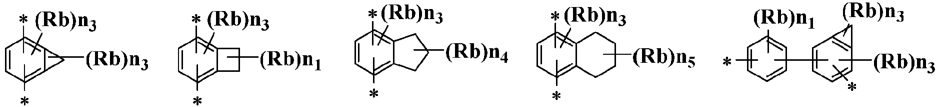 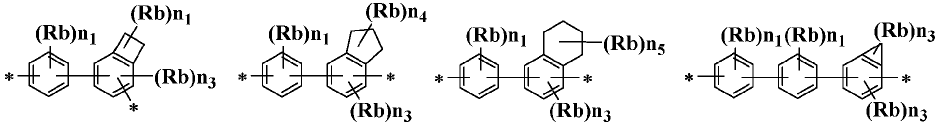 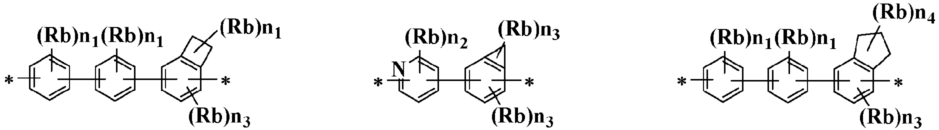 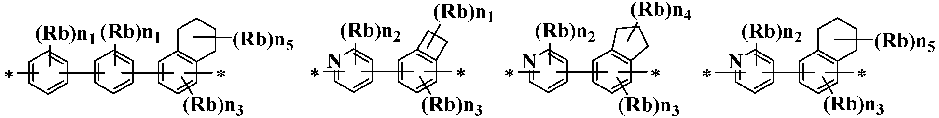 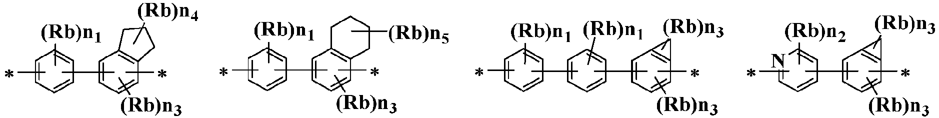 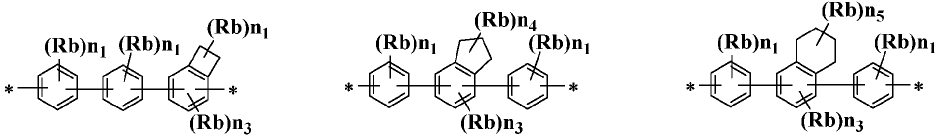 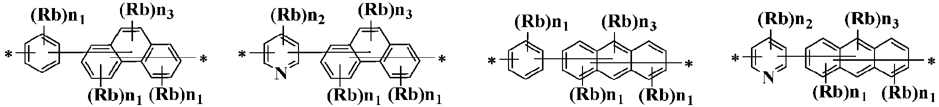 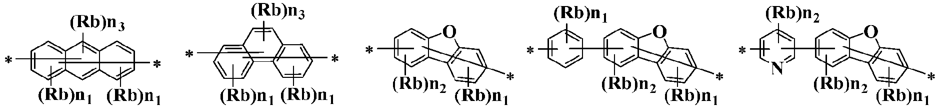 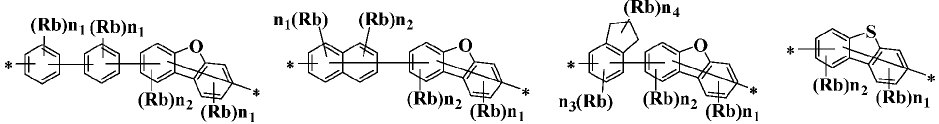 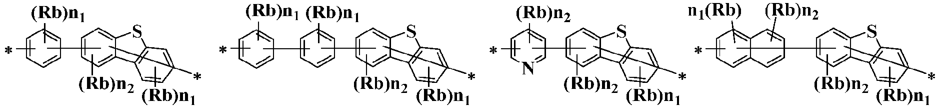 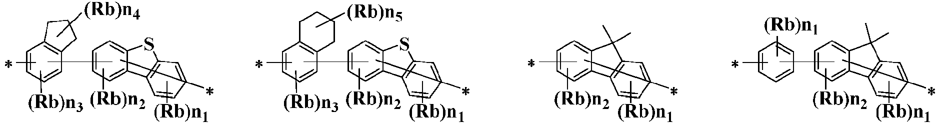 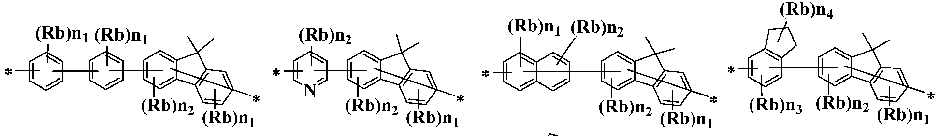 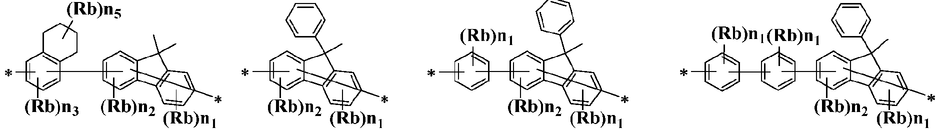 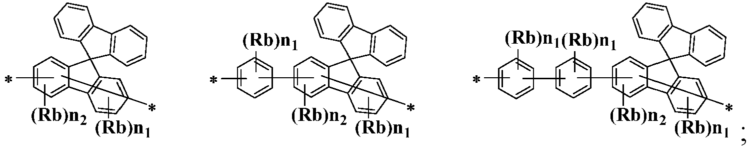
wherein Rb is independently selected from any one of hydrogen, deuterium, tritium, cyano, halogen, nitro, substituted or unsubstituted C1 to C12 alkyl, substituted or unsubstituted silyl, substituted or unsubstituted C1 to C12 alkoxy, substituted or unsubstituted C3 to C12 cycloalkyl, substituted or unsubstituted C2 to C12 heterocycloalkyl, substituted or unsubstituted C6 to C30 aryl, or substituted or unsubstituted C2 to C30 heteroaryl;
n₁ is independently selected from 0, 1, 2, 3 or 4, n₂ is independently selected from 0, 1, 2 or 3, n₃ is independently selected from 0, 1 or 2, n₄ is independently selected from 0, 1, 2, 3, 4, 5 or 6, and n₅ is independently selected from 0, 1, 2, 3, 4, 5, 6, 7 or 8.

8. The fluorene-containing heterocyclic compound according to claim 1, wherein the heterocyclic compound is selected from any one of the following structures:

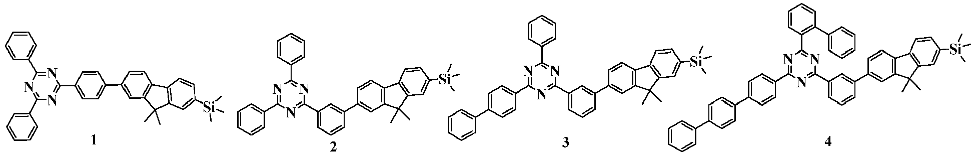

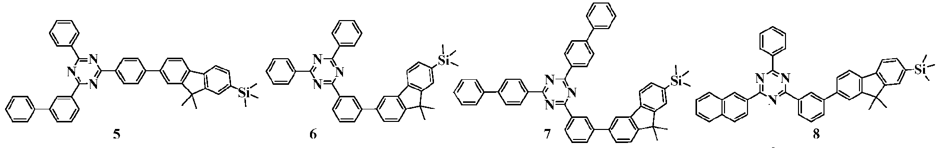

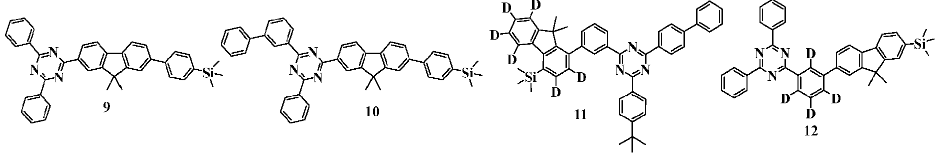

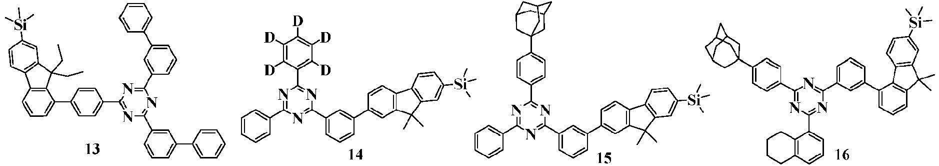

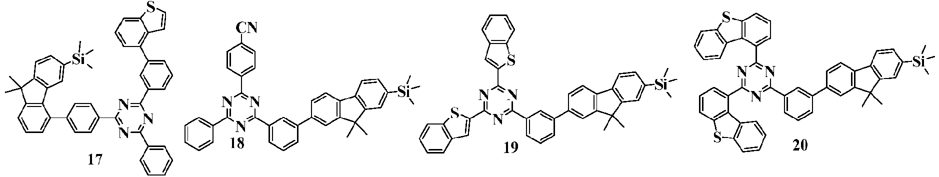

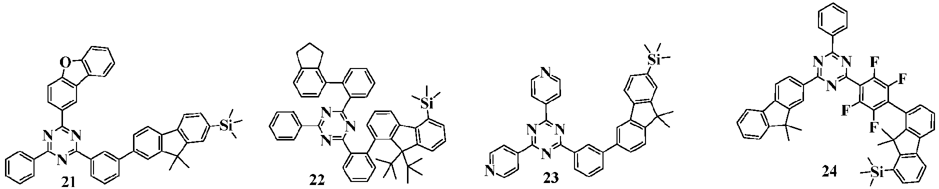

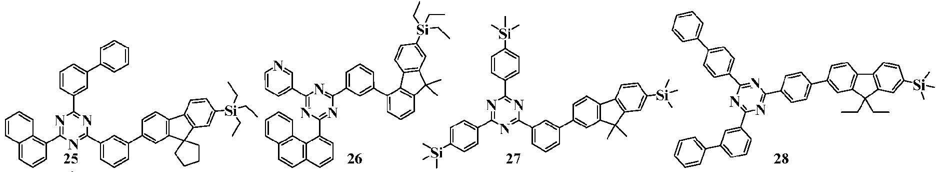

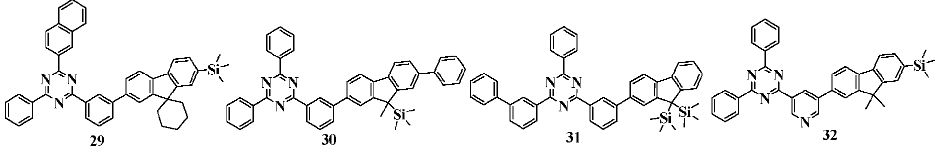

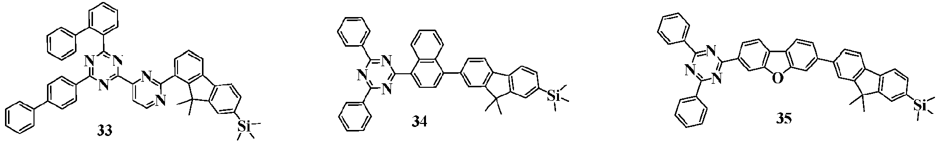

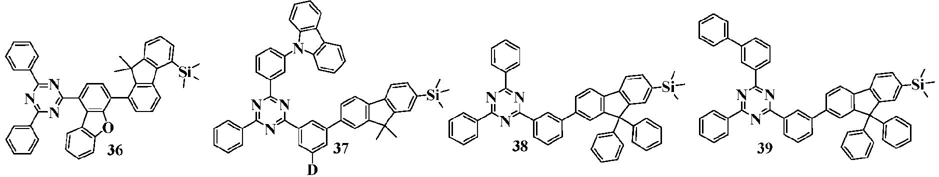

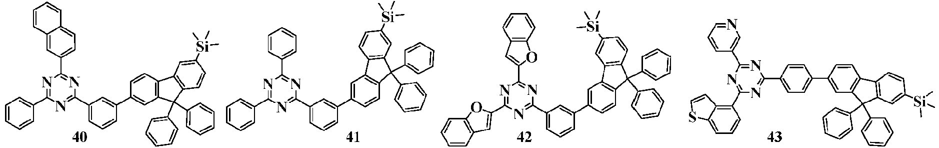

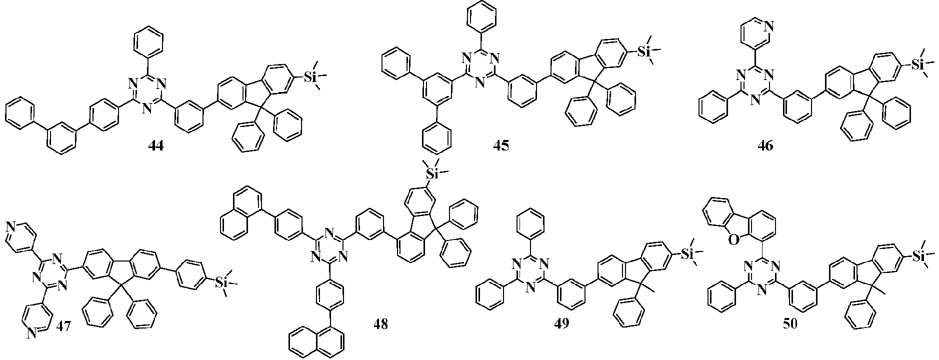

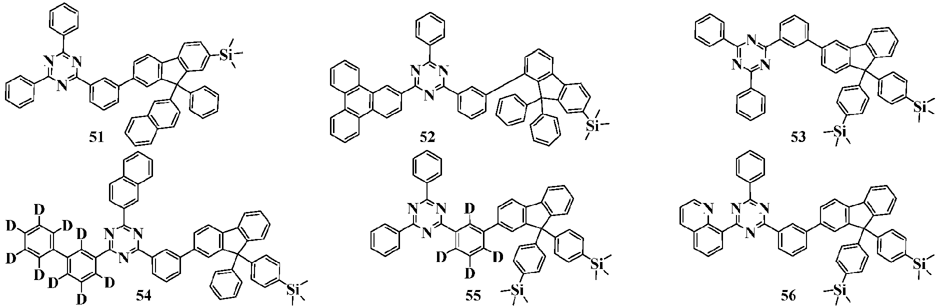

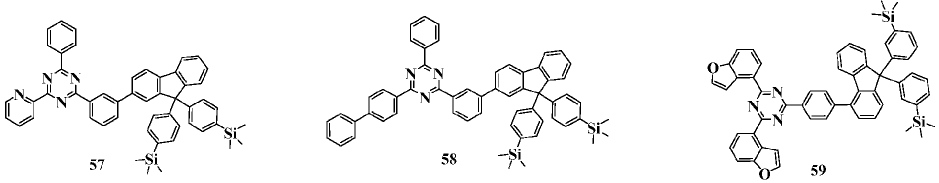

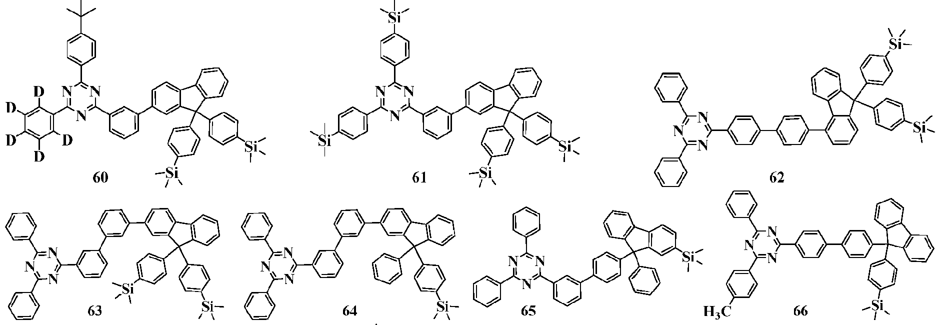

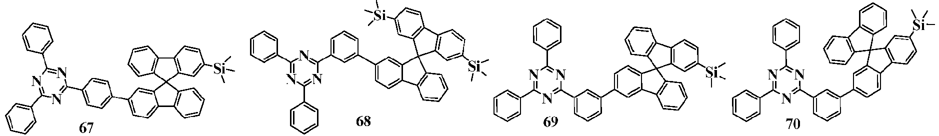

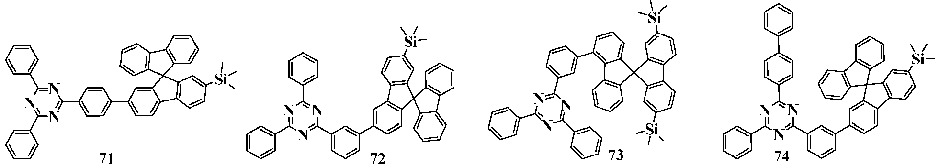

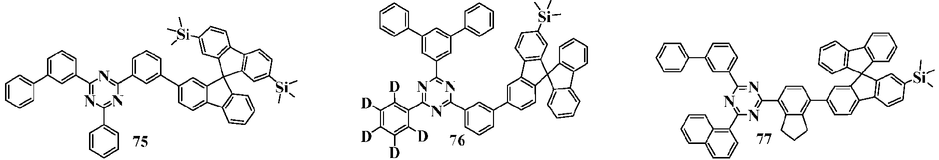

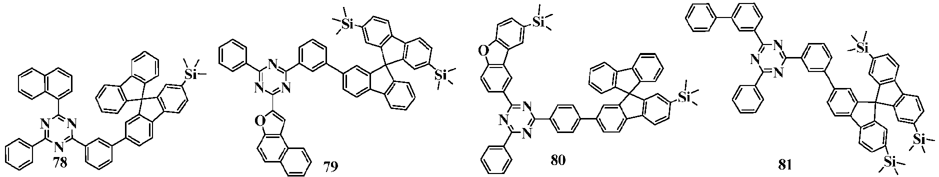

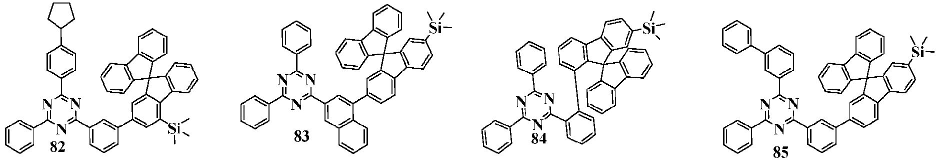

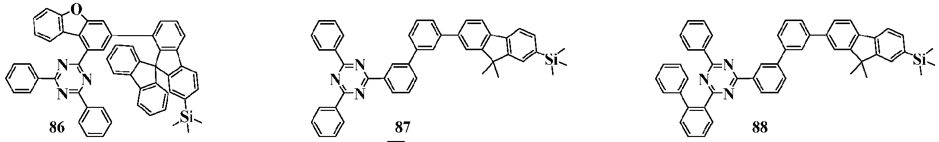

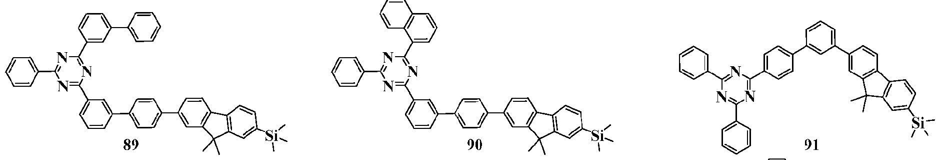

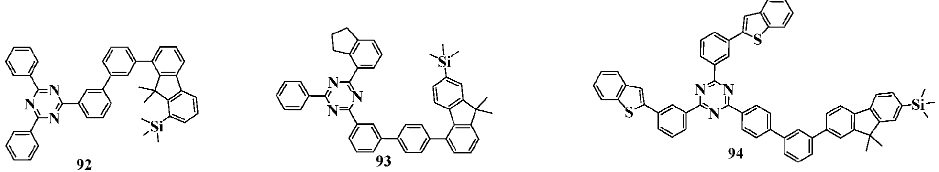

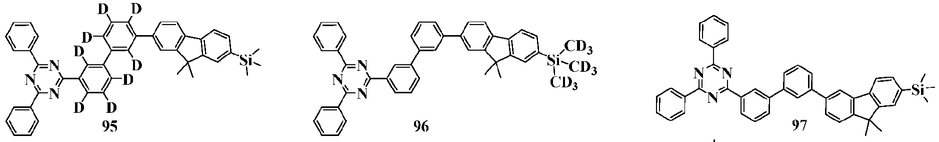

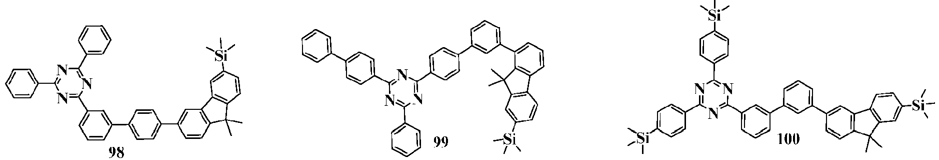

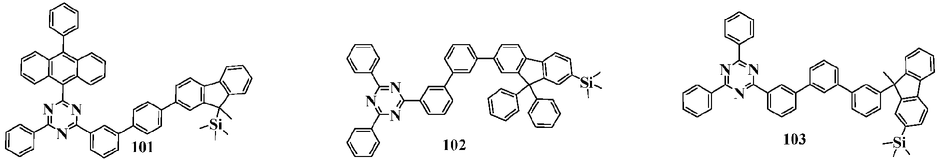

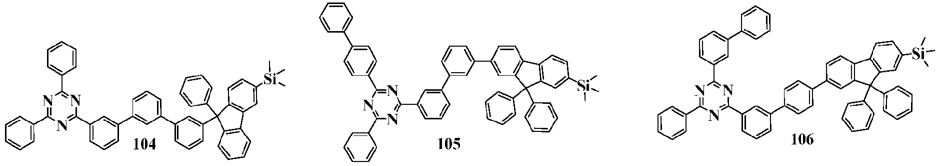

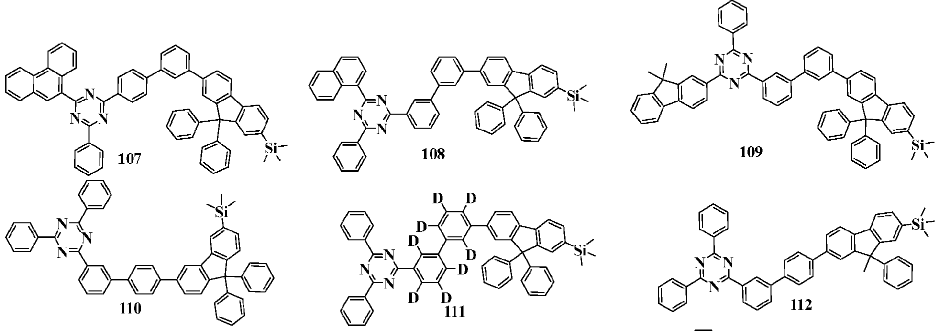

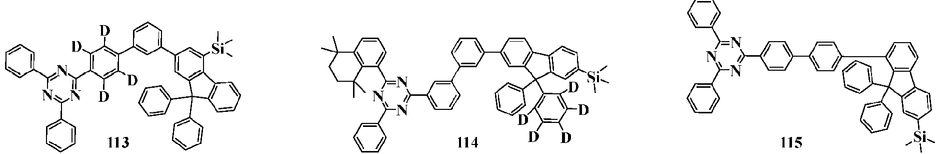

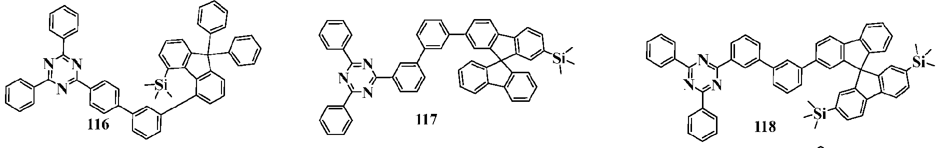

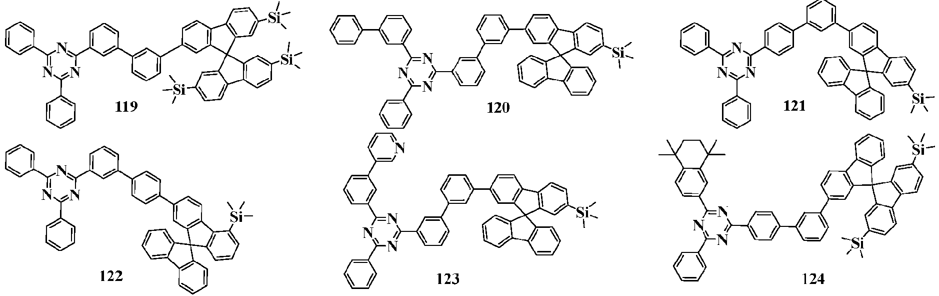

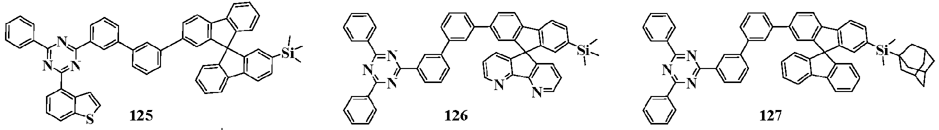

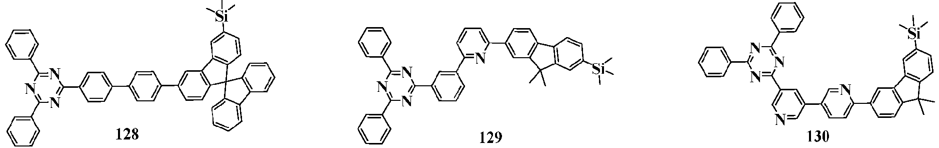

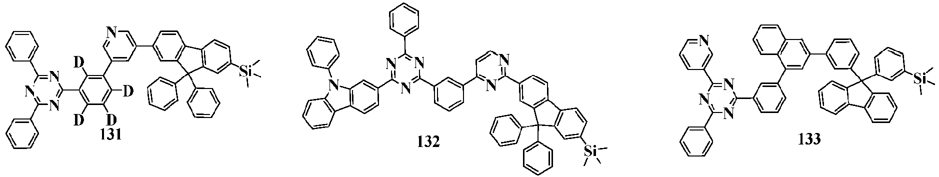

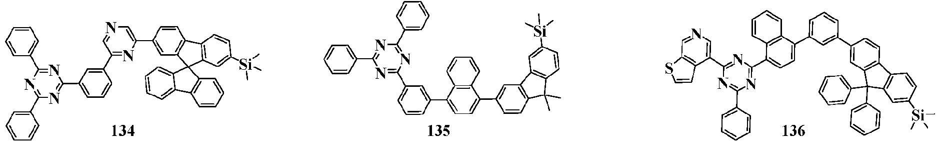

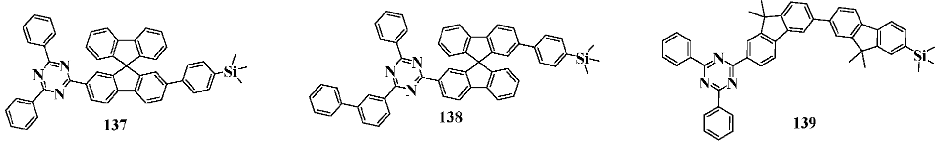

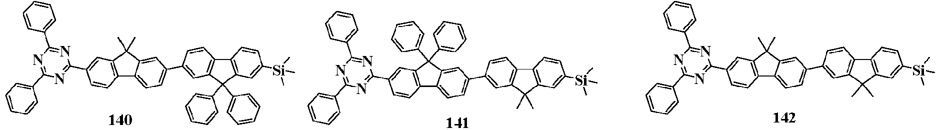

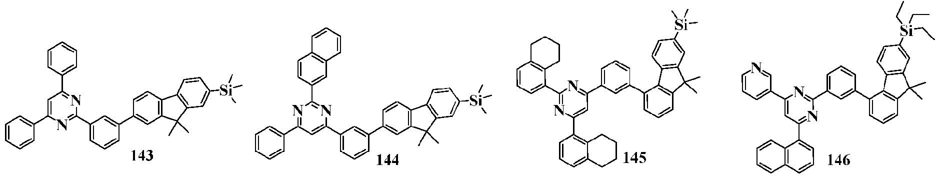

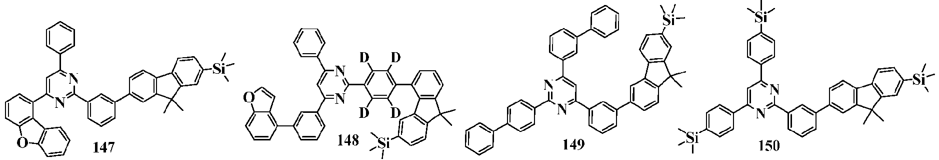

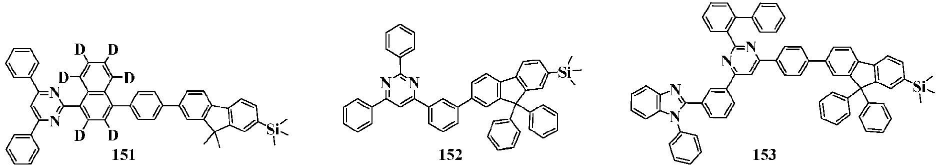

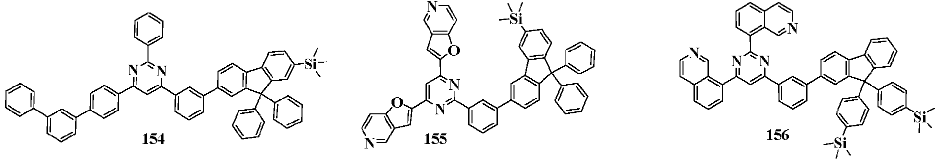

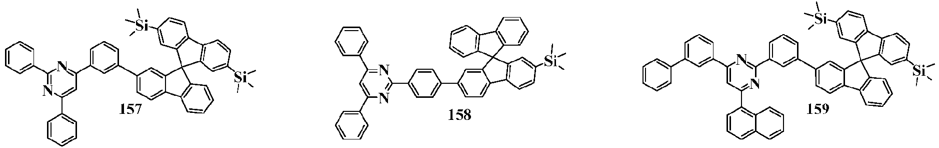

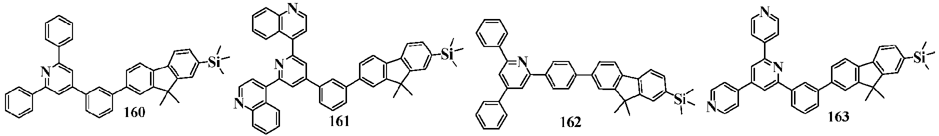

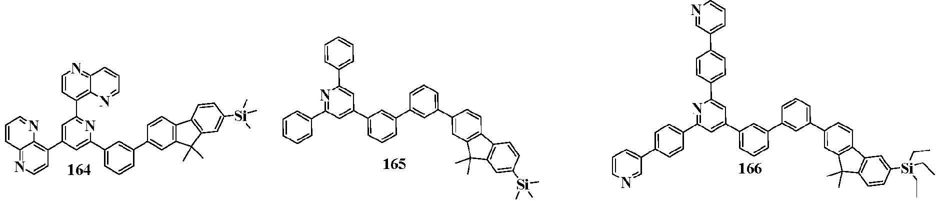

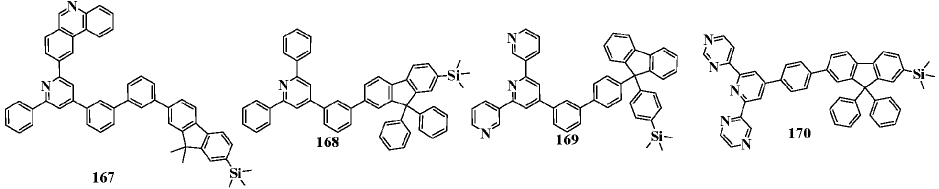

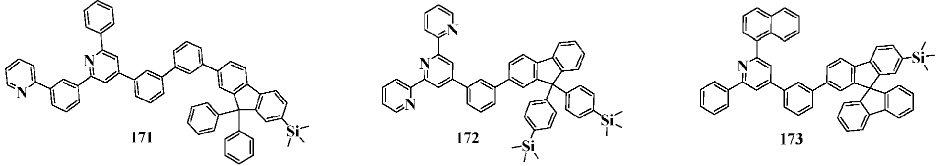

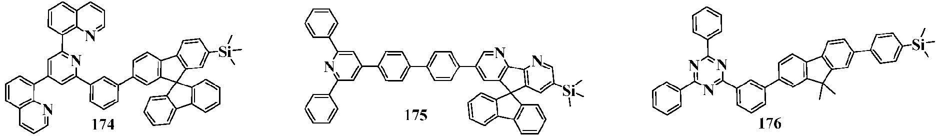

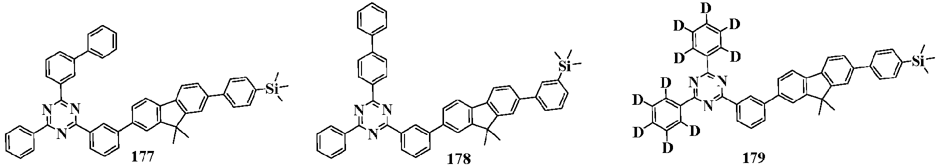

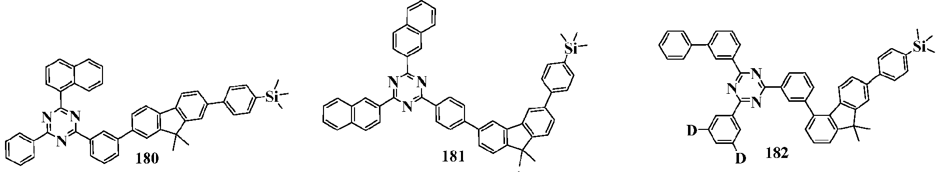

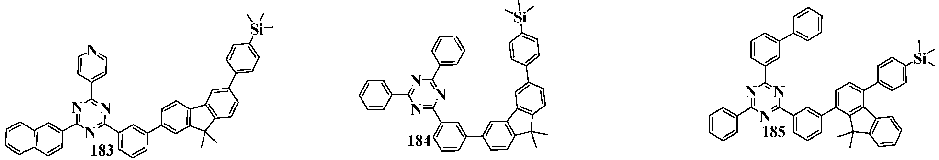

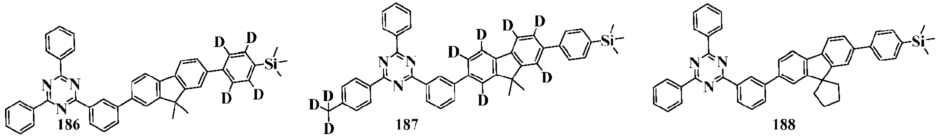

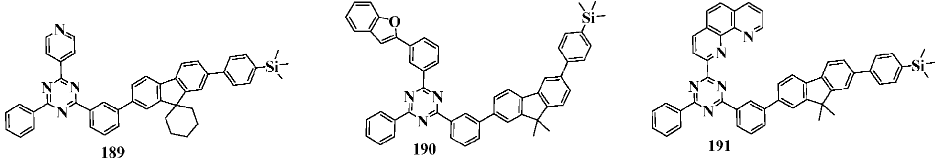

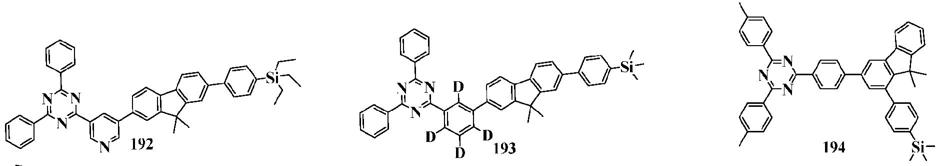

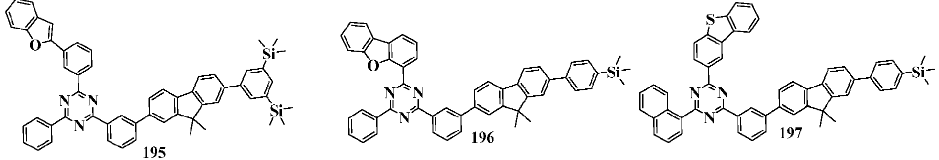

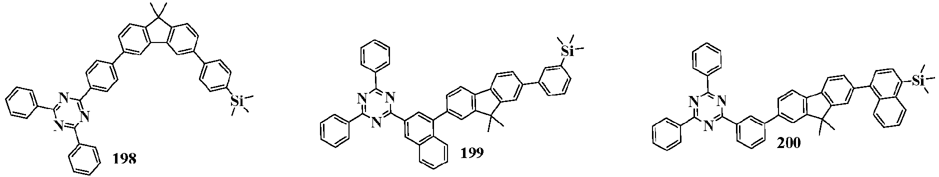

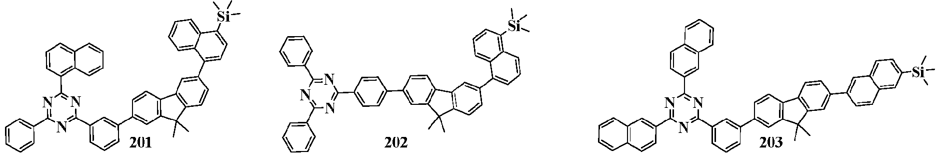

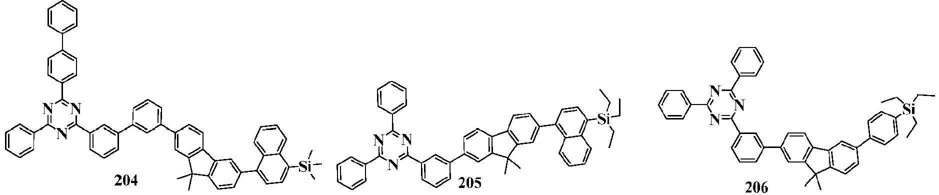

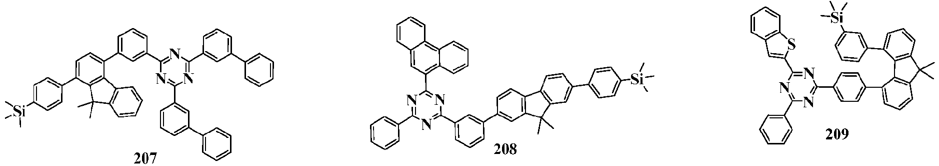

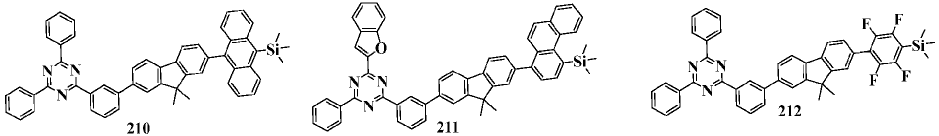

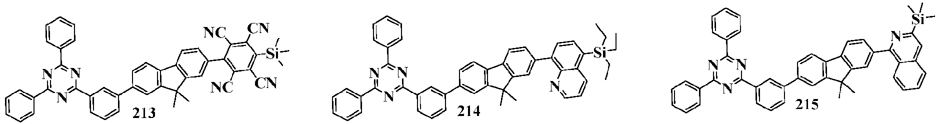

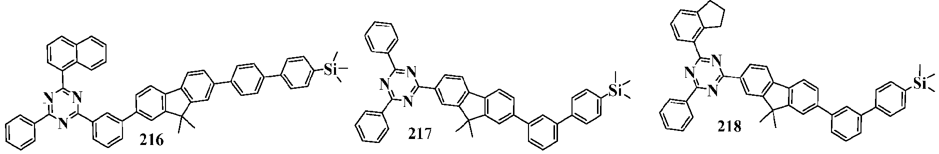

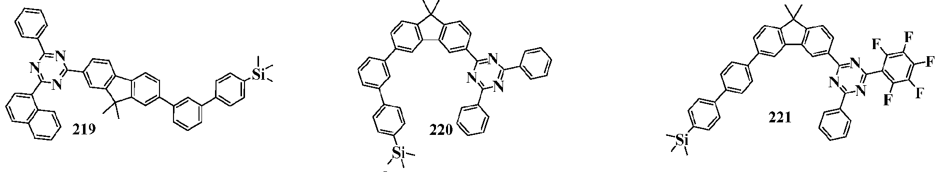

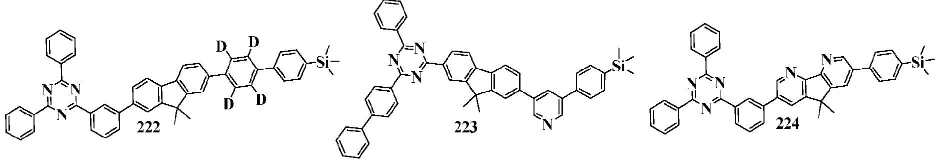

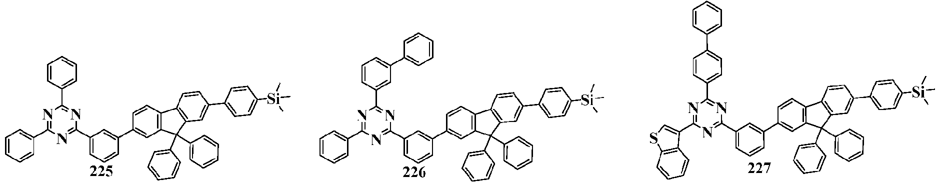

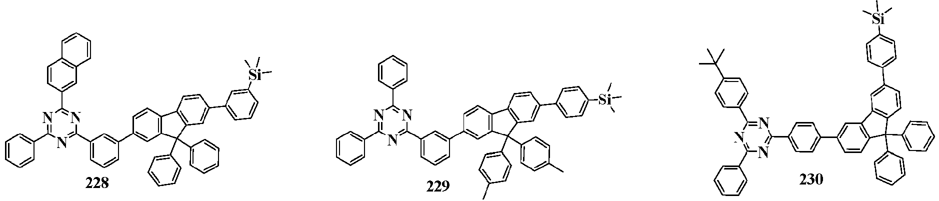

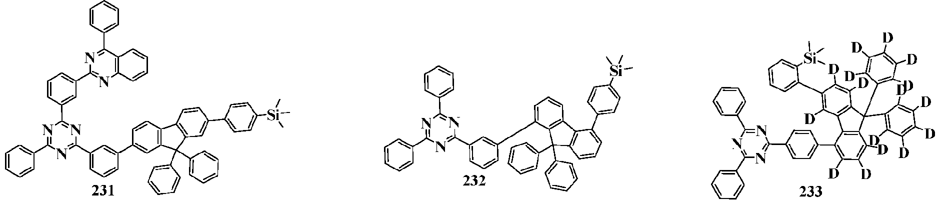

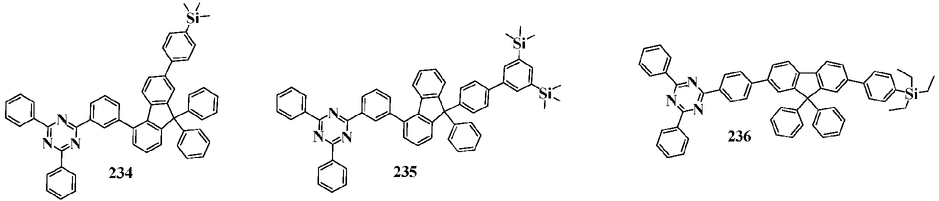

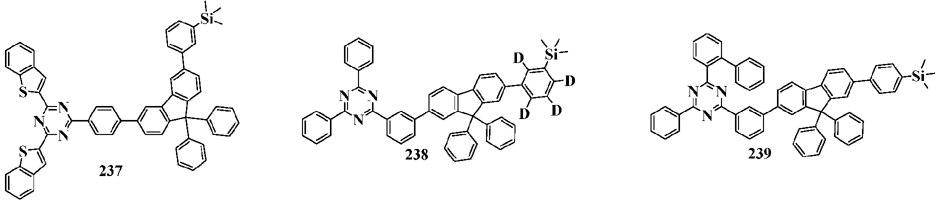

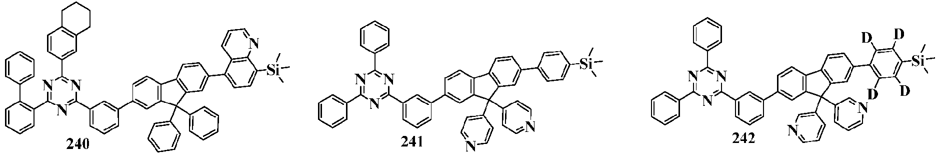

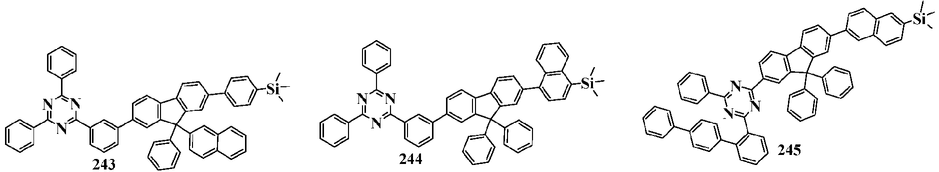

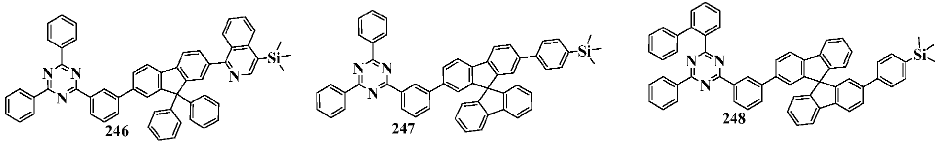

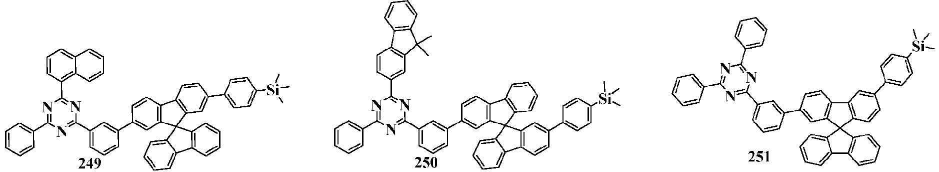

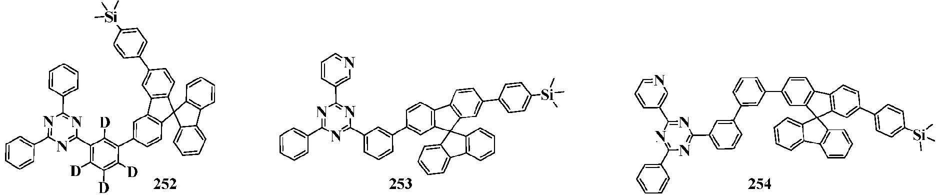

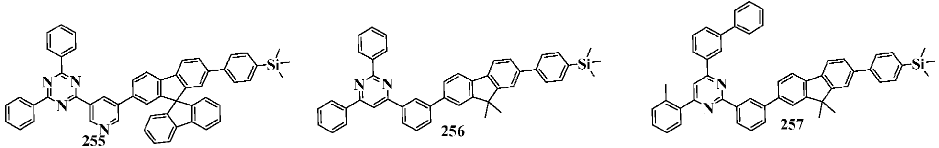

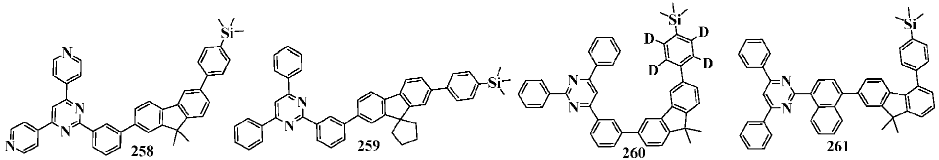

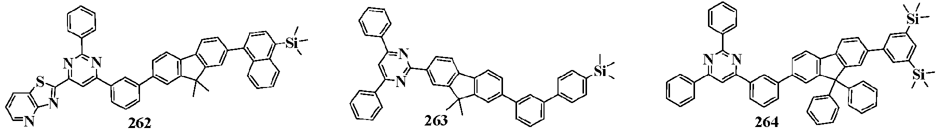

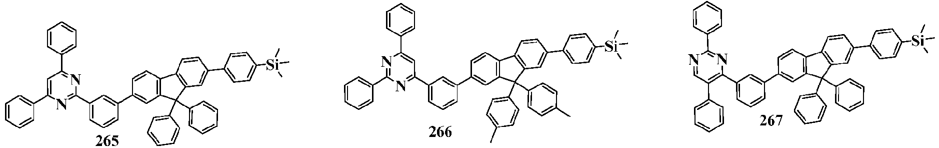

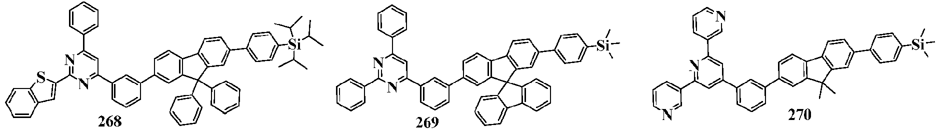

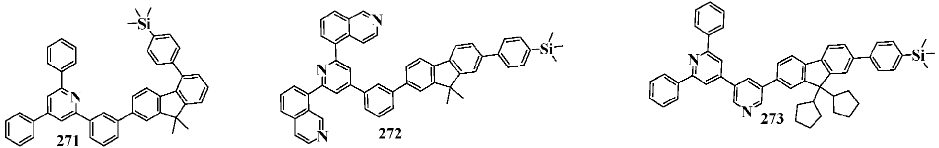

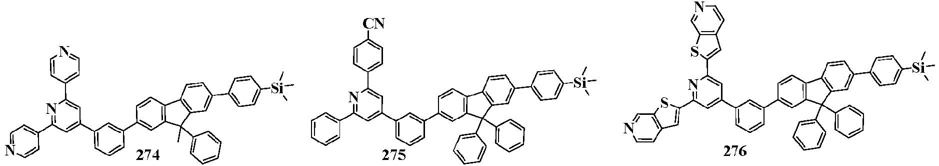

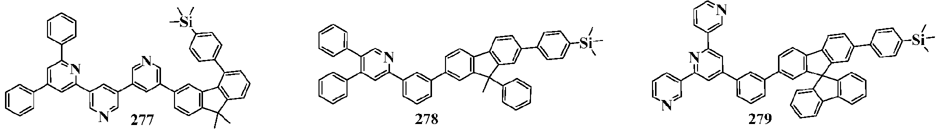

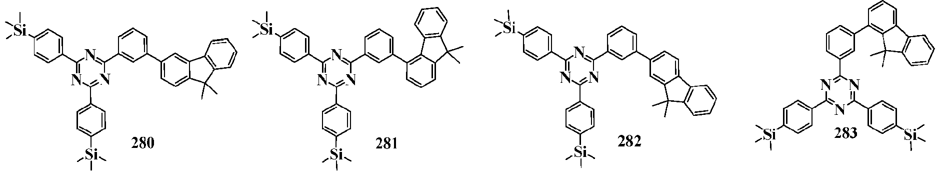

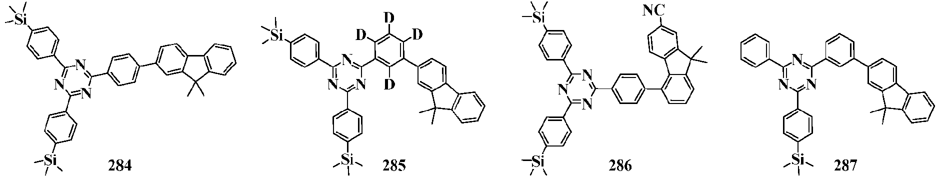

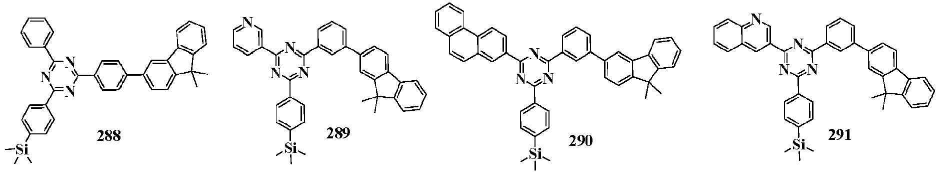

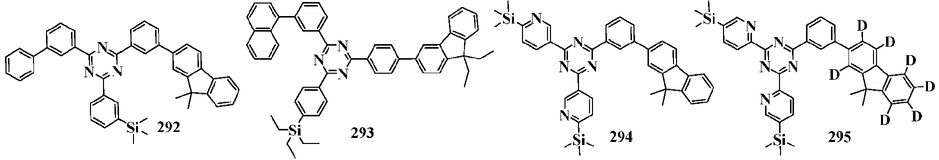

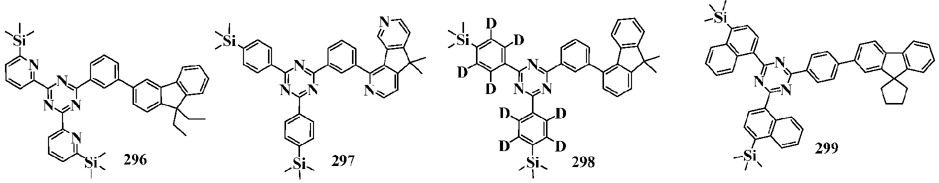

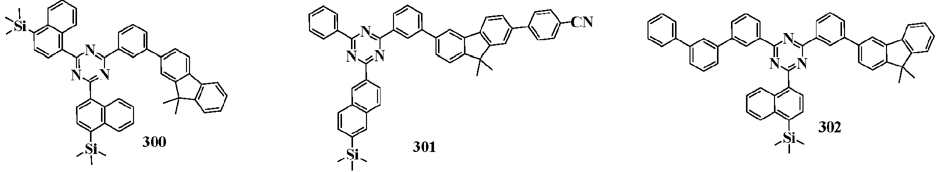

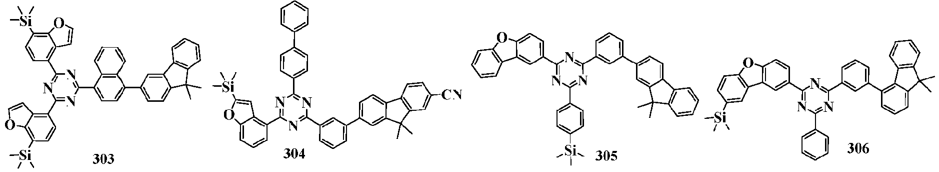

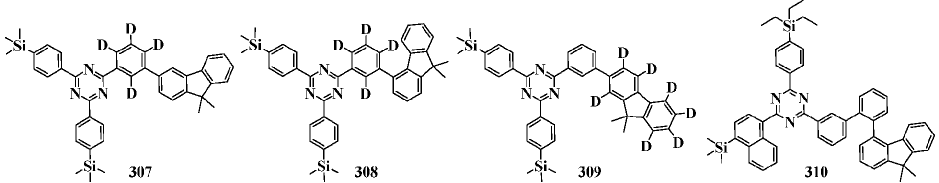

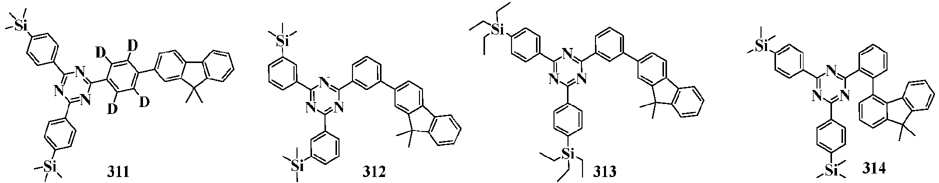

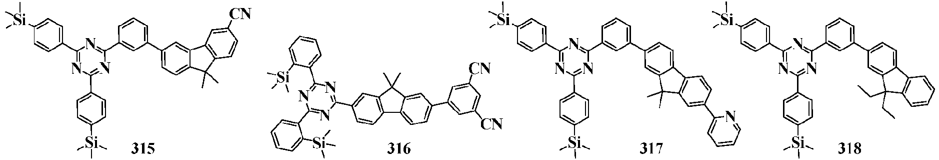

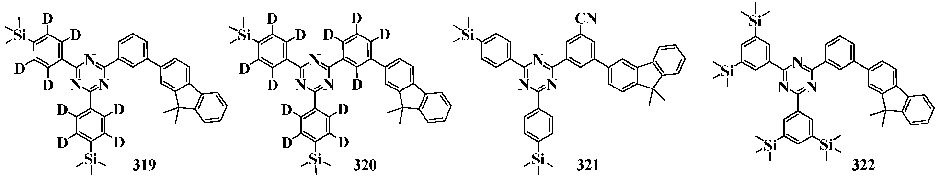

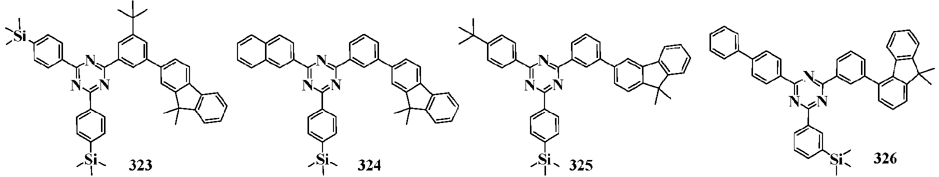

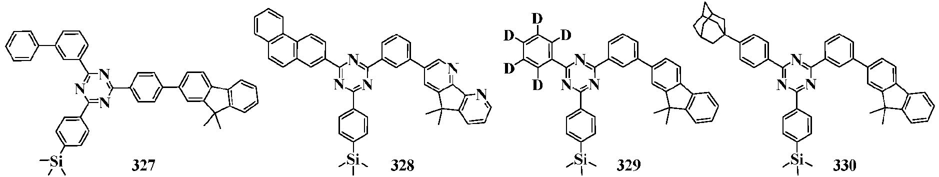

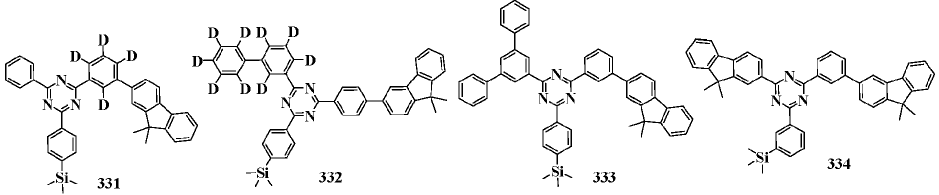

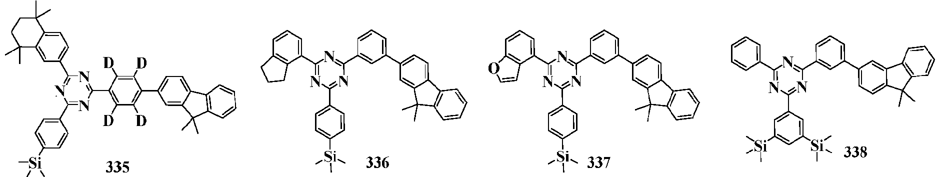

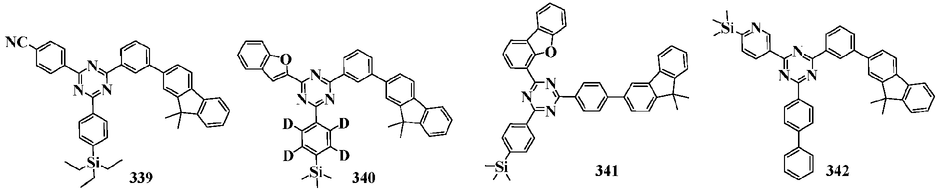

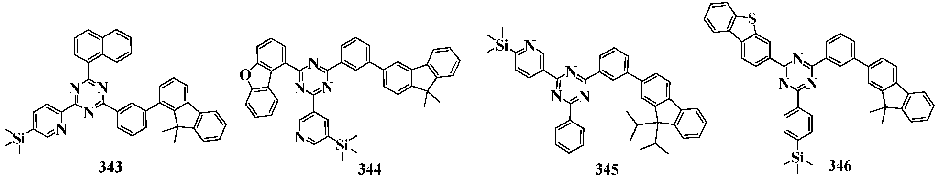

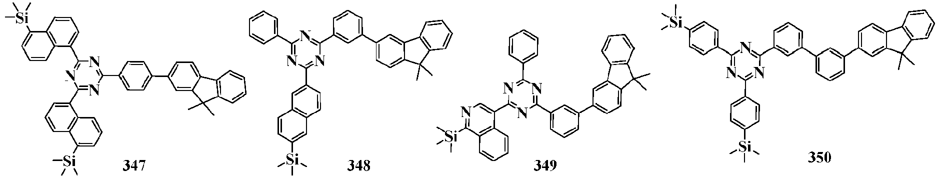

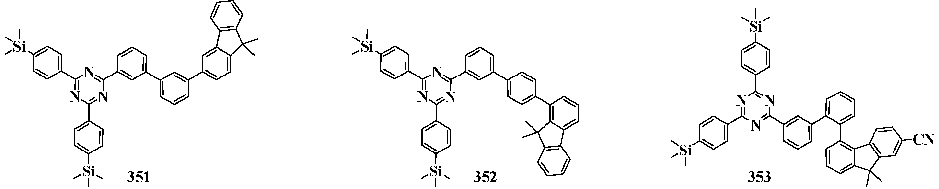

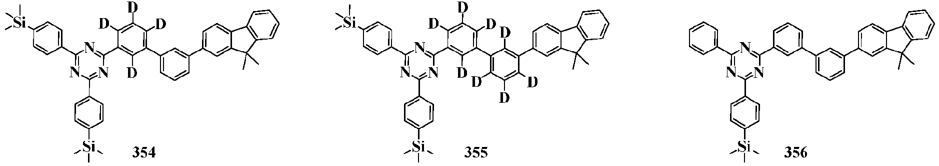

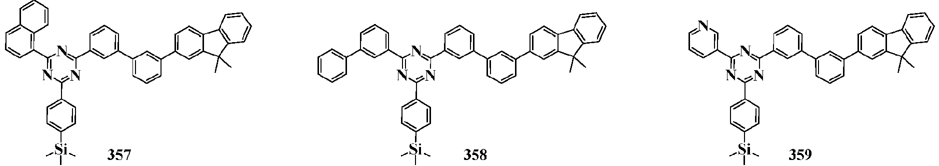

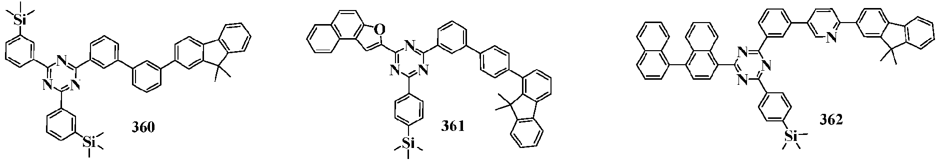

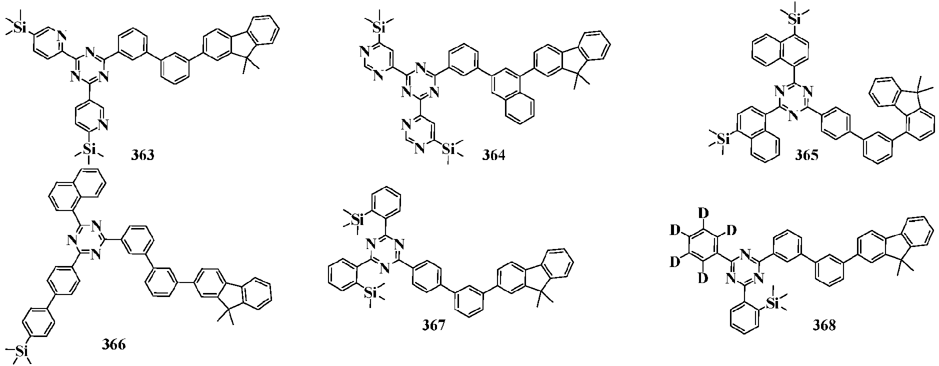

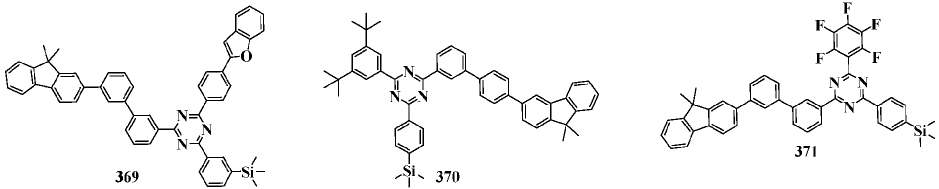

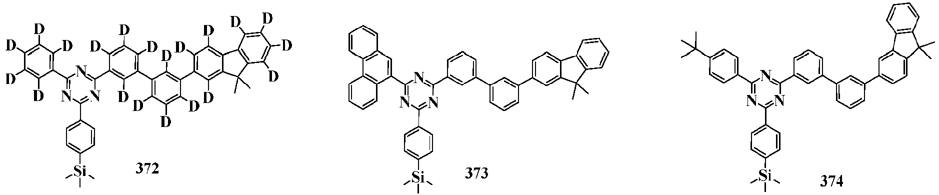

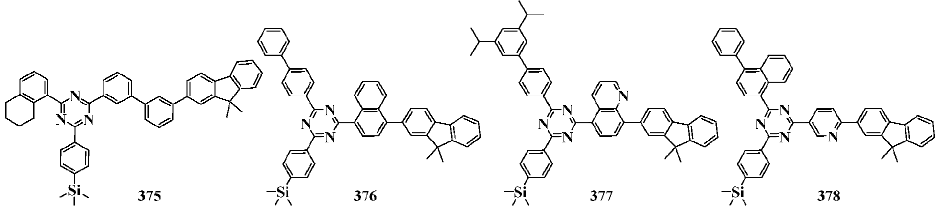

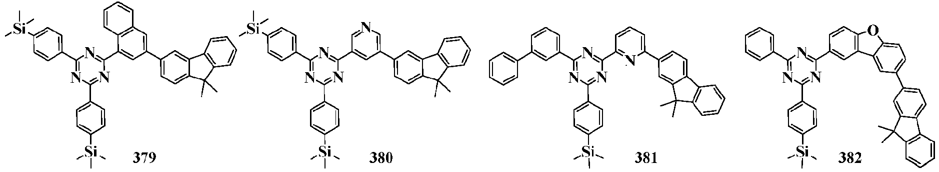

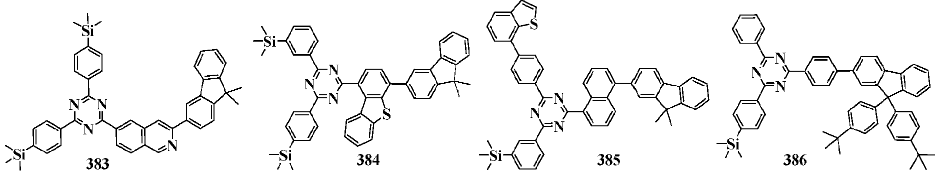

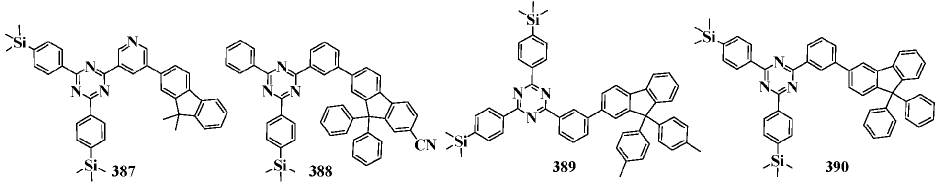

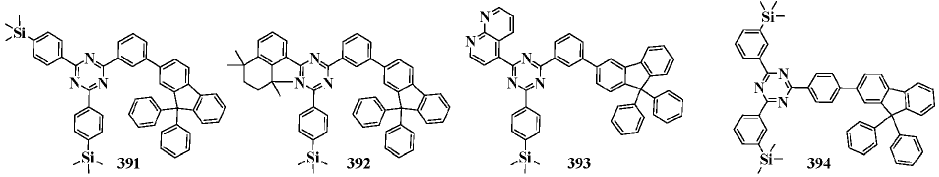

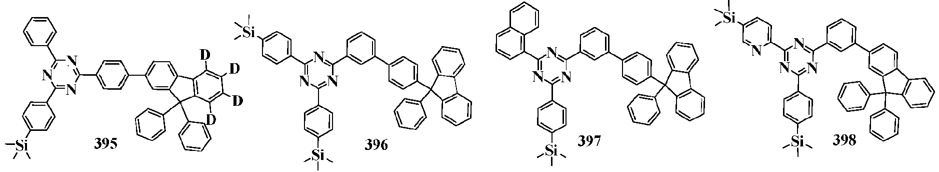

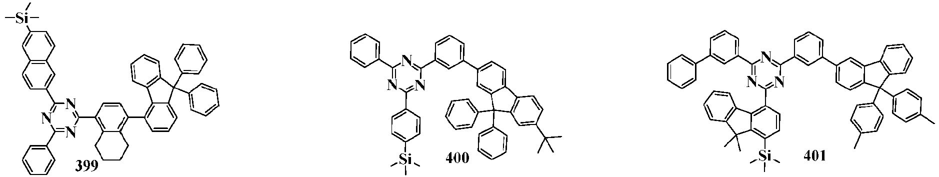

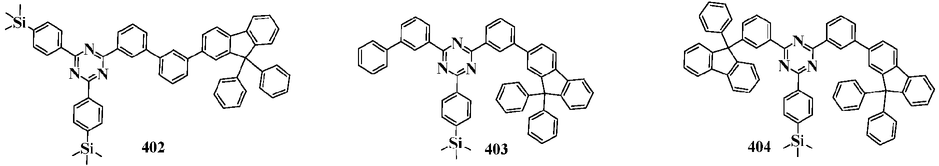

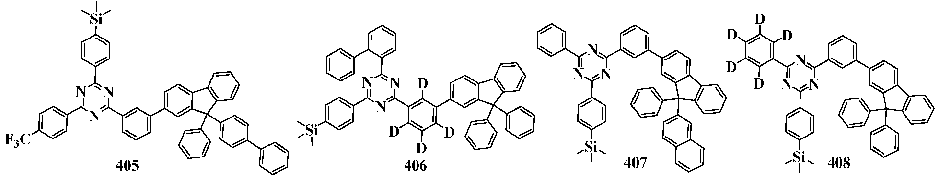

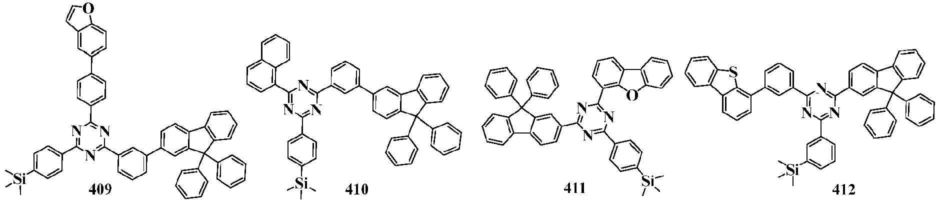

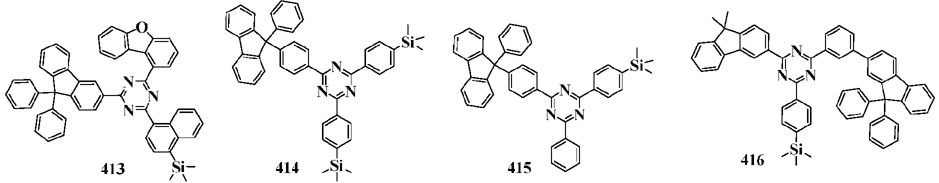

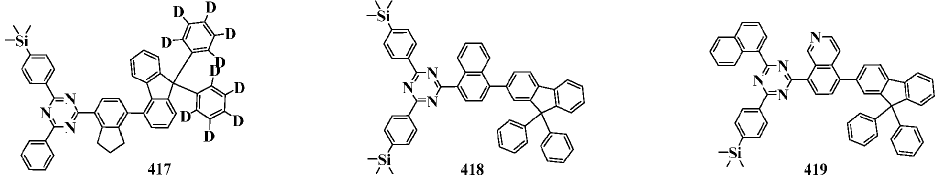

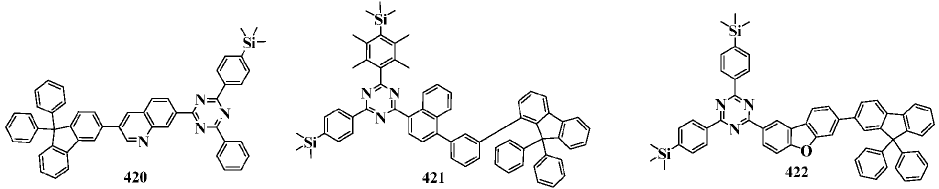

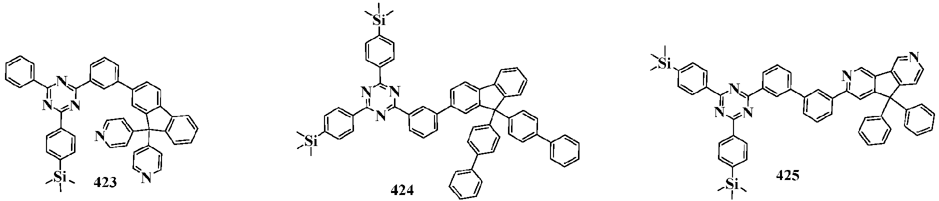

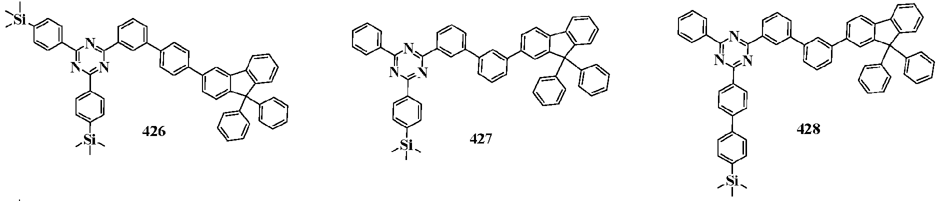

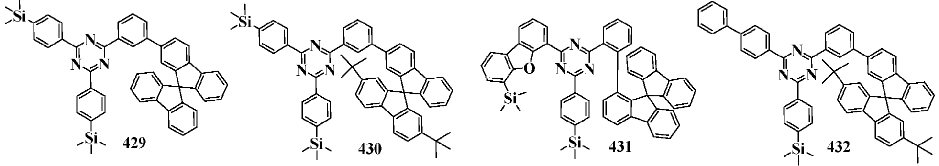

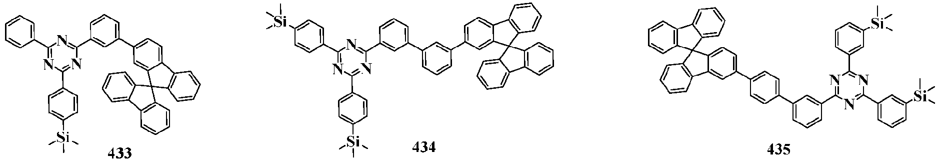

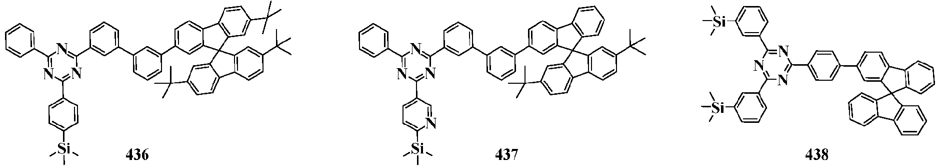

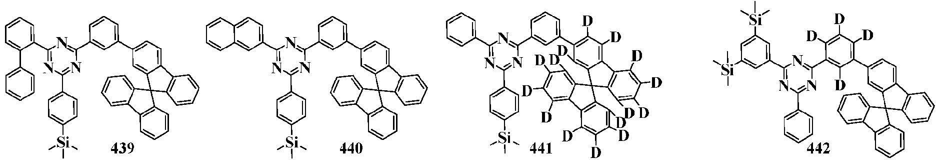

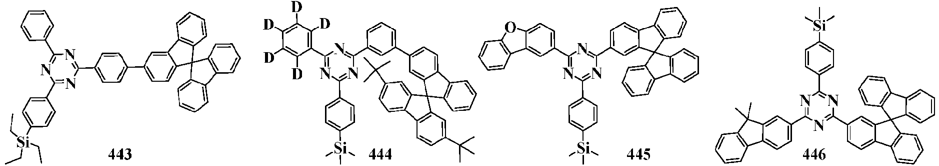

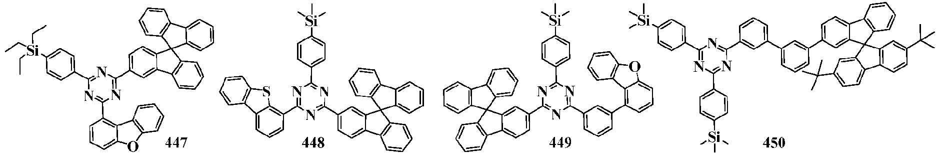

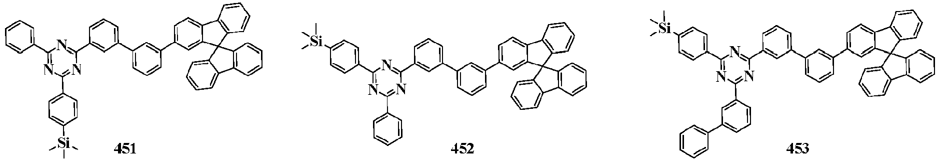

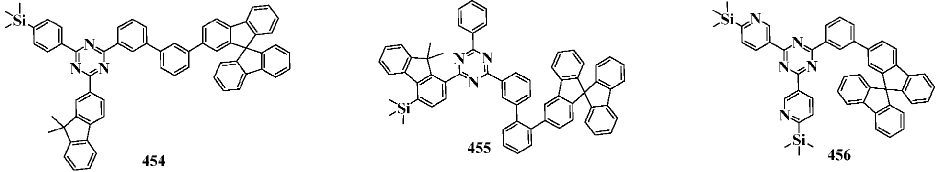

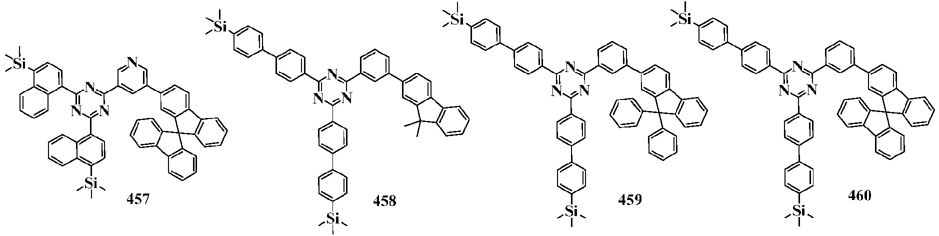

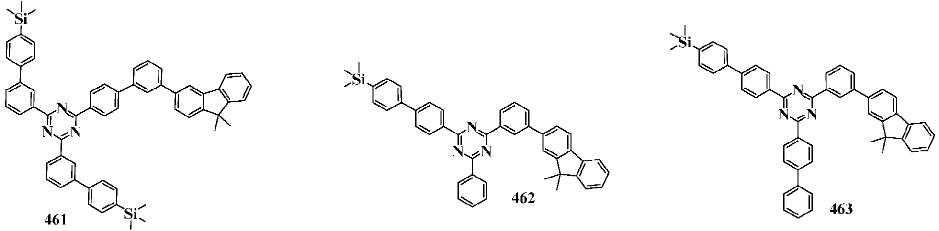

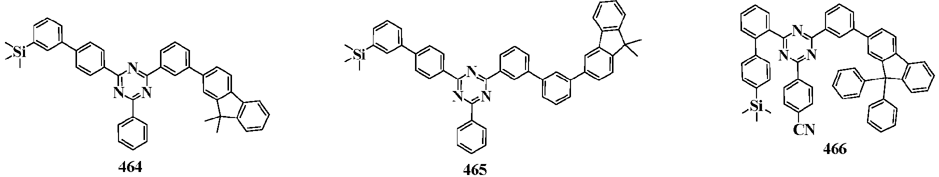

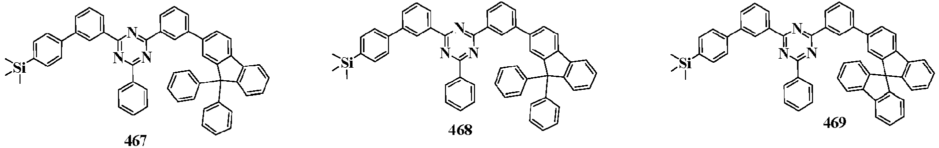

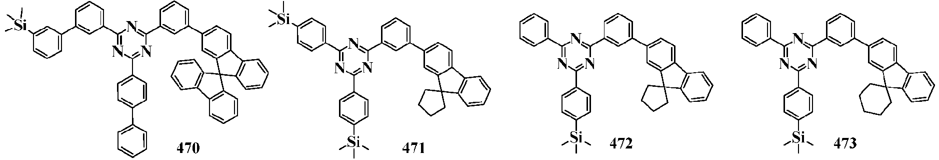

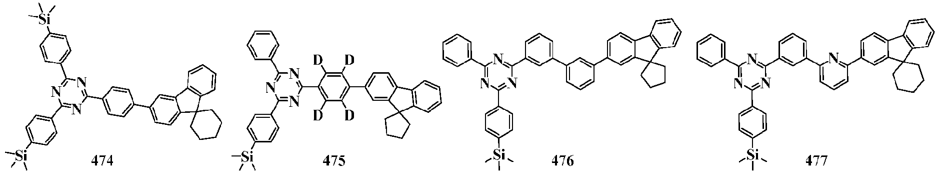

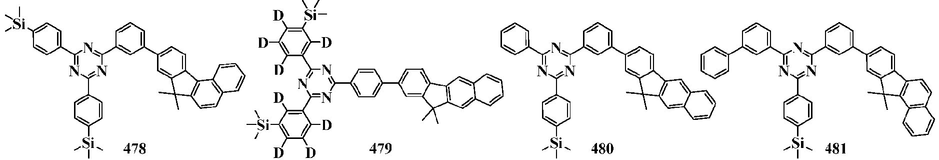

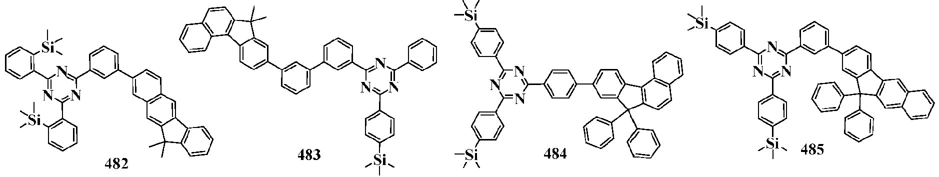

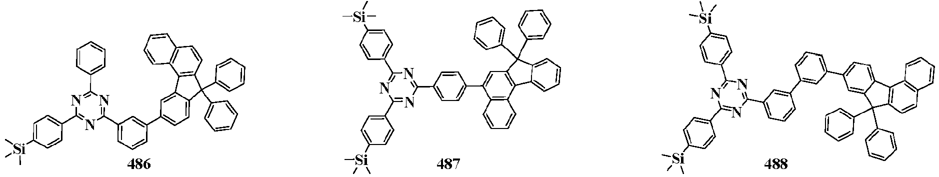

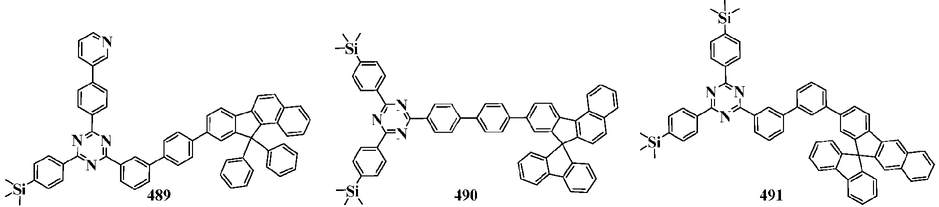

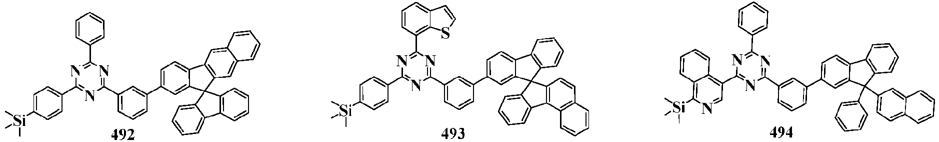

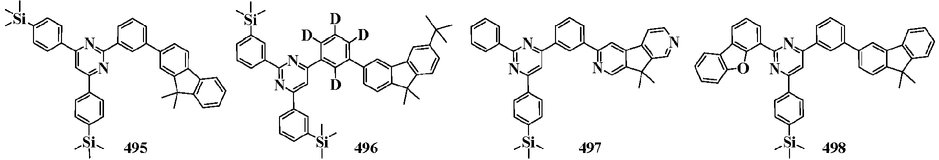

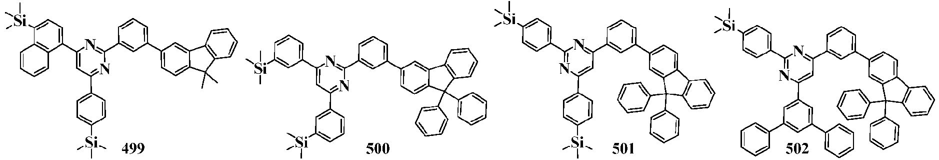

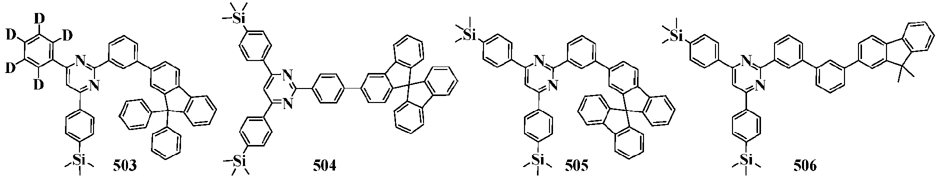

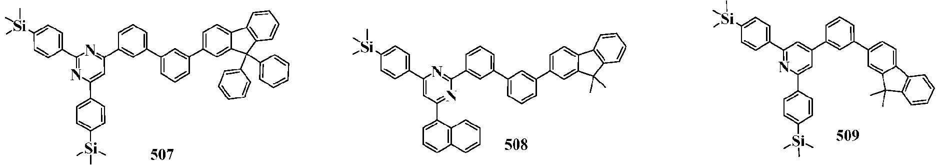

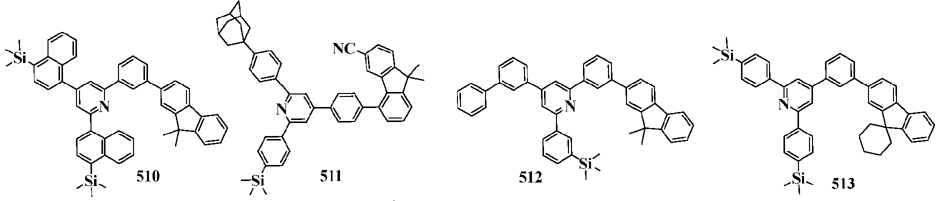

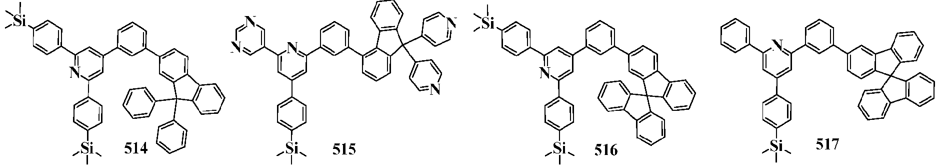

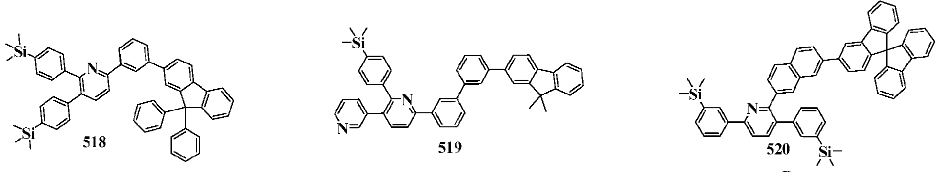

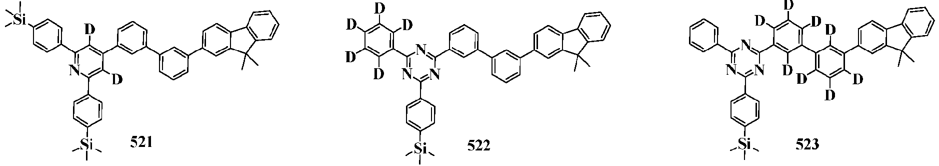

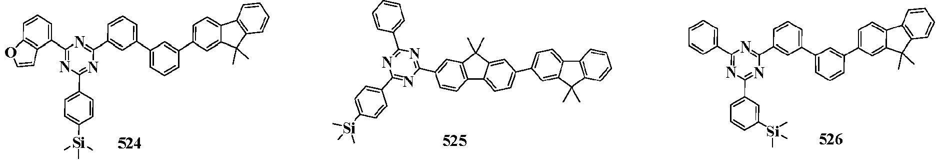

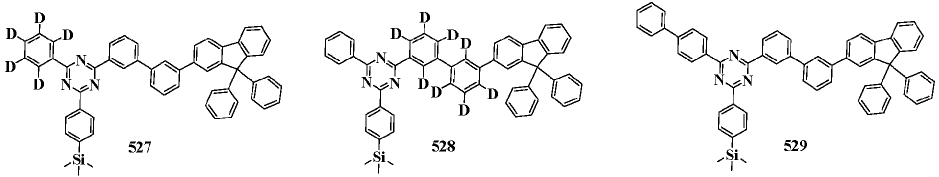

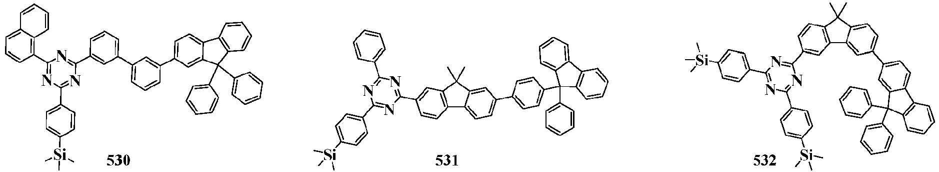

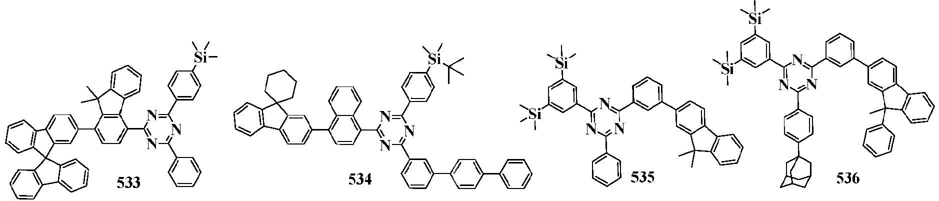

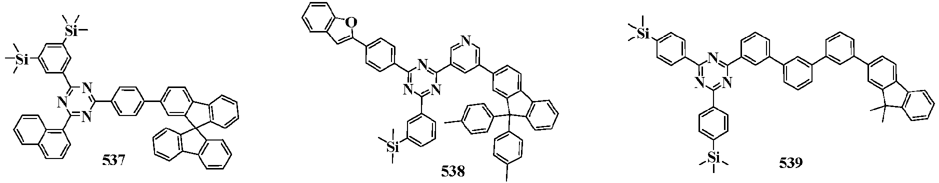

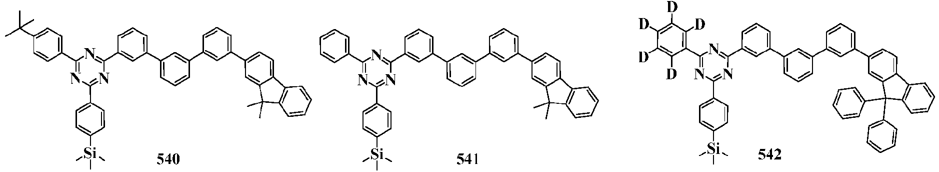

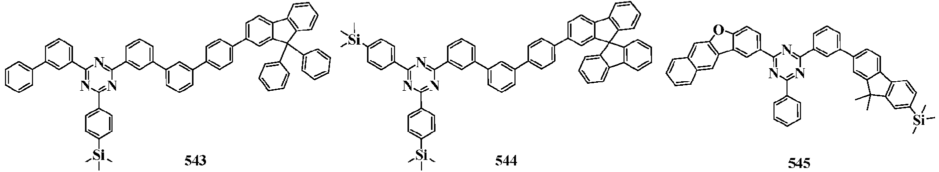

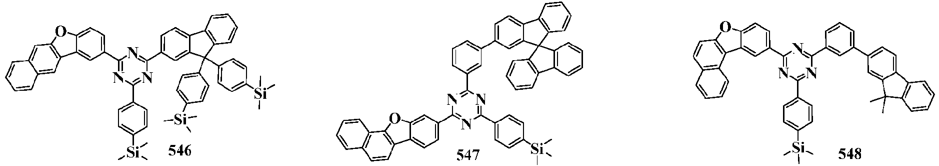

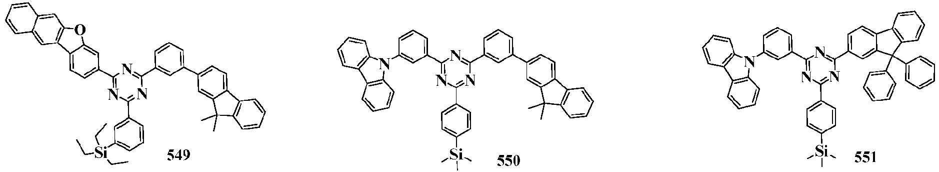

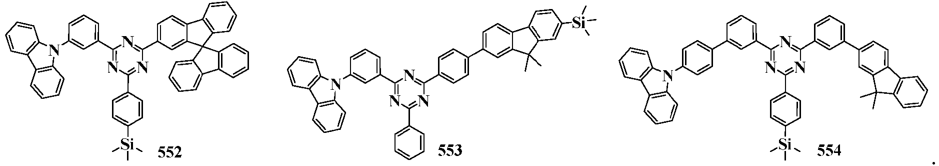

9. An organic electroluminescent device, comprising an anode, a cathode and an organic layer, wherein the organic layer is disposed between the anode and the cathode, the organic layer comprises at least one of a light-emitting layer, an electron transport layer or a hole blocking layer, and at least one of the light-emitting layer, the electron transport layer or the hole blocking layer comprises any one or more of the fluorene-containing heterocyclic compound according to any one of claims 1 to 8.

10. An organic electroluminescent device, comprising an anode, a cathode and an organic layer, wherein the organic layer is disposed on an outer side of at least one of the anode or the cathode, the organic layer comprises a light extraction layer, and the light extraction layer comprises any one or more of the fluorene-containing heterocyclic compound according to any one of claims 1 to 8.

## Patentansprüche

1. Eine Fluoren-enthaltende heterocyclische Verbindung, die eine Struktur gemäß Formel I aufweist: 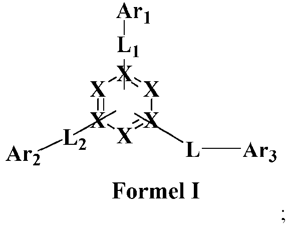
wobei in Formel I X jeweils unabhängig ausgewählt wird aus C(R₀) oder einem N-Atom, und mindestens eines der X aus einem N-Atom ausgewählt wird;
R₀ jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
Ar₃ ausgewählt ist aus einer Gruppe, die durch Formel II-1 oder Formel II-2 dargestellt wird: 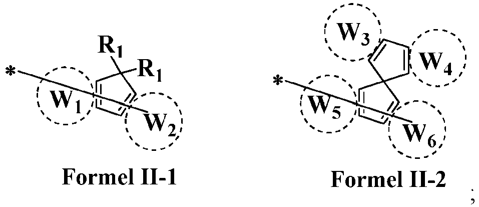
wobei der Ring W₁, der Ring W₂, der Ring W₃, der Ring W₄, der Ring W₅ und der Ring W₆ jeweils unabhängig ausgewählt werden aus einer der folgenden Strukturen: 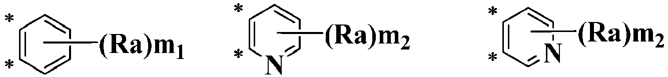 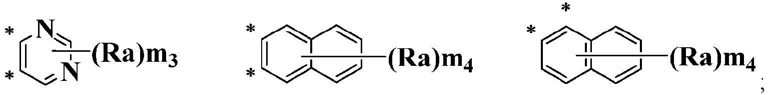
"*" stellt eine Fusionsstelle dar;
Ra jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
m₁ j unabhängig ausgewählt wird aus 0, 1, 2, 3 oder 4, m₂ unabhängig ausgewählt wird aus 0, 1, 2 oder 3, m₃ unabhängig ausgewählt wird aus 0, 1 oder 2 und m₄ unabhängig ausgewählt wird aus 0, 1, 2, 3, 4, 5 oder 6;
R₁ jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl; oder wobei zwei benachbarte R₁ miteinander verknüpft sind, um einen substituierten oder unsubstituierten C3-C7-Aliphatenring zu bilden;
L ausgewählt ist aus Einfachbindung, unsubstituiertem oder durch ein oder mehrere Rb substituiertem C6-C30-Arylen oder unsubstituiertem oder durch ein oder mehrere Rb substituiertem C2-C30-Heteroarylen;
L₁ und L₂ jeweils unabhängig ausgewählt werden aus Einfachbindung, substituiertem oder unsubstituiertem C6-C30-Arylen oder substituiertem oder unsubstituiertem C2-C30-Heteroarylen;
Ar₁ und Ar₂ jeweils unabhängig ausgewählt werden aus unsubstituiertem oder durch ein oder mehrere Rc substituiertem C6-C30-Aryl oder aus einer der folgenden Gruppen: 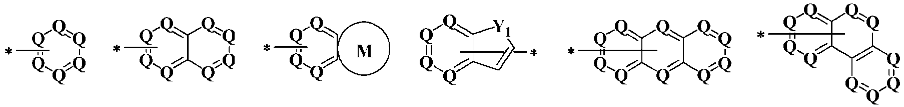 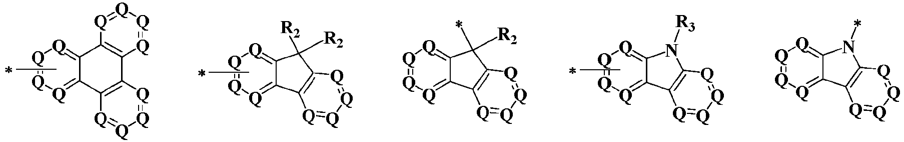 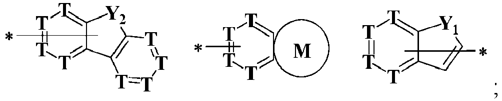
Q jeweils unabhängig ausgewählt wird aus C(Rd) oder einem N-Atom, wobei mindestens eines der Q in jeder Gruppe aus einem N-Atom ausgewählt wird;
T jeweils unabhängig ausgewählt wird aus C(Rd);
der Ring M jeweils unabhängig ausgewählt wird aus unsubstituiertem oder durch ein oder mehrere R4 substituiertem C3-C7-Aliphatenring;
Y₁ ausgewählt ist aus O, S, C(R₅)₂ oder N(R₆); Y2 ausgewählt ist aus einem O-Atom, einem S-Atom oder N(R₃);
Rd jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
R₂, R₄ und R₅ jeweils unabhängig ausgewählt werden aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
R₃ und R₆ jeweils unabhängig ausgewählt werden aus substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl; Rb und Rc jeweils unabhängig ausgewählt werden aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
unter der Bedingung, dass mindestens eines von R₁, Ra, Rb, Rc oder Rd aus einer Gruppe ausgewählt ist, die durch Formel III dargestellt wird: 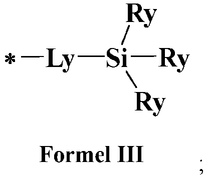
Ry jeweils unabhängig ausgewählt wird aus Wasserstoff, Deuterium, Cyano, Nitro, Halogen,
substituiertem oder unsubstituiertem C1-C12-Alkyl, substituiertem oder unsubstituiertem C2-C12-Alkenyl, substituiertem oder unsubstituiertem C3-C12-Cycloalkyl oder substituiertem oder unsubstituiertem C2-C12-Heterocycloalkyl;
Ly jeweils unabhängig ausgewählt wird aus Einfachbindung, substituiertem oder unsubstituiertem C6-C30-Aryl oder substituiertem oder unsubstituiertem C2-C30-Heteroaryl; Wenn zwei oder mehr R₁, Ra, Rb, Rc und Rd vorhanden sind, sind die zwei oder mehr R₁, Ra, Rb, Rc und Rd entweder identisch miteinander oder voneinander verschieden.

2. Die Fluoren-enthaltende heterocyclische Verbindung nach Anspruch 1, wobei die Fluoren-enthaltende heterocyclische Verbindung ausgewählt ist aus einer der folgenden Strukturen, die durch die Formeln IV-1 bis IV-5 dargestellt werden: 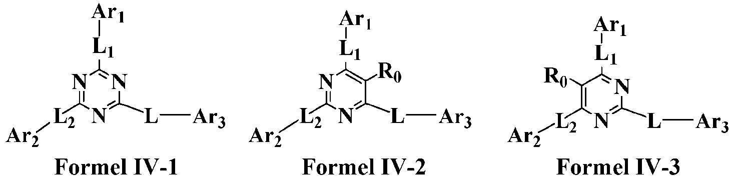 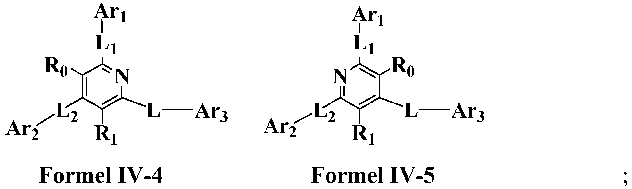 wobei Ar₁, Ar₂, Ar₃, L, Li, L₂ und R₀ die in Formel I angegebenen Bedeutungen haben.

3. Fluoren-enthaltende heterocyclische Verbindung nach Anspruch 1, wobei Ar₃ jeweils unabhängig ausgewählt wird aus einer der folgenden Gruppen: 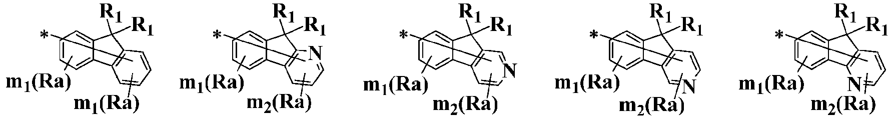 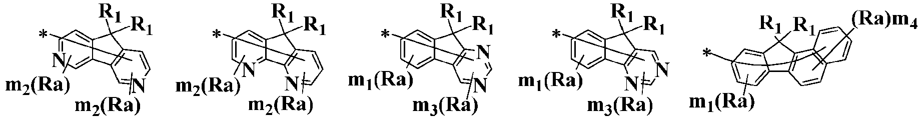 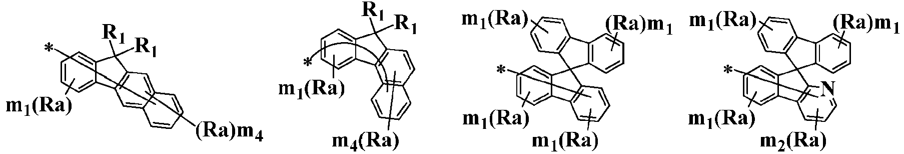 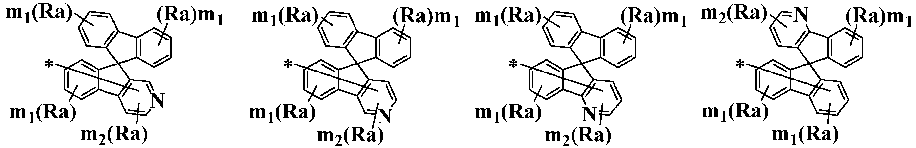 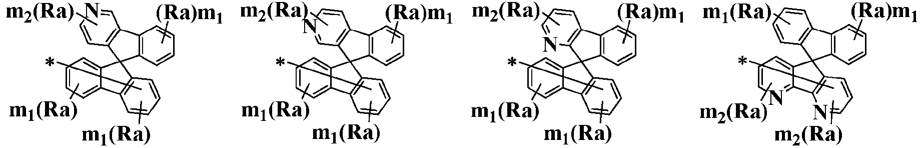 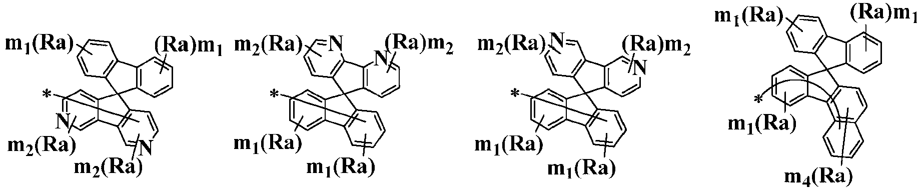 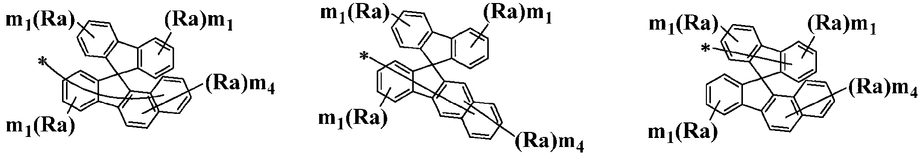 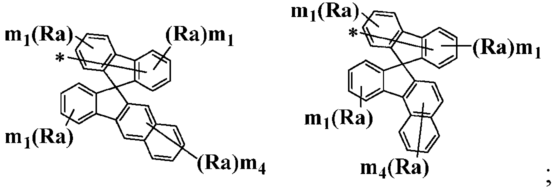
wobei R₁ jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl; oder wobei zwei benachbarte R₁ miteinander verknüpft sind, um eine der folgenden Ringsystemgruppen zu bilden: 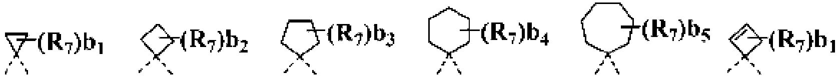 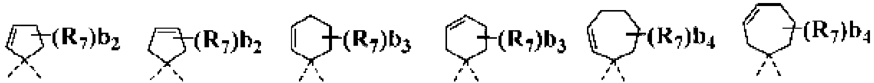 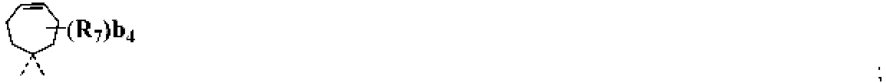
R7 jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
n₁ wird unabhängig ausgewählt aus 0, 1, 2, 3 oder 4, n₂ wird unabhängig ausgewählt aus 0, 1, 2, 3, 4, 5 oder 6, n₃ wird unabhängig ausgewählt aus 0, 1, 2, 3, 4, 5, 6, 7 oder 8, n₄ wird unabhängig ausgewählt aus 0, 1, 2, 3, 4, 5, 6, 7, 8, 9 oder 10, und n₅ wird unabhängig ausgewählt aus 0, 1, 2, 3, 4, 5, 6, 7, 8, 9, 10, 11 oder 12;
Ra jeweils unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
m₁ j unabhängig ausgewählt wird aus 0, 1, 2, 3 oder 4, m₂ unabhängig ausgewählt wird aus 0, 1, 2 oder 3, m₃ unabhängig ausgewählt wird aus 0, 1 oder 2 und m₄ unabhängig ausgewählt wird aus 0, 1, 2, 3, 4, 5 oder 6.

4. Fluoren-enthaltende heterocyclische Verbindung nach Anspruch 1, wobei mindestens eines von Ra, Rc oder Rd aus einer Gruppe ausgewählt ist, die durch Formel III dargestellt wird, und wobei, wenn zwei oder mehr Ra, Rc und Rd vorhanden sind, diese identisch oder voneinander verschieden sind.

5. Fluoren-enthaltende heterocyclische Verbindung nach Anspruch 1, wobei Formel III aus einer der folgenden Gruppen ausgewählt ist:

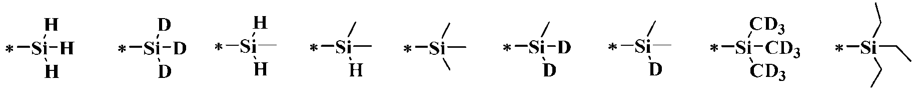

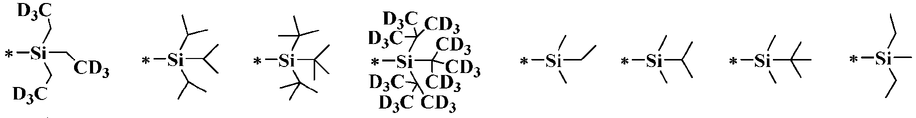

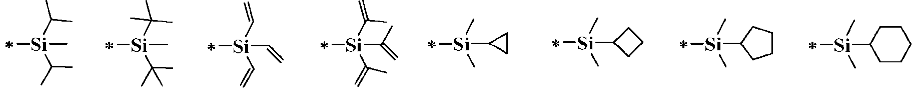

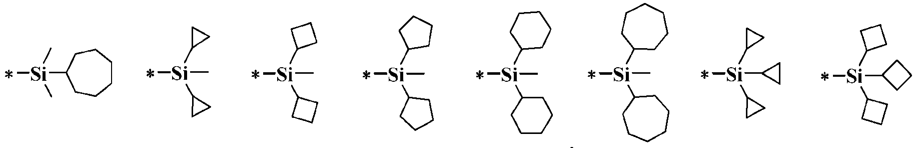

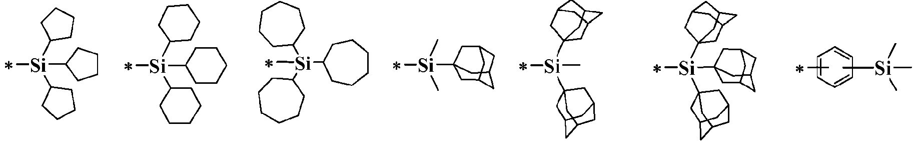

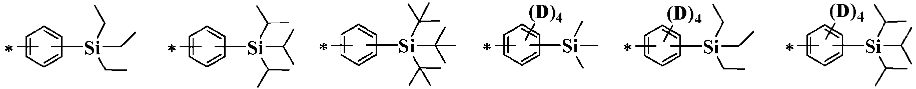

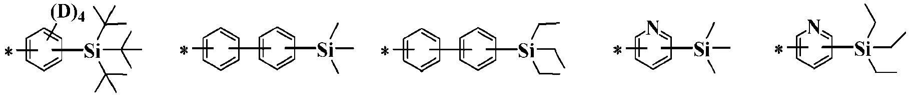

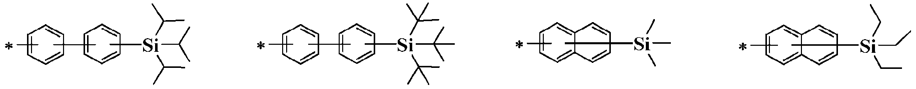

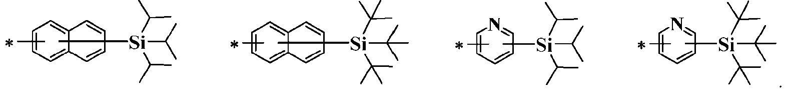

6. Fluoren-enthaltende heterocyclische Verbindung nach Anspruch 1, wobei Ar₁ und Ar₂ jeweils unabhängig ausgewählt werden aus einer der folgenden Gruppen: 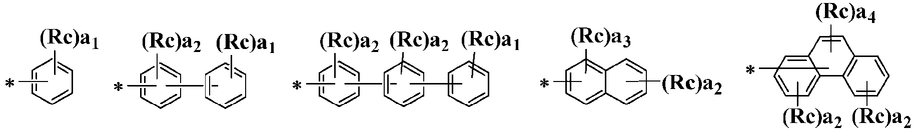 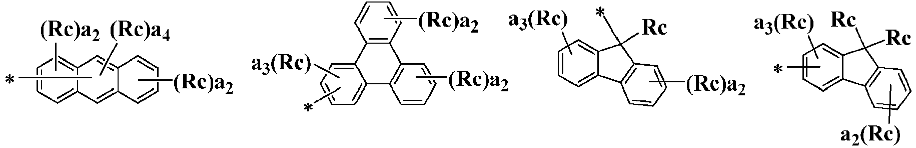 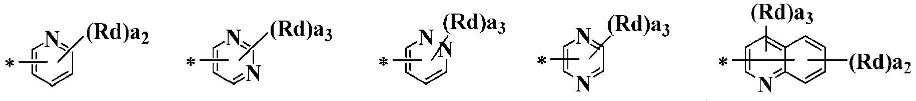 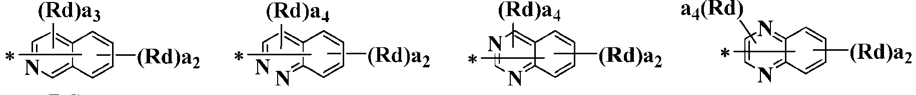 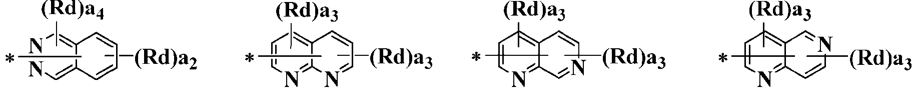 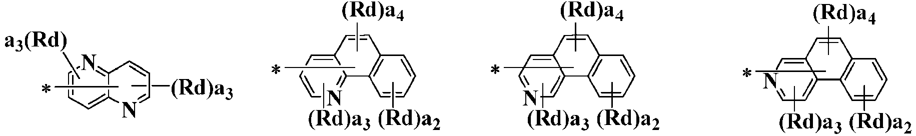 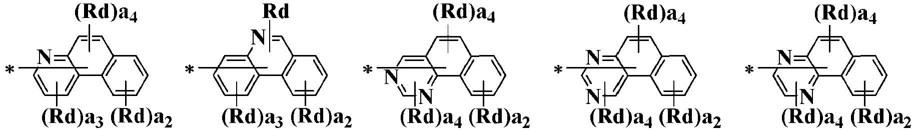 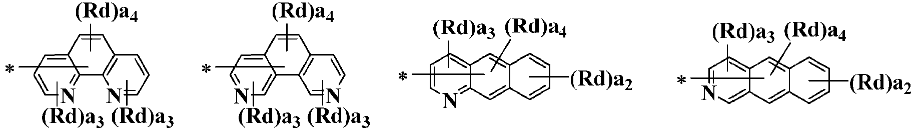 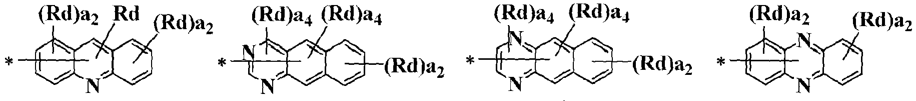 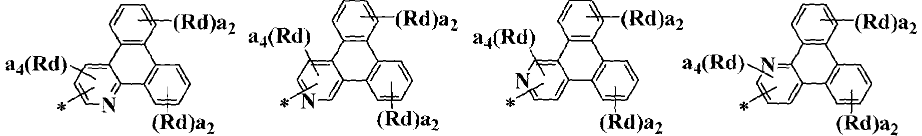 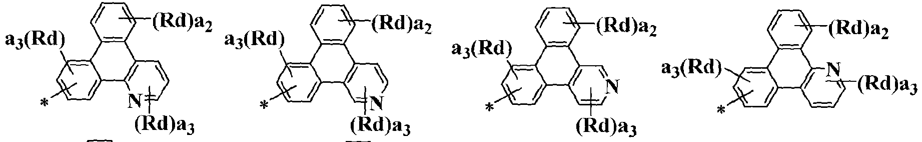 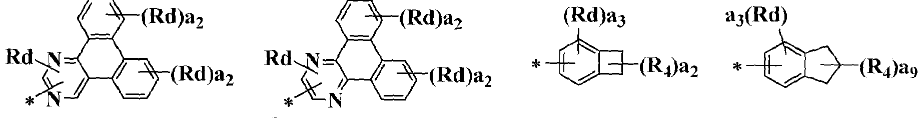 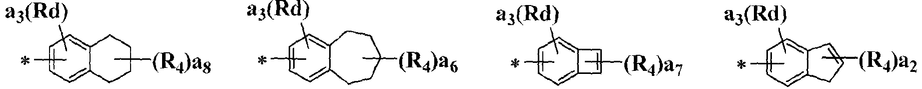 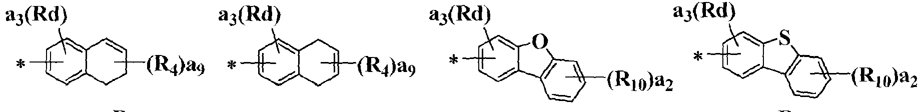 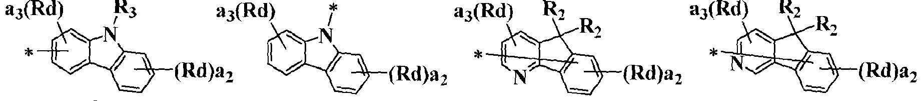 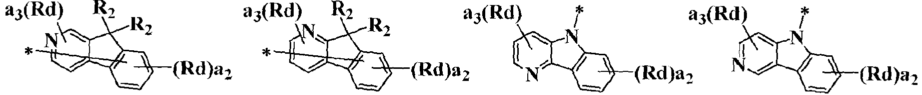 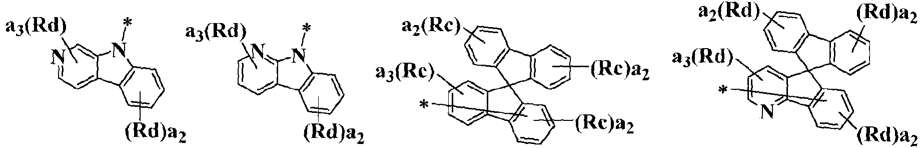 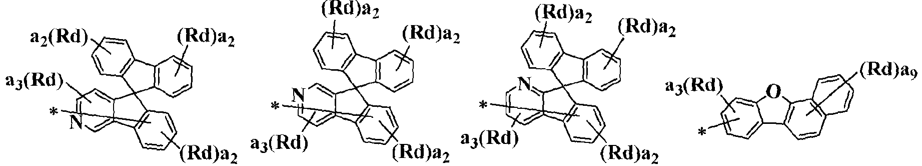 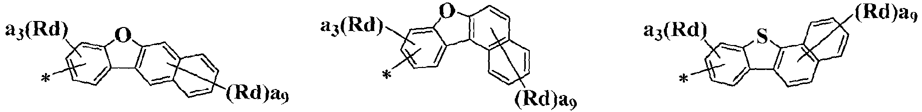 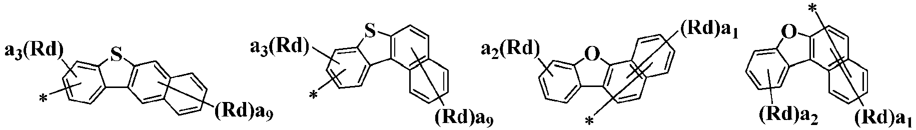 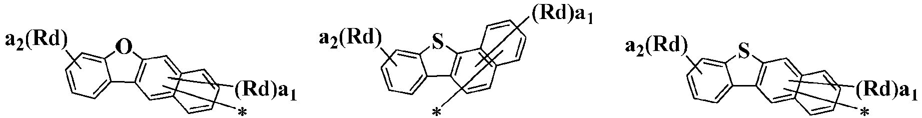 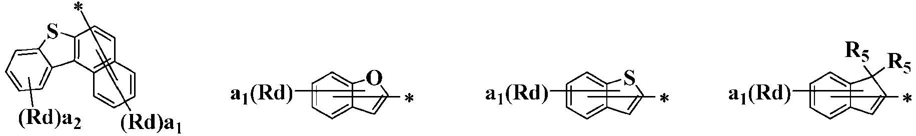 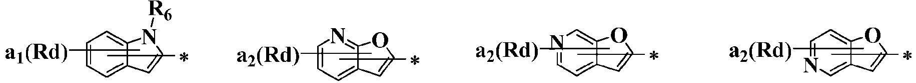 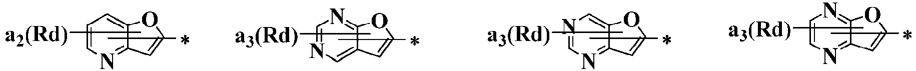 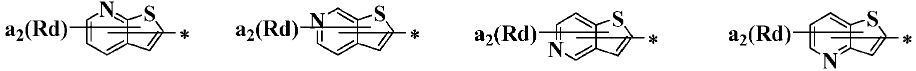 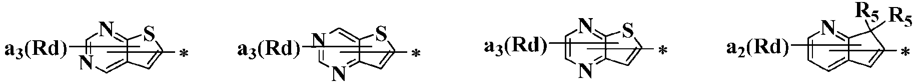 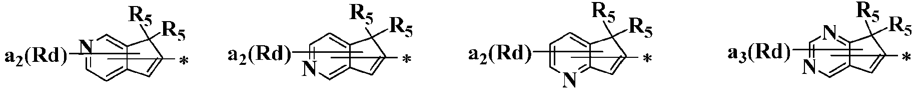 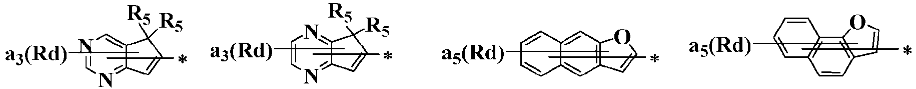 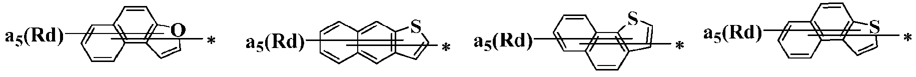 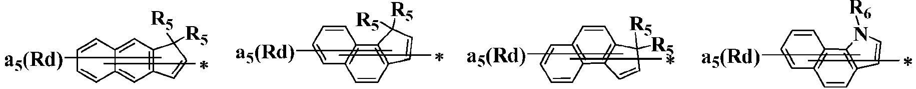 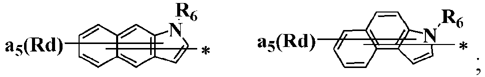
wobei Rc, Rd, R₂, R₃, R₄, R₅ und R₆ die in Formel I angegebenen Bedeutungen haben;
a₁ wird unabhängig ausgewählt aus 0, 1, 2, 3, 4 oder 5, a₂ wird unabhängig ausgewählt aus 0, 1, 2, 3 oder 4, a₃ wird unabhängig ausgewählt aus 0, 1, 2 oder 3, a₄ wird unabhängig ausgewählt aus 0, 1 oder 2 ausgewählt, a₅ wird unabhängig ausgewählt aus 0, 1, 2, 3, 4, 5, 6 oder 7, a₆ wird unabhängig ausgewählt aus 0, 1, 2, 3, 4, 5, 6, 7, 8, 9 oder 10, a₇ wird unabhängig ausgewählt aus 0, 1 oder 2, a₈ wird unabhängig ausgewählt aus 0, 1, 2, 3, 4, 5, 6, 7 oder 8, und a₉ wird unabhängig ausgewählt aus 0, 1, 2, 3, 4, 5 oder 6 ausgewählt.

7. Fluoren-enthaltende heterocyclische Verbindung nach Anspruch 1, wobei L, L₁ und L₂ jeweils unabhängig ausgewählt werden aus einer Einfachbindung oder einer der folgenden Gruppen: 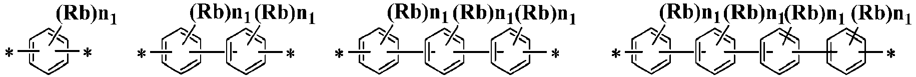 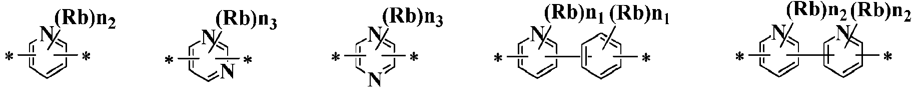 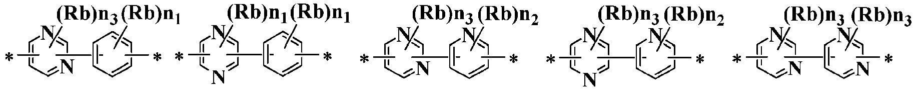 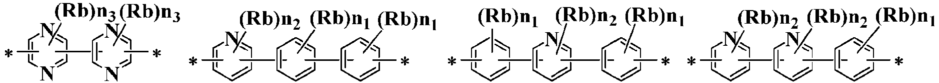 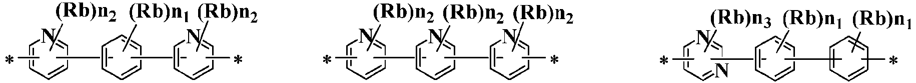 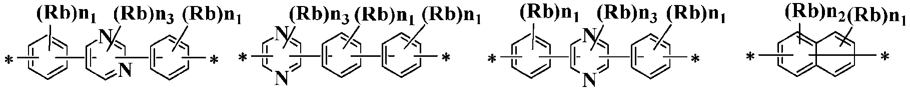 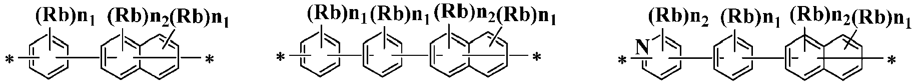 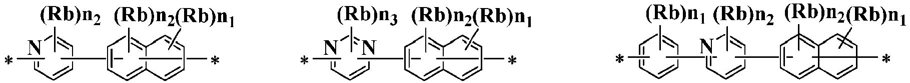 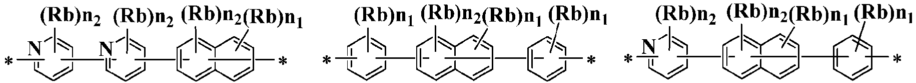 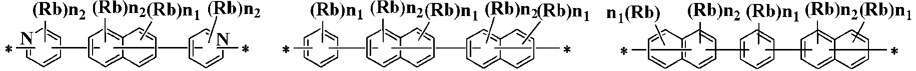 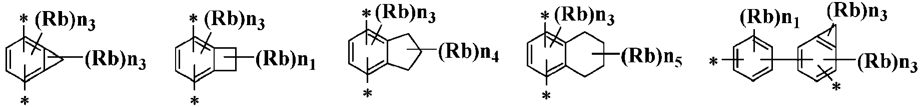 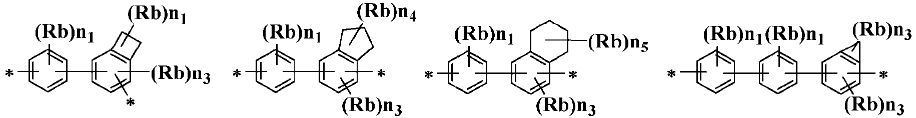 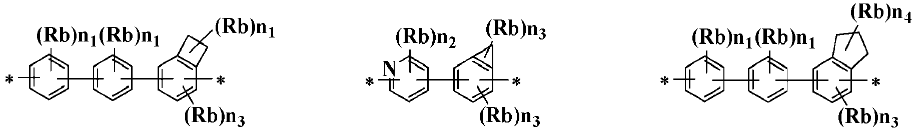 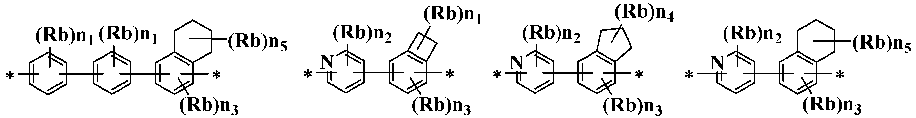 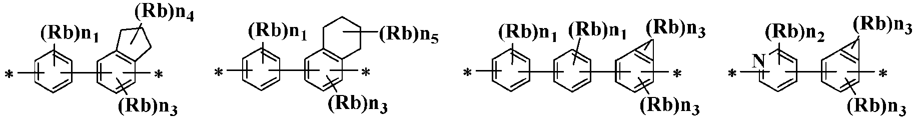 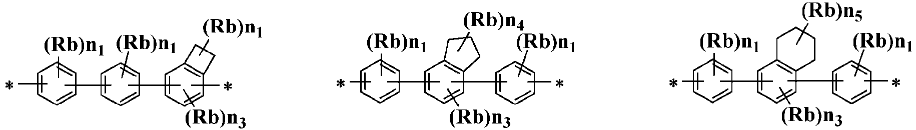 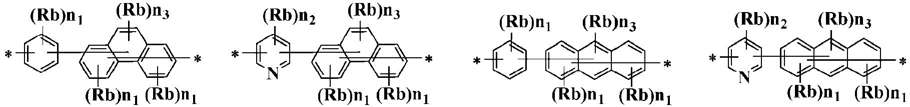 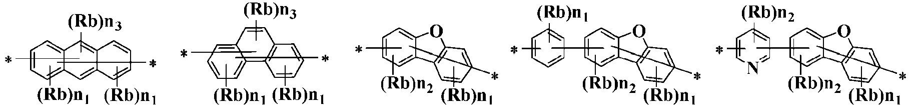 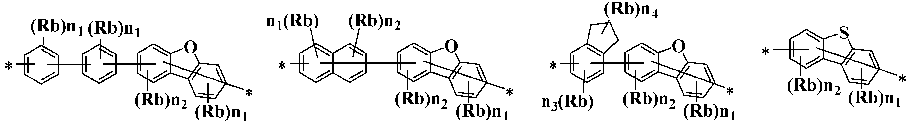 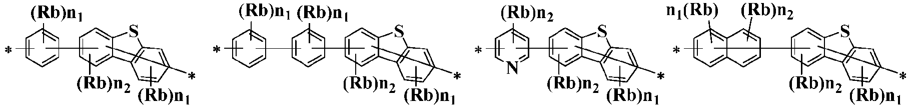 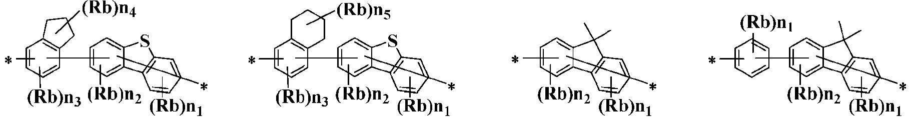 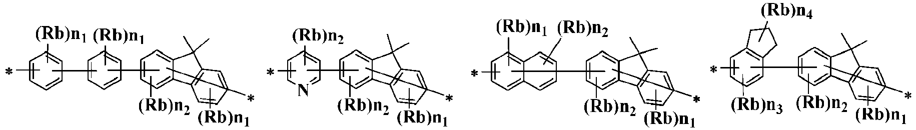 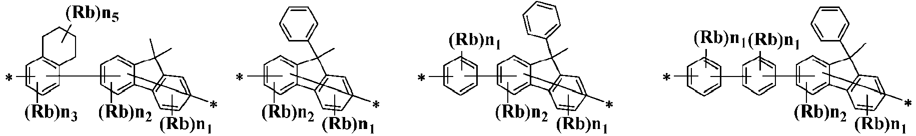 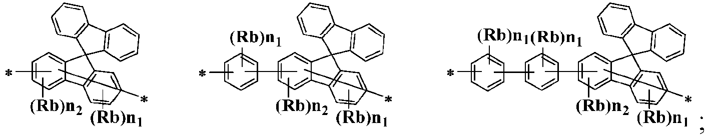
wobei Rb unabhängig ausgewählt wird aus Wasserstoff, Deuterium, Tritium, Cyano, Halogen, Nitro, substituiertem oder unsubstituiertem C1-C12-Alkyl, substituiertem oder unsubstituiertem Silyl, substituiertem oder unsubstituiertem C1-C12-Alkoxy, substituiertem oder unsubstituiertem C3-C12-Cycloalkyl, substituiertem oder unsubstituiertem C2-C12-Heterocycloalkyl, substituiertem oder unsubstituiertem C6-C30-Aryl oder substituiertem oder unsubstituiertem C2-C30-Heteroaryl;
n₁ wird unabhängig ausgewählt aus 0, 1, 2, 3 oder 4, n₂ wird unabhängig ausgewählt aus 0, 1, 2 oder 3, n₃ wird unabhängig ausgewählt aus 0, 1 oder 2, n₄ wird unabhängig ausgewählt aus 0, 1, 2, 3, 4, 5 oder 6, und n₅ wird unabhängig ausgewählt aus 0, 1, 2, 3, 4, 5, 6, 7 oder 8.

8. Fluoren-enthaltende heterocyclische Verbindung nach Anspruch 1, wobei die heterocyclische Verbindung ausgewählt ist aus einer der folgenden Strukturen:

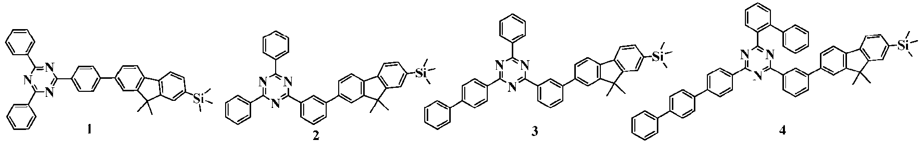

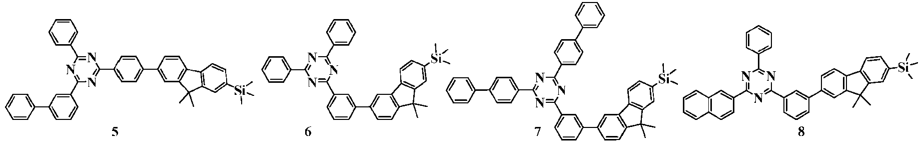

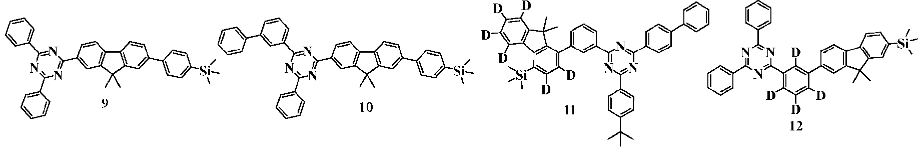

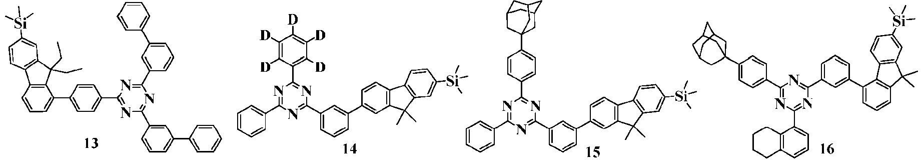

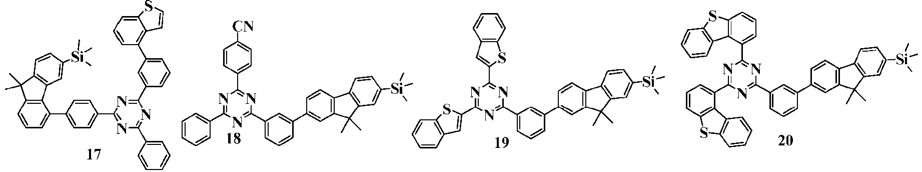

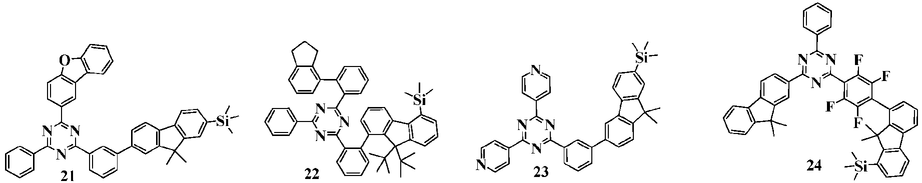

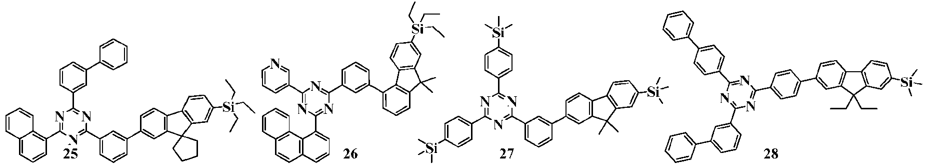

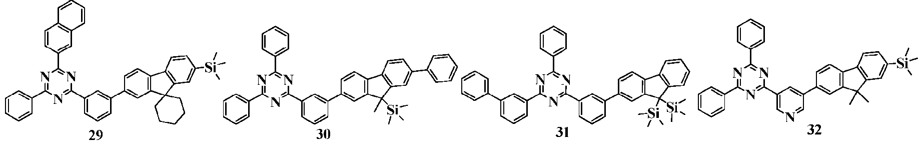

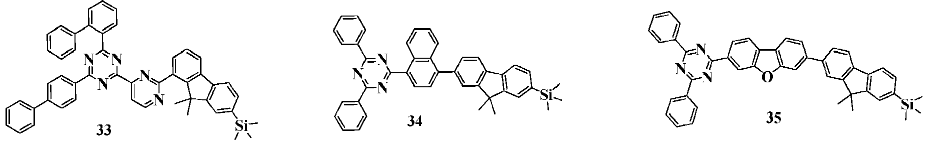

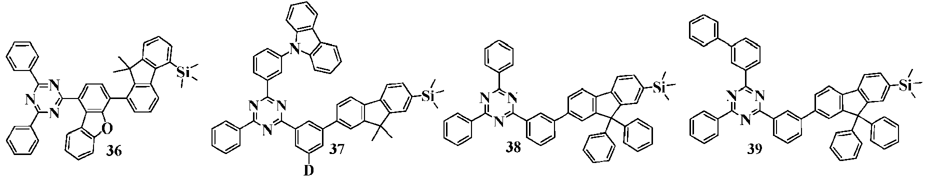

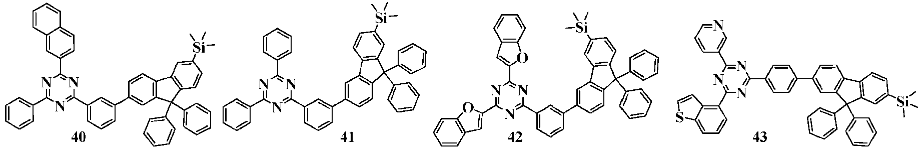

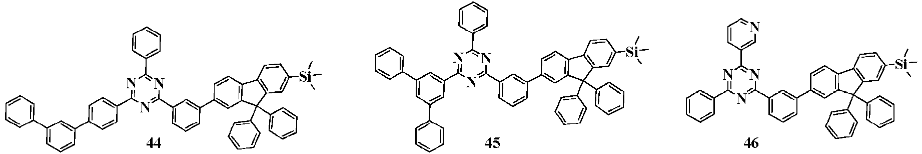

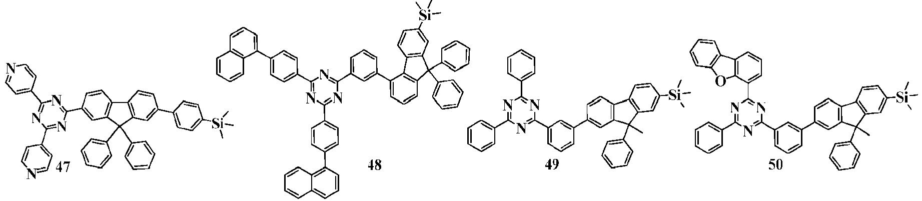

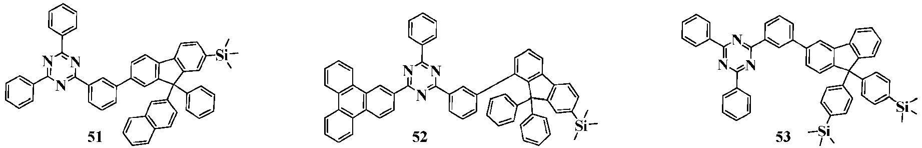

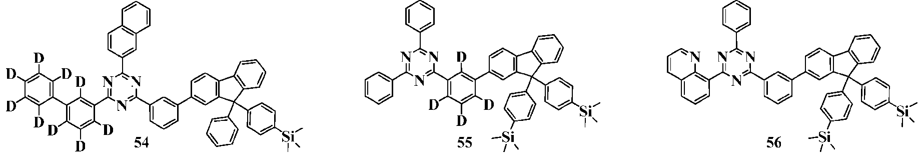

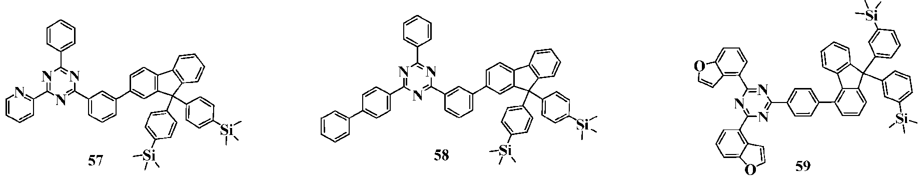

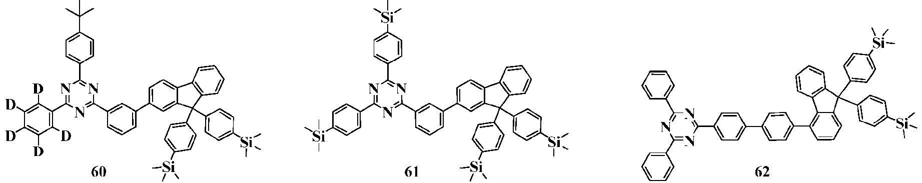

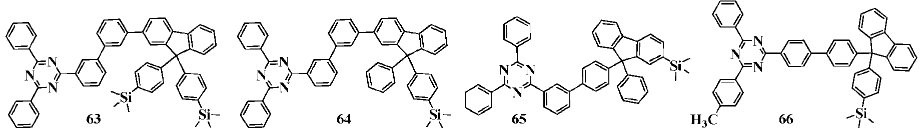

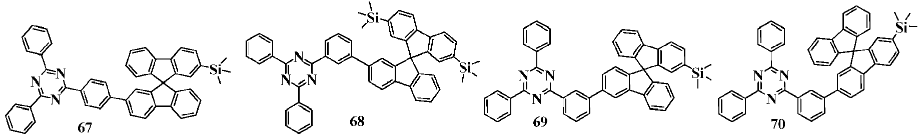

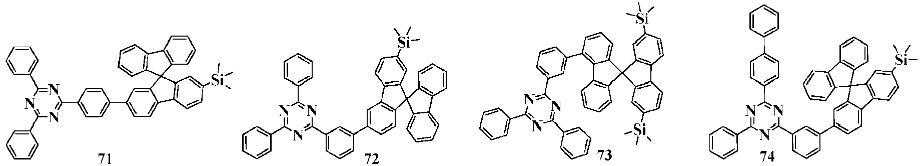

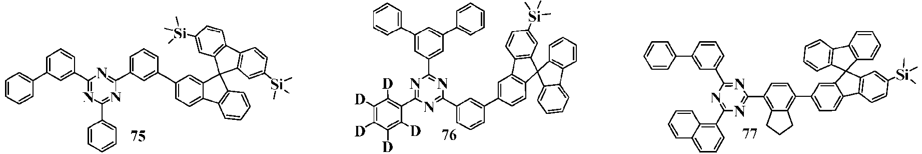

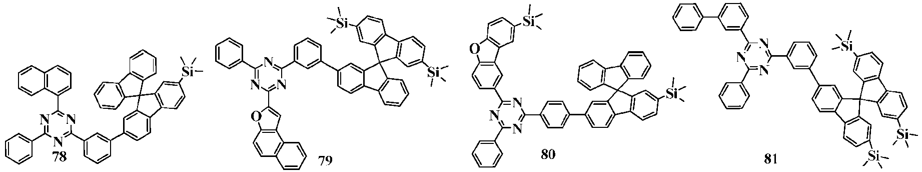

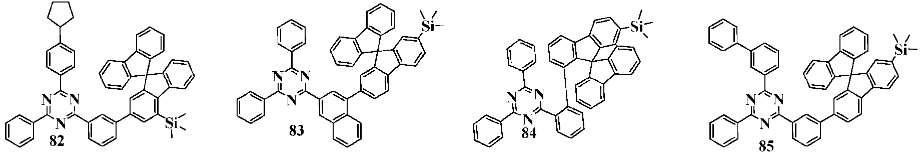

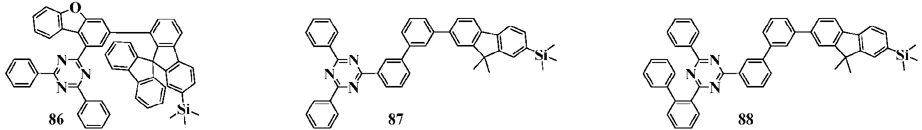

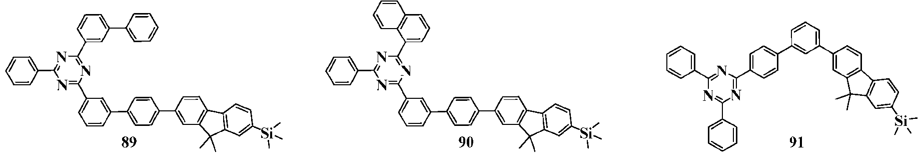

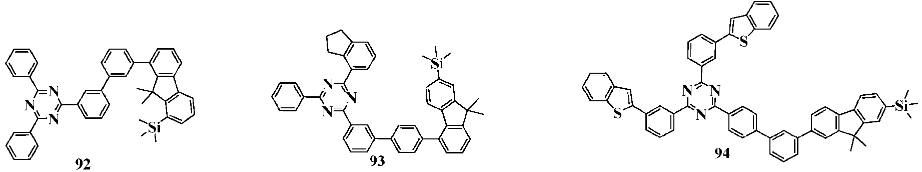

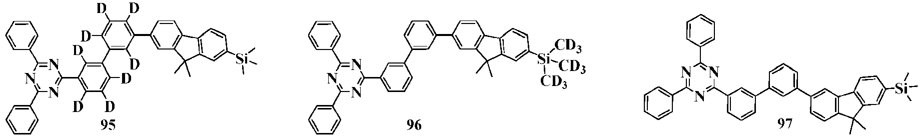

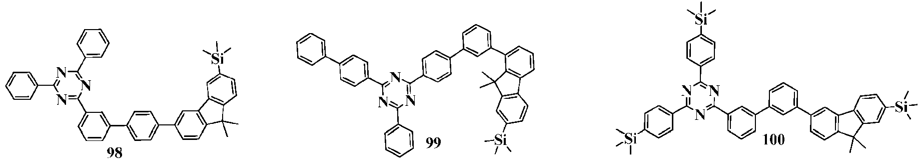

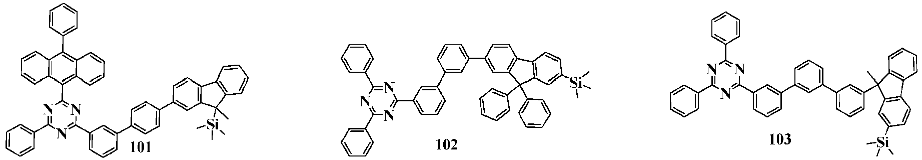

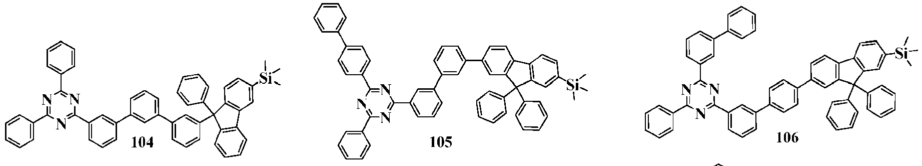

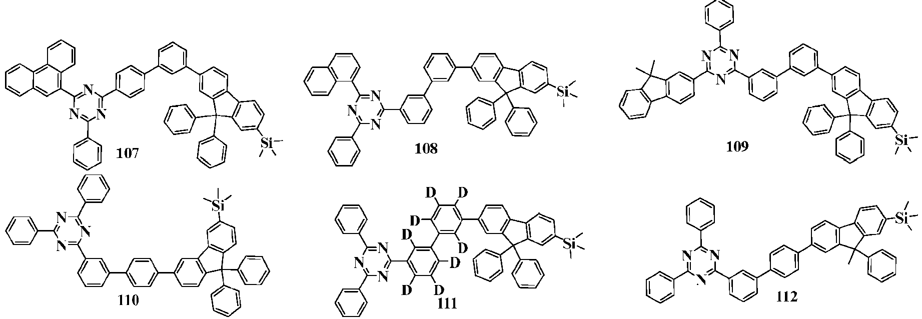

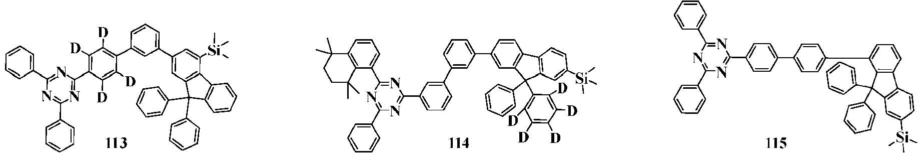

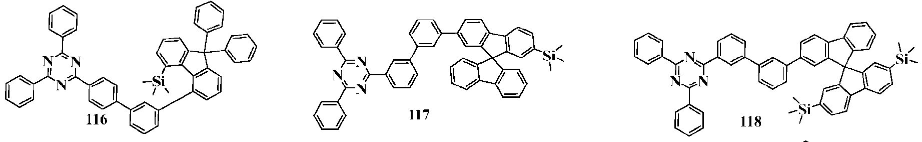

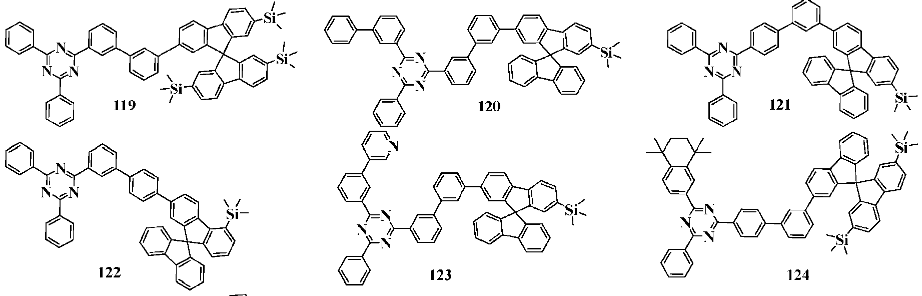

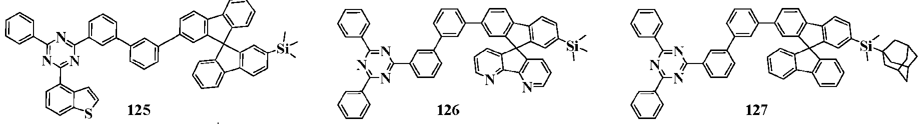

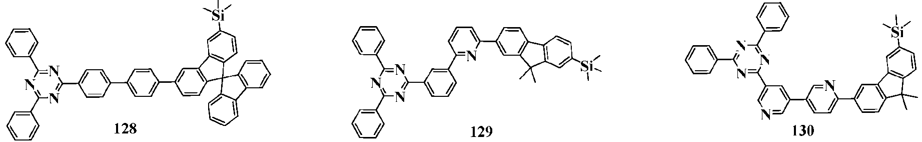

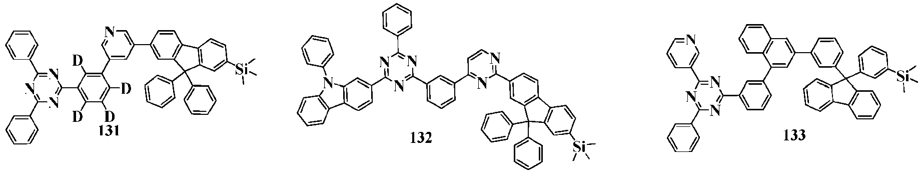

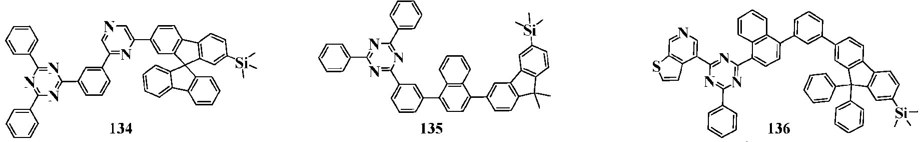

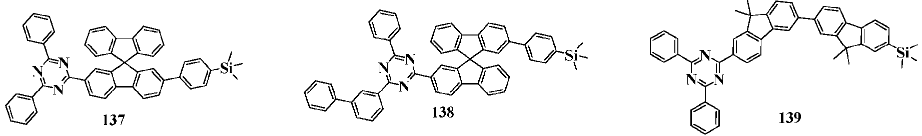

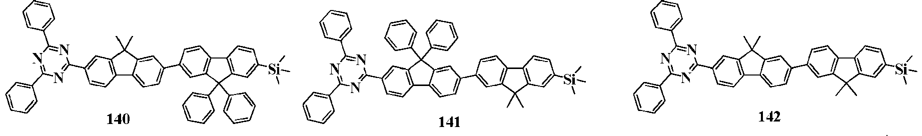

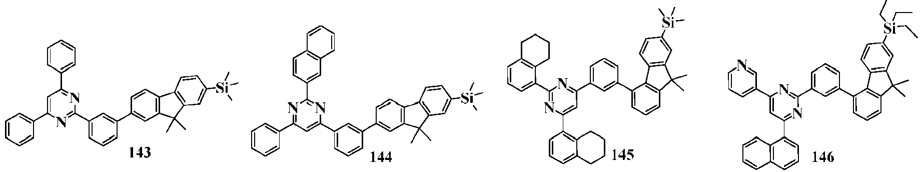

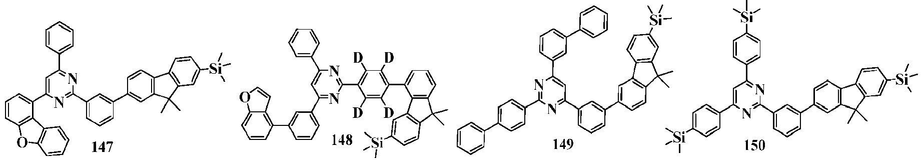

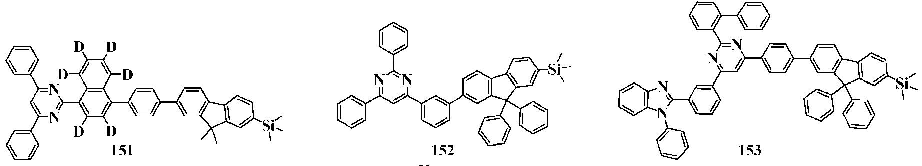

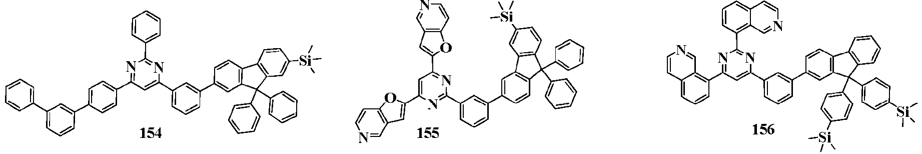

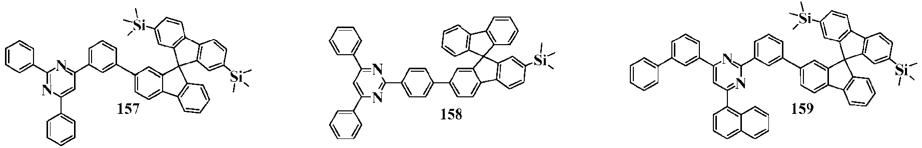

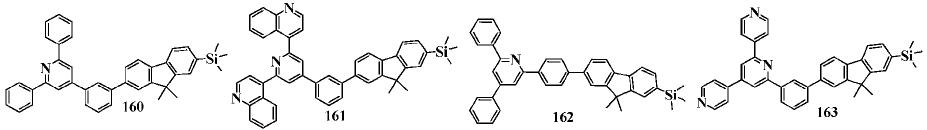

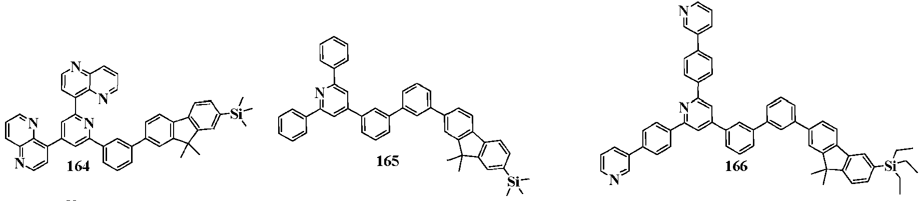

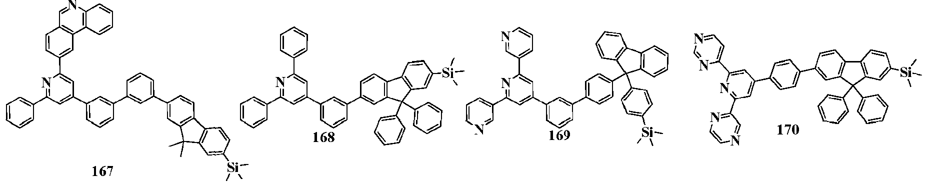

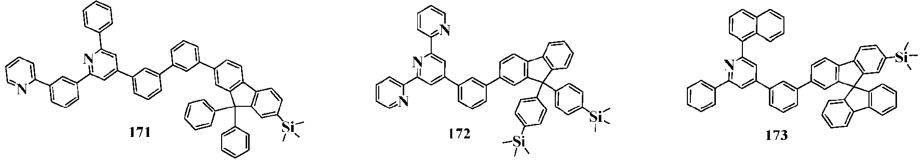

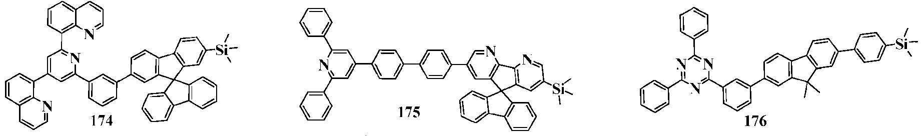

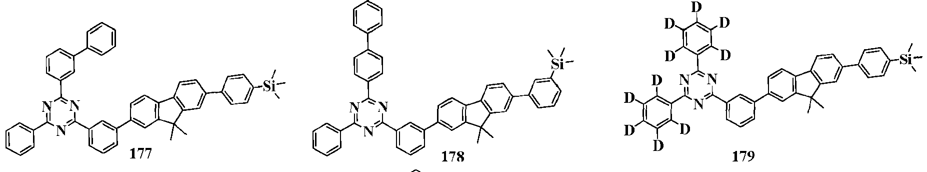

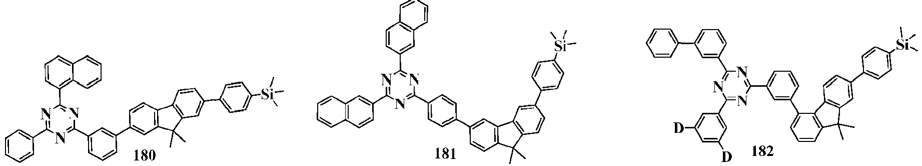

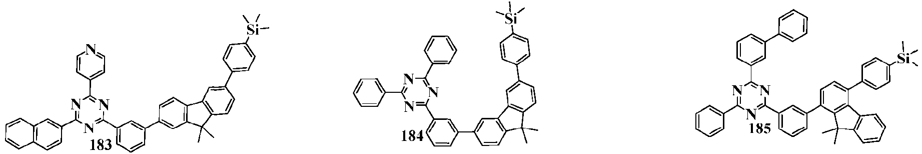

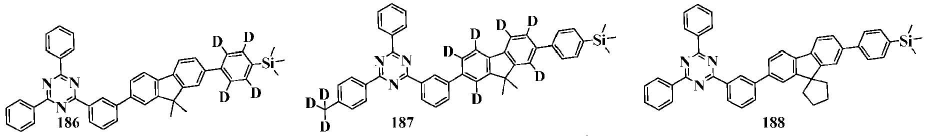

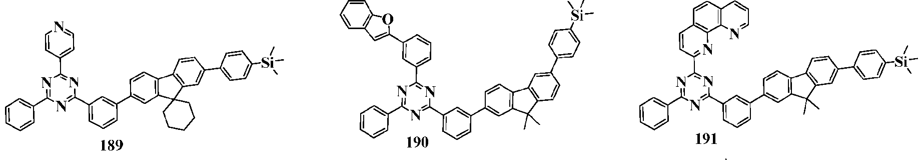

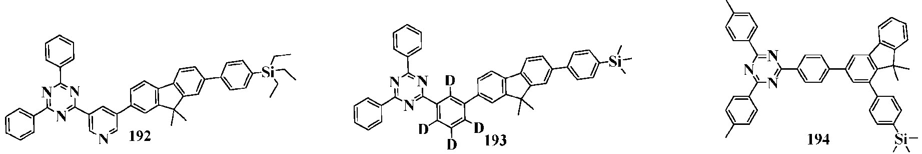

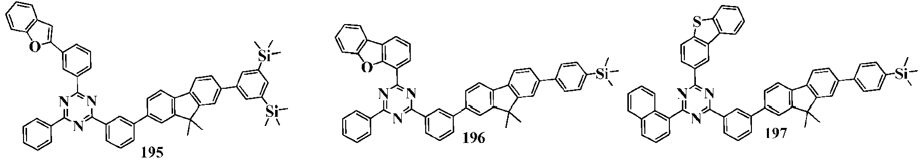

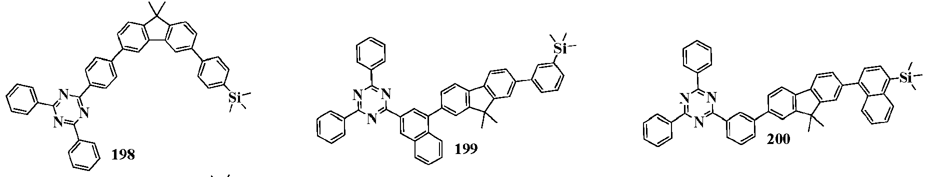

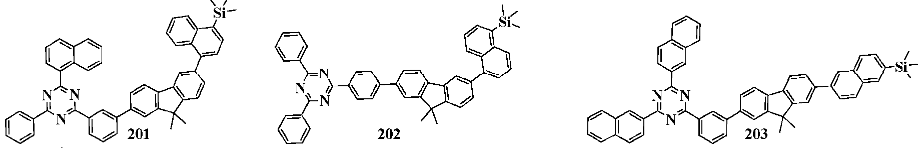

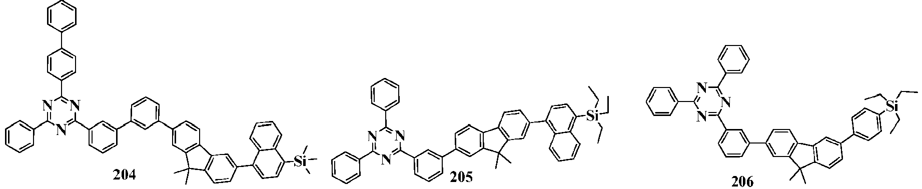

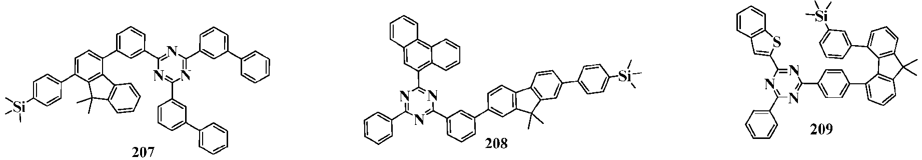

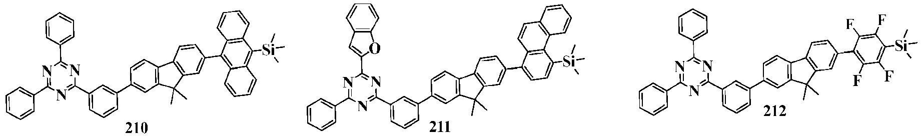

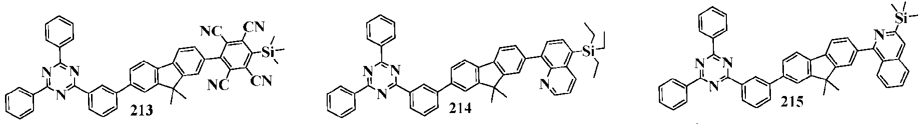

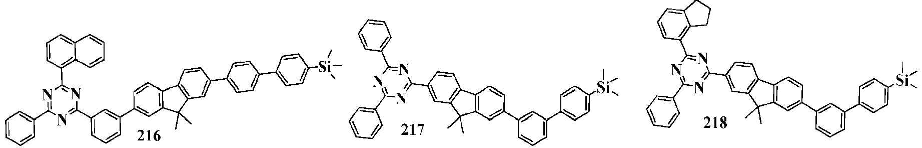

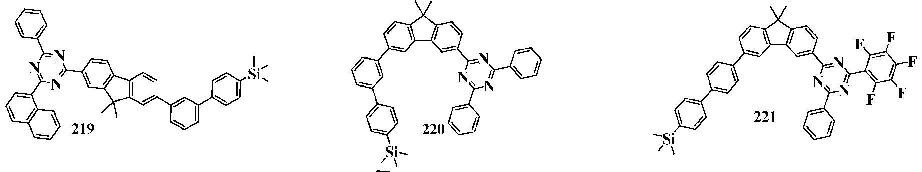

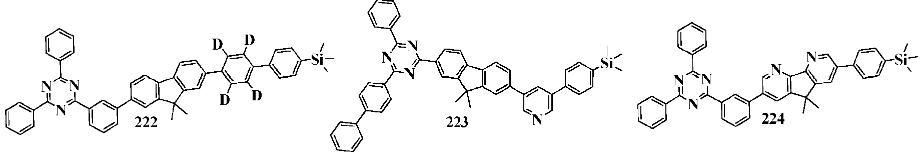

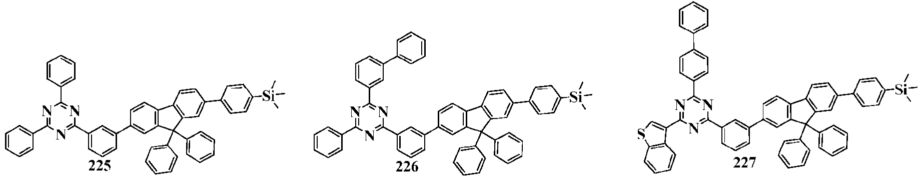

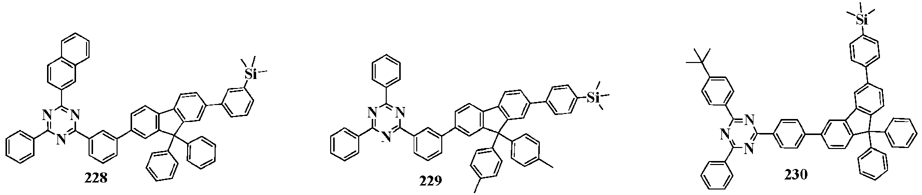

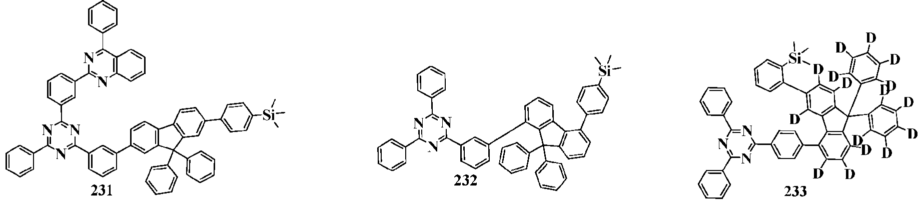

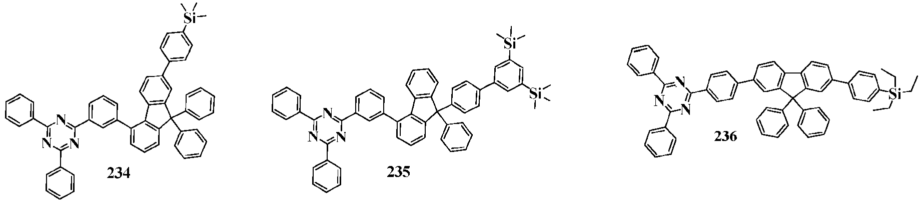

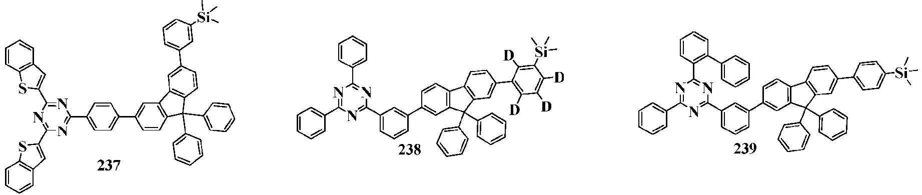

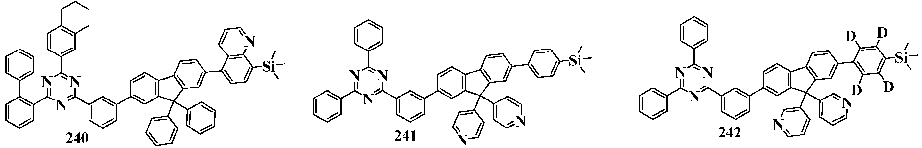

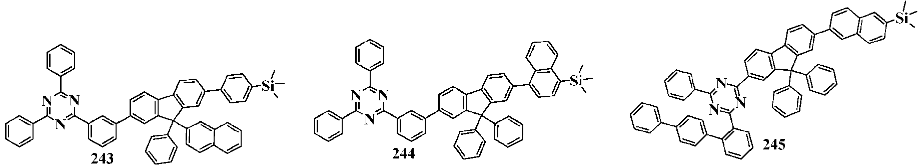

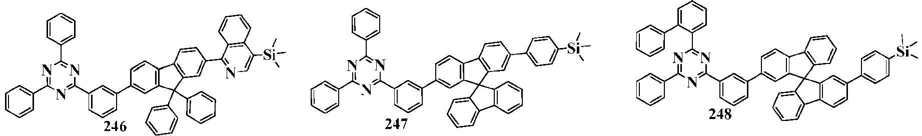

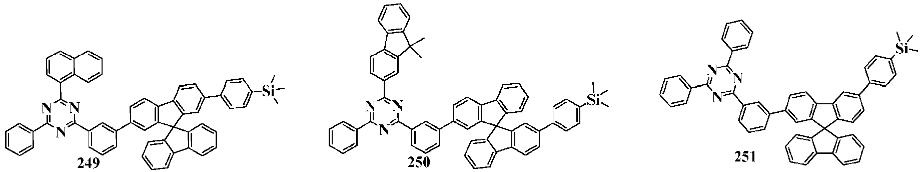

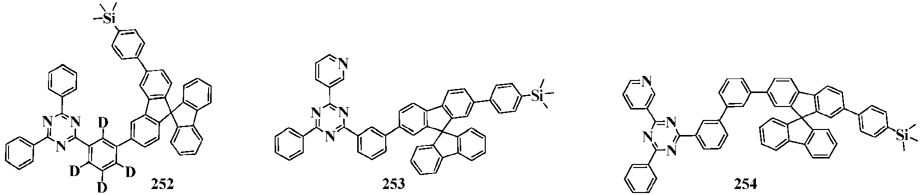

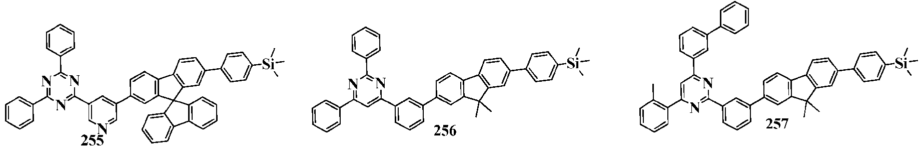

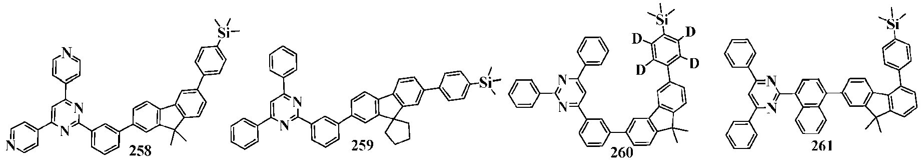

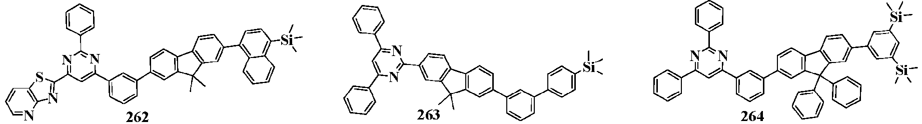

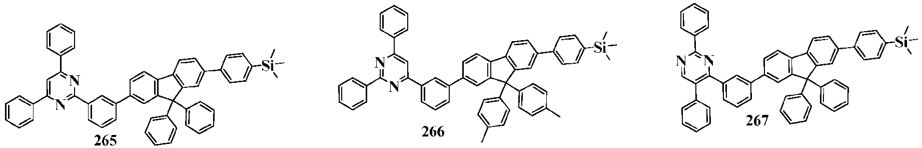

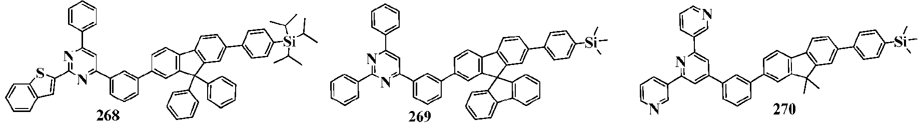

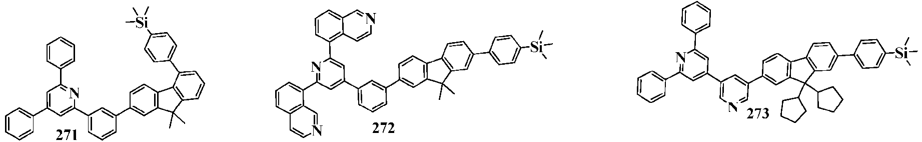

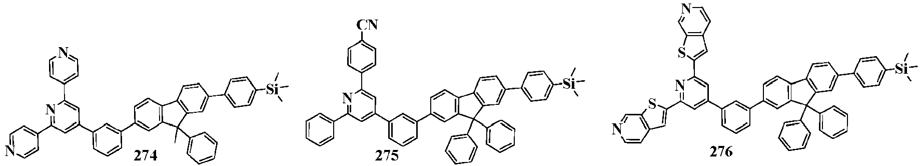

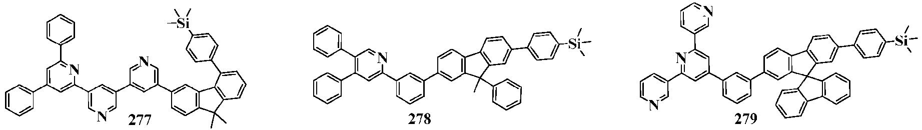

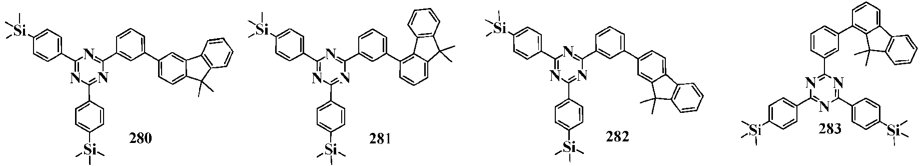

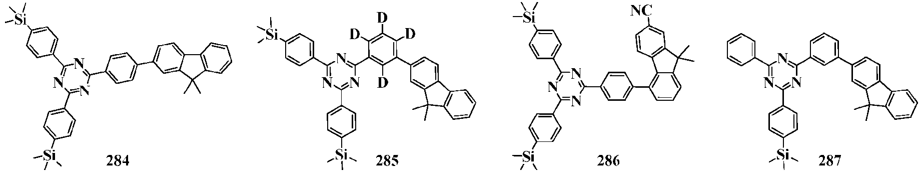

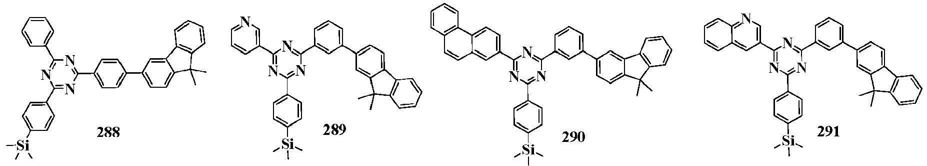

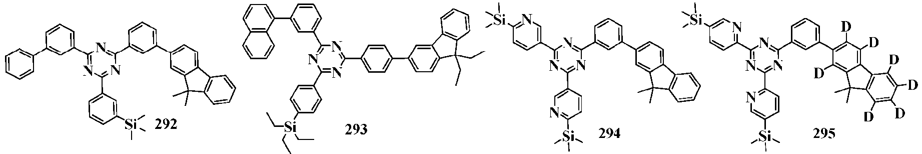

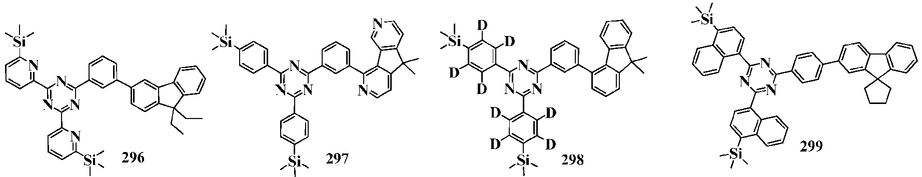

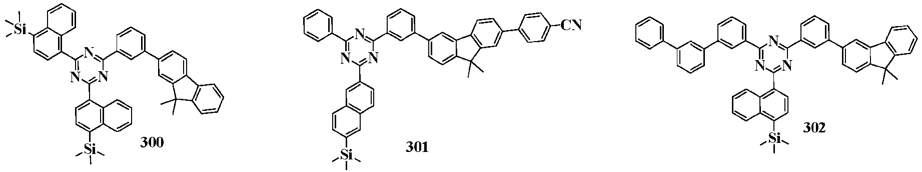

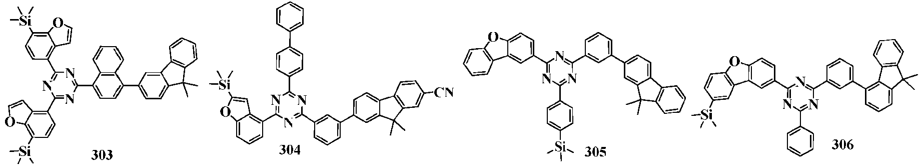

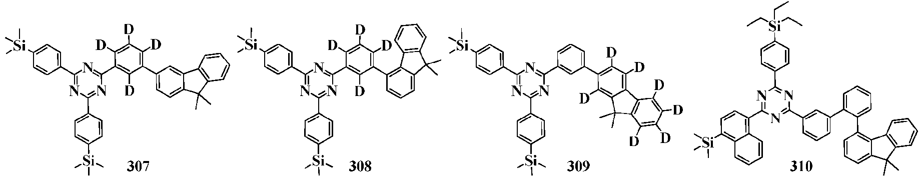

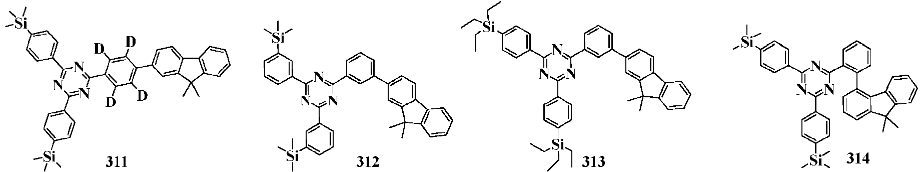

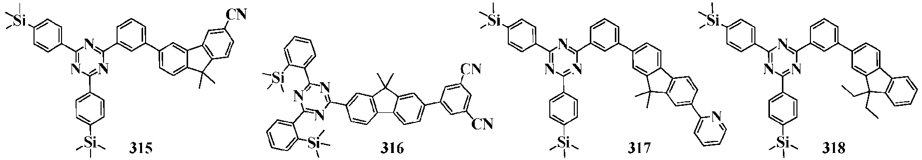

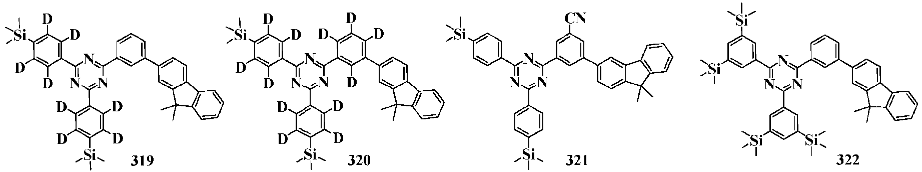

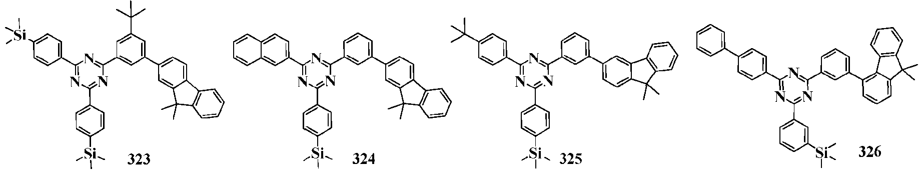

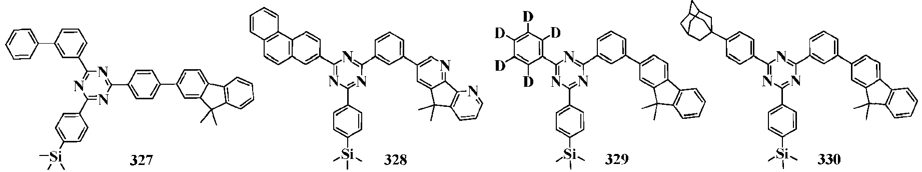

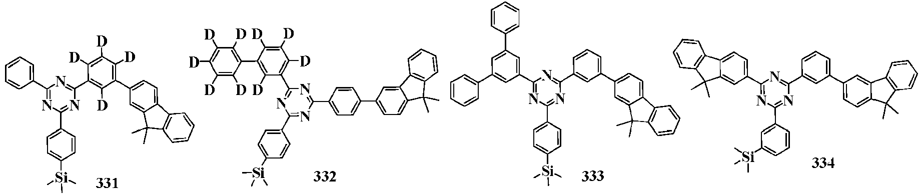

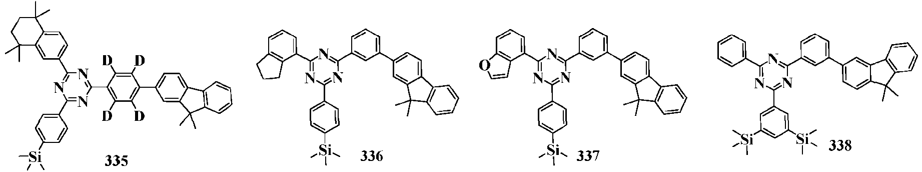

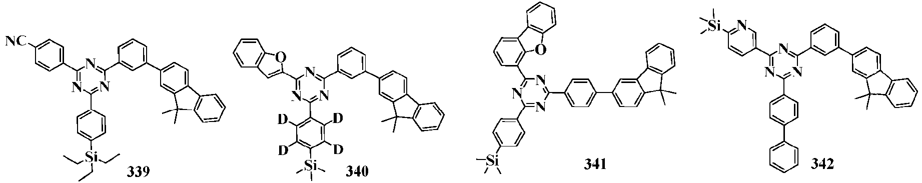

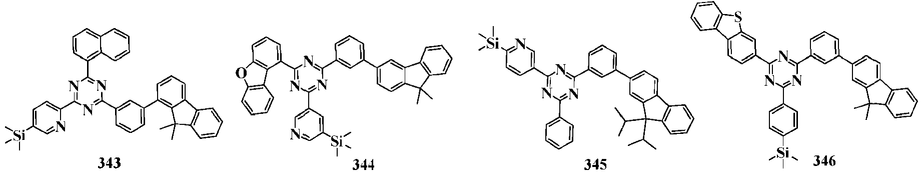

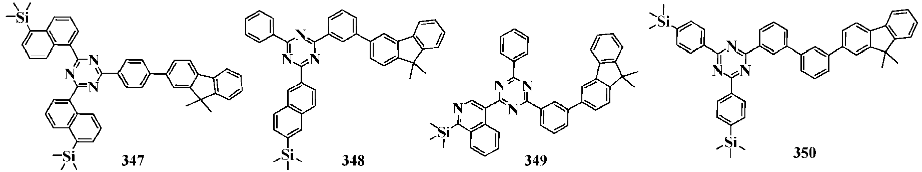

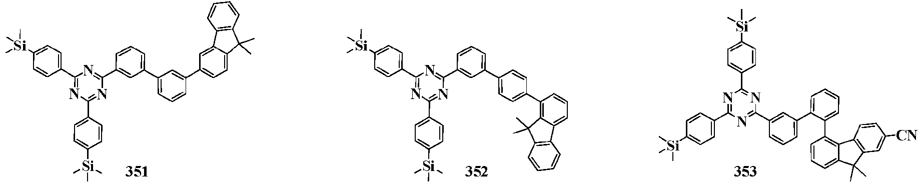

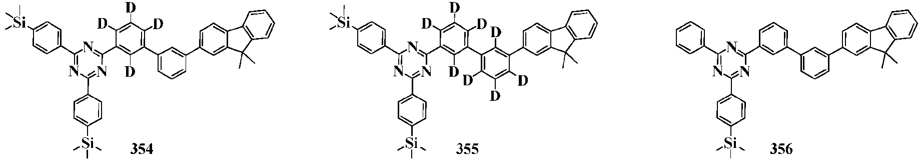

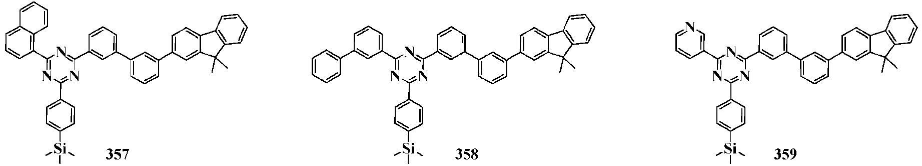

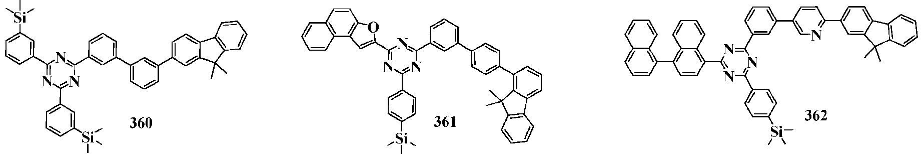

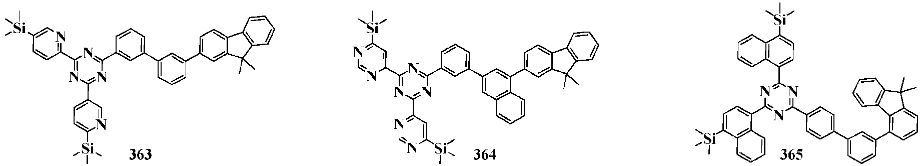

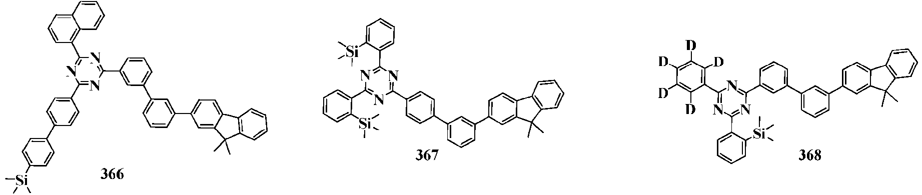

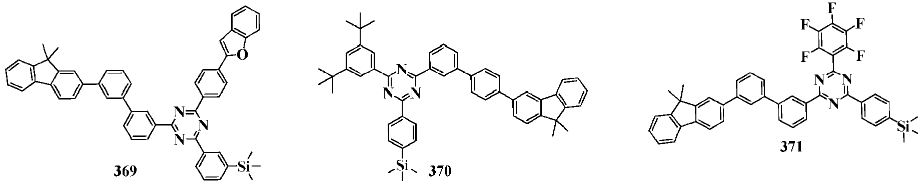

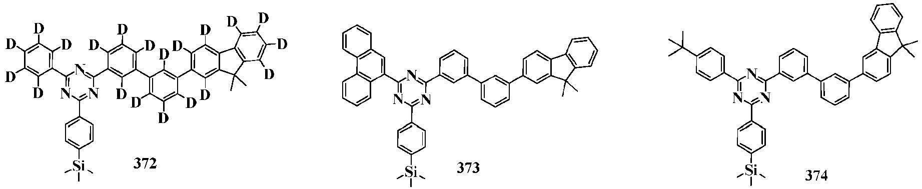

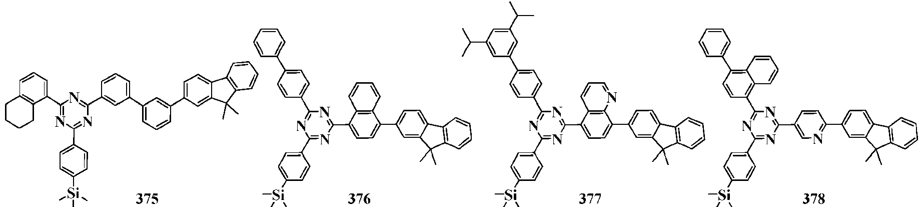

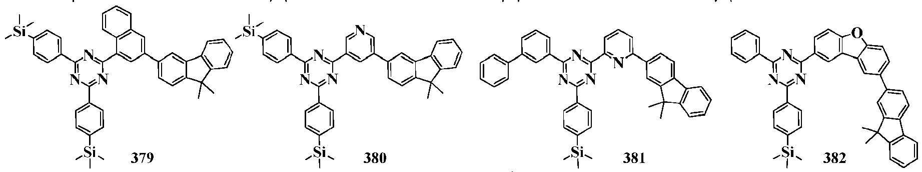

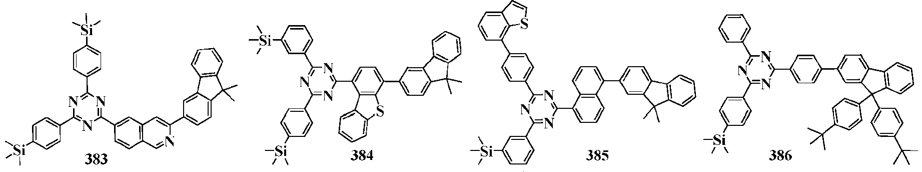

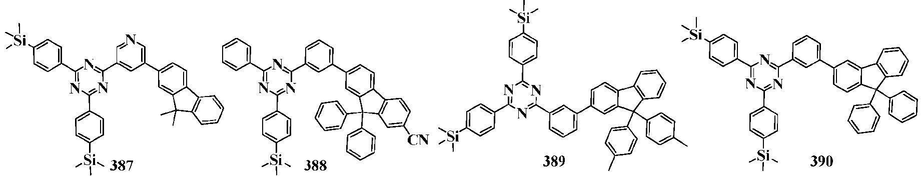

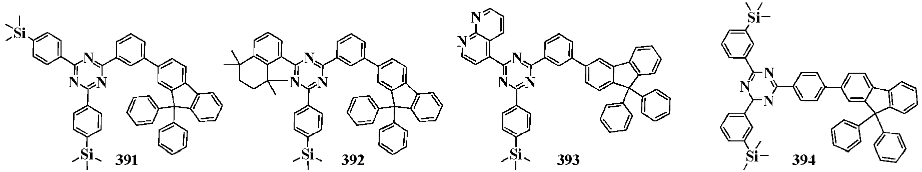

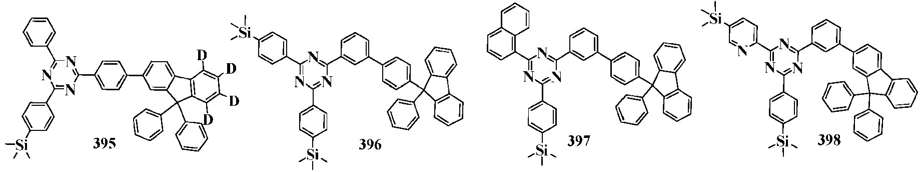

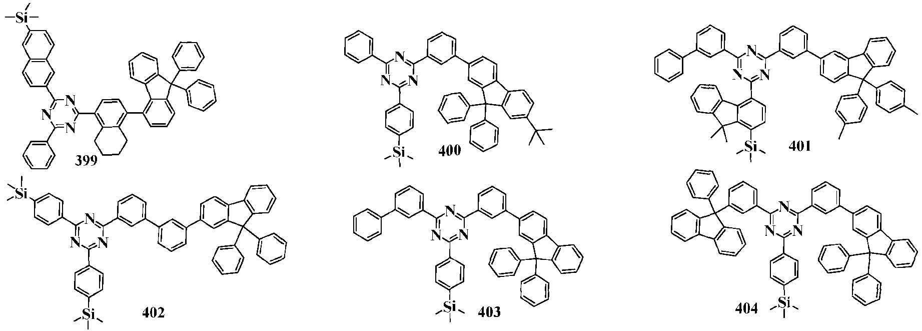

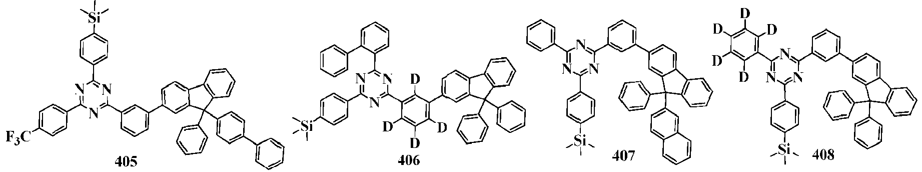

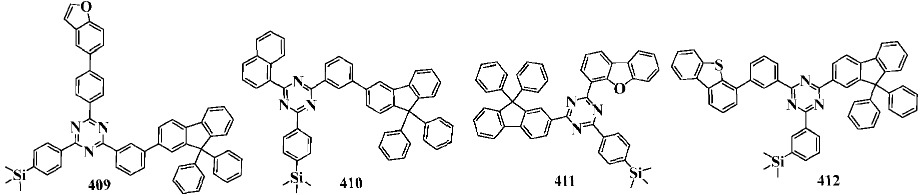

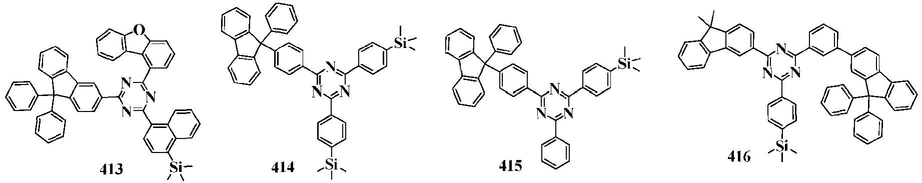

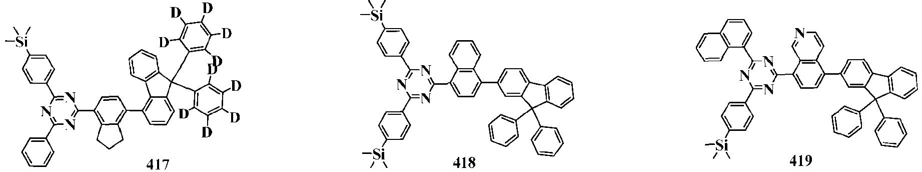

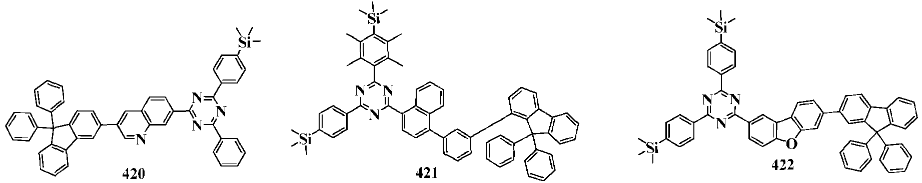

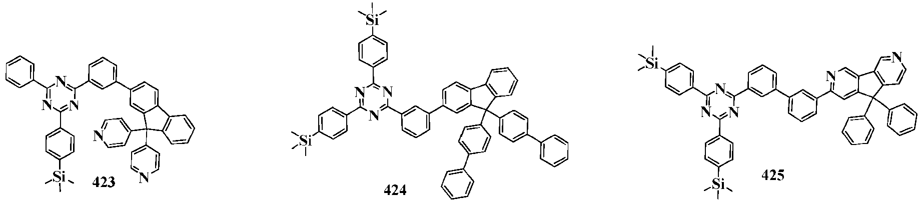

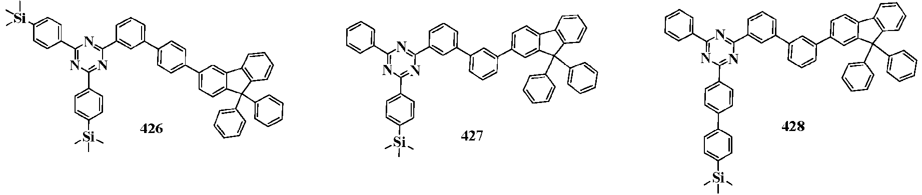

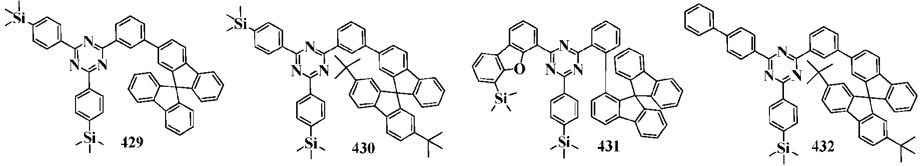

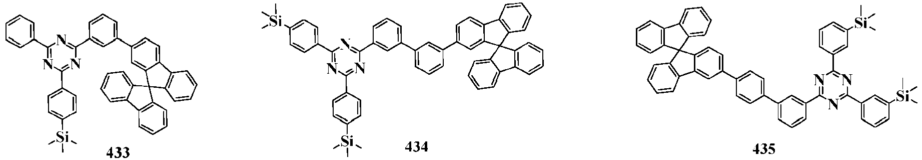

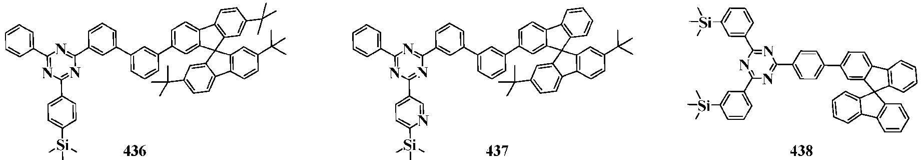

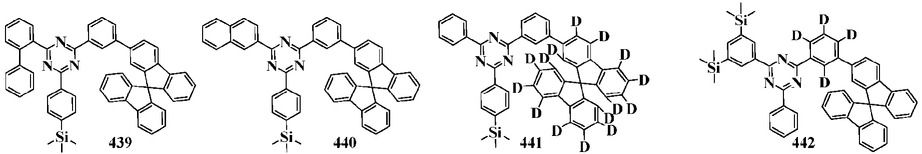

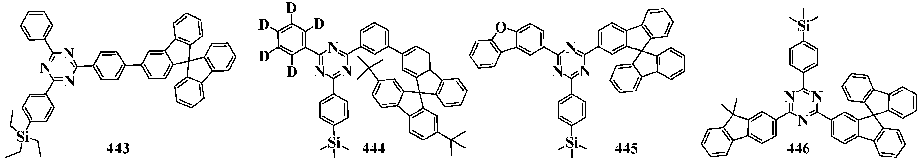

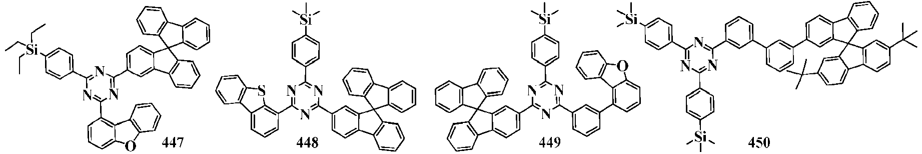

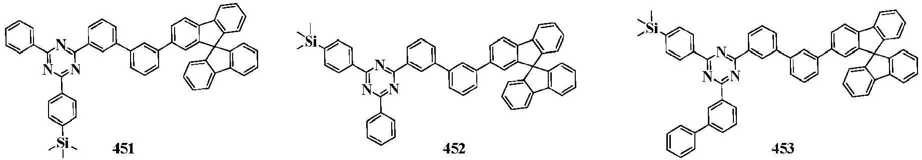

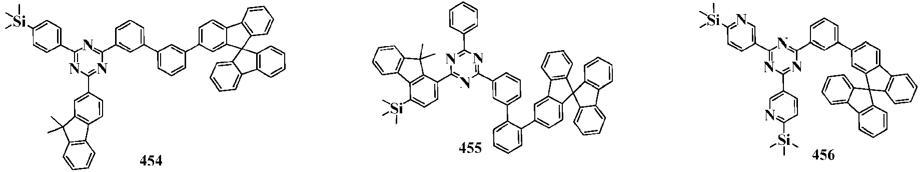

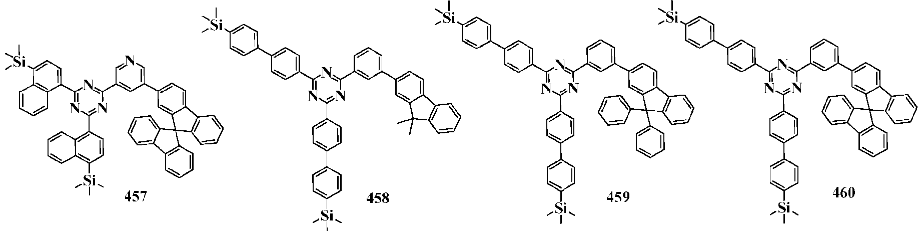

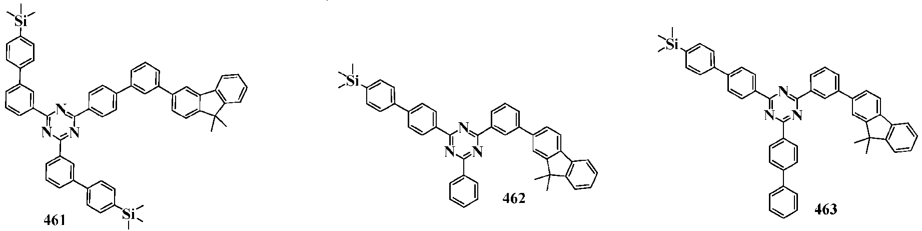

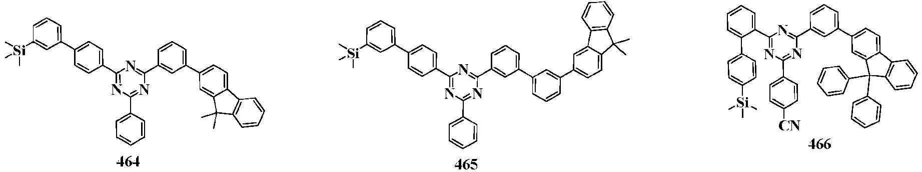

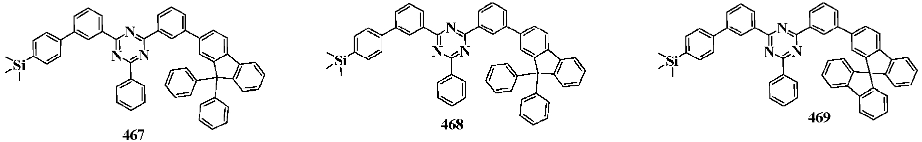

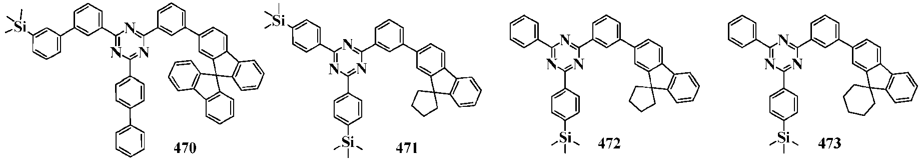

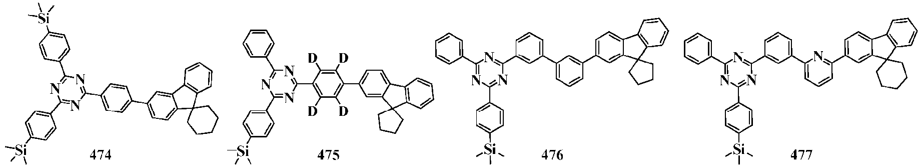

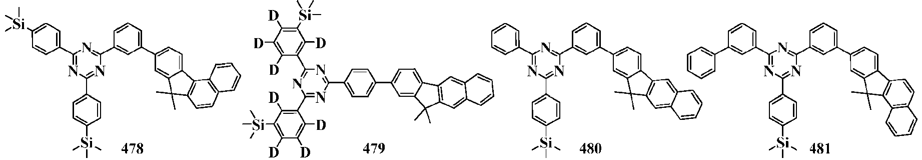

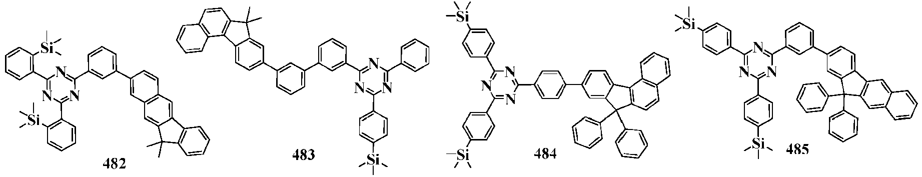

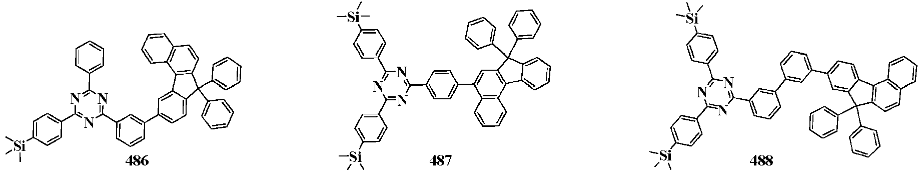

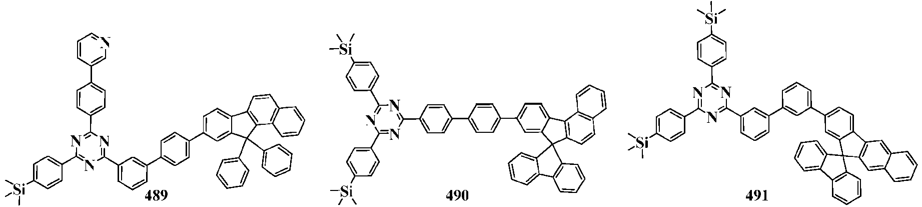

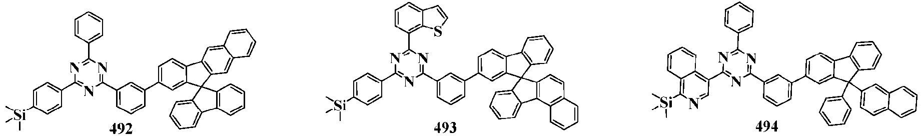

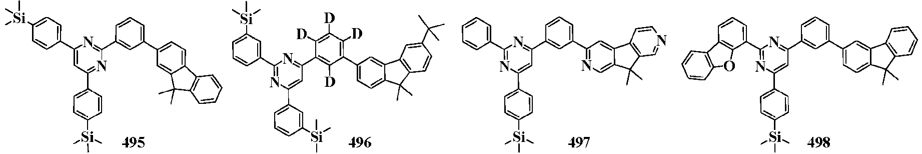

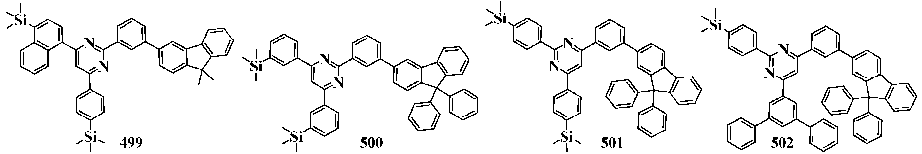

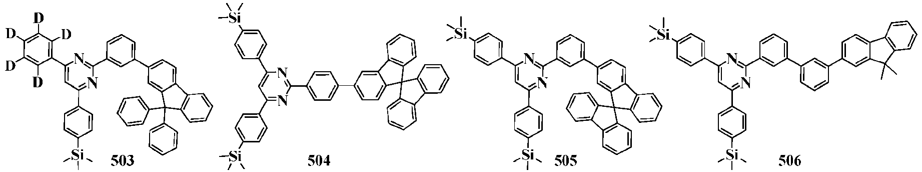

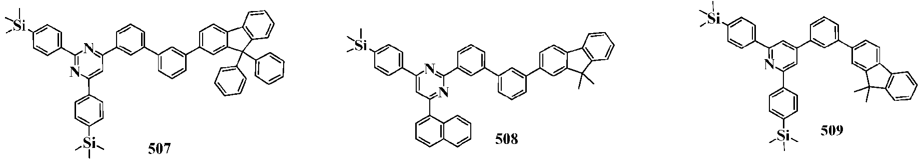

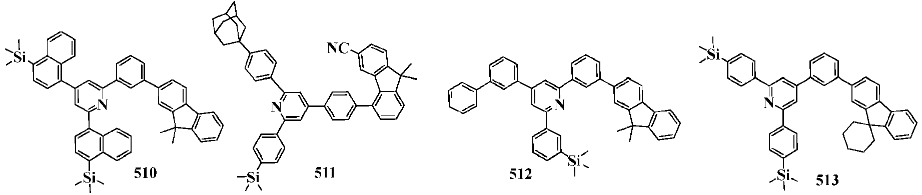

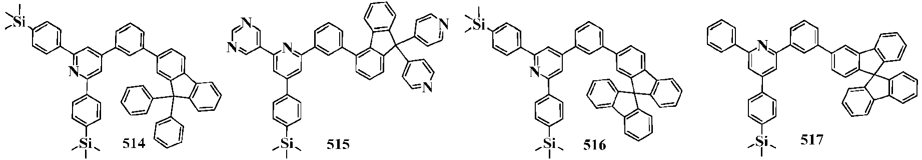

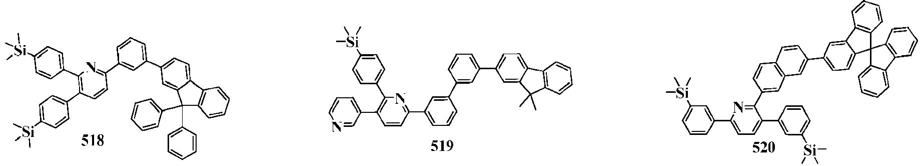

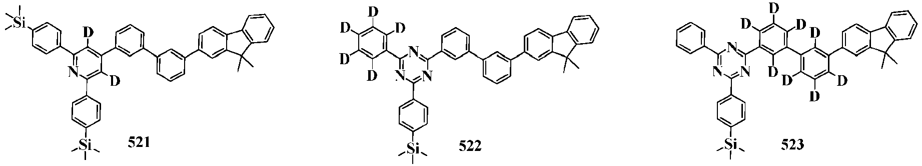

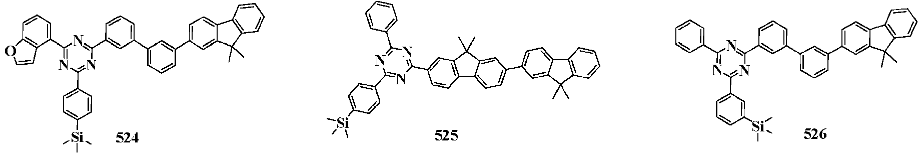

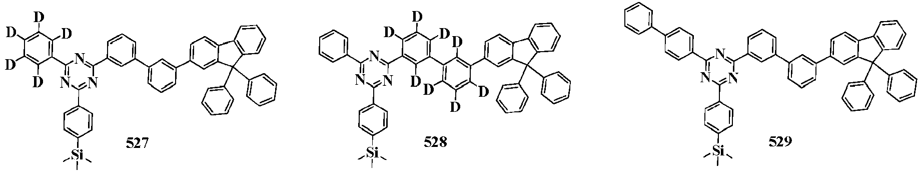

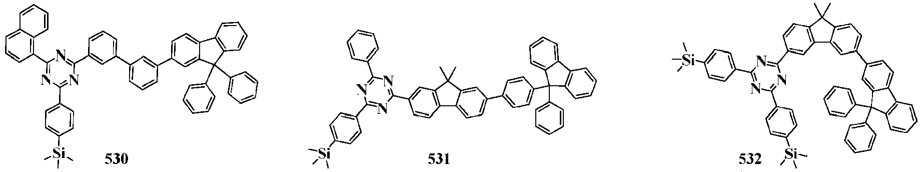

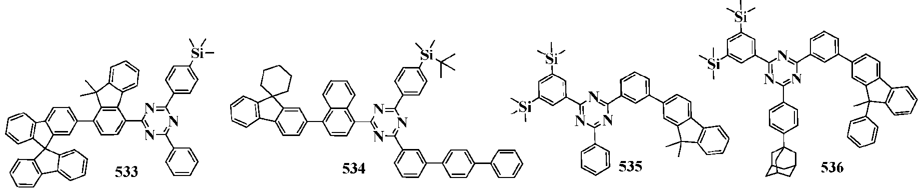

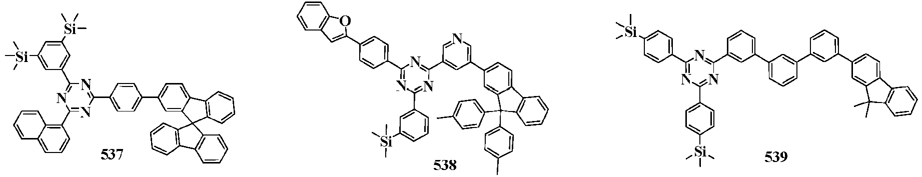

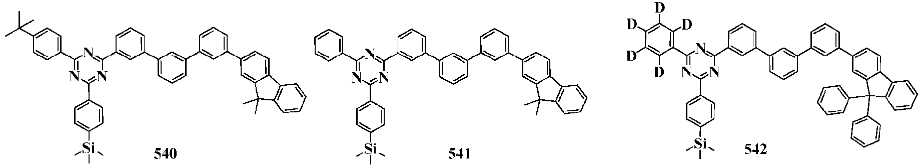

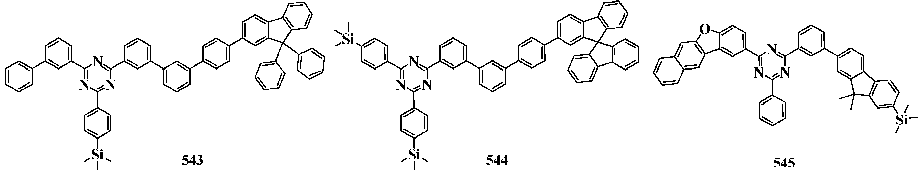

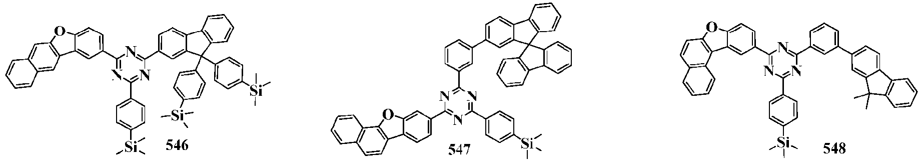

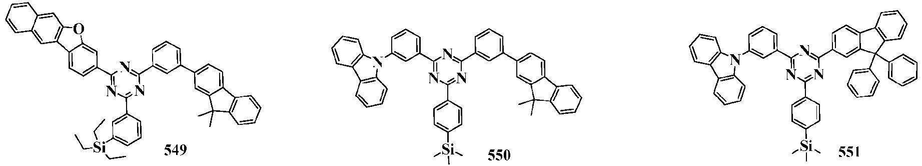

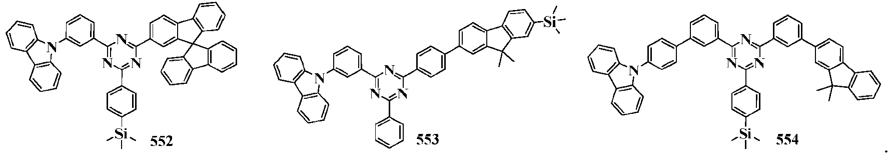

9. Eine organische elektrolumineszente Vorrichtung, umfassend eine Anode, eine Kathode und eine organische Schicht, wobei die organische Schicht zwischen der Anode und der Kathode angeordnet ist, die organische Schicht mindestens eine von einer lichtemittierenden Schicht, einer Elektronentransportschicht oder einer Lochsperrschicht umfasst und mindestens eine der lichtemittierenden Schicht, der Elektronentransportschicht oder der Lochsperrschicht eine oder mehrere der Fluoren-enthaltenden heterocyclischen Verbindungen gemäß einem der Ansprüche 1 bis 8 umfasst.

10. Eine organische elektrolumineszente Vorrichtung, umfassend eine Anode, eine Kathode und eine organische Schicht, wobei die organische Schicht auf einer Außenseite von mindestens einer der Anode oder der Kathode angeordnet ist, die organische Schicht eine Lichtauskopplungsschicht umfasst und die Lichtauskopplungsschicht eine oder mehrere der Fluoren-enthaltenden heterocyclischen Verbindungen gemäß einem der Ansprüche 1 bis 8 umfasst.

## Revendications

1. Composé hétérocyclique contenant du fluorène, présentant une structure représentée par la formule I : 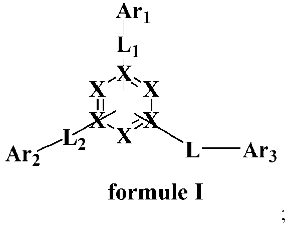
où dans la formule I, X est choisi indépendamment parmi C(R₀) ou un atome N, et au moins un de X est choisi parmi un atome de N ;
R₀ est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
Ar₃ est choisi dans un groupe représenté par la formule II-1 ou la formule II-2 : 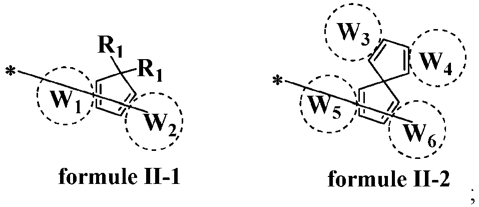
l'anneau W₁, l'anneau W₂, l'anneau W₃, l'anneau W₄, l'anneau W₅, et l'anneau W₆ sont indépendamment choisis parmi l'une quelconque des structures suivantes : 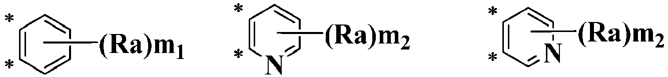 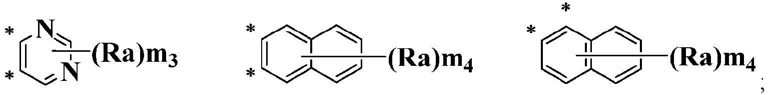
« * » représente un site de fusion ;
Ra est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
m₁ est indépendamment choisi parmi 0, 1, 2, 3 ou 4, m₂ est indépendamment choisi parmi 0, 1, 2 ou 3, m₃ est indépendamment choisi parmi 0, 1 ou 2, et m₄ est indépendamment choisi parmi 0, 1, 2, 3, 4, 5 ou 6 ;
R₁ est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ; ou deux R₁ adjacents sont liés l'un à l'autre pour former un cycle aliphatique C3 à C7 substitué ou non substitué ;
L est choisi parmi une liaison simple, l'arylène C6 à C30 non substitué ou substitué par un ou plusieurs Rb, ou l'hétéroarylène C2 à C30 non substitué ou substitué par un ou plusieurs Rb ; L₁ et L₂ sont indépendamment choisis parmi une liaison simple, l'arylène C6 à C30 substitué ou non substitué ou l'hétéroarylène C2 à C30 substitué ou non substitué ;
Ar₁ et Ar₂ sont indépendamment choisis parmi l'aryle C6 à C30 non substitué ou substitué par un ou plusieurs Rc, ou sont choisis parmi l'un quelconque des groupes suivants : 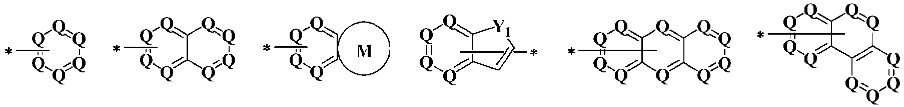 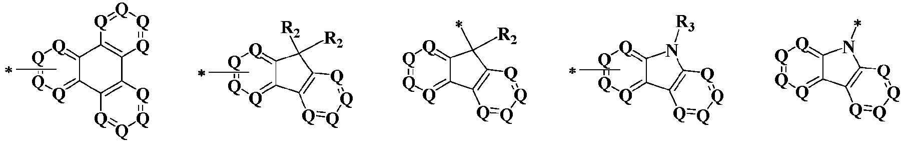 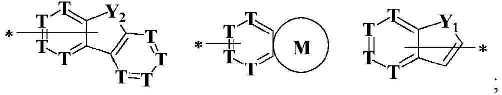
Q est indépendamment choisi parmi les C(Rd) ou un atome N, et au moins un Q dans chaque groupe est choisi parmi un atome N ;
T est indépendamment choisi parmi les C(Rd) ;
l'anneau M est indépendamment choisi parmi un cycle aliphatique C3 à C7 non substitué ou substitué par un ou plusieurs R4 ;
Y₁ est choisi parmi O, S, C(R₅)₂ ou N(R₆) ; Y2 est choisi parmi un atome O, un atome S ou N(R₃) ;
Rd est indépendamment choisi parmi l'hydrogène, le deutérium, le tritium, le cyano,
l'halogène, le nitro, l'alkyle C1 à C12 substitué(e) ou non, le silyle substitué(e) ou non, l'alcoxy C1 à C12 substitué(e) ou non, le cycloalkyle C3 à C12 substitué(e) ou non, l'hétérocycloalkyle C2 à C12 substitué(e) ou non, l'aryle C6 à C30 substitué(e) ou non et l'hétéroaryle C2 à C30 substitué(e) ou non ;
R₂, R₄ et R₅ sont indépendamment choisis parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
R₃ et R₆ sont indépendamment choisis parmi l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
Rb et Rc sont indépendamment choisis parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
à condition qu'au moins un parmi R₁, Ra, Rb, Rc ou Rd soit choisi dans un groupe représenté par la formule III : 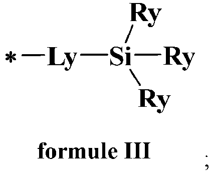
Ry est indépendamment choisi parmi l'hydrogène, le deutérium, le cyano, l'halogène, le nitro, l'alkyle C1 à C12 substitué ou non substitué, l'alcényle C2 à C12 substitué ou non substitué, le cycloalkyle C3 à C12 substitué ou non substitué, ou l'hétérocycloalkyle C2 à C12 substitué ou non substitué ;
Ly est indépendamment choisi parmi une liaison simple, l'aryle C6 à C30 substitué(e) ou non et l'hétéroaryle C2 à C30 substitué(e) ou non ;
lorsque deux ou plusieurs R₁, Ra, Rb, Rc et Rd sont présents, les deux ou plusieurs R₁, Ra, Rb, Rc et Rd sont identiques entre eux ou différents les uns des autres.

2. Composé hétérocyclique contenant du fluorène selon la revendication 1, dans lequel le composé hétérocyclique contenant du fluorène est choisi parmi une des structures suivantes représentées par les formules IV-1 à IV-5 : 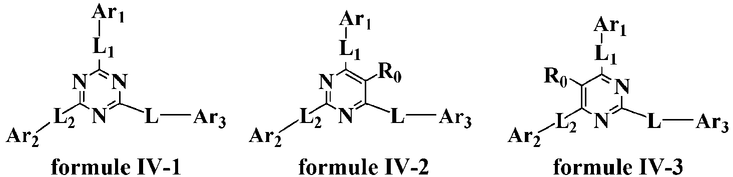 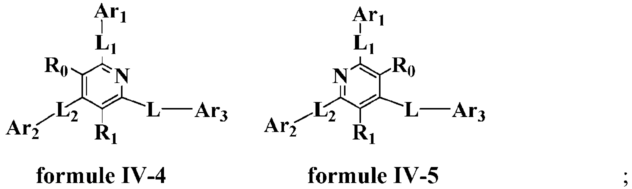 où Ar₁, Ar₂, Ar₃, L, Li, L₂ et R₀ sont les mêmes que ceux définis dans la formule I.

3. Composé hétérocyclique contenant du fluorène selon la revendication 1, dans lequel Ar₃ est indépendamment choisi parmi l'un des groupes suivants : 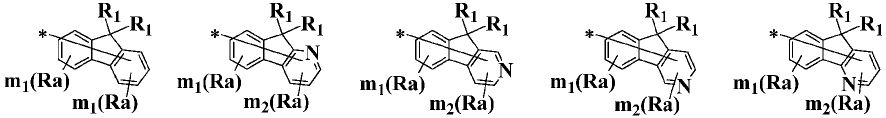 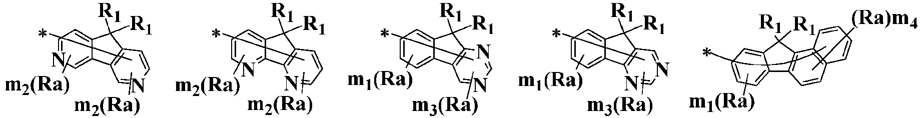 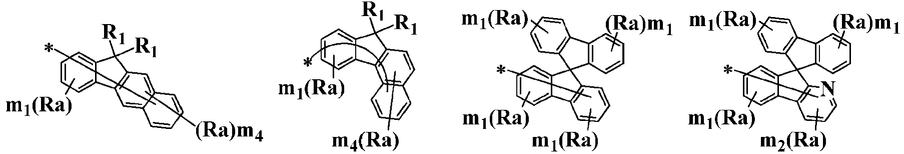 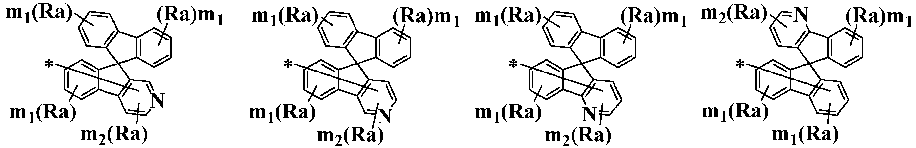 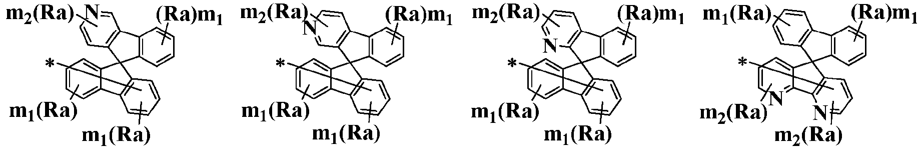 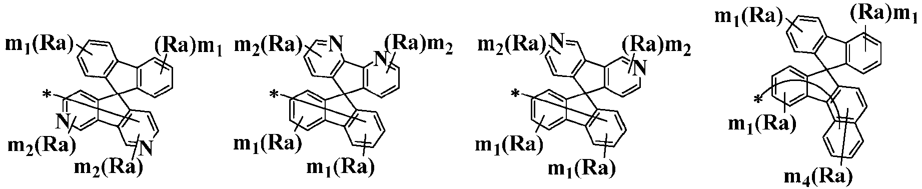 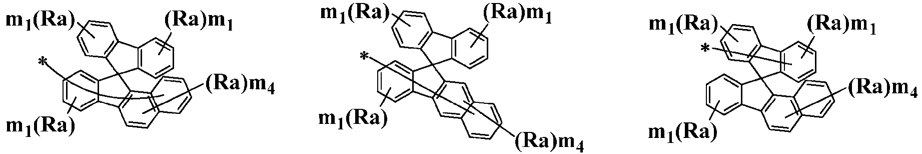 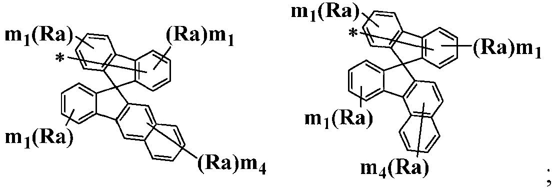
où R₁ est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ; ou deux R₁ adjacents sont liés l'un à l'autre pour former l'un quelconque des groupes cycliques suivants : 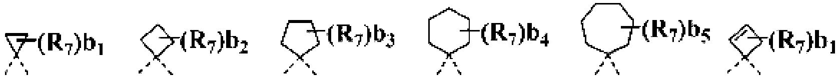 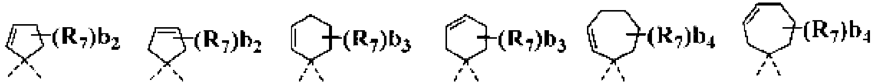 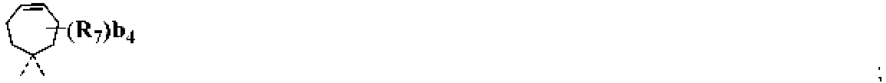
R7 est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
n₁ est indépendamment choisi parmi 0, 1, 2, 3 ou 4, n₂ est indépendamment choisi parmi 0, 1, 2, 3, 4, 5 ou 6, n₃ est indépendamment choisi parmi 0, 1, 2, 3, 4, 5, 6, 7 ou 8, n₄ est indépendamment choisi parmi 0, 1, 2, 3, 4, 5, 6, 7, 8, 9 ou 10, et n₅ est indépendamment choisi parmi 0, 1, 2, 3, 4, 5, 6, 7, 8, 9, 10, 11 ou 12 ;
Ra est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
m₁ est indépendamment choisi parmi 0, 1, 2, 3 ou 4, m₂ est indépendamment choisi parmi 0, 1, 2 ou 3, m₃ est indépendamment choisi parmi 0, 1 ou 2, et m₄ est indépendamment choisi parmi 0, 1, 2, 3, 4, 5 ou 6.

4. Composé hétérocyclique contenant du fluorène selon la revendication 1, dans lequel au moins un parmi Ra, Rc ou Rd est choisi dans un groupe représenté par la formule III, et lorsque deux ou plusieurs Ra, Rc et Rd sont présents, les deux ou plusieurs Ra, Rc et Rd sont identiques entre eux ou différents les uns des autres.

5. Composé hétérocyclique contenant du fluorène selon la revendication 1, dans lequel la formule III est choisie parmi l'un des groupes suivants :

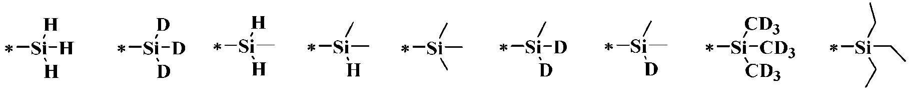

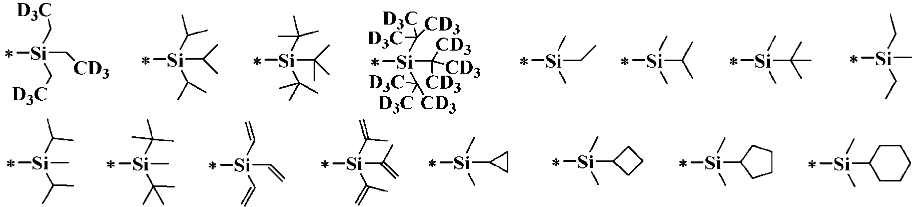

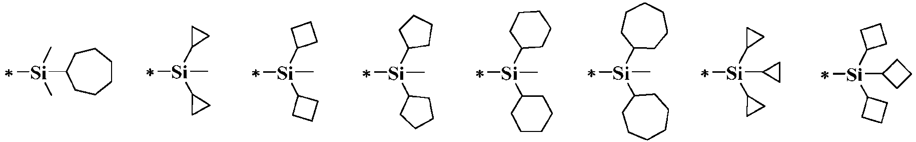

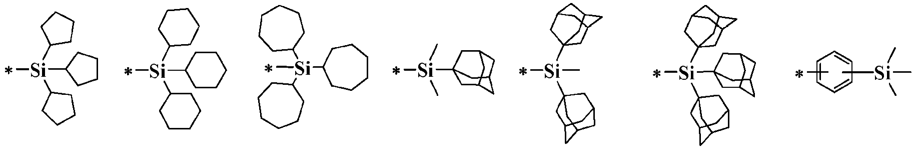

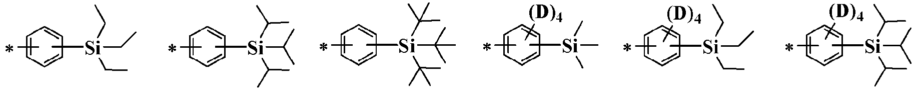

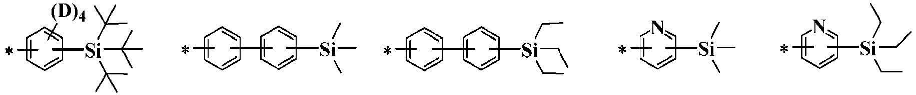

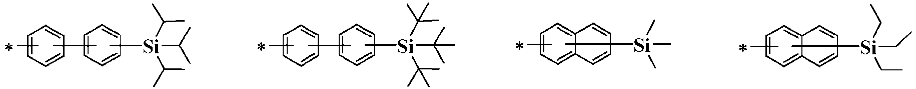

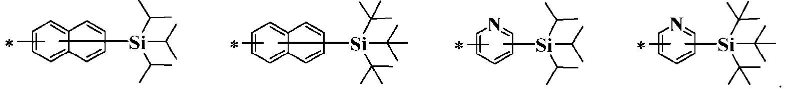

6. Composé hétérocyclique contenant du fluorène selon la revendication 1, dans lequel Ar₁ et Ar₂ sont indépendamment choisis parmi l'un des groupes suivants : 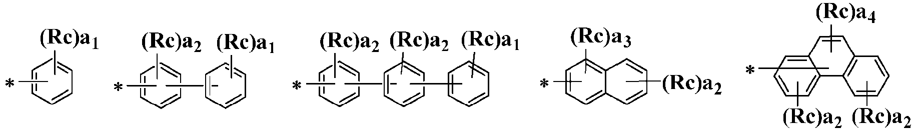 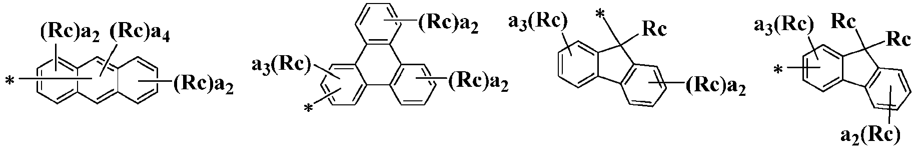 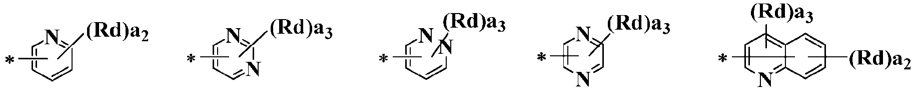 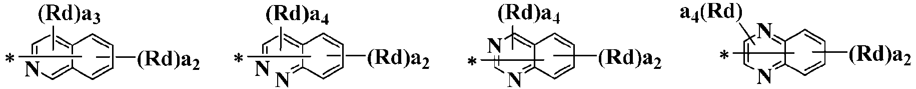 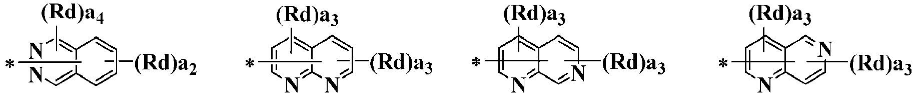 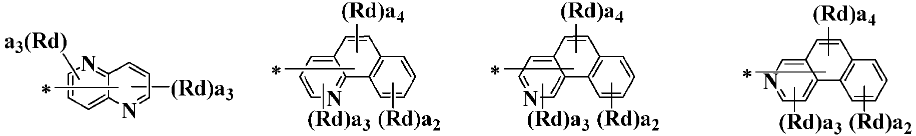 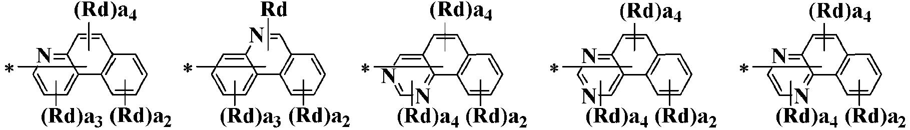 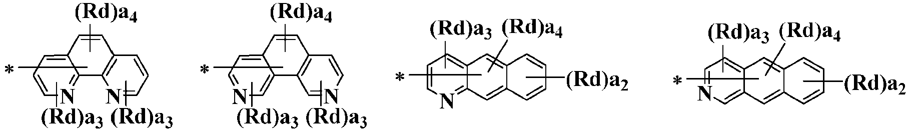 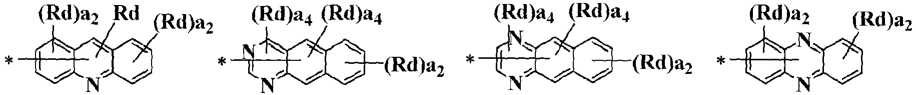 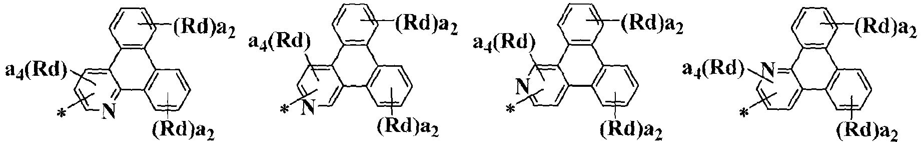 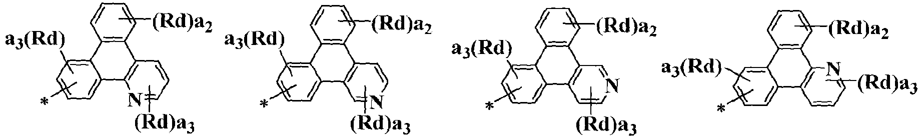 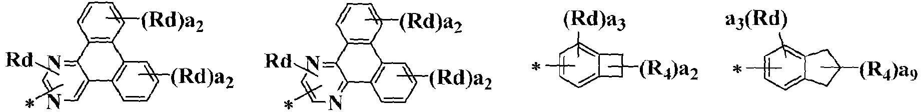 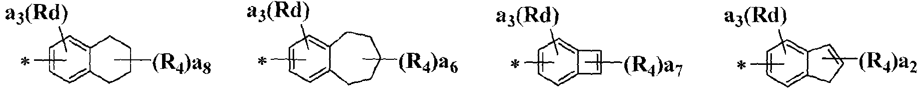 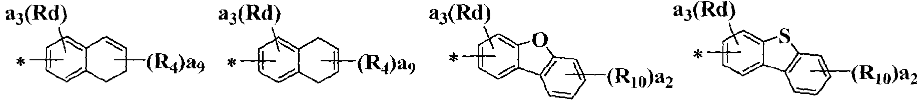 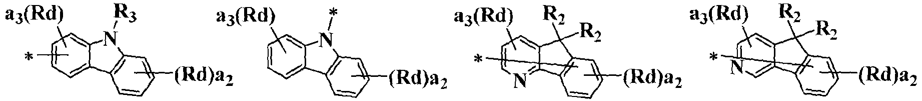 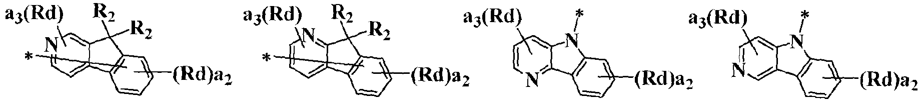 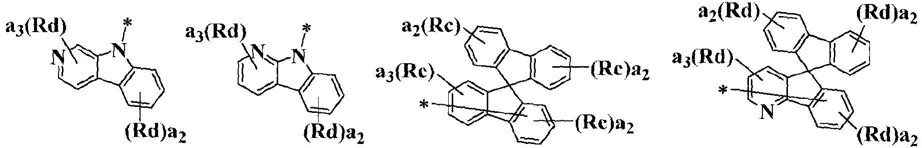 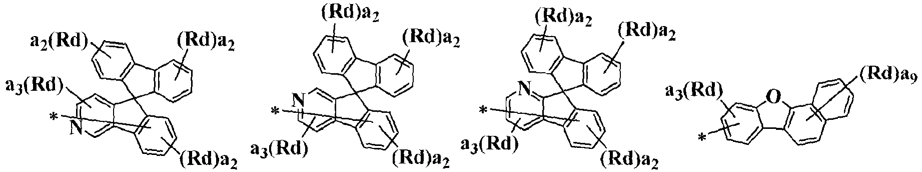 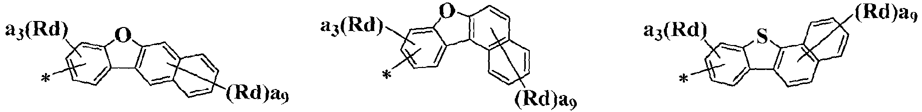 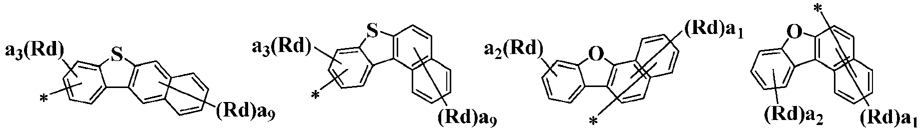 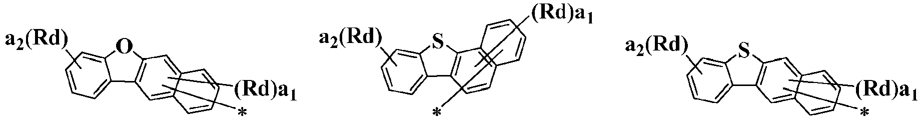 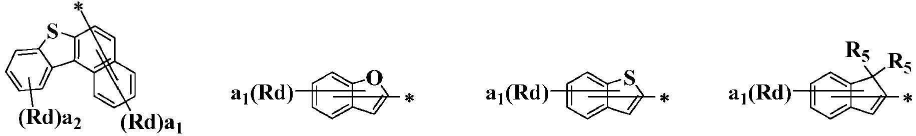 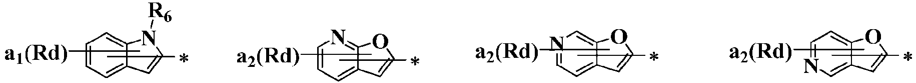 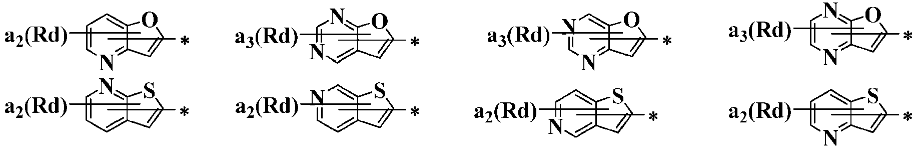 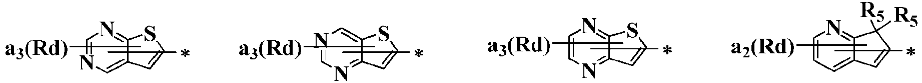 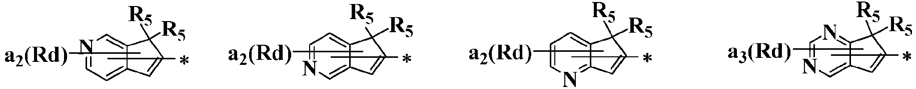 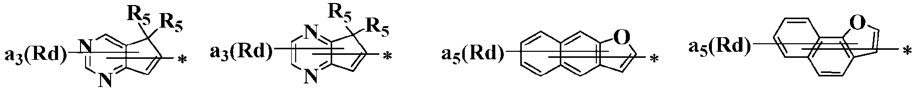 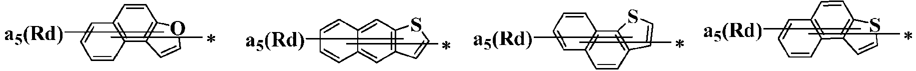 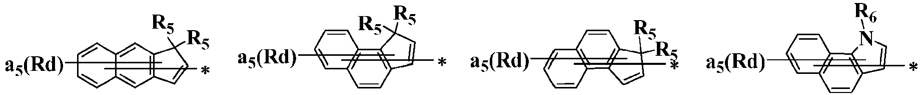 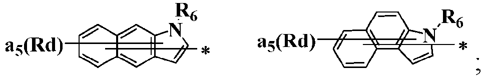
où Rc, Rd, R₂, R₃, R₄, R₅ et R₆ sont les mêmes que ceux définis dans la formule I ;
a₁ est indépendamment choisi parmi 0 , 1, 2, 3, 4 ou 5, a₂ est indépendamment choisi parmi 0 , 1, 2, 3, ou 4, a₃ est indépendamment choisi parmi 0 , 1, 2, ou 3, a₄ est indépendamment choisi parmi 0 , 1 ou 2, a₅ est indépendamment choisi parmi 0 , 1, 2, 3, 4, 5, 6 ou 7, a₆ est indépendamment choisi parmi 0, 1, 2, 3, 4, 5, 6, 7, 8, 9 ou 10, a₇ est indépendamment choisi parmi 0, 1 ou 2, a₈ est indépendamment choisi parmi 0, 1, 2, 3, 4, 5, 6, 7 ou 8, et a₉ est indépendamment choisi parmi 0, 1, 2, 3, 4, 5 ou 6.

7. Composé hétérocyclique contenant du fluorène selon la revendication 1, dans lequel L, L₁ et L₂ sont indépendamment choisis parmi une liaison simple ou l'un des groupes suivants : 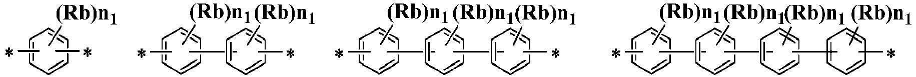 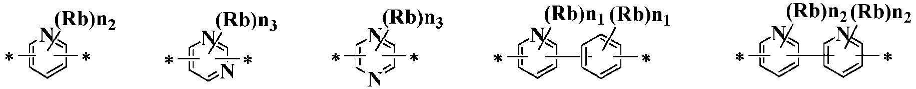 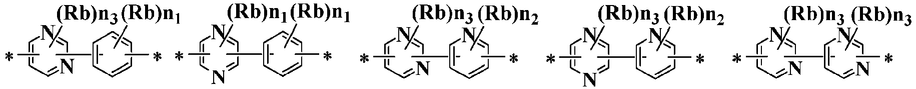 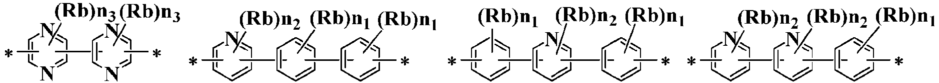 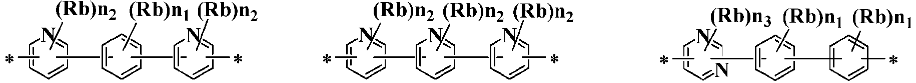 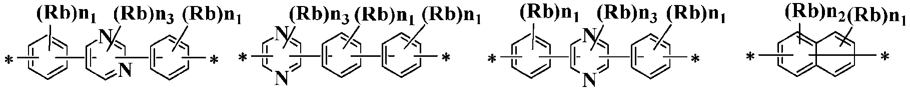 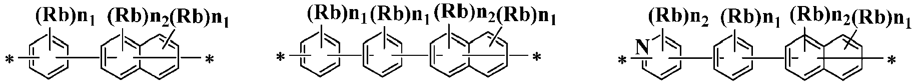 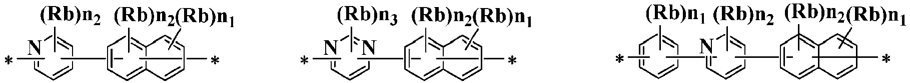 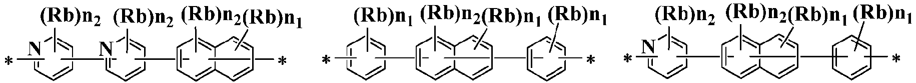 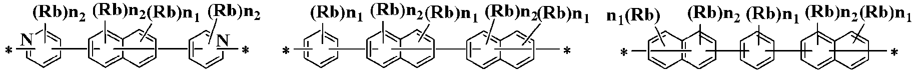 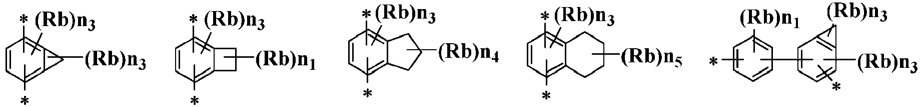 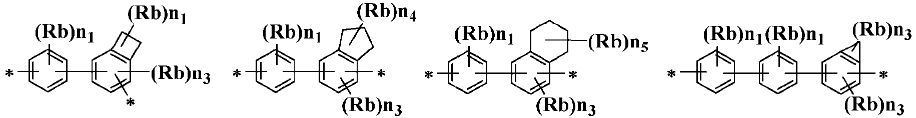 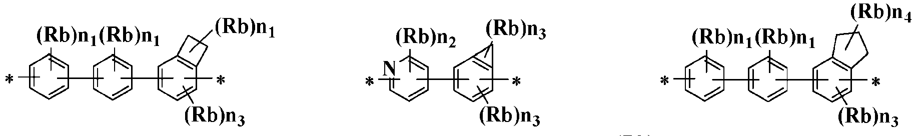 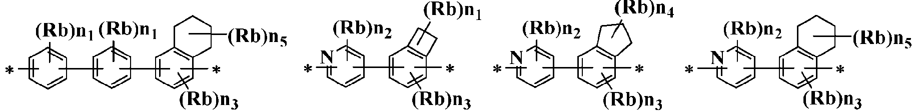 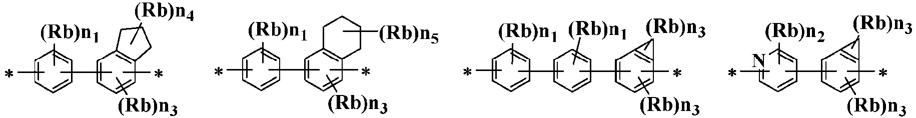 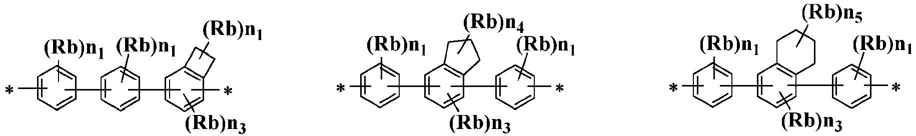 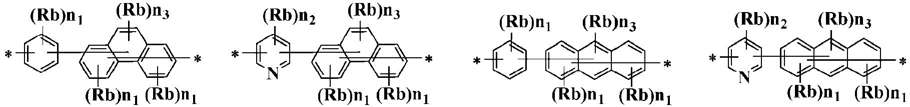 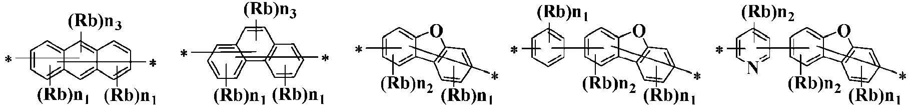 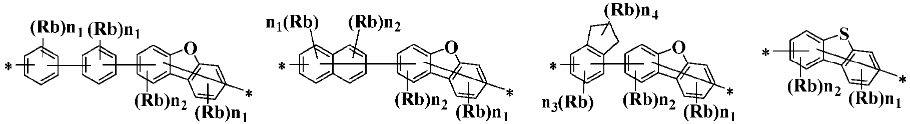 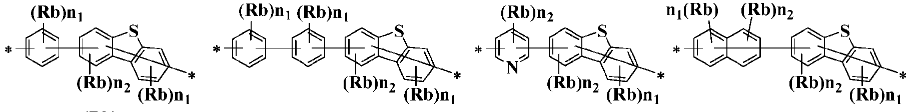 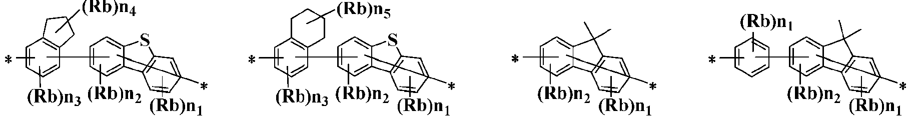 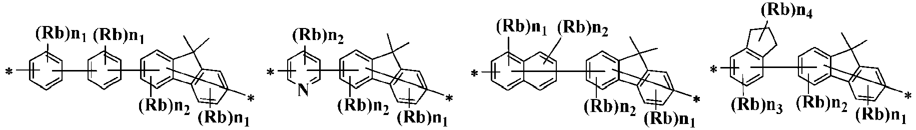 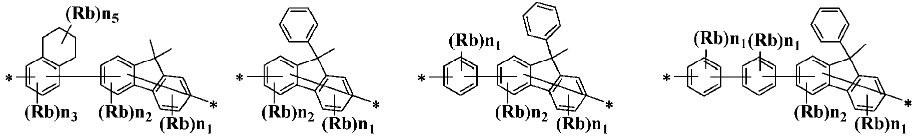 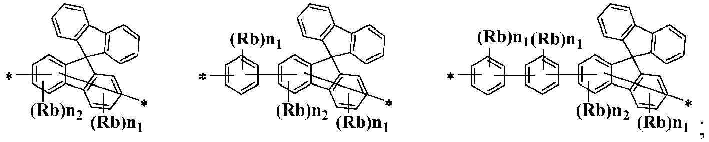
où Rb est indépendamment choisi parmi l'hydrogène, le deutérium, le tritium, le cyano, l'halogène, le nitro, l'alkyle C1 à C12 substitué ou non substitué, le silyle substitué ou non substitué, l'alcoxy C1 à C12 substitué ou non substitué ou le cycloalkyle C3 à C12 substitué ou non substitué, l'hétérocycloalkyle C2 à C12 substitué ou non substitué, l'aryle C6 à C30 substitué ou non substitué, l'hétéroaryle C2 à C30 substitué ou non substitué ;
n₁ est indépendamment choisi parmi 0, 1, 2, 3 ou 4, n₂ est indépendamment choisi parmi 0, 1, 2 ou 3, n₃ est indépendamment choisi parmi 0, 1 ou 2, n₄ est indépendamment choisi parmi 0, 1, 2, 3, 4, 5 ou 6, et n₅ est indépendamment choisi parmi 0, 1, 2, 3, 4, 5, 6, 7 ou 8.

8. Composé hétérocyclique contenant du fluorène selon la revendication 1, dans lequel le composé est choisi parmi l'une des structures suivantes :

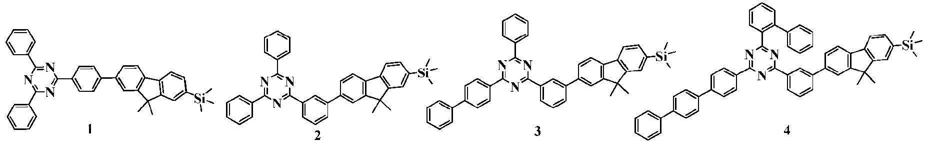

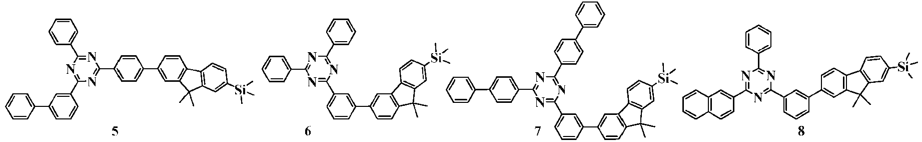

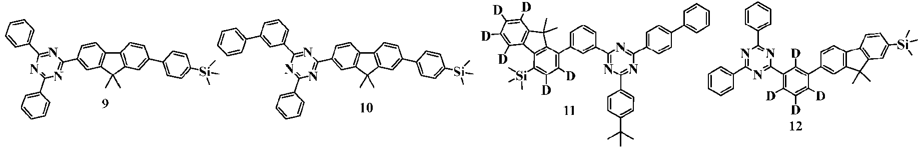

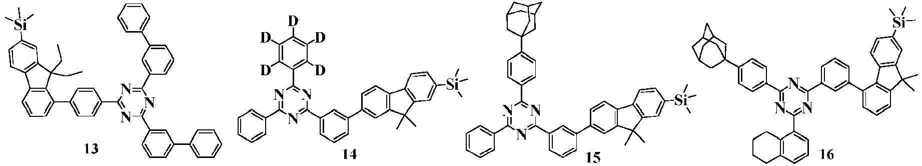

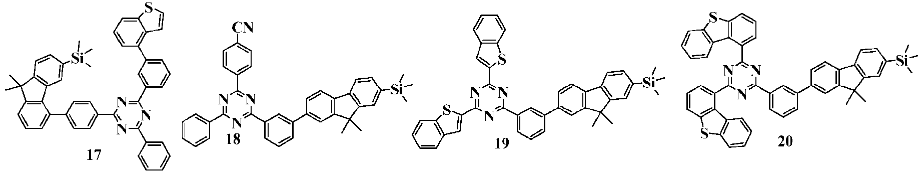

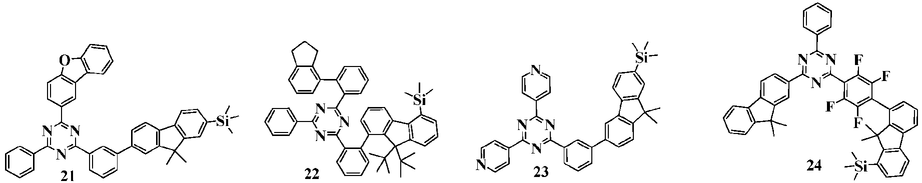

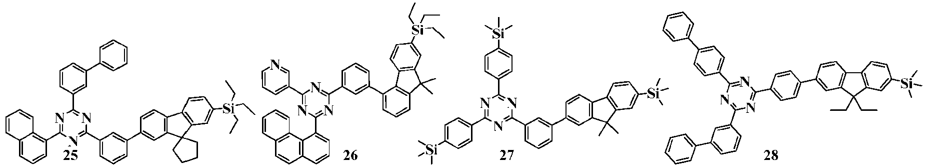

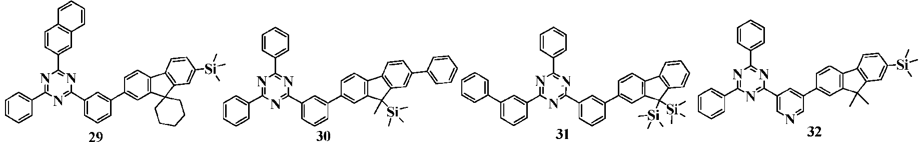

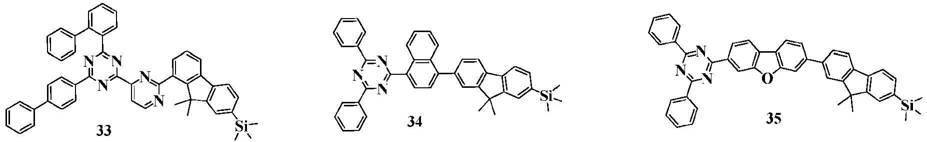

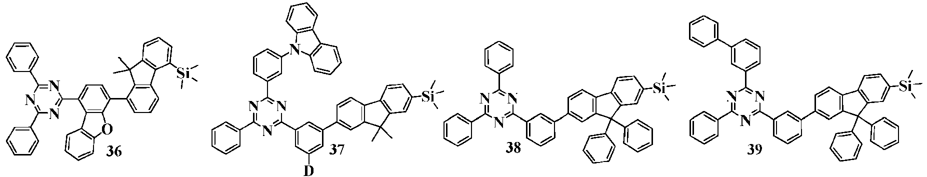

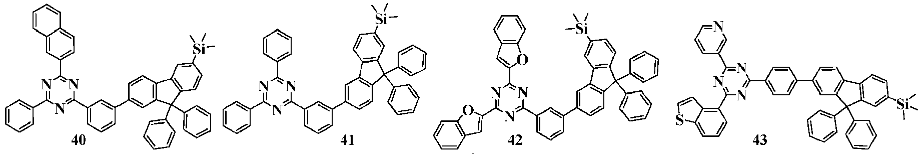

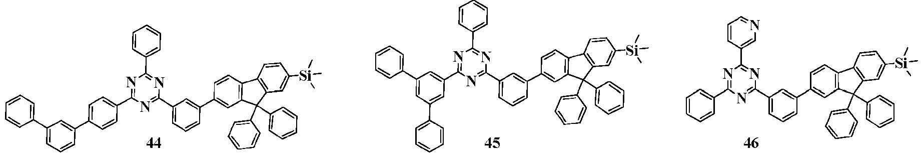

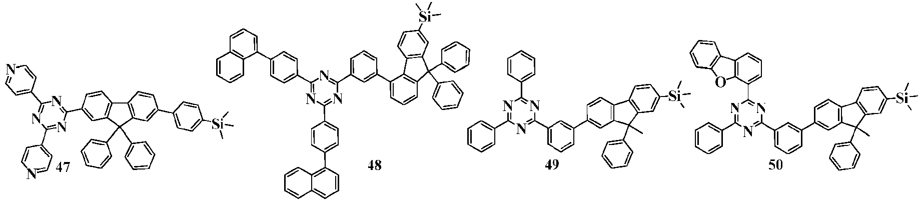

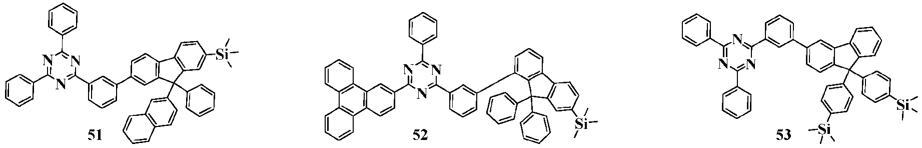

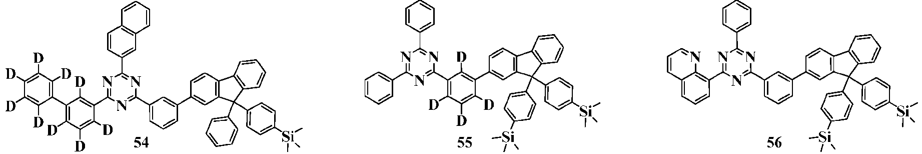

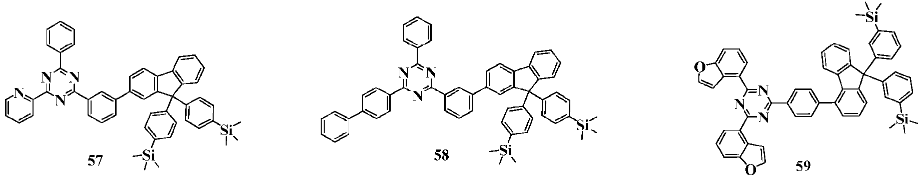

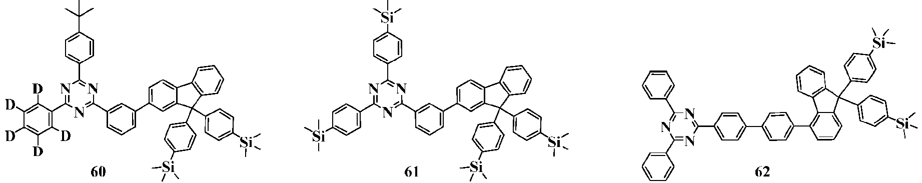

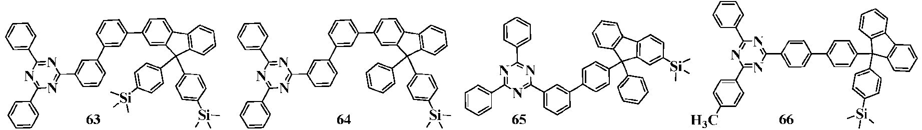

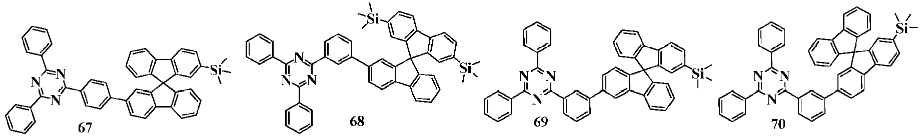

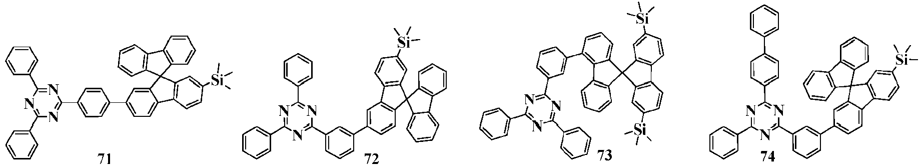

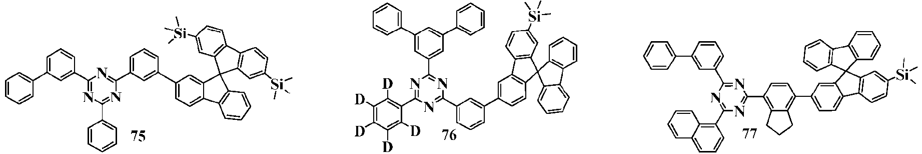

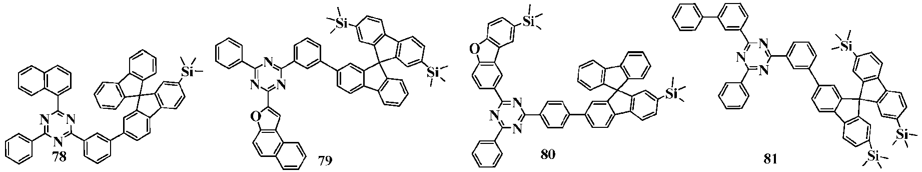

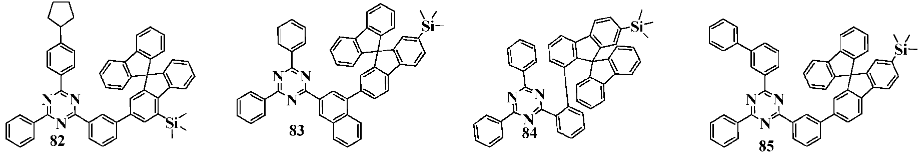

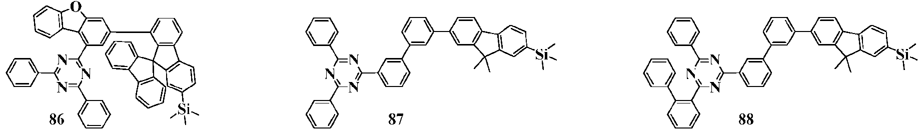

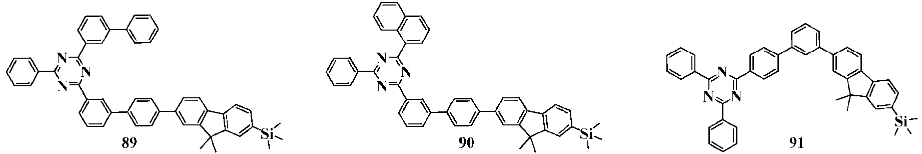

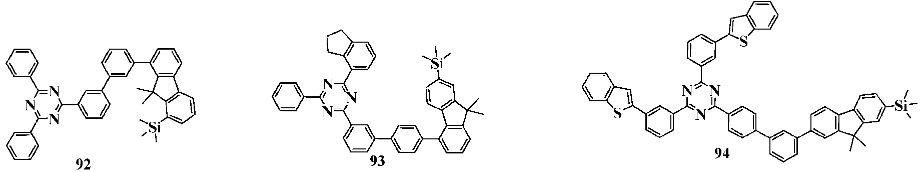

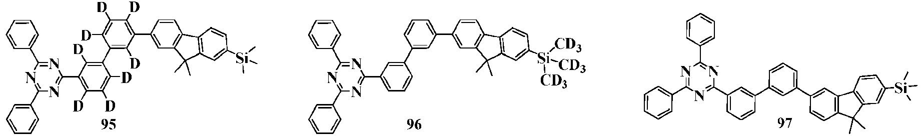

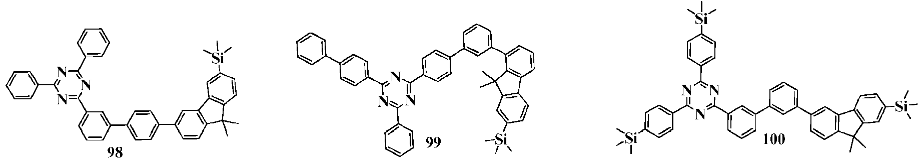

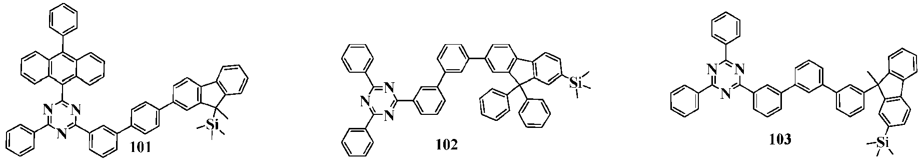

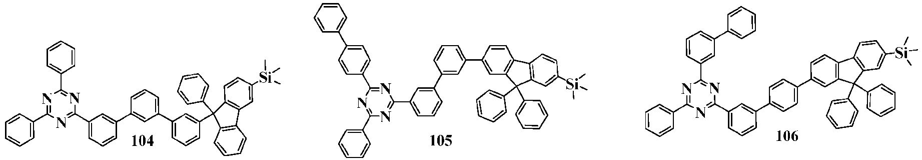

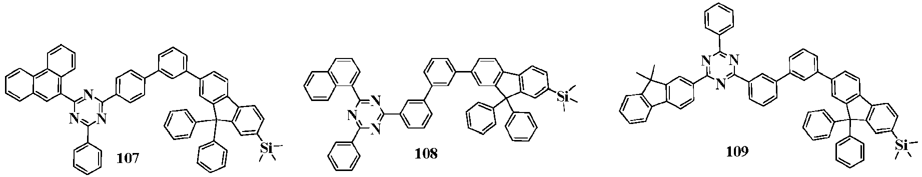

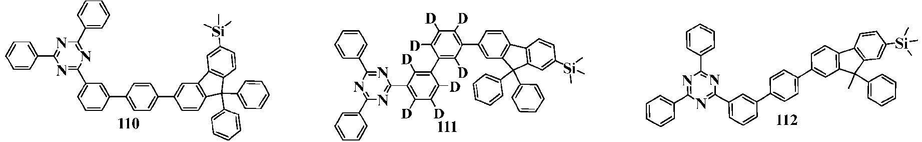

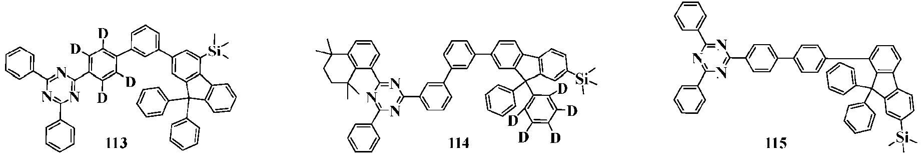

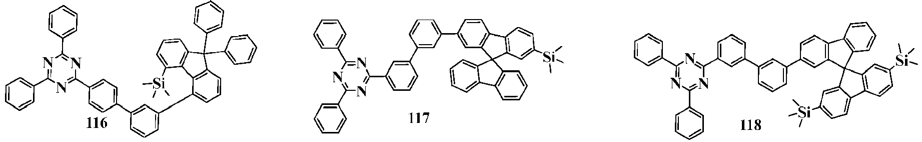

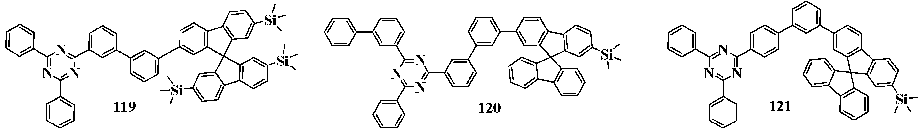

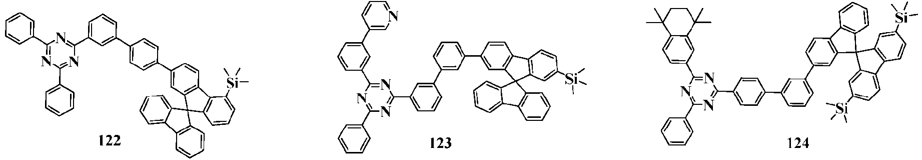

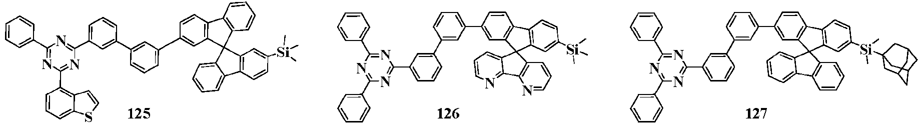

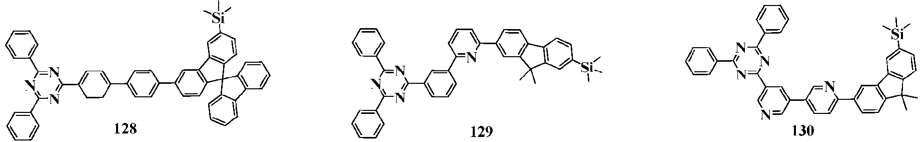

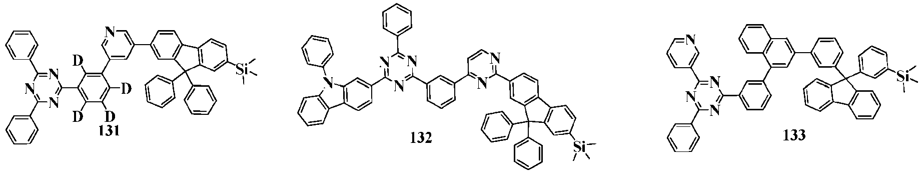

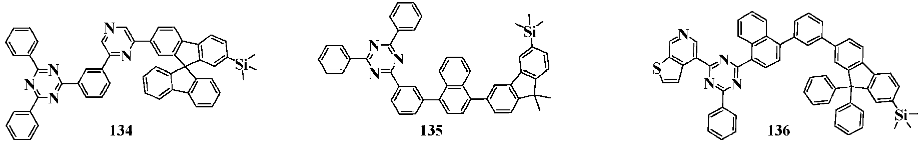

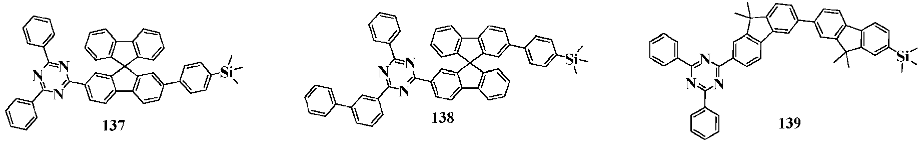

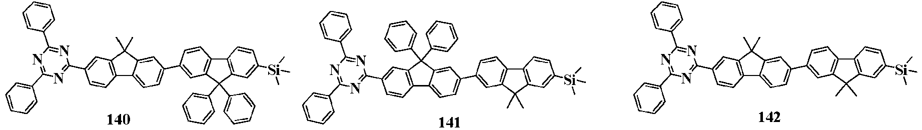

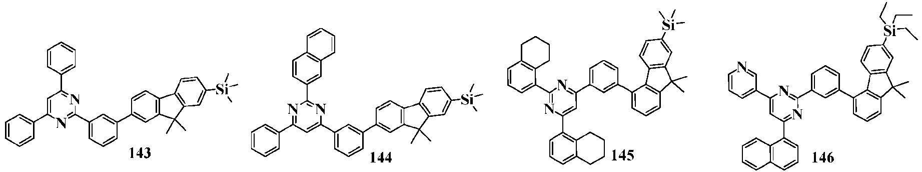

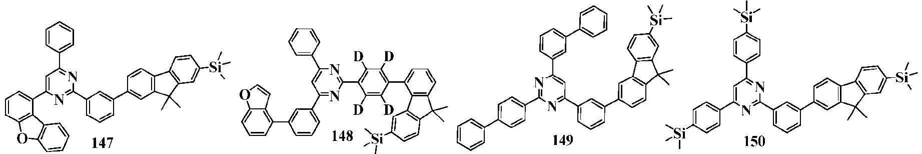

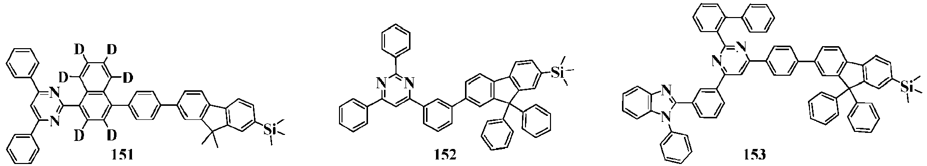

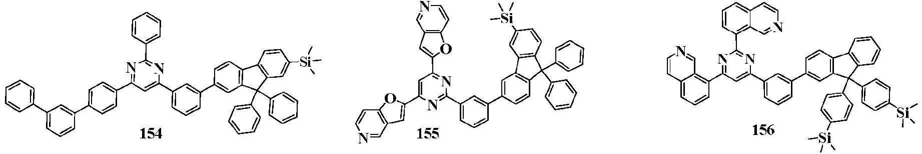

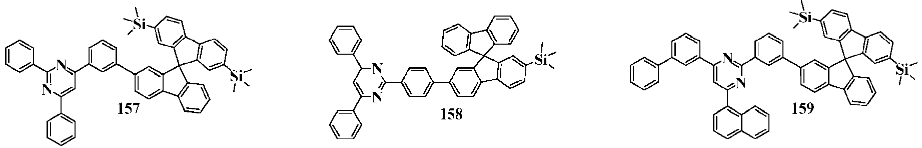

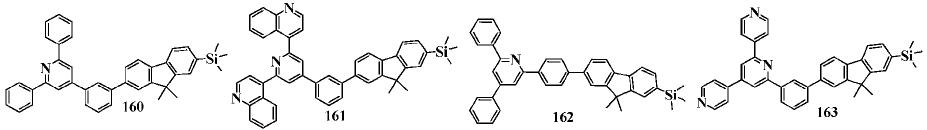

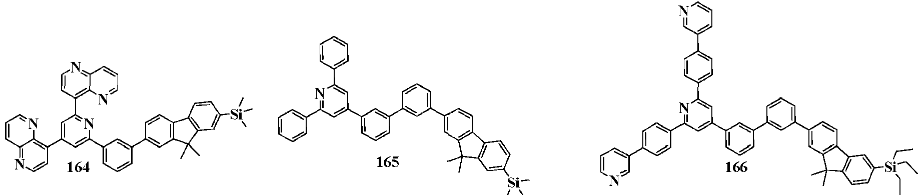

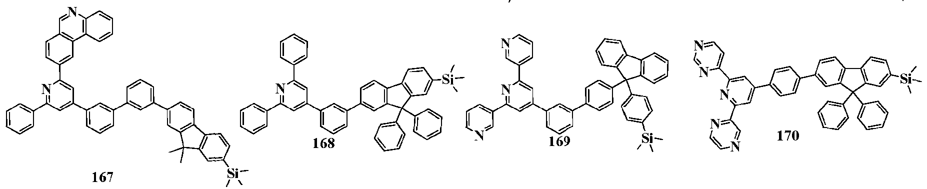

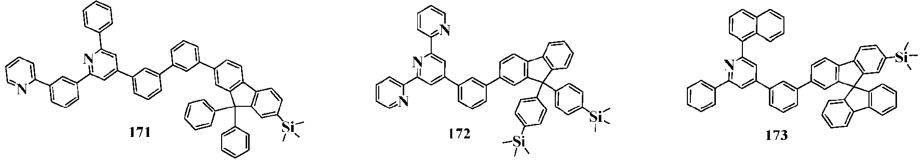

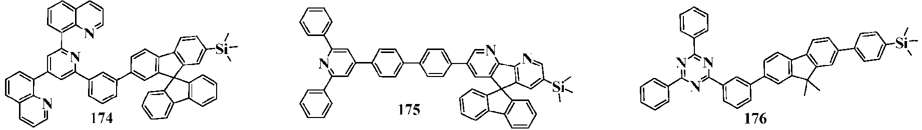

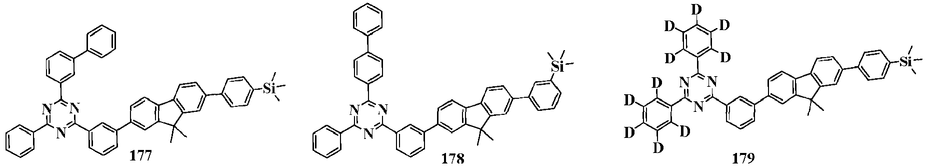

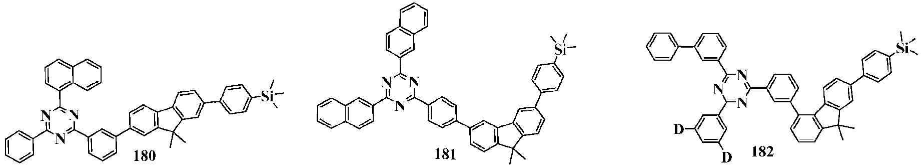

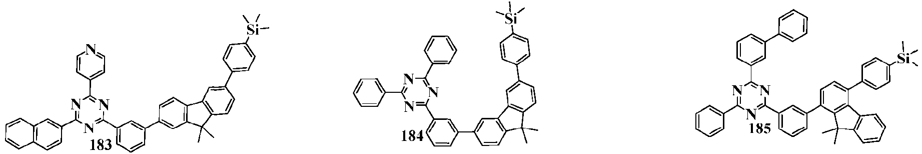

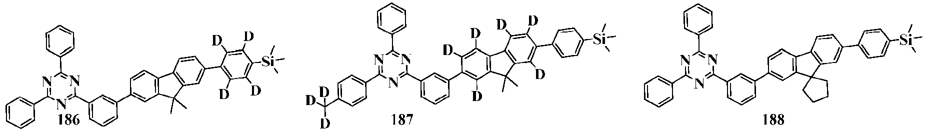

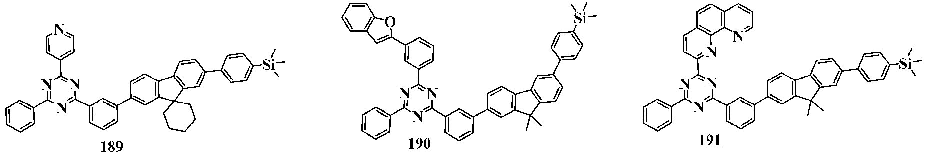

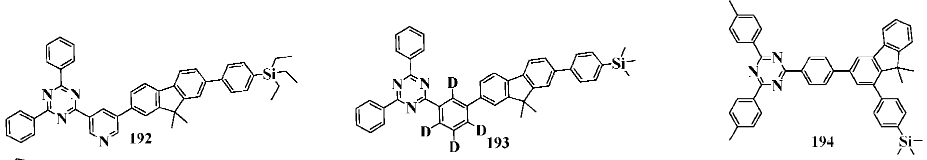

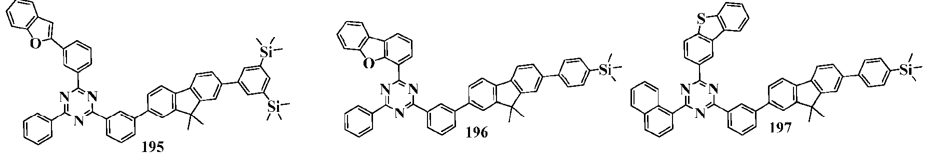

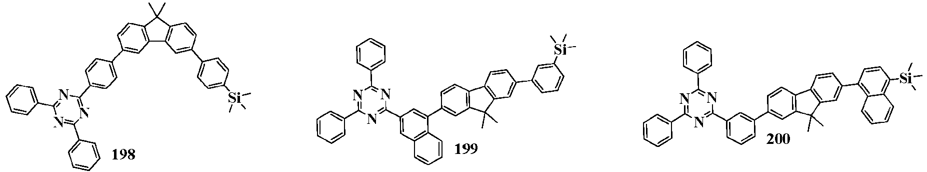

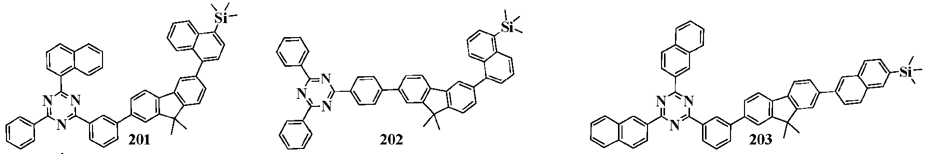

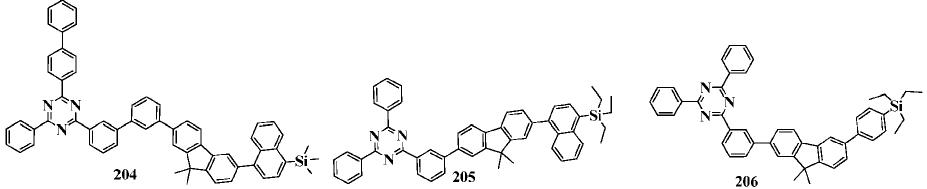

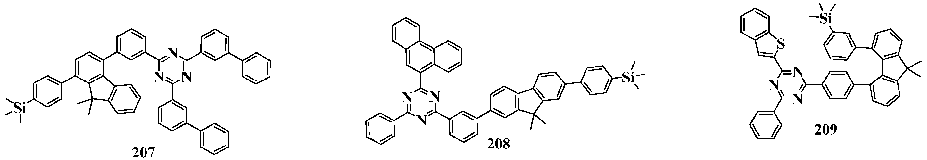

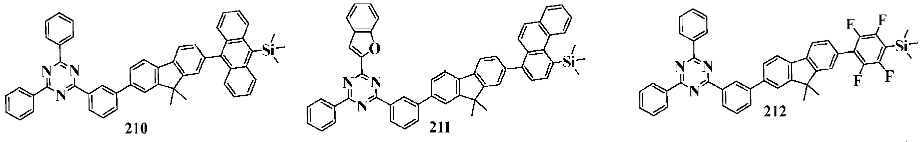

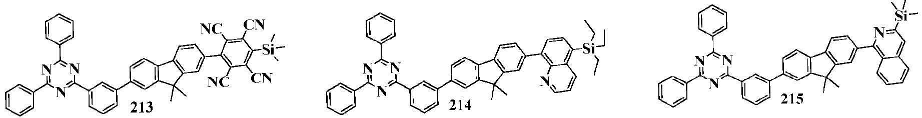

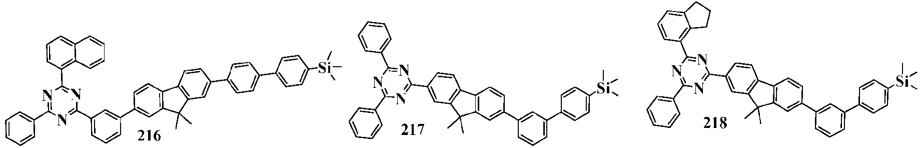

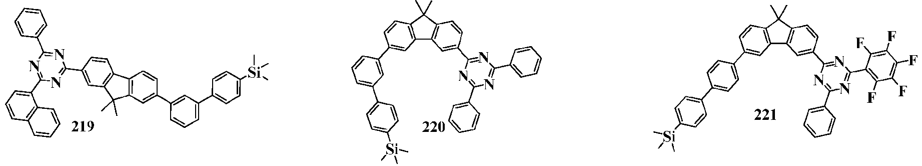

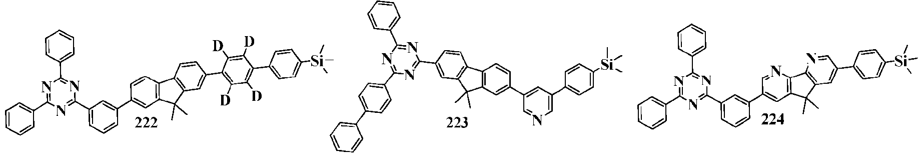

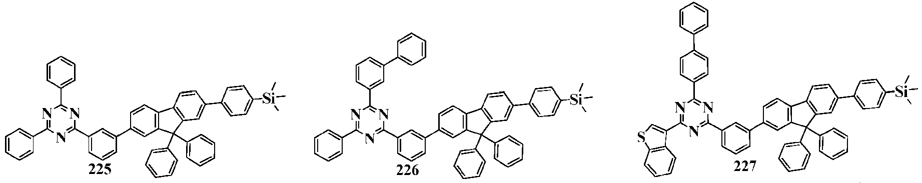

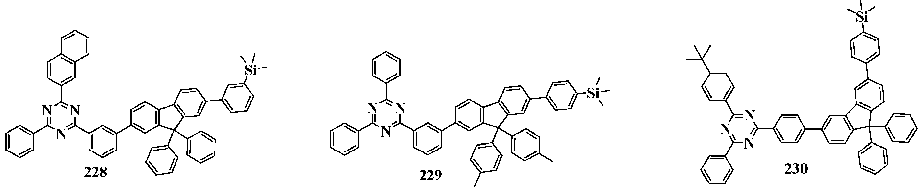

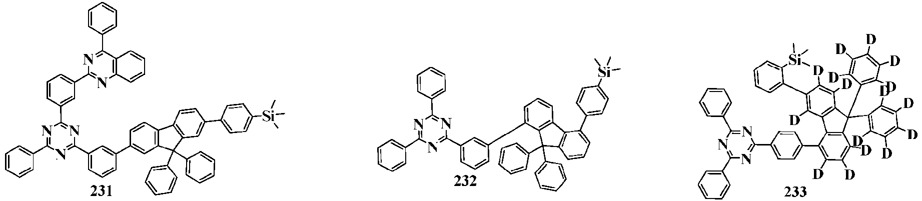

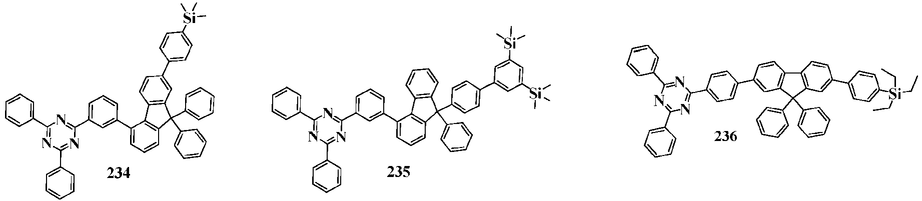

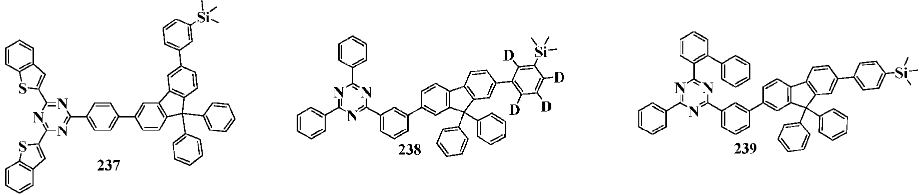

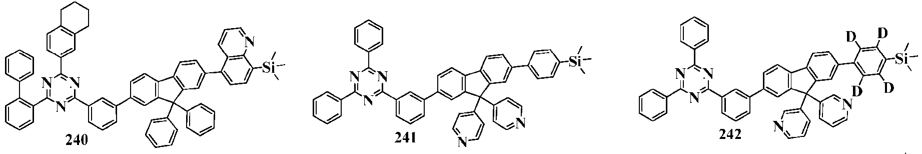

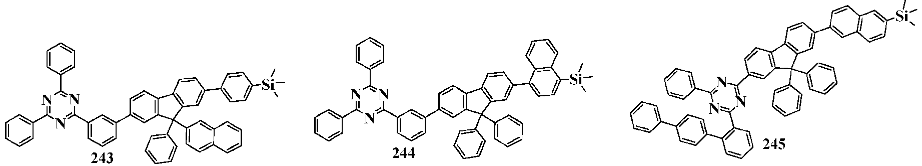

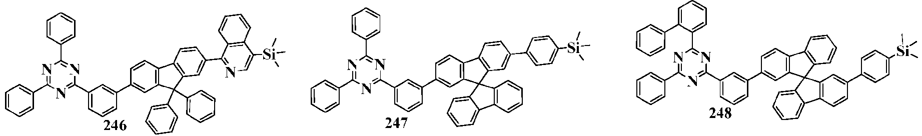

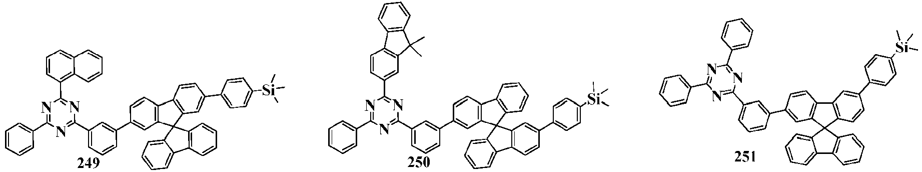

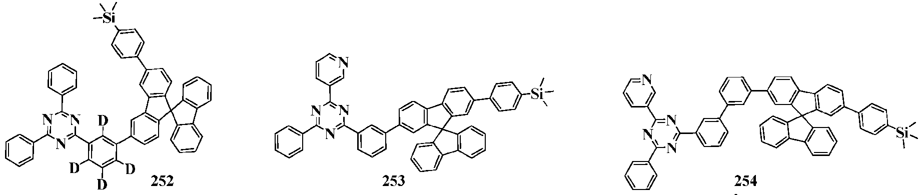

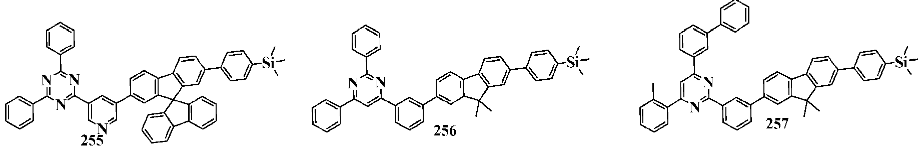

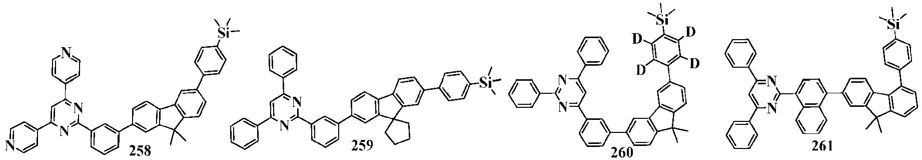

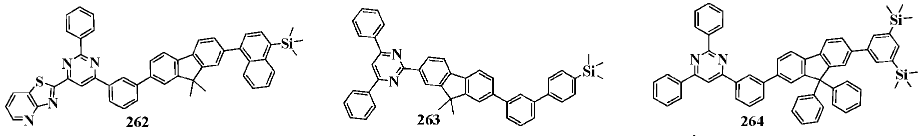

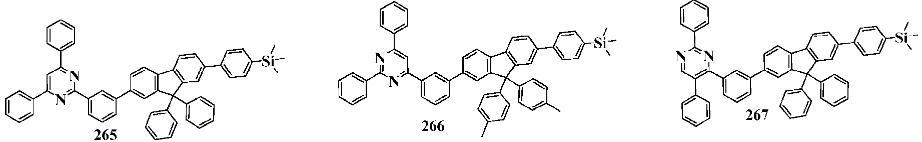

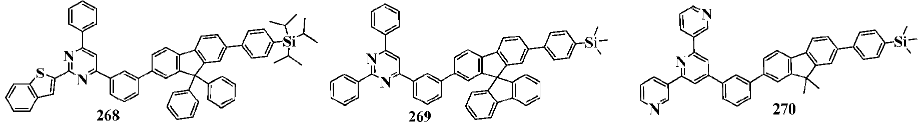

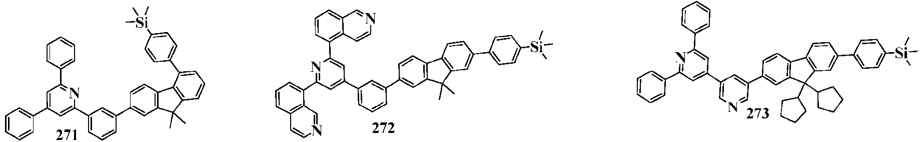

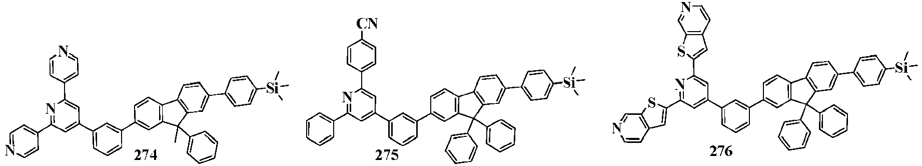

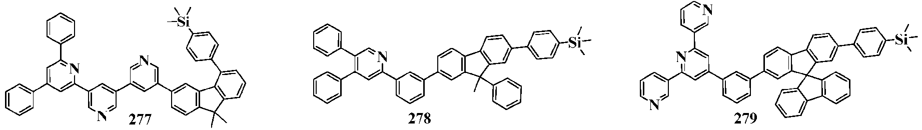

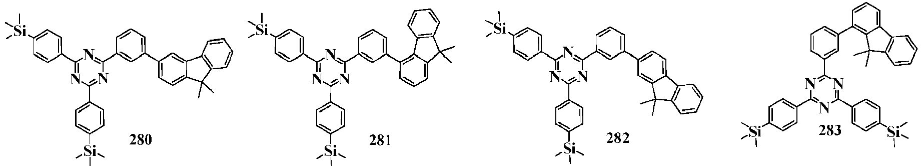

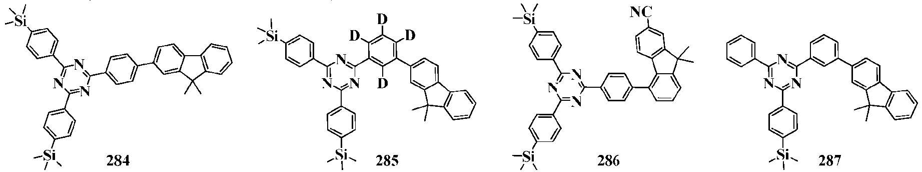

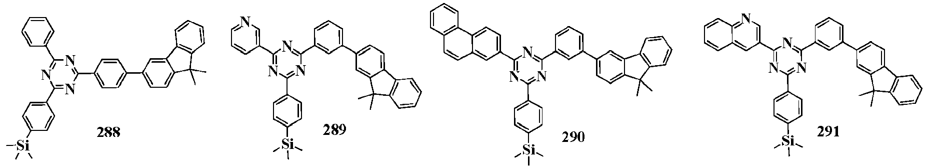

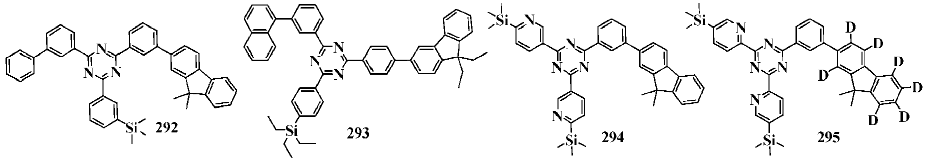

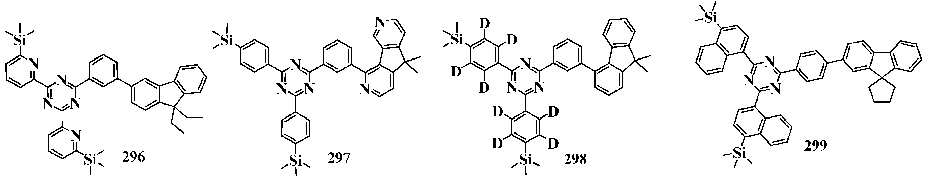

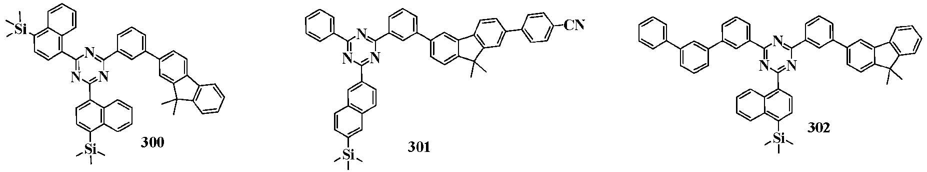

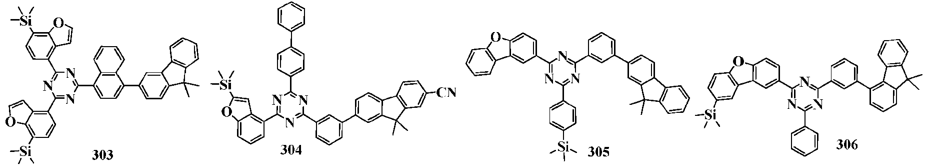

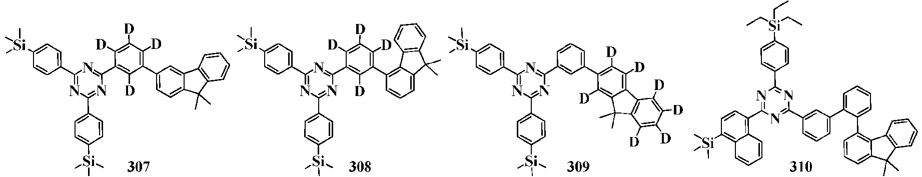

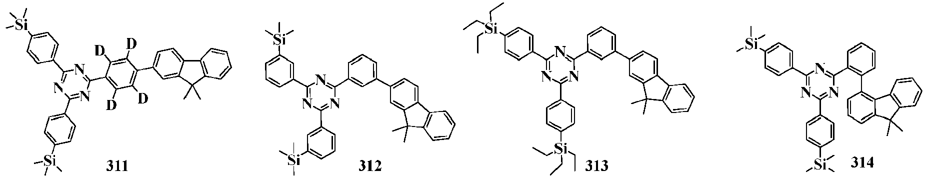

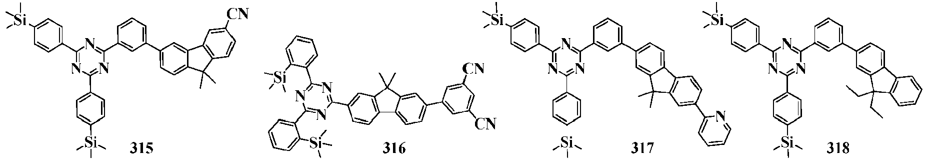

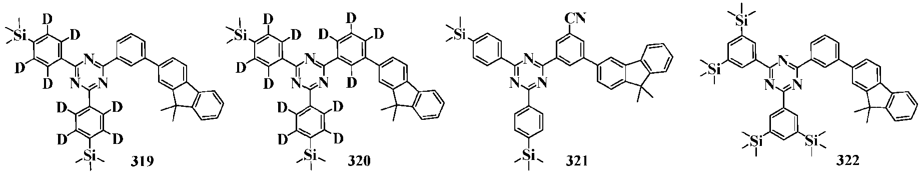

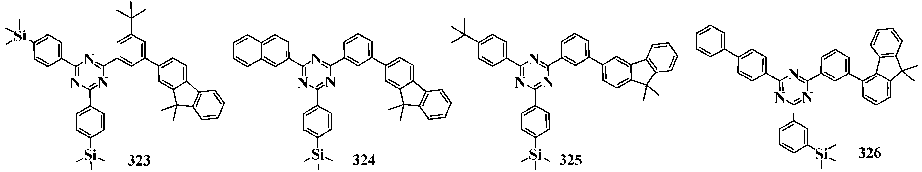

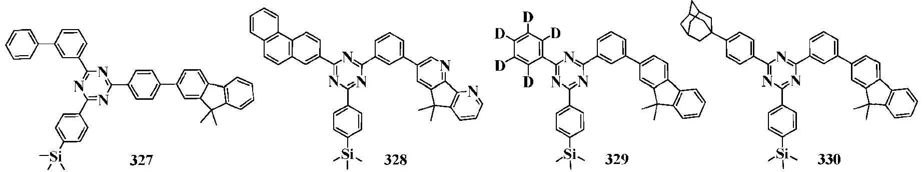

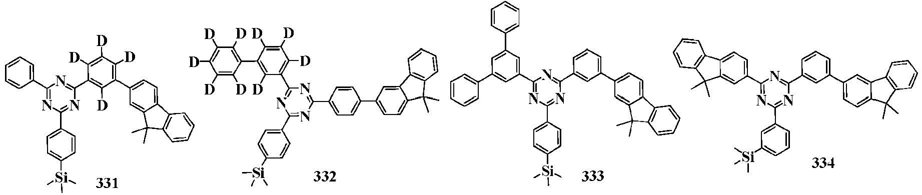

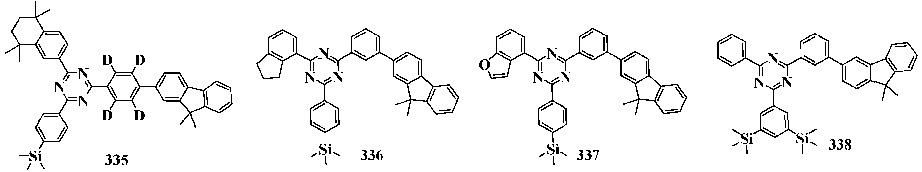

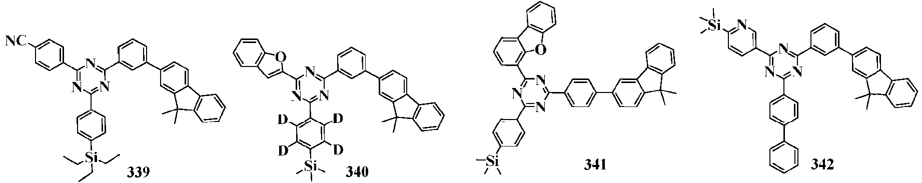

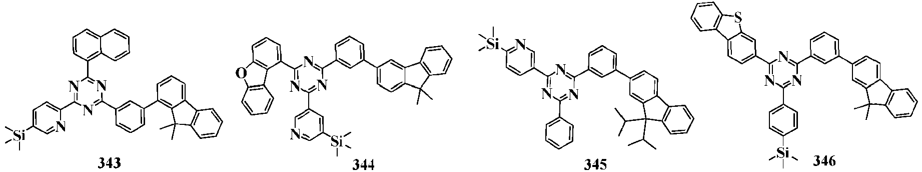

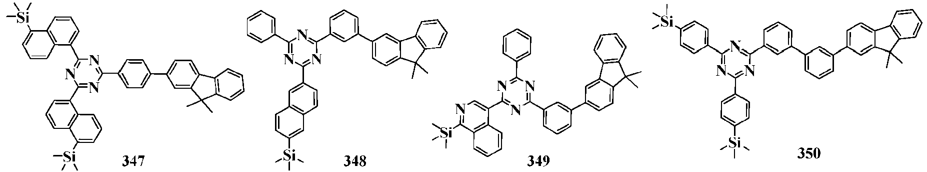

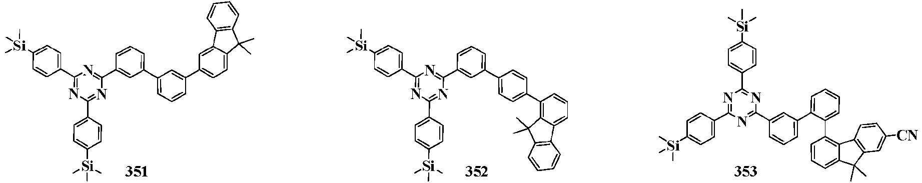

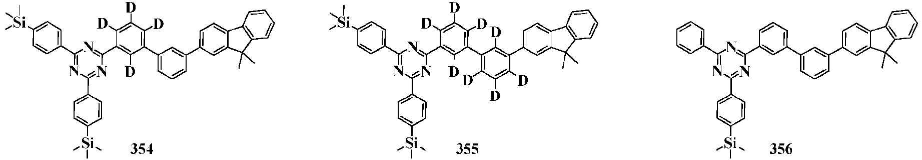

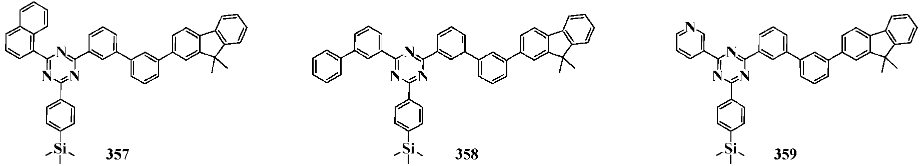

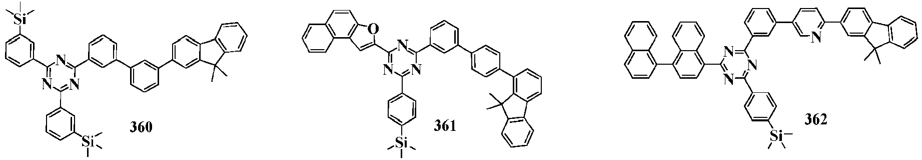

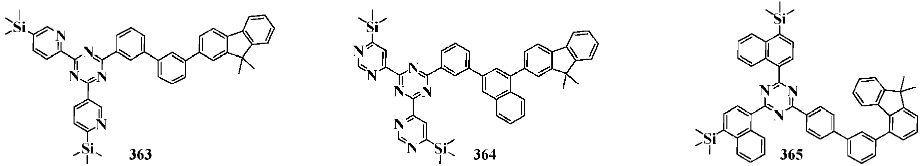

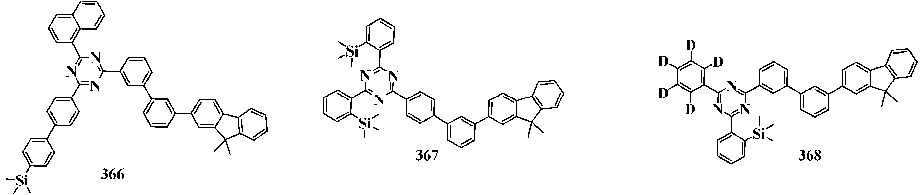

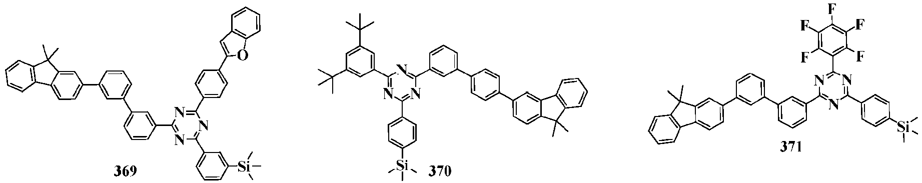

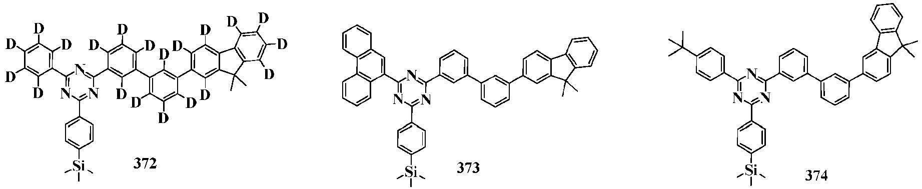

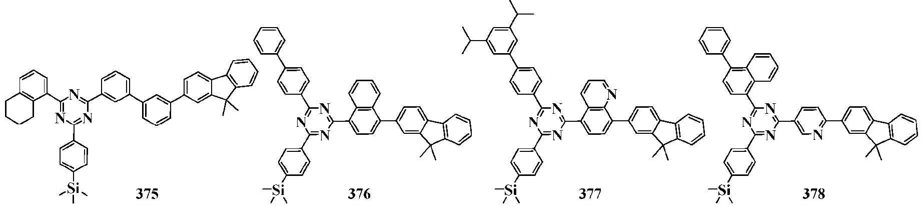

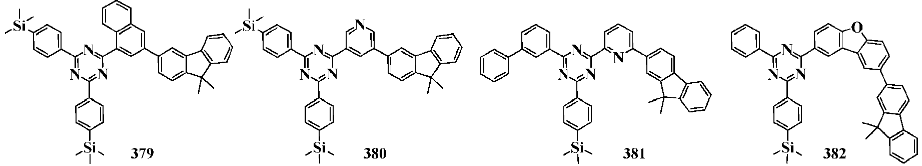

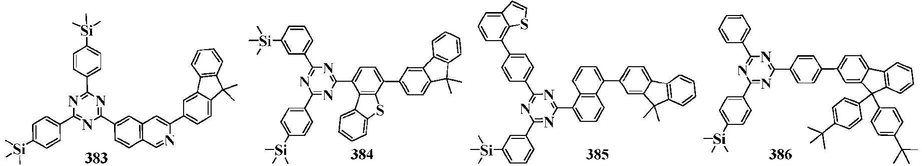

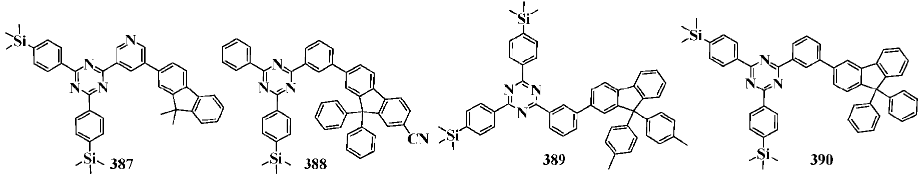

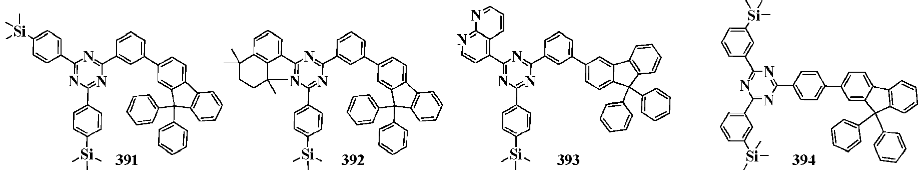

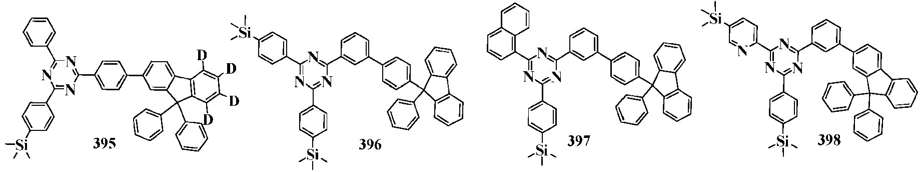

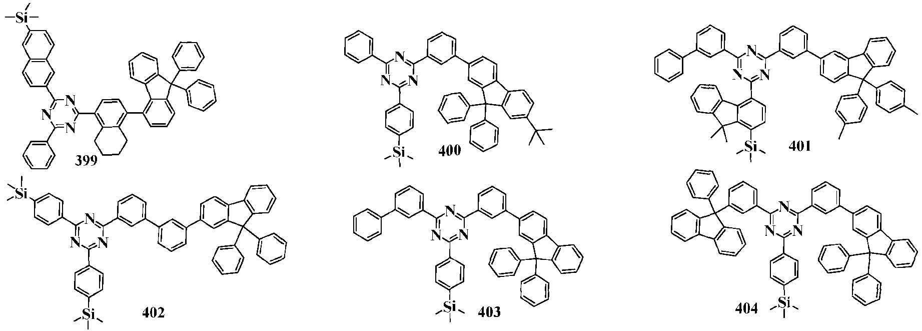

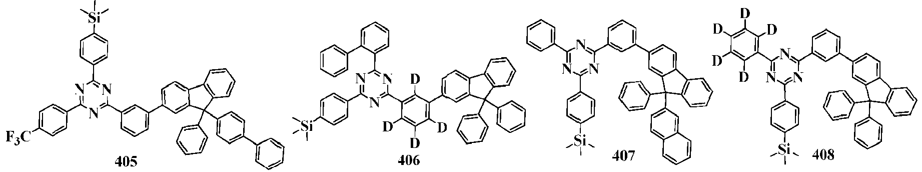

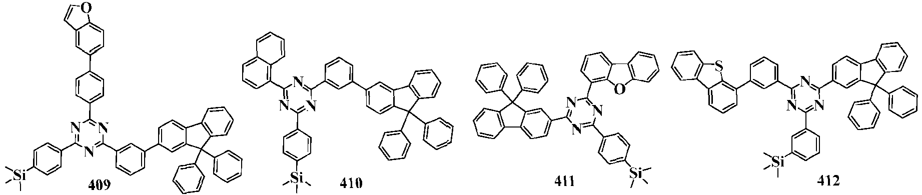

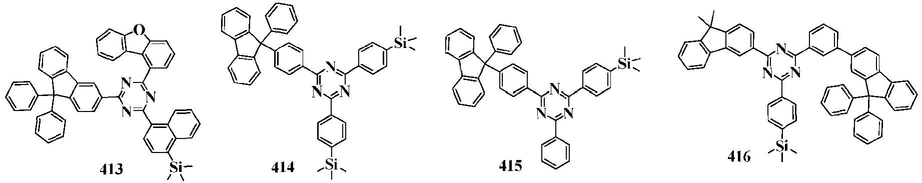

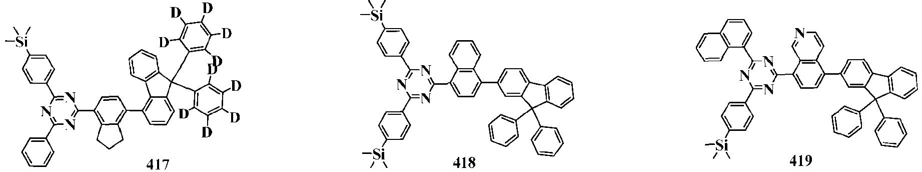

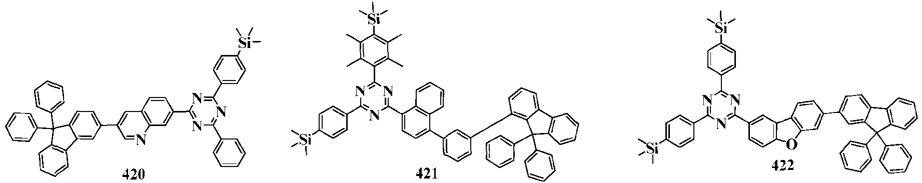

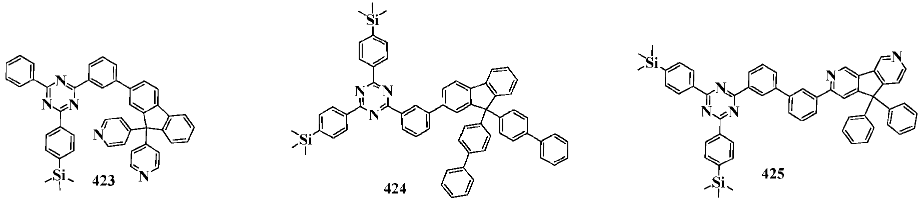

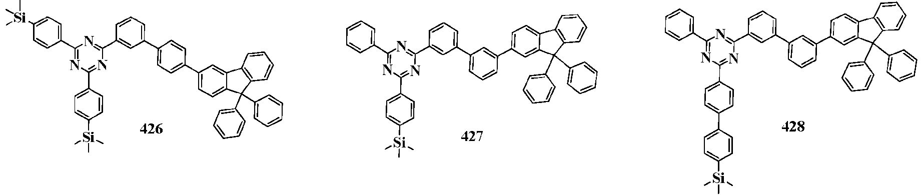

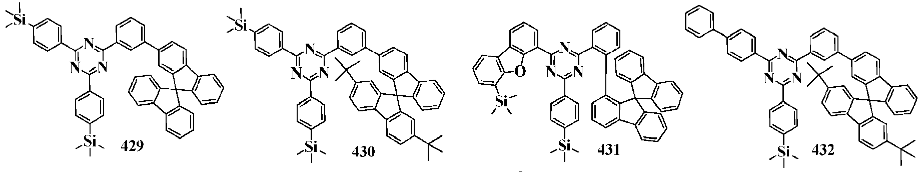

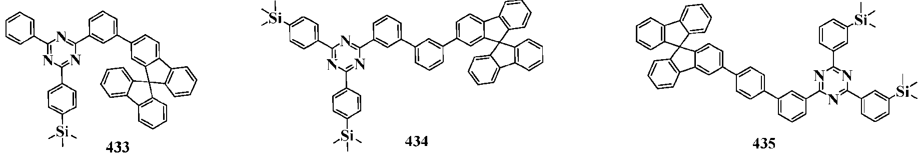

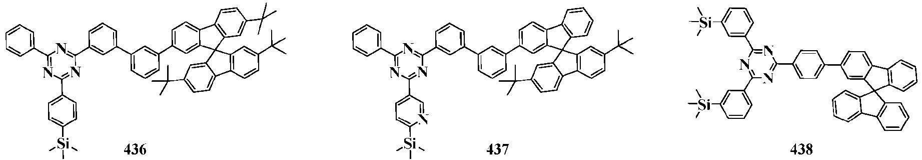

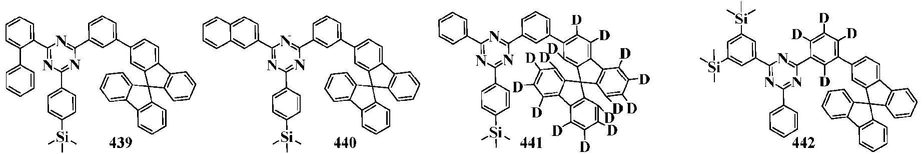

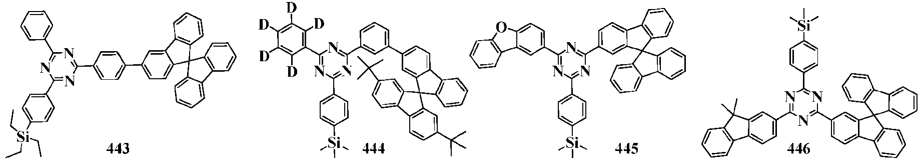

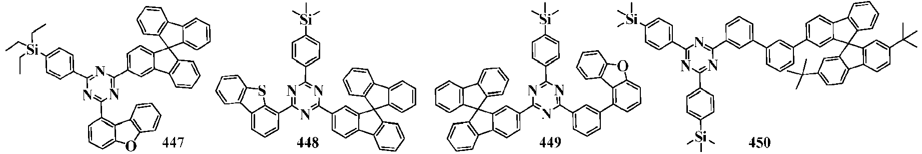

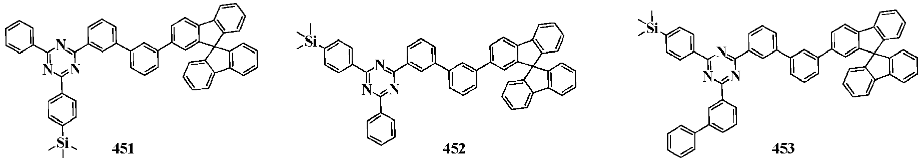

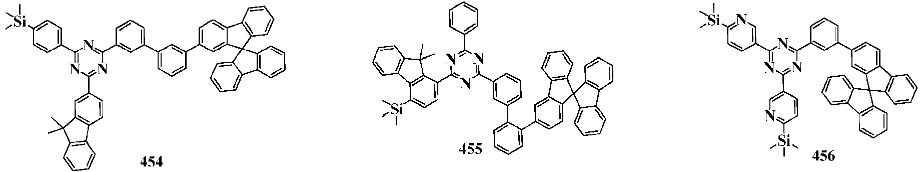

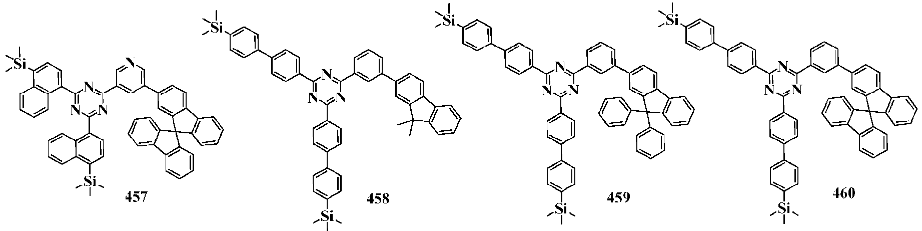

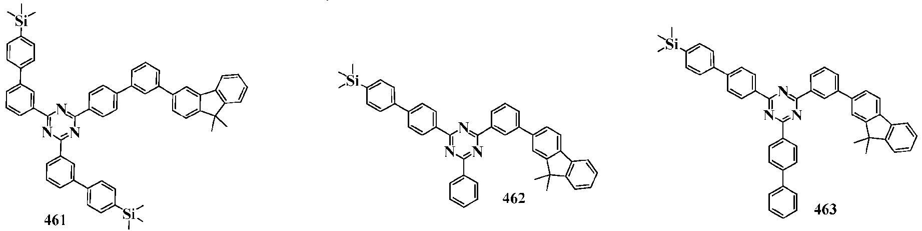

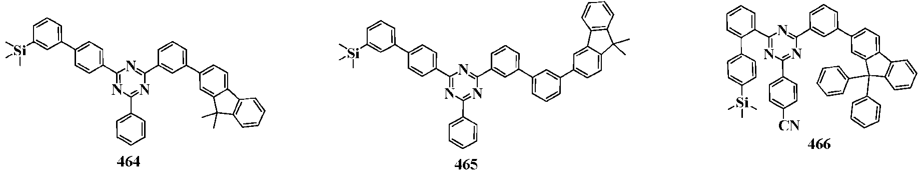

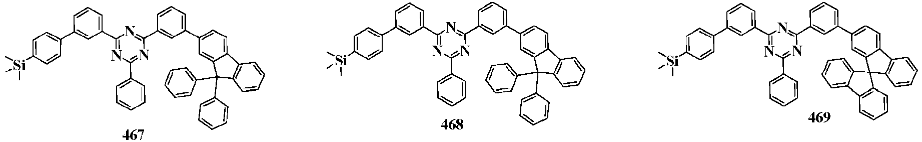

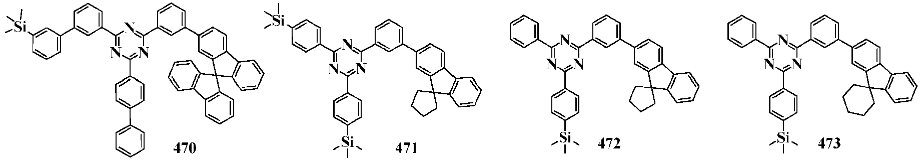

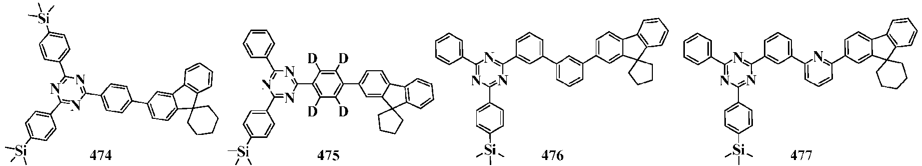

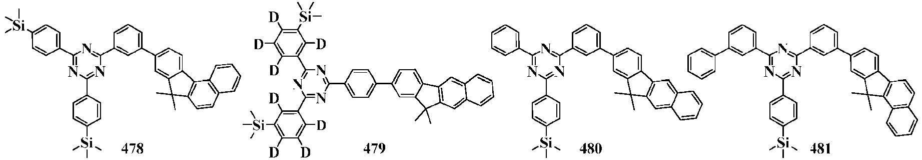

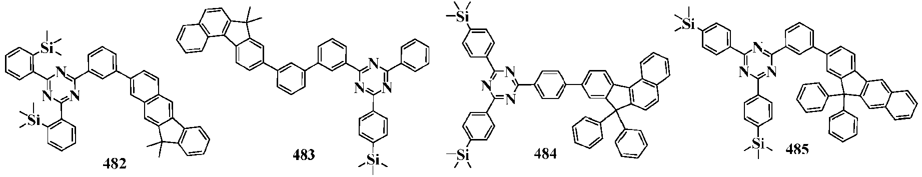

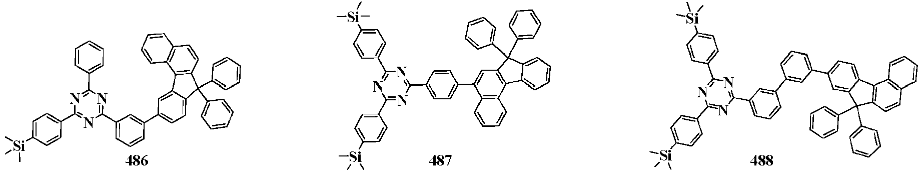

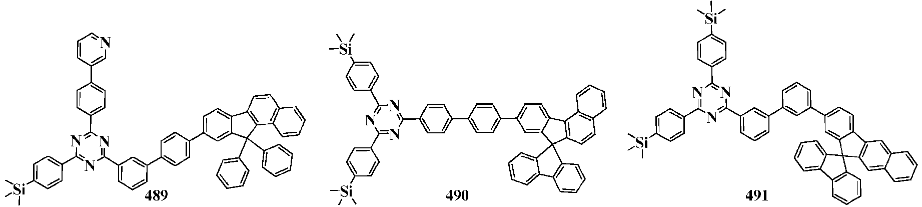

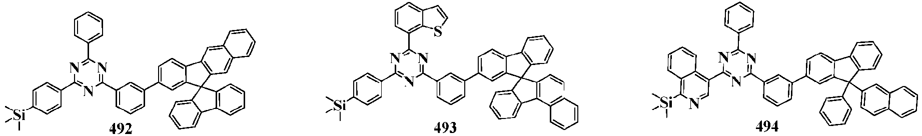

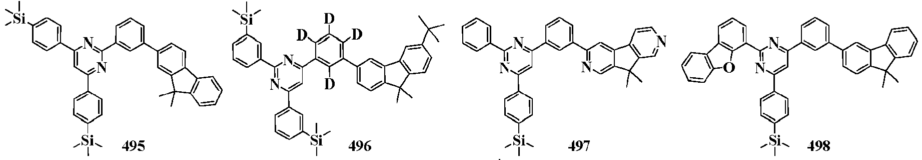

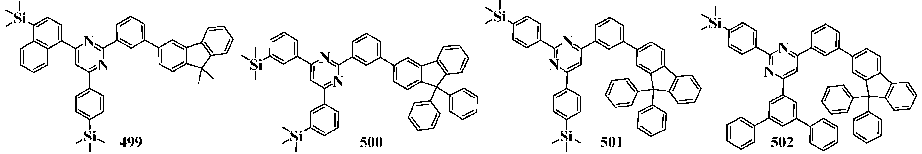

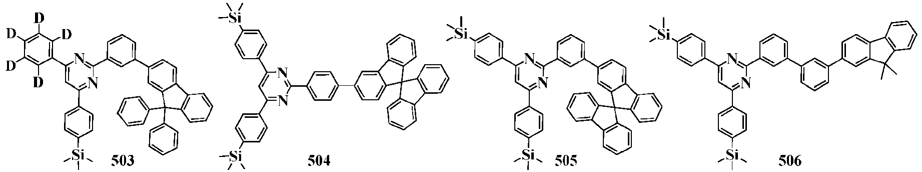

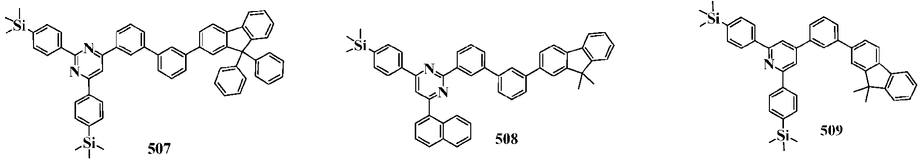

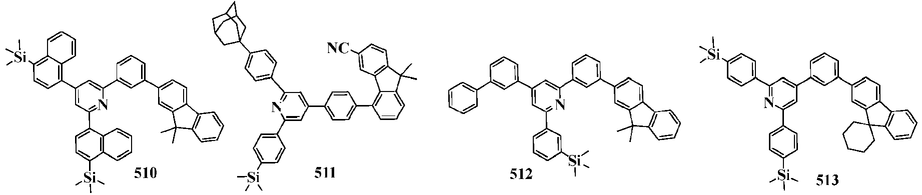

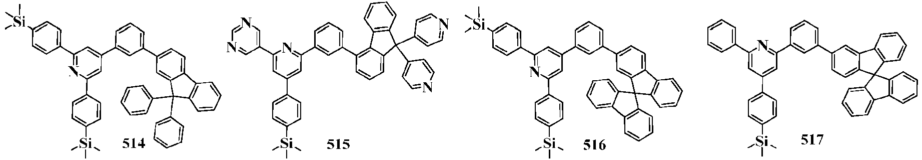

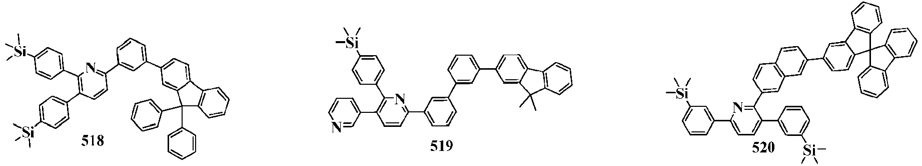

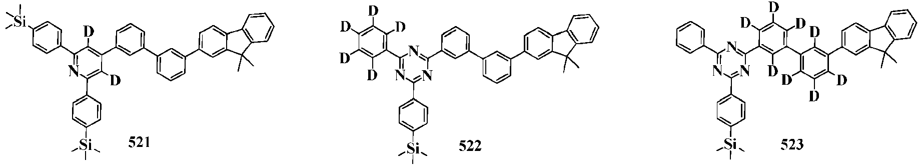

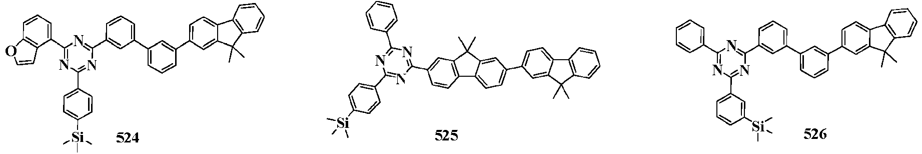

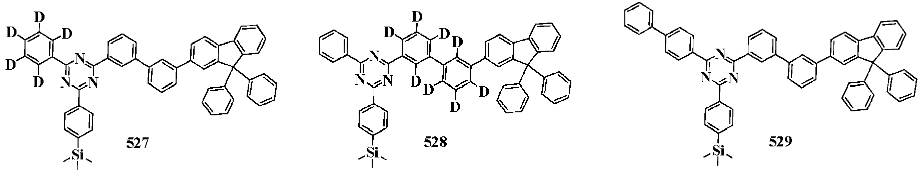

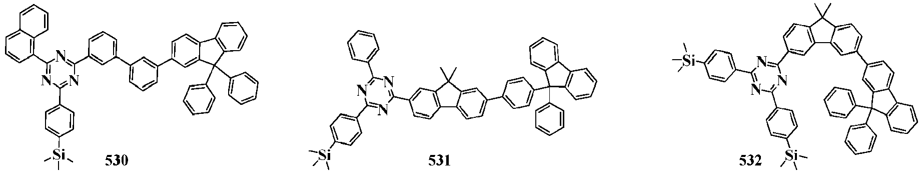

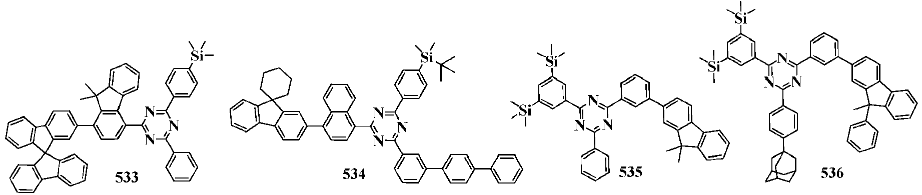

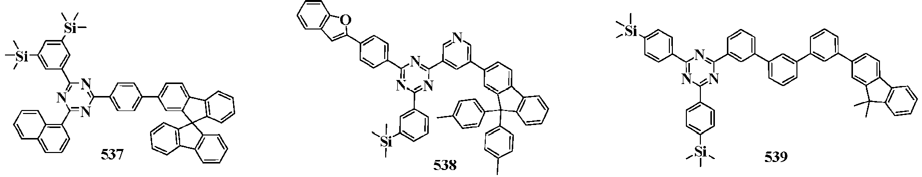

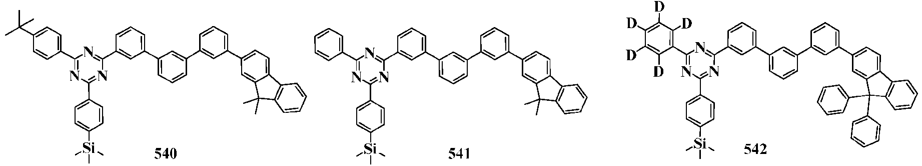

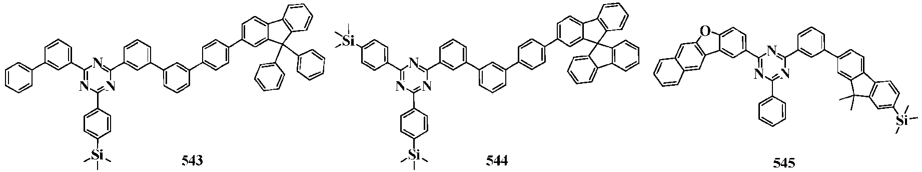

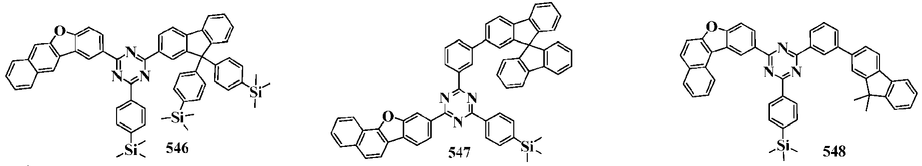

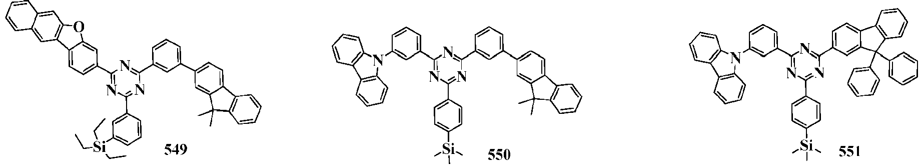

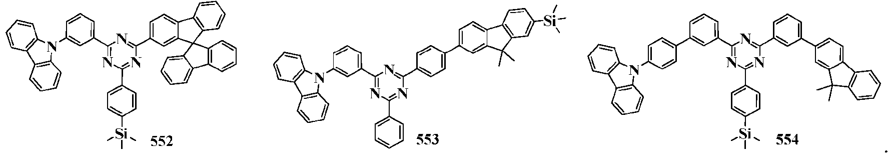

9. Dispositif électroluminescent organique comprenant une anode, une cathode et une couche organique, dans lequel la couche organique est disposée entre l'anode et la cathode, la couche organique comprend au moins une couche émettrice de lumière, une couche de transport d'électrons ou une couche de blocage de trous, et au moins une parmi la couche émettrice de lumière, la couche de transport d'électrons ou la couche de blocage de trous comprend un ou plusieurs des composés hétérocycliques contenant du fluorène selon l'une quelconque des revendications 1 à 8.

10. Dispositif électroluminescent organique, comprenant une anode, une cathode et une couche organique, dans lequel la couche organique est disposée sur un côté extérieur d'au moins une de l'anode ou de la cathode, la couche organique comprend une couche d'extraction de lumière, et la couche d'extraction de lumière comprend un ou plusieurs des composés hétérocycliques contenant du fluorène selon l'une quelconque des revendications 1 à 8.
